(19) Europäisches Patentamt
European Patent Office
Office européen des brevets

(11) EP 4 527 845 A1

(12) **EUROPEAN PATENT APPLICATION**

(43) Date of publication:
**26.03.2025 Bulletin 2025/13**

(21) Application number: **24197919.4**

(22) Date of filing: **02.09.2024**

(51) International Patent Classification (IPC):
***C07F 15/00*** *(2006.01)* ***C09K 11/06*** *(2006.01)*
***H10K 85/00*** *(2023.01)*

(52) Cooperative Patent Classification (CPC):
**C07F 15/0086; C09K 11/06; H10K 85/00;**
C07B 2200/05

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **04.09.2023 KR 20230117230**
**29.08.2024 KR 20240117154**

(71) Applicant: **Samsung Electronics Co., Ltd.**
**Gyeonggi-do, 16677 (KR)**

(72) Inventors:
- **KIM, Hwang Suk**
  **16678 Suwon-si (KR)**
- **KIM, Sangmo**
  **16678 Suwon-si (KR)**
- **MIN, Minsik**
  **16678 Suwon-si (KR)**
- **BAE, Hyejin**
  **16678 Suwon-si (KR)**
- **CHUNG, Yeon Sook**
  **16678 Suwon-si (KR)**
- **CHOI, Hyesung**
  **16678 Suwon-si (KR)**
- **HEO, Joon**
  **16678 Suwon-si (KR)**
- **KANG, Hosuk**
  **16678 Suwon-si (KR)**
- **KIM, Jong Soo**
  **16678 Suwon-si (KR)**
- **KIM, Joonghyuk**
  **16678 Suwon-si (KR)**
- **SON, Youngmok**
  **16678 Suwon-si (KR)**
- **LEE, Yeonkyung**
  **16678 Suwon-si (KR)**
- **JEONG, Daun**
  **18448 Hwaseong-si (KR)**
- **JU, Kyeongsik**
  **16678 Suwon-si (KR)**

(74) Representative: **Elkington and Fife LLP**
**Prospect House**
**8 Pembroke Road**
**Sevenoaks, Kent TN13 1XR (GB)**

(54) **ORGANOMETALLIC COMPOUND, ORGANIC LIGHT-EMITTING DEVICE INCLUDING THE SAME, AND ELECTRONIC APPARATUS INCLUDING THE ORGANIC LIGHT-EMITTING DEVICE**

(57) An organometallic compound represented by Formula 1:

EP 4 527 845 A1

Formula 1

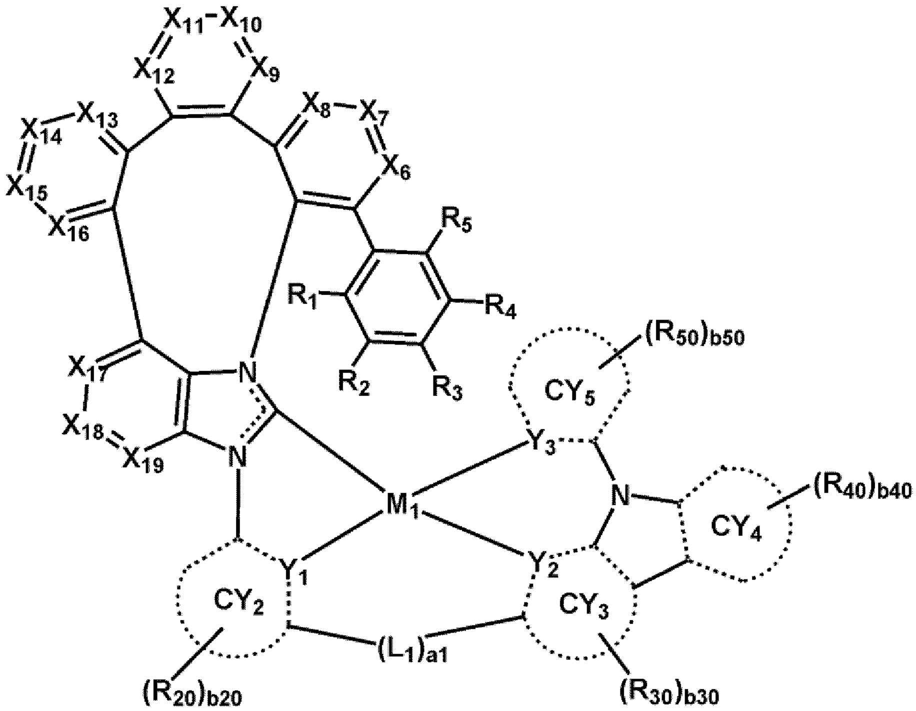

wherein $M_1$ is a transition metal; $Y_1$ to $Y_3$ are each independently C or N; $R_4$ is a substituted or unsubstituted $C_1$-$C_{60}$ alkyl group; ring $CY_2$ to ring CYs are each independently a $C_5$-$C_{60}$ carbocyclic group or a $C_1$-$C_{60}$ heterocyclic group; $L_1$ is a single bond, O, S, Se, $N(R_{61})$, $B(R_{61})$, $C(R_{61})(R_{62})$, or $Si(R_{61})(R_{62})$; a1 is 1, 2, 3, 4, or 5; b10, b20, b30, b40, and b50 are each independently 1, 2, 3, 4, 5, 6, 7, 8, 9, or 10; and the remaining substituent groups of Formula 1 are as provided herein.

FIG. 1

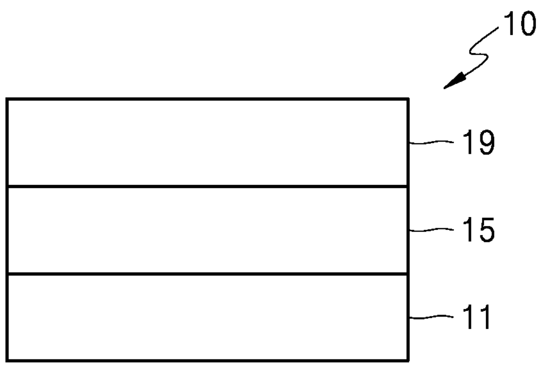

**Description**

FIELD OF THE INVENTION

The disclosure relates to an organometallic compound, an organic light-emitting device including the same, and an electronic apparatus including the organic light-emitting device.

BACKGROUND OF THE INVENTION

Organic light-emitting devices (OLEDs) are self-emissive devices, which have improved characteristics in terms of viewing angles, response time, brightness, driving voltage, and response speed. In addition, OLEDs can produce full-color images.

In an example, an organic light-emitting device may include an anode, a cathode, and an organic layer that is arranged between the anode and the cathode, wherein the organic layer includes an emission layer. A hole transport region may be located between the anode and the emission layer, and an electron transport region may be located between the emission layer and the cathode. Holes provided from the anode may move toward the emission layer through the hole transport region, and electrons provided from the cathode may move toward the emission layer through the electron transport region. The holes and the electrons may recombine in the emission layer to produce excitons. The excitons may transition from an excited state to a ground state, thereby generating light.

SUMMARY OF THE INVENTION

Provided are an organometallic compound, an organic light-emitting device including the same, and an electronic apparatus including the organic light-emitting device.

Additional aspects will be set forth in part in the detailed description that follows and, in part, will be apparent from the detailed description, or may be learned by practice of the presented exemplary embodiments that are described herein.

According to an aspect, provided is an organometallic compound represented by Formula 1:

Formula 1

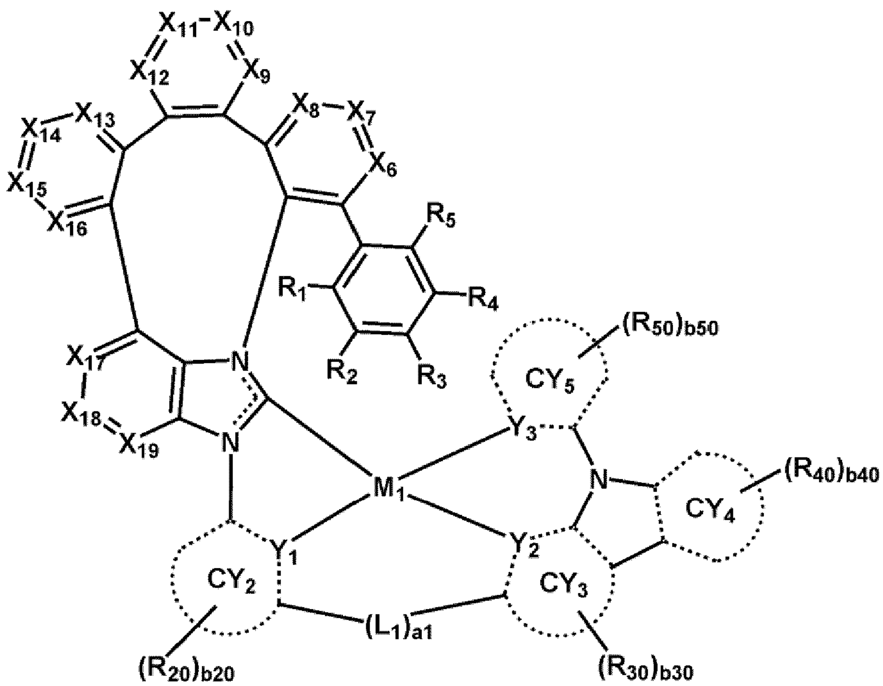

wherein, in Formula 1,

$M_1$ is a transition metal,
$Y_1$ to $Y_3$ are each independently C or N,
ring $CY_2$ to ring $CY_5$ are each independently a $C_5$-$C_{60}$ carbocyclic group or a $C_1$-$C_{60}$ heterocyclic group,

$X_6$ is $C(R_6)$ or N, $X_7$ is $C(R_7)$ or N, and $X_8$ is $C(R_8)$ or N,
$X_9$ is $C(R_9)$ or N, $X_{10}$ is $C(R_{10})$ or N, $X_{11}$ is $C(R_{11})$ or N, and $X_{12}$ is $C(R_{12})$ or N,
$X_{13}$ is $C(R_{13})$ or N, $X_{14}$ is $C(R_{14})$ or N, $X_{15}$ is $C(R_{15})$ or N, and $X_{16}$ is $C(R_{16})$ or N,
$X_{17}$ is $C(R_{17})$ or N, $X_{18}$ is $C(R_{18})$ or N, and $X_{19}$ is $C(R_{19})$ or N,
$L_1$ is a single bond, O, S, Se, $N(R_{61})$, $B(R_{61})$, $C(R_{61})(R_{62})$, or $Si(R_{61})(R_{62})$,
a1 is 1, 2, 3, 4, or 5,
$R_4$ is a substituted or unsubstituted $C_1$-$C_{60}$ alkyl group,
$R_1$ to $R_3$, $R_5$ to $R_{20}$, $R_{30}$, $R_{40}$, $R_{50}$, $R_{61}$, and $R_{62}$ are each independently hydrogen, deuterium, -F, -Cl, -Br, -I, $-SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-C(=O)(Q_1)$, $-S(=O)(Q_1)$, $-S(=O)_2(Q_1)$, $-N(Q_4)(Q_5)$, $-B(Q_6)(Q_7)$, $-P(Q_8)(Q_9)$, $-P(=O)(Q_8)(Q_9)$, or $-P(=S)(Q_8)(Q_9)$,
neighboring two or more of $R_1$ to $R_{20}$, $R_{30}$, $R_{40}$, $R_{50}$, $R_{61}$, and $R_{62}$ are optionally bonded to each other to form a substituted or unsubstituted $C_5$-$C_{30}$ carbocyclic group or a substituted or unsubstituted $C_1$-$C_{30}$ heterocyclic group,
b20, b30, b40, and b50 are each independently 1, 2, 3, 4, 5, 6, 7, 8, 9, or 10,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be
deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group,
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, $-C(Q_{11})(Q_{12})(Q_{13})$, $-C(=O)(Q_{11})$, $-S(=O)(Q_{11})$, $-S(=O)_2(Q_{11})$, $-N(Q_{14})(Q_{15})$, $-B(Q_{16})(Q_{17})$, $-P(Q_{18})(Q_{19})$, $-P(=O)(Q_{18})(Q_{19})$, $-P(=S)(Q_{18})(Q_{19})$, or a combination thereof,
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group,
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$

heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, $-Ge(Q_{21})(Q_{22})(Q_{23})$, $-C(Q_{21})(Q_{22})(Q_{23})$, $-C(=O)(Q_{21})$, $-S(=O)(Q_{21})$, $-S(=O)_2(Q_{21})$, $-N(Q_{24})(Q_{25})$, $-B(Q_{26})(Q_{27})$, $-P(Q_{28})(Q_{29})$, $-P(=O)(Q_{28})(Q_{29})$, $-P(=S)(Q_{28})(Q_{29})$, or a combination thereof, or

$-Si(Q_{31})(Q_{32})(Q_{33})$, $-Ge(Q_{31})(Q_{32})(Q_{33})$, $-C(Q_{31})(Q_{32})(Q_{33})$, $-C(=O)(Q_{31})$, $-S(=O)(Q_{31})$, $-S(=O)_2(Q_{31})$, $-N(Q_{34})(Q_{35})$, $-B(Q_{36})(Q_{37})$, $-P(Q_{38})(Q_{39})$, $-P(=O)(Q_{38})(Q_{39})$, or $-P(=S)(Q_{38})(Q_{39})$, and

$Q_1$ to Q9, Q11 to Q19, Q21 to Q29, and Q31 to Q39 are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

According to another aspect, an organic light-emitting device includes at least one of the organometallic compounds represented by Formula 1.

According to an aspect, provided is an organic light-emitting device that includes a first electrode; a second electrode; and an organic layer arranged between the first electrode and the second electrode, wherein the organic layer includes at least one of the organometallic compounds represented by Formula 1.

According to another aspect, an electronic apparatus includes the organic light-emitting device.

BRIEF DESCRIPTION OF THE DRAWINGS

The above and other aspects, features, and advantages of certain exemplary embodiments of the disclosure will be more apparent from the following detailed description taken in conjunction with the accompanying drawings, in which:

FIG. 1 is a schematic cross-sectional view of an organic light-emitting device according to one or more embodiments;
FIG. 2 is a schematic diagram illustrating energy transfer of an organic light-emitting device according to one or more embodiments;
FIG. 3 is a schematic diagram illustrating energy transfer of an organic light-emitting device according to one or more embodiments; and
FIG. 4 is a schematic diagram illustrating energy transfer of an organic light-emitting device according to one or more embodiments.

DETAILED DESCRIPTION OF THE EMBODIMENTS

Reference will now be made in further detail to exemplary embodiments, examples of which are illustrated in the accompanying drawings, wherein like reference numerals refer to like elements throughout. In this regard, the present exemplary embodiments may have different forms and should not be construed as being limited to the detailed descriptions set forth herein. Accordingly, the exemplary embodiments are merely described in further detail below, and by referring to the figures, to explain certain aspects and features. As used herein, the term "and/or" includes any and all combinations of one or more of the associated listed items. Expressions such as "at least one of," when preceding a list

of elements, modify the entire list of elements and do not modify the individual elements of the list.

The terminology used herein is for the purpose of describing one or more exemplary embodiments only and is not intended to be limiting. As used herein, the singular forms "a," "an," and "the" are intended to include the plural forms as well, unless the context clearly indicates otherwise. The term "or" means "and/or." It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

It will be understood that, although the terms first, second, third etc. may be used herein to describe various elements, components, regions, layers, and/or sections, these elements, components, regions, layers, and/or sections should not be limited by these terms. These terms are only used to distinguish one element, component, region, layer, or section from another element, component, region, layer, or section. Thus, a first element, component, region, layer, or section discussed below could be termed a second element, component, region, layer, or section without departing from the teachings of the present embodiments.

Exemplary embodiments are described herein with reference to cross section illustrations that are schematic illustrations of idealized embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

It will be understood that when an element is referred to as being "on" another element, it can be directly in contact with the other element or intervening elements may be present therebetween. In contrast, when an element is referred to as being "directly on" another element, there are no intervening elements present.

Unless otherwise defined, all terms (including technical and scientific terms) used herein have the same meaning as commonly understood by one of ordinary skill in the art to which this general inventive concept belongs. It will be further understood that terms, such as those defined in commonly used dictionaries, should be interpreted as having a meaning that is consistent with their meaning in the context of the relevant art and the present disclosure, and will not be interpreted in an idealized or overly formal sense unless expressly so defined herein.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10%, 5% of the stated value.

As used herein, an "energy level" (e.g., a highest occupied molecular orbital (HOMO) energy level or a triplet ($T_1$) energy level) is expressed as an absolute value from a vacuum level. In addition, when the energy level is referred to as being "deep," "high," or "large," the energy level has a large absolute value based on "0 electron Volts (eV)" of the vacuum level, and when the energy level is referred to as being "shallow," "low," or "small," the energy level has a small absolute value based on "0 eV" of the vacuum level.

An aspect provides an organometallic compound represented by Formula 1:

Formula 1

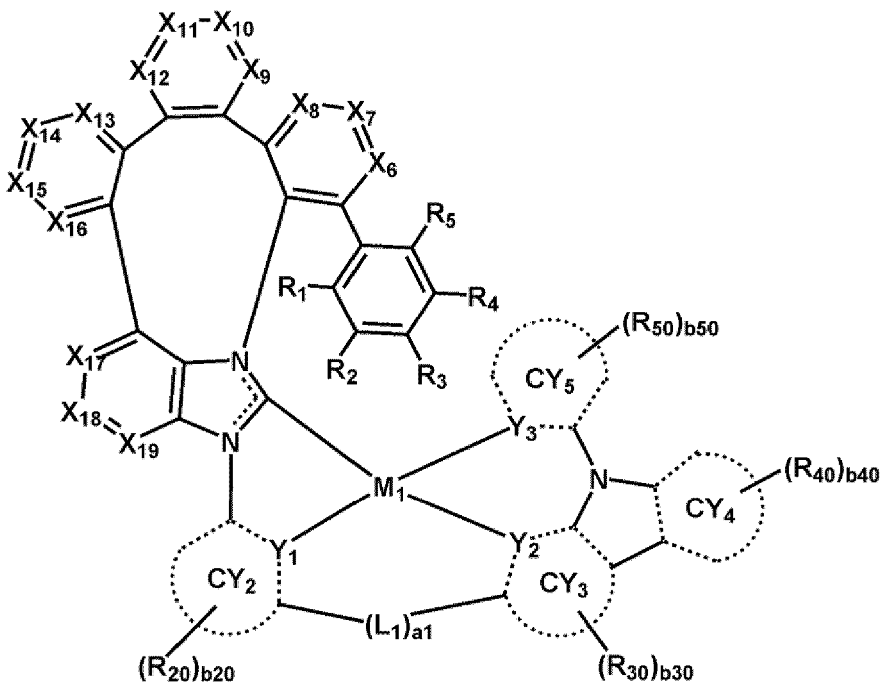

wherein, in Formula 1, $M_1$ is a transition metal.

In one or more embodiments, $M_1$ may be beryllium (Be), magnesium (Mg), aluminum (Al), calcium (Ca), titanium (Ti), manganese (Mn), cobalt (Co), copper (Cu), zinc (Zn), gallium (Ga), germanium (Ge), zirconium (Zr), ruthenium (Ru), rhodium (Rh), palladium (Pd), silver (Ag), rhenium (Re), platinum (Pt), or gold (Au).

In one or more embodiments, $M_1$ may be Pd, Ag, Re, Pt, or Au.

In one or more embodiments, $M_1$ may be Pd or Pt.

In Formula 1, $Y_1$ to $Y_3$ are each independently C or N.

In one or more embodiments, $Y_1$ may be C.

In one or more embodiments, $Y_2$ may be C.

In one or more embodiments, $Y_3$ may be N.

In Formula 1, ring $CY_2$ to ring $CY_5$ are each independently a $C_5$-$C_{60}$ carbocyclic group or a $C_1$-$C_{60}$ heterocyclic group.

In one or more embodiments, ring $CY_2$ to ring $CY_5$ may each independently be (i) a first ring, (ii) a second ring, (iii) a condensed ring group in which two or more first rings are condensed with each other, (iv) a condensed ring group in which two or more second rings are condensed with each other, or (v) a condensed ring group in which at least one first ring is condensed with at least one second ring,

the first ring may be a cyclopentane group, a cyclopentadiene group, a furan group, a thiophene group, a pyrrole group, a silole group, an indene group, a benzofuran group, a benzothiophene group, an indole group, a benzosilole group, an oxazole group, an isoxazole group, an oxadiazole group, an isoxadiazole group, an oxatriazole group, an isoxatriazole group, a thiazole group, an isothiazole group, a thiadiazole group, an isothiadiazole group, a thiatriazole group, an isothiatriazole group, a pyrazole group, an imidazole group, a triazole group, a tetrazole group, an azasilole group, a diazasilole group, or a triazasilole group, and

the second ring may be an adamantane group, a norbornene group, a bicyclo[1.1.1]pentane group, a bicyclo[2.1.1]hexane group, a bicyclo[2.2.1]heptane (norbornane) group, a bicyclo[2.2.2]octane group, a cyclohexane group, a cyclohexene group, a benzene group, a pyridine group, a pyrimidine group, a pyrazine group, a pyridazine group, or a triazine group.

In one or more embodiments, ring $CY_2$ to ring $CY_5$ may each independently be a benzene group, a naphthalene group, an anthracene group, a phenanthrene group, a triphenylene group, a pyrene group, a chrysene group, a 1,2,3,4-tetrahydronaphthalene group, a benzothiophene group, a benzofuran group, an indole group, an indene group, a benzosilole group, a benzoborole group, a benzophosphole group, a benzoselenophene group, a benzogermole group, a dibenzothiophene group, a dibenzofuran group, a carbazole group, a fluorene group, a dibenzosilole group, a

dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a 5,6,7,8-tetrahydroisoquinoline group, a 5,6,7,8-tetrahydroquinoline group, an adamantane group, a norbornane group, or a norbornene group.

In one or more embodiments, ring $CY_2$ to ring $CY_5$ may each independently be a benzene group, a naphthalene group, a phenanthrene group, a furan group, a thiophene group, a pyrrole group, a cyclopentene group, a silole group, a germole group, a benzofuran group, a benzothiophene group, an indole group, an indene group, a benzosilole group, a benzogermole group, a dibenzofuran group, a dibenzothiophene group, a carbazole group, a fluorene group, a dibenzosilole group, a dibenzogermole group, a pyridine group, a pyrimidine group, a pyridazine group, or a pyrazine group.

In Formula 1, $X_6$ is $C(R_6)$ or N, $X_7$ is $C(R_7)$ or N, $X_8$ is $C(R_8)$ or N, $X_9$ is $C(R_9)$ or N, $X_{10}$ is $C(R_{10})$ or N, $X_{11}$ is $C(R_{11})$ or N, $X_{12}$ is $C(R_{12})$ or N, $X_{13}$ is $C(R_{13})$ or N, $X_{14}$ is $C(R_{14})$ or N, $X_{15}$ is $C(R_{15})$ or N, $X_{16}$ is $C(R_{16})$ or N, $X_{17}$ is $C(R_{17})$ or N, $X_{18}$ is $C(R_{18})$ or N, and $X_{19}$ is $C(R_{19})$ or N.

In Formula 1, $L_1$ is a single bond, O, S, Se, $N(R_{61})$, $B(R_{61})$, $C(R_{61})(R_{62})$, or $Si(R_{61})(R_{62})$.

In Formula 1, a1 is 1, 2, 3, 4, or 5.

In Formula 1, $R_4$ is a substituted or unsubstituted $C_1$-$C_{60}$ alkyl group.

In one or more embodiments, $R_4$ may be a substituted or unsubstituted $C_1$-$C_{20}$ alkyl group.

In one or more embodiments, $R_4$ may be a $C_1$-$C_{20}$ alkyl group which is unsubstituted or substituted with deuterium.

In one or more embodiments, $R_4$ may be a linear $C_1$-$C_{20}$ alkyl group or a branched $C_1$-$C_{20}$ alkyl group (e.g. sec-alkyl group, tert-alkyl group, or the like), which is unsubstituted or substituted with deuterium.

In one or more embodiments, $R_4$ may be a methyl group, $-CD_3$, $-CD_2H$, $-CDH_2$, or a group represented by one of Formulae 9-1 to 9-39 or 9-44 to 9-62:

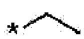
9-1
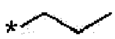
9-2
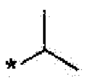
9-3
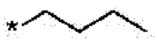
9-4
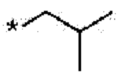
9-5
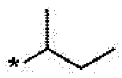
9-6
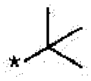
9-7
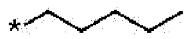
9-8

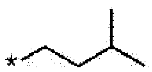
9-9
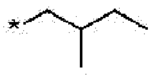
9-10
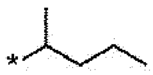
9-11
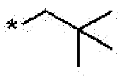
9-12
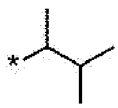
9-13
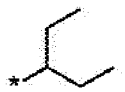
9-14
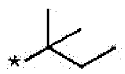
9-15

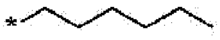
9-16
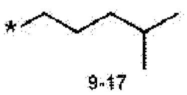
9-17
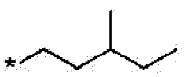
9-18
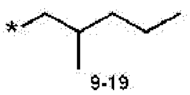
9-19
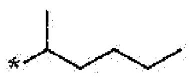
9-20
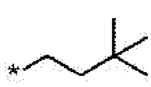
9-21

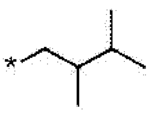
9-22
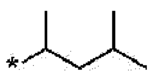
9-23
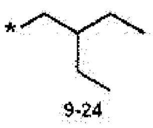
9-24
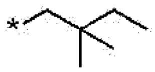
9-25
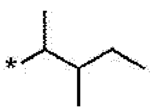
9-26
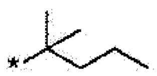
9-27
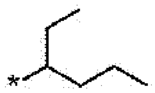
9-28

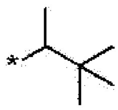
9-29

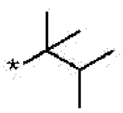
9-30

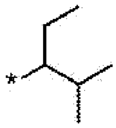
9-31

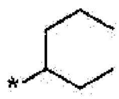
9-32

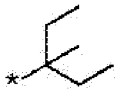
9-33

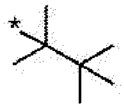
9-34

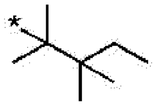
9-35

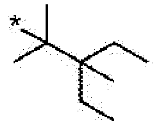
9-36

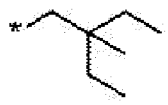
9-37

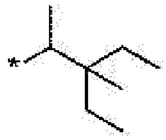
9-38

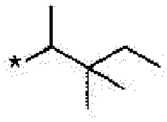
9-39

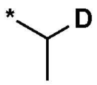
9-44

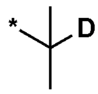
9-45

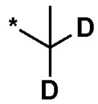
9-46

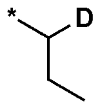
9-47

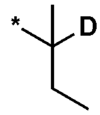
9-48

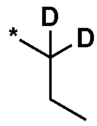
9-49

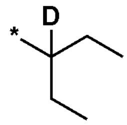
9-50

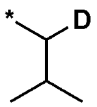
9-51

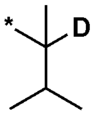
9-52

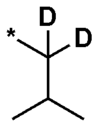
9-53

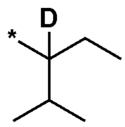
9-54

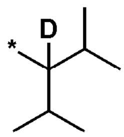
9-55

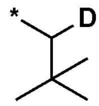
9-56

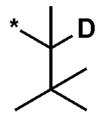
9-57

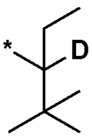
9-58

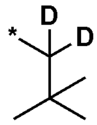
9-59

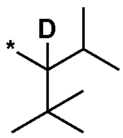
9-60

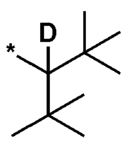
9-61

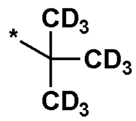
9-62

wherein, in Formulae 9-1 to 9-39 and 9-44 to 9-62,

* indicates a binding site to a neighboring atom.

In Formula 1, $R_1$ to $R_3$, $R_5$ to $R_{20}$, $R_{30}$, $R_{40}$, $R_{50}$, $R_{61}$, and $R_{62}$ are each independently hydrogen, deuterium, -F, -Cl, -Br, -I, $-SF_5$, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alky aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-C(=O)(Q_1)$, $-S(=O)(Q_1)$, $-S(=O)_2(Q_1)$, $-N(Q_4)(Q_5)$, $-B(Q_6)(Q_7)$, $-P(Q_8)(Q_9)$, $-P(=O)(Q_8)(Q_9)$, or $-P(=S)(Q_8)(Q_9)$.

In one or more embodiments, $R_1$ to $R_3$, $R_5$ to $R_{20}$, $R_{30}$, $R_{40}$, $R_{50}$, $R_{61}$, and $R_{62}$ may each independently be:

hydrogen, deuterium, -F, -Cl, -Br, -I, $-SF_5$, a hydroxyl group, a cyano group, a nitro group, an amino group, an amidino

group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, or a $C_1$-$C_{20}$ alkylthio group;

a $C_1$-$C_{20}$ alkyl group, a $C_1$-$C_{20}$ alkoxy group, or a $C_1$-$C_{20}$ alkylthio group, each substituted with at least one of deuterium, -F, -Cl, -Br, -I, $-SF_5$, $-CD_3$, $- CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group (norbornanyl group), a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or a combination thereof;

a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a benzoisothiazolyl group, a benzoxazolyl group, a benzoisoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or

$-Si(Q_1)(Q_2)(Q_3)$, $-Ge(Q_1)(Q_2)(Q_3)$, $-C(Q_1)(Q_2)(Q_3)$, $-C(=O)(Q_1)$, $- S(=O)(Q_1)$, $-S(=O)_2(Q_1)$, $-N(Q_4)(Q_5)$, $-B(Q_6)(Q_7)$, $-P(Q_8)(Q_9)$, $-P(=O)(Q_8)(Q_9)$, or $-P(=S)(Q_8)(Q_9)$.

In one or more embodiments, $R_1$ to $R_3$, $R_5$ to $R_{20}$, $R_{30}$, $R_{40}$, $R_{50}$, $R_{61}$, and $R_{62}$ may each independently be:

hydrogen, deuterium, -F, -Cl, -Br, -I, $-SF_5$, $-CD_3$, $-CD_2H$, $-CDH_2$, $-CF_3$, $-CF_2H$, $-CFH_2$, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group; or a group represented by one of Formulae 9-1 to 9-62, 9-201 to 9-244, 10-1 to 10-154, or 10-201 to 10-350:

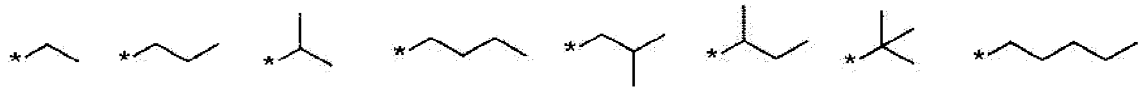

9-1 9-2 9-3 9-4 9-5 9-6 9-7 9-8

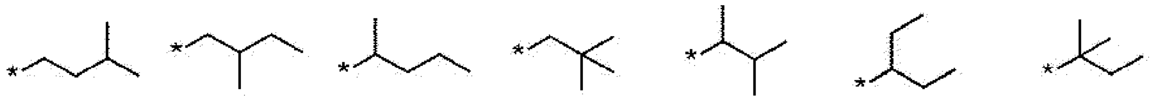

9-9 9-10 9-11 9-12 9-13 9-14 9-15

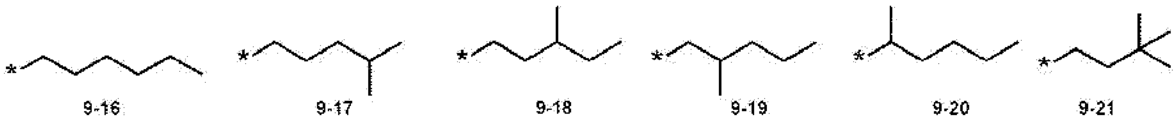

9-16 9-17 9-18 9-19 9-20 9-21

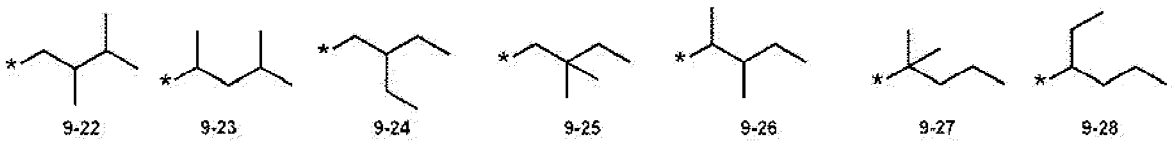

9-22 9-23 9-24 9-25 9-26 9-27 9-28

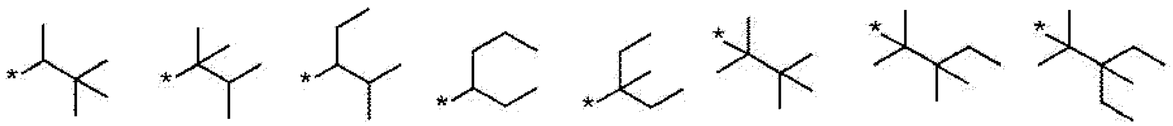

9-29 9-30 9-31 9-32 9-33 9-34 9-35 9-36

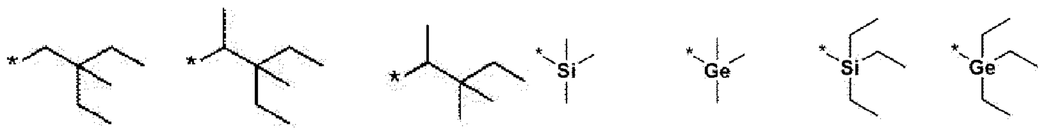

9-37 9-38 9-39 9-40 9-41 9-42 9-43

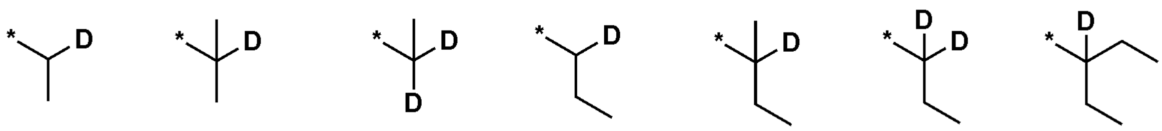

9-44 9-45 9-46 9-47 9-48 9-49 9-50

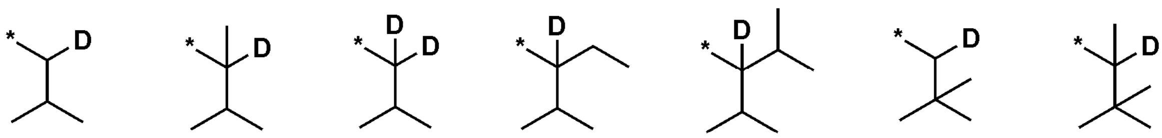

9-51 9-52 9-53 9-54 9-55 9-56 9-57

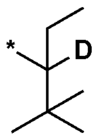
**9-58**

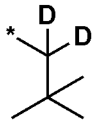
**9-59**

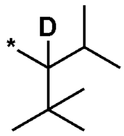
**9-60**

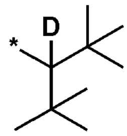
**9-61**

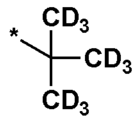
**9-62**

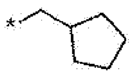
9-201

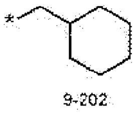
9-202

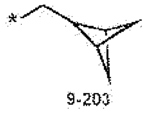
9-203

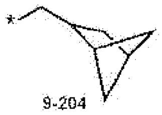
9-204

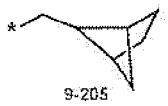
9-205

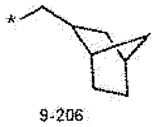
9-206

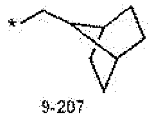
9-207

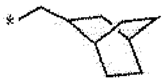
9-208

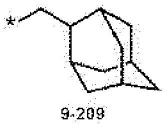
9-209

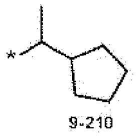
9-210

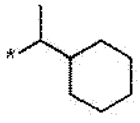
9-211

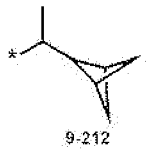
9-212

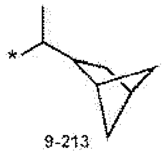
9-213

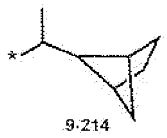
9-214

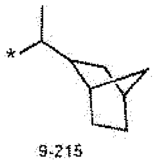
9-215

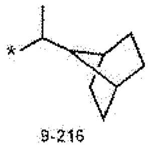
9-216

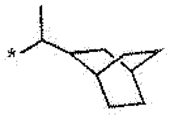
9-217

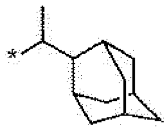
9-218

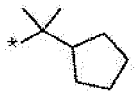
9-219

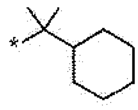
9-220

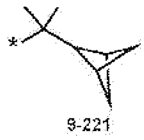
9-221

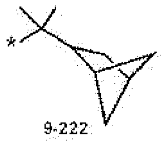
9-222

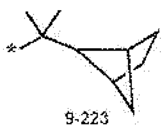
9-223

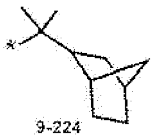
9-224

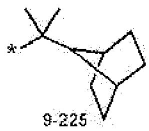
9-225

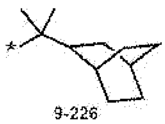
9-226

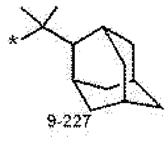
9-227

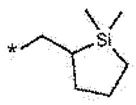
9-228

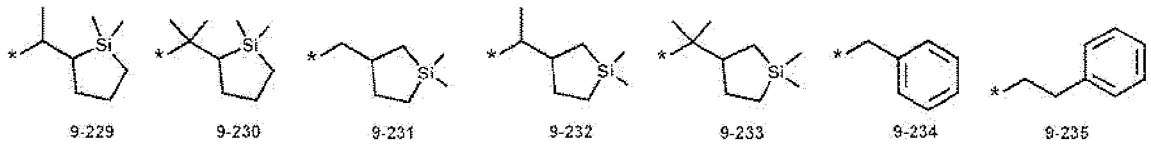
9-229 9-230 9-231 9-232 9-233 9-234 9-235

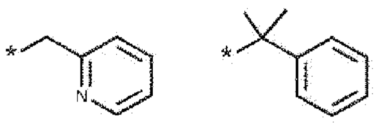
9-236 9-237

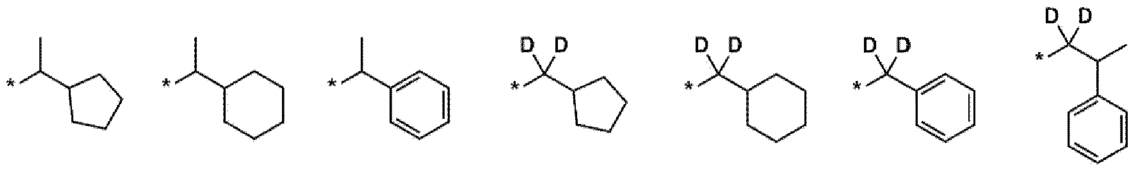
**9-238** **9-239** **9-240** **9-241** **9-242** **9-243** **9-244**

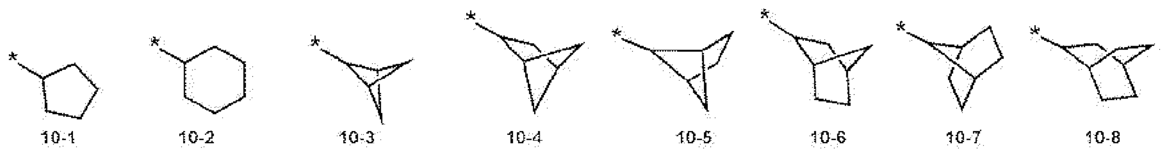
10-1 10-2 10-3 10-4 10-5 10-6 10-7 10-8

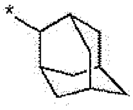
10-9
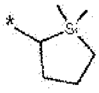
10-10
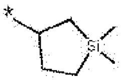
10-11
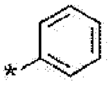
10-12
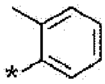
10-13
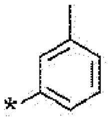
10-14
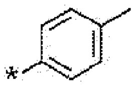
10-15
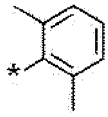
10-16

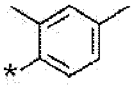
10-17
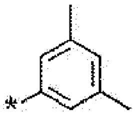
10-18
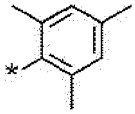
10-19
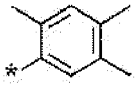
10-20
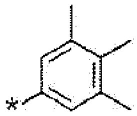
10-21
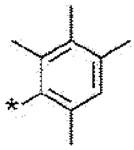
10-22
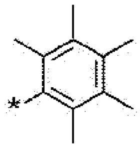
10-23

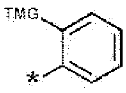
10-24
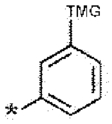
10-25
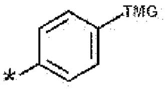
10-26
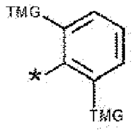
10-27
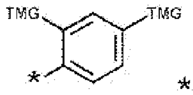
10-28
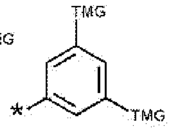
10-29
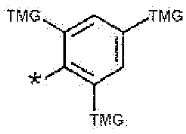
10-30

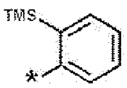
10-31
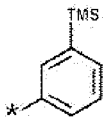
10-32
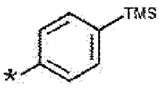
10-33
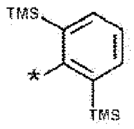
10-34
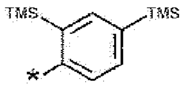
10-35
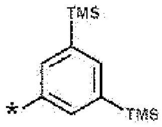
10-36
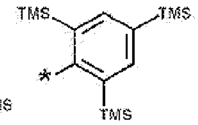
10-37

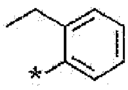
10-38
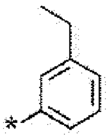
10-39
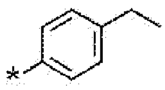
10-40
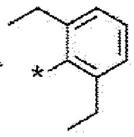
10-41
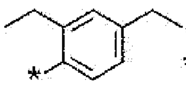
10-42
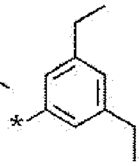
10-43
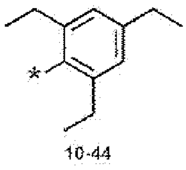
10-44

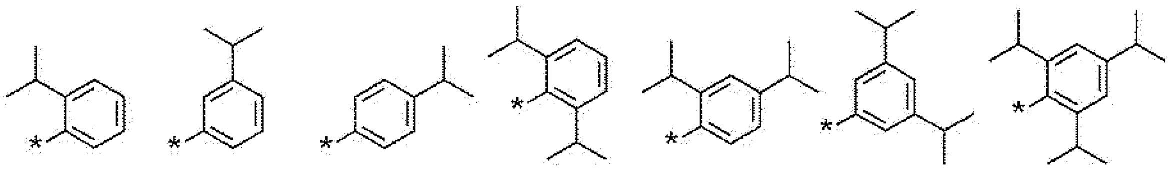
10-45 10-46 10-47 10-48 10-49 10-50 10-51

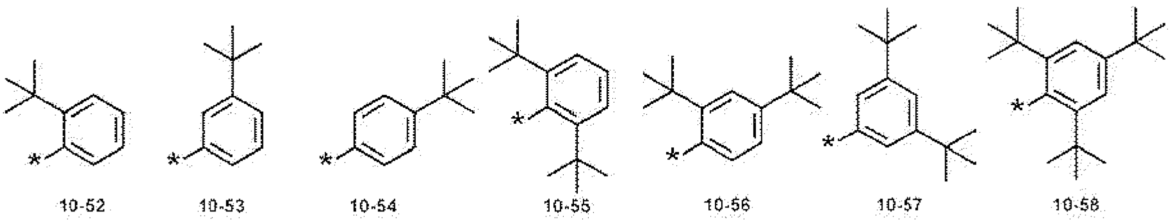
10-52 10-53 10-54 10-55 10-56 10-57 10-58

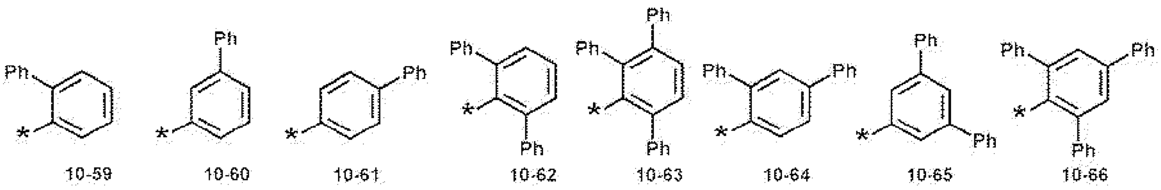
10-59 10-60 10-61 10-62 10-63 10-64 10-65 10-66

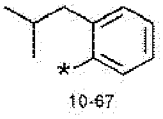
10-67

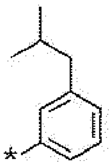
10-68

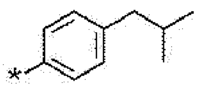
10-69

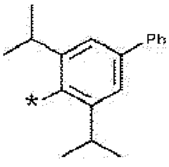
10-70

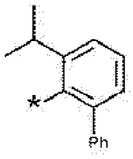
10-71

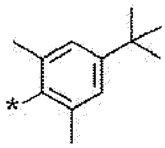
10-72

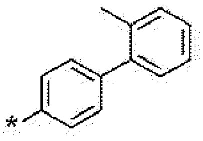
10-73

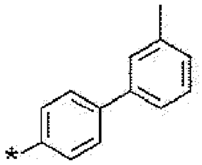
10-74

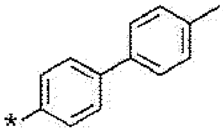
10-75

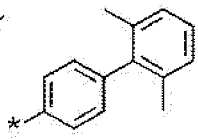
10-76

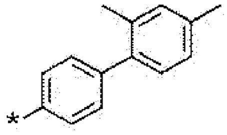
10-77

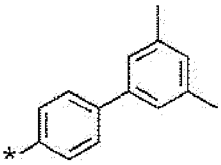
10-78

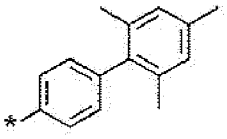
10-79

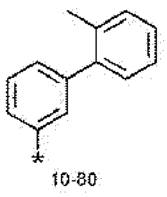
10-80

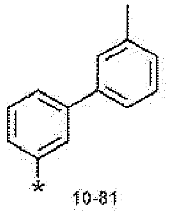
10-81

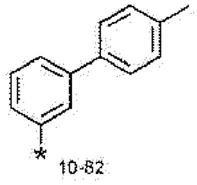
10-82

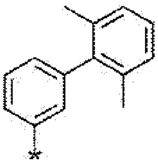
10-83

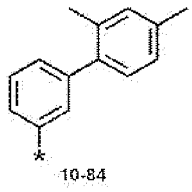
10-84

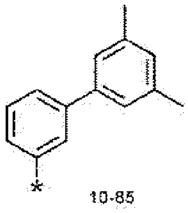
10-85

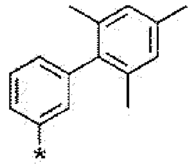
10-86

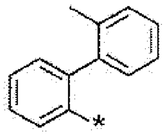
10-87

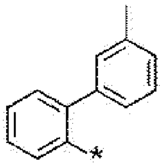
10-88

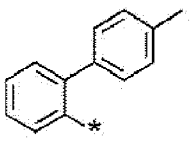
10-89

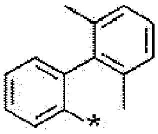
10-90

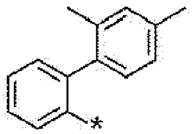
10-91

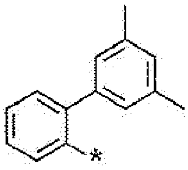
10-92

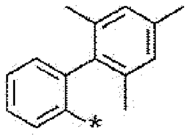
10-93

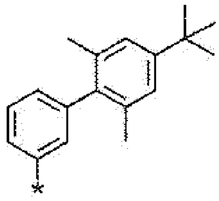
10-94

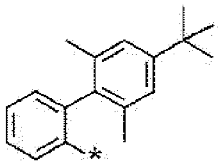
10-95

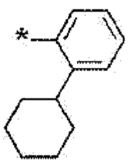
10-96

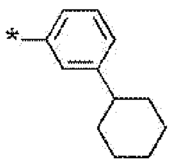
10-97

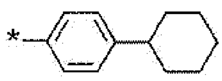
10-98

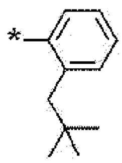
10-99

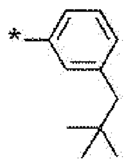
10-100

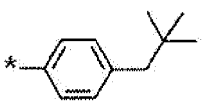
10-101

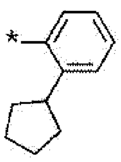
10-102

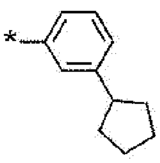
10-103

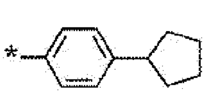
10-104

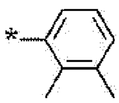
10-105

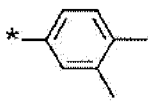
10-106

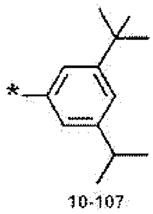
10-107

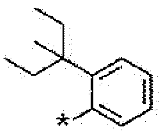
10-108

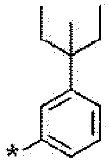
10-109

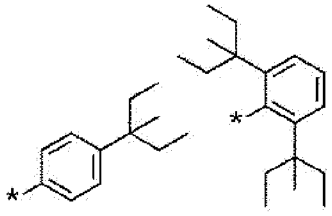
10-110

10-111

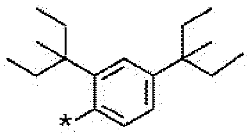
10-112

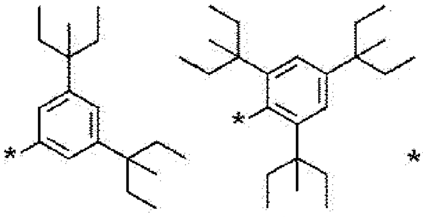
10-113

10-114

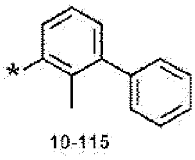
10-115

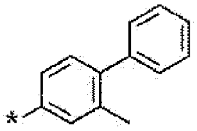
10-116

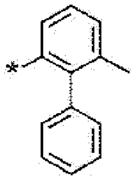
10-117

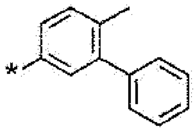
10-118

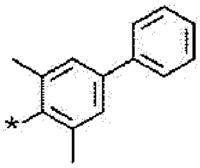
10-119

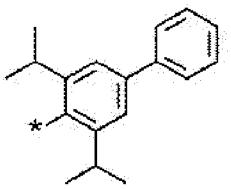
10-120

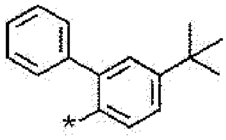
10-121

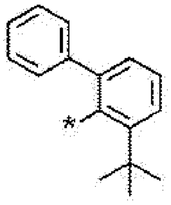
10-122

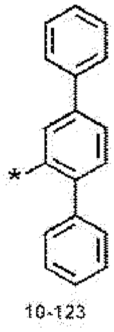
10-123

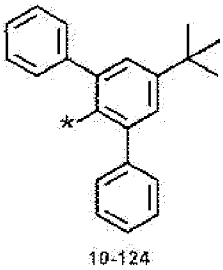
10-124

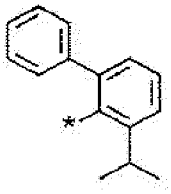
10-125

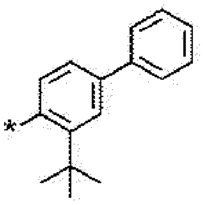
10-126

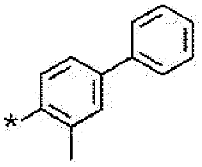
10-127

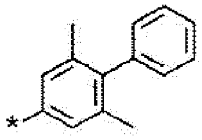
10-128

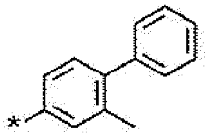
10-129

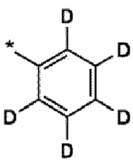
**10-130**

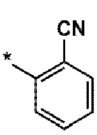
**10-131**

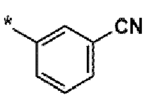
**10-132**

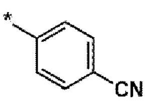
**10-133**

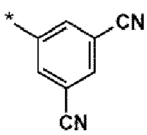
**10-134**

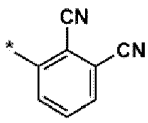
**10-135**

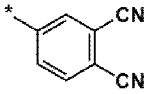
10-136

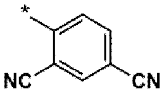
10-137

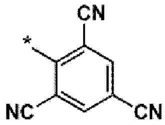
10-138

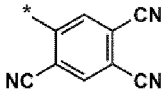
10-139

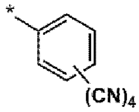
10-140

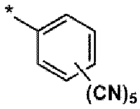
10-141

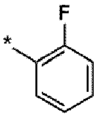
10-142

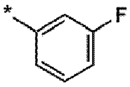
10-143

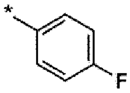
10-144

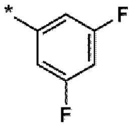
10-145

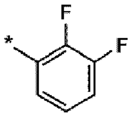
10-146

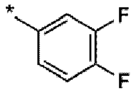
10-147

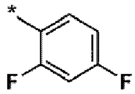
10-148

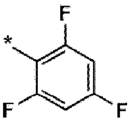
10-149

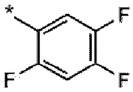
10-150

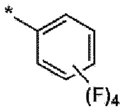
10-151

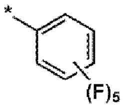
10-152

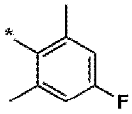
10-153

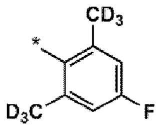
10-154

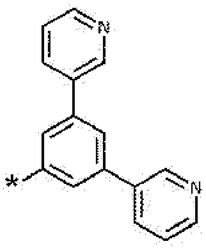
10-201

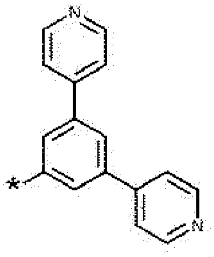
10-202

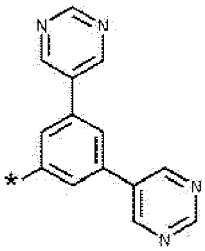
10-203

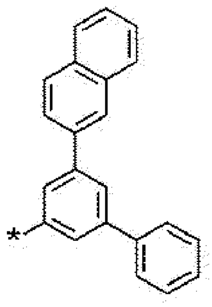
10-204

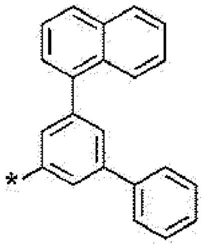
10-205

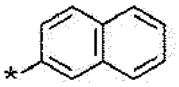
10-206

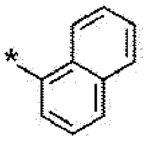
10-207

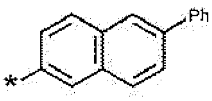
10-208

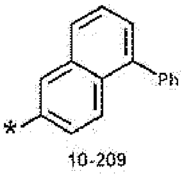
10-209

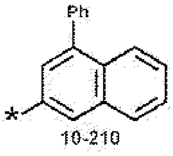
10-210

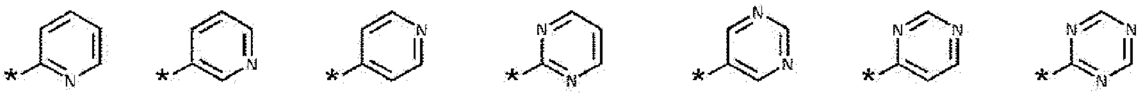
10-211 10-212 10-213 10-214 10-215 10-216 10-217

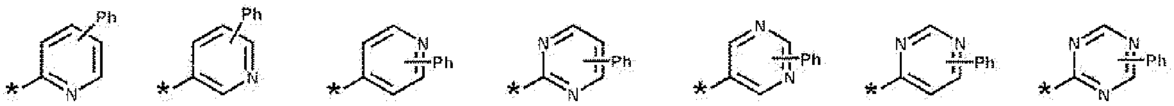
10-218 10-219 10-220 10-221 10-222 10-223 10-224

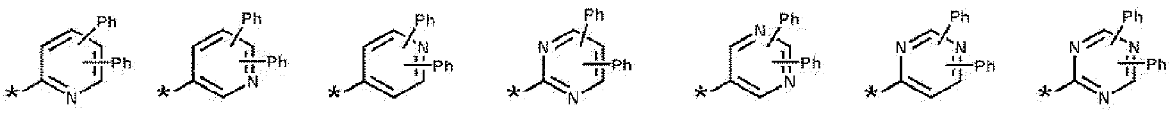
10-225 10-226 10-227 10-228 10-229 10-230 10-231

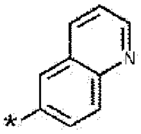
10-232
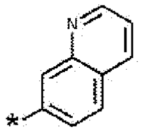
10-233
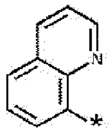
10-234
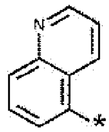
10-235
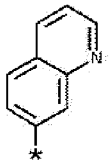
10-236
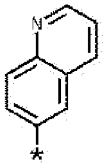
10-237

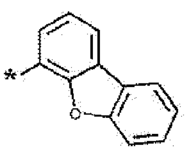
10-238
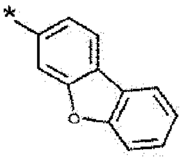
10-239
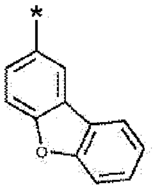
10-240
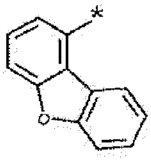
10-241
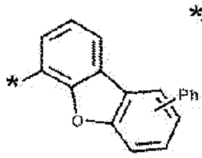
10-242
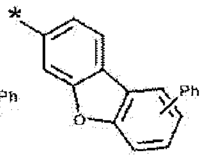
10-243

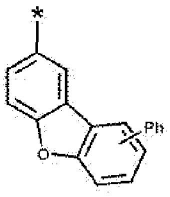
10-244
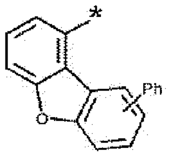
10-245
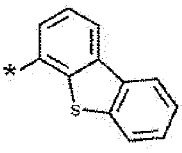
10-246
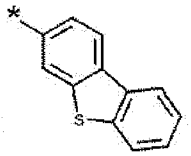
10-247
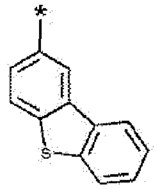
10-248
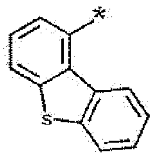
10-249

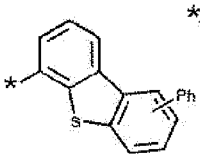
10-250
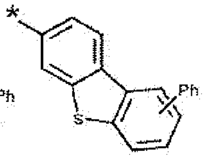
10-251
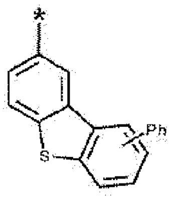
10-252
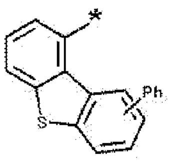
10-253
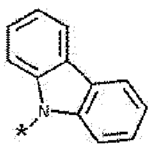
10-254
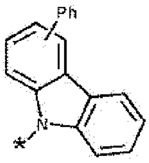
10-255

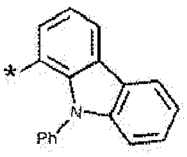
10-256
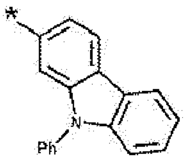
10-257
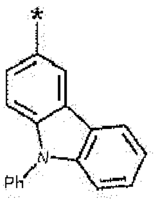
10-258
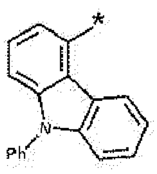
10-259
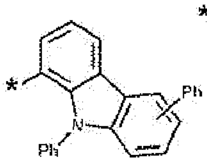
10-260
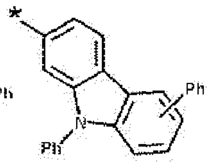
10-261

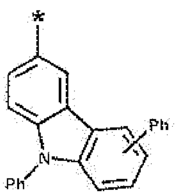
10-262
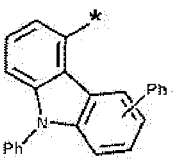
10-263
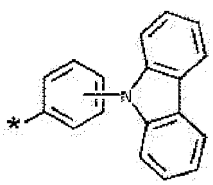
10-264
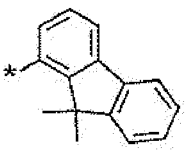
10-265
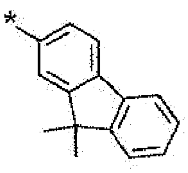
10-266
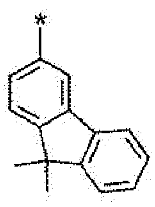
10-267

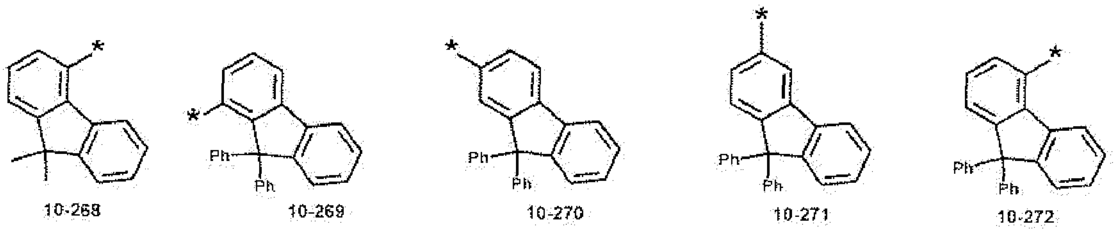

10-268 10-269 10-270 10-271 10-272

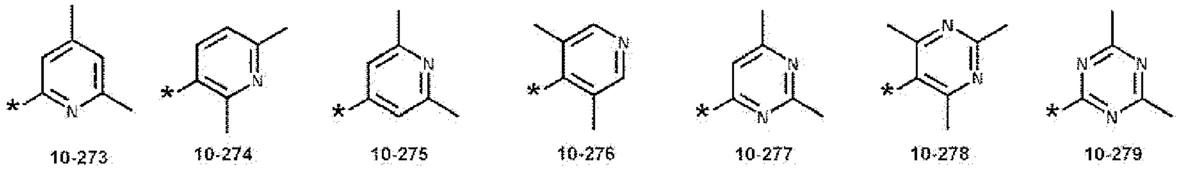

10-273 10-274 10-275 10-276 10-277 10-278 10-279

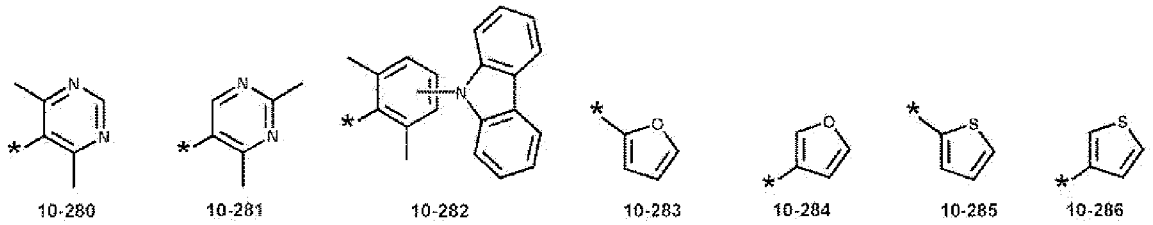

10-280 10-281 10-282 10-283 10-284 10-285 10-286

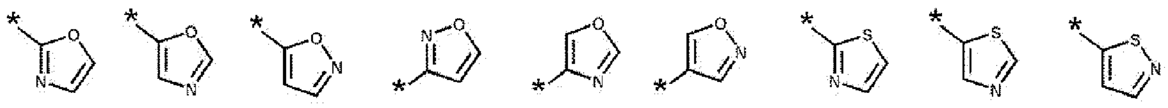

10-287 10-288 10-289 10-290 10-291 10-292 10-293 10-294 10-295

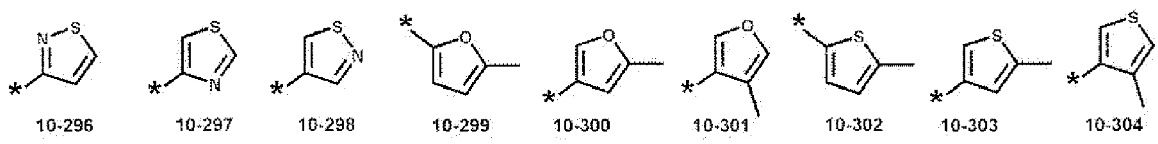

10-296 10-297 10-298 10-299 10-300 10-301 10-302 10-303 10-304

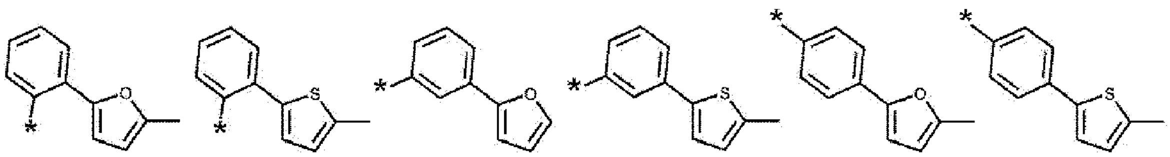

10-305 10-306 10-307 10-308 10-309 10-310

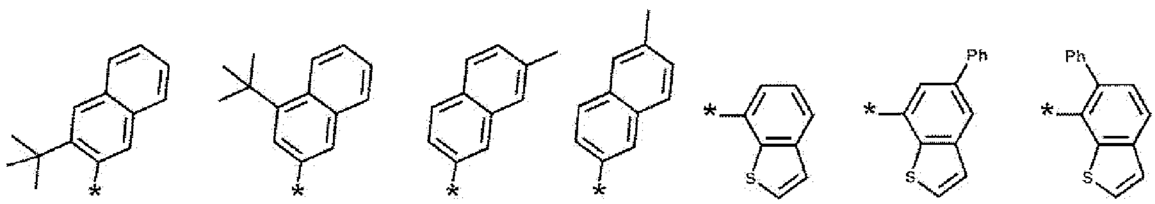

10-311 10-312 10-313 10-314 10-315 10-316 10-317

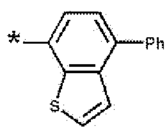
10-318
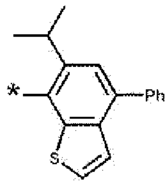
10-319
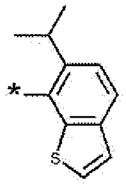
10-320
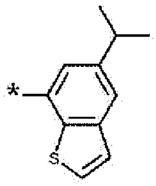
10-321
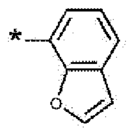
10-322
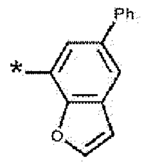
10-323
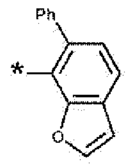
10-324

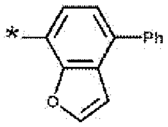
10-325
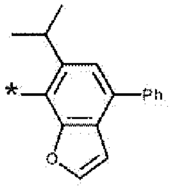
10-326
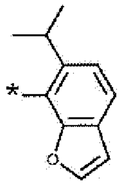
10-327
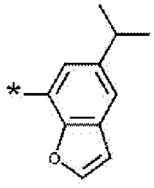
10-328
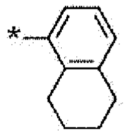
10-329
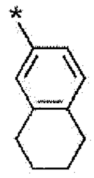
10-330
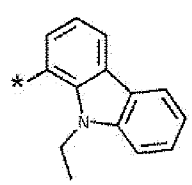
10-331

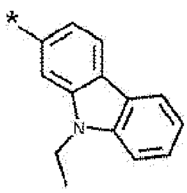
10-332
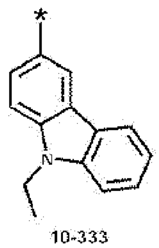
10-333
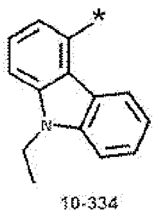
10-334
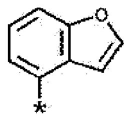
10-335
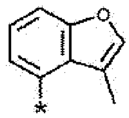
10-336
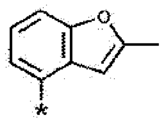
10-337

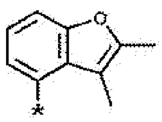
10-338
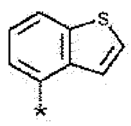
10-339
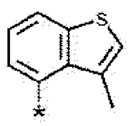
10-340
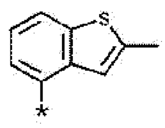
10-341
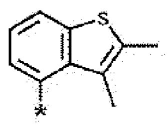
10-342
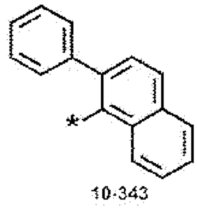
10-343

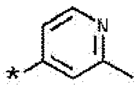
10-344
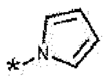
10-345
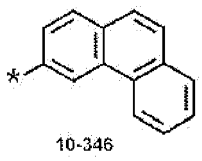
10-346
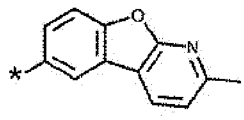
10-347
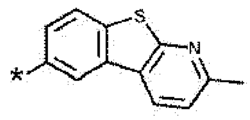
10-348

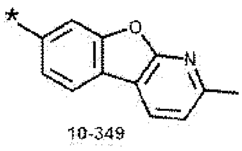
10-349
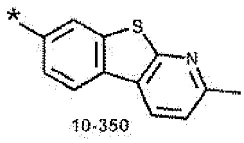
10-350

wherein, in Formulae 9-1 to 9-62, 9-201 to 9-244, 10-1 to 10-154, and 10-201 to 10-350, * indicates a binding site to a neighboring atom, "Ph" indicates a phenyl group, "TMS" indicates a trimethylsilyl group, and "TMG" indicates a trimethylgermyl group.

In one or more embodiments, $R_1$ to $R_{20}$, $R_{30}$, $R_{40}$, $R_{50}$, $R_{61}$, and $R_{62}$ may each independently be hydrogen, deuterium, a methyl group, an ethyl group, an n-propyl group, an isopropyl group, an n-butyl group, an isobutyl group, a sec-butyl group, a tert-butyl group, an n-pentyl group, an isopentyl group, a 2-methylbutyl group, a sec-pentyl group, a tert-pentyl group, a neo-pentyl group, a 3-pentyl group, a 3-methyl-2-butyl group, a phenyl group, a biphenyl group, a $C_1$-$C_{20}$ alkylphenyl group, or a naphthyl group.

In Formula 1, neighboring two or more of $R_1$ to $R_{20}$, $R_{30}$, $R_{40}$, $R_{50}$, $R_{61}$, and $R_{62}$ are optionally bonded to each other to form a substituted or unsubstituted $C_5$-$C_{30}$ carbocyclic group or a substituted or unsubstituted $C_1$-$C_{30}$ heterocyclic group.

In Formula 1, b20, b30, b40, and b50 are each independently 1, 2, 3, 4, 5, 6, 7, 8, 9, or 10.

In one or more embodiments, b20, b30, b40, and b50 may each independently be 1, 2, 3, or 4.

At least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, the substituted monovalent non-aromatic condensed heteropolycyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, and the substituted divalent non-aromatic condensed heteropolycyclic group described herein is:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, $-C(Q_1)(Q_2)(Q_3)$, $-C(=O)(Q_{11})$, $-S(=O)(Q_{11})$, $-S(=O)_2(Q_{11})$, $-N(Q_{14})(Q_{15})$, $-B(Q_{16})(Q_{17})$, $-P(Q_{18})(Q_{19})$, $-P(=O)(Q_{18})(Q_{19})$, $-P(=S)(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each unsubstituted or substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, $-Ge(Q_{21})(Q_{22})(Q_{23})$, $-C(Q_{21})(Q_{22})(Q_{23})$, $-C(=O)(Q_{21})$, $-S(=O)(Q_{21})$, $-S(=O)_2(Q_{21})$, $-N(Q_{24})(Q_{25})$, $-B(Q_{26})(Q_{27})$, $-P(Q_{28})(Q_{29})$, $-P(=O)(Q_{28})(Q_{29})$, $-P(=S)(Q_{28})(Q_{29})$, or a combination thereof;

$-si(Q_{31})(Q_{32})(Q_{33})$, $-Ge(Q_{31})(Q_{32})(Q_{33})$, $-C(Q_{31})(Q_{32})(Q_{33})$, $-C(=O)(Q_{31})$, $-S(=O)(Q_{31})$, $-S(=O)_2(Q_{31})$, $-N(Q_{34})(Q_{35})$, $-B(Q_{36})(Q_{37})$, $-P(Q_{38})(Q_{39})$, $-P(=O)(Q_{38})(Q_{39})$, or $-P(Q_{38})(Q_{39})$; or

a combination thereof.

$Q_1$ to Q9, Q11 to Q19, Q21 to Q29, and Q31 to Q39 described herein may each independently be hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a

substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a monovalent non-aromatic condensed polycyclic group, or a substituted or unsubstituted monovalent non-aromatic condensed heteropolycyclic group.

For example, $Q_1$ to $Q_9$, $Q_{11}$ to $Q_{19}$, $Q_{21}$ to $Q_{29}$, and $Q_{31}$ to $Q_{39}$ described herein may each independently be:

$-CH_3$, $-CD_3$, $-CD_2H$, $-CDH_2$, $-CH_2CH_3$, $-CH_2CD_3$, $-CH_2CD_2H$, $-CH_2CDH_2$, $-CHDCH_3$, $-CHDCD_2H$, $-CHDCDH_2$, $-CHDCD_3$, $-CD_2CD_3$, $-CD_2CD_2H$, or - $CD_2CDH_2$; or
an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, a phenyl group, a biphenyl group, or a naphthyl group, each unsubstituted or substituted with at least one of deuterium, a $C_1$-$C_{10}$ alkyl group, a phenyl group, or a combination thereof.

In one or more embodiments, $R_2$ and $R_4$ may be different from each other, and $R_2$ may not be hydrogen.

In one or more embodiments, the organometallic compound may be represented by Formula 11:

Formula 11

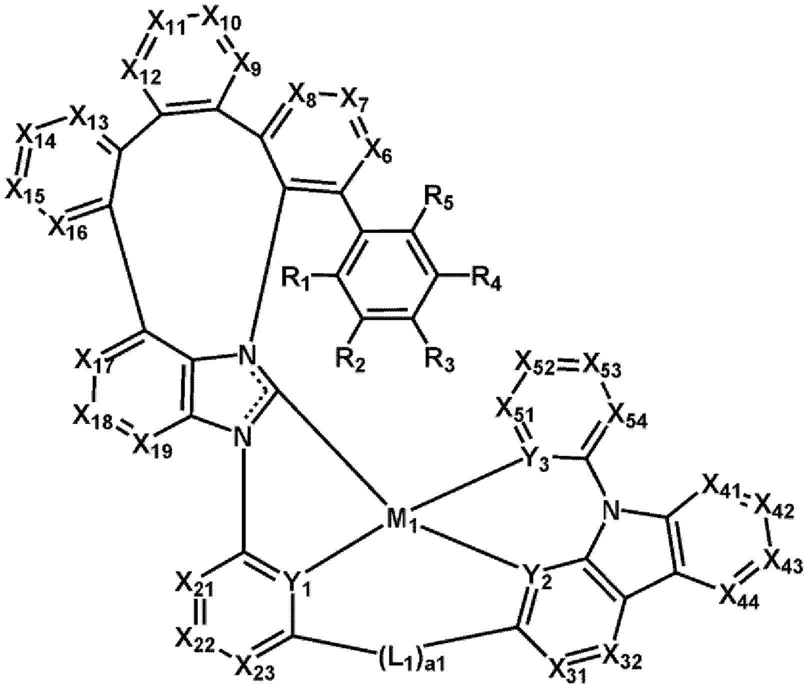

wherein, in Formula 11,

$M_1$, $Y_1$ to $Y_3$, , $X_6$ to $X_{19}$, $L_1$, a1, and $R_1$ to $R_5$ may each be the same as described herein,
$X_{21}$ may be $C(R_{21})$ or N, $X_{22}$ may be $C(R_{22})$ or N, and $X_{23}$ may be $C(R_{23})$ or N,
$X_{31}$ may be $C(R_{31})$ or N, and $X_{32}$ may be $C(R_{32})$ or N,
$X_{41}$ may be $C(R_{41})$ or N, $X_{42}$ may be $C(R_{42})$ or N, $X_{43}$ may be $C(R_{43})$ or N, and $X_{44}$ may be $C(R_{44})$ or N,
$X_{51}$ may be $C(R_{51})$ or N, $X_{52}$ may be $C(R_{52})$ or N, $X_{53}$ may be $C(R_{53})$ or N, and $X_{54}$ may be $C(R_{54})$ or N,
$R_{21}$ to $R_{23}$ may each be the same as described in connection with $R_{20}$,
$R_{31}$ and $R_{32}$ may each be the same as described in connection with $R_{30}$,
$R_{41}$ to $R_{44}$ may each be the same as described in connection with $R_{40}$, and
$R_{51}$ to $R_{54}$ may each be the same as described in connection with $R_{50}$.

In Formula 11, $R_4$ may be a $C_1$-$C_{60}$ alkyl group substituted with deuterium.

In one or more embodiments, $R_1$ to $R_3$ and $R_5$ may each independently be hydrogen or deuterium.

In one or more embodiments, $R_{53}$ may be a substituted or unsubstituted branched $C_3$-$C_{20}$ alkyl group (e.g. sec-alkyl group, tert-alkyl group and the like).

In one or more embodiments, the organometallic compound may be represented by Formula 11A:

Formula 11A

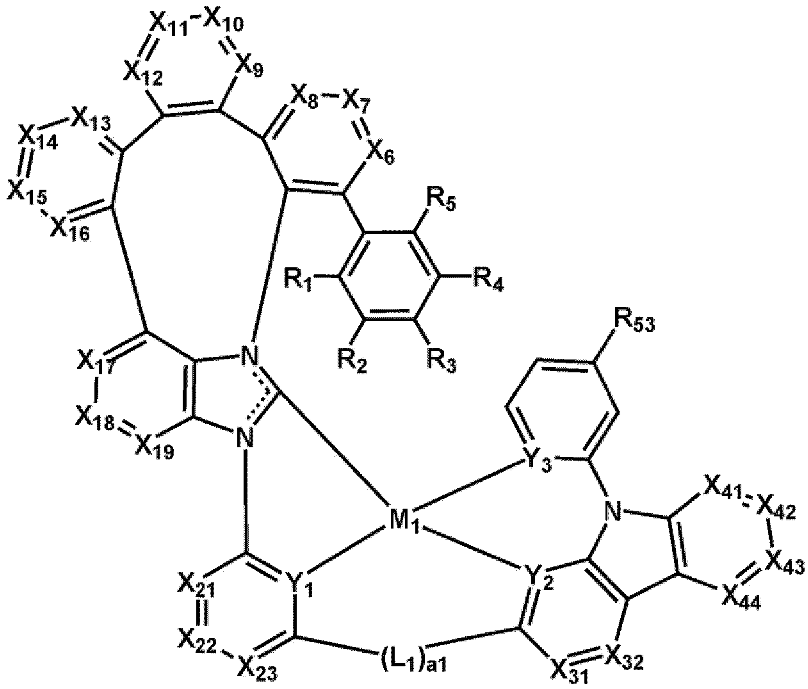

wherein, in Formula 11A,

$M_1$, $X_6$ to $X_{19}$, $L_1$, a1, $R_1$ to $R_3$ and $R_5$ may each be the same as described herein,
$R_4$ may be a $C_1$-$C_{60}$ alkyl group substituted with deuterium,
$R_9$ to $R_{12}$ and $R_{53}$ may each independently be hydrogen, deuterium, -F, -Cl, -Br, -I, -$SF_5$, a cyano group, or a substituted or unsubstituted $C_1$-$C_{60}$ alkyl group,
$X_{21}$ may be $C(R_{21})$ or N, $X_{22}$ may be $C(R_{22})$ or N, and $X_{23}$ may be $C(R_{23})$ or N,
$X_{31}$ may be $C(R_{31})$ or N, and $X_{32}$ may be $C(R_{32})$ or N,
$X_{41}$ may be $C(R_{41})$ or N, $X_{42}$ may be $C(R_{42})$ or N, $X_{43}$ may be $C(R_{43})$ or N, and $X_{44}$ may be $C(R_{44})$ or N,
$R_{21}$ to $R_{23}$ may each be the same as described in connection with $R_{20}$,
$R_{31}$ and $R_{32}$ may each be the same as described in connection with $R_{30}$,
$R_{41}$ to $R_{44}$ may each be the same as described in connection with $R_{40}$.

In one or more embodiments, the organometallic compound may be represented by Formula 21:

Formula 21

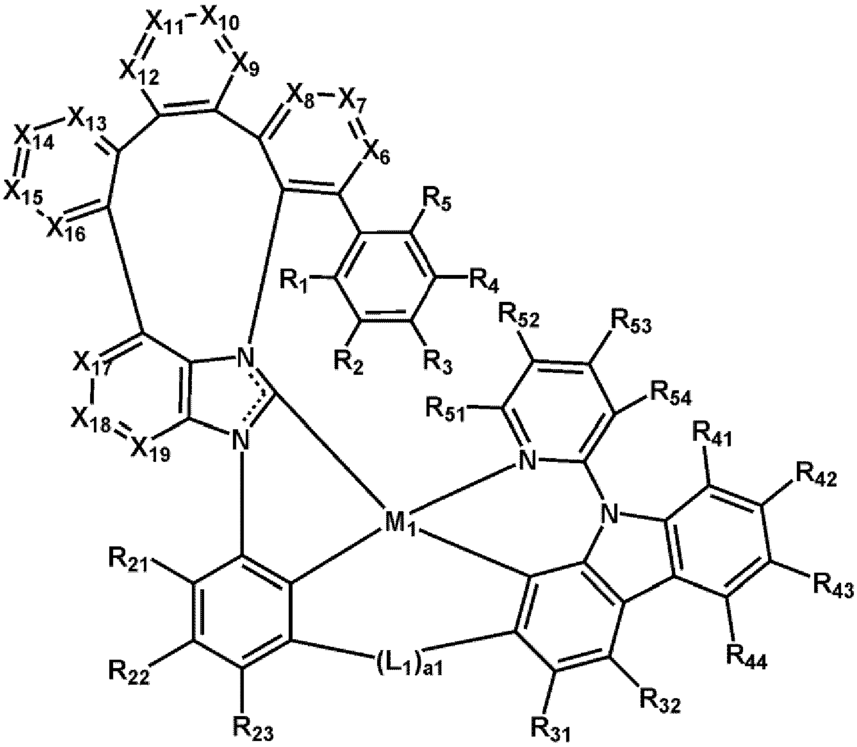

wherein, in Formula 21,

$M_1$, $X_6$ to $X_{19}$, $L_1$, a1, and $R_1$ to $R_5$ may each be the same as described herein,
$R_{21}$ to $R_{23}$ may each be the same as described in connection with $R_{20}$,
$R_{31}$ and $R_{32}$ may each be the same as described in connection with $R_{30}$,
$R_{41}$ to $R_{44}$ may each be the same as described in connection with $R_{40}$, and
$R_{51}$ to $R_{54}$ may each be the same as described in connection with $R_{50}$.

In one or more embodiments, the organometallic compound may be at least one of Compounds 1 to 473, but embodiments are not limited thereto:

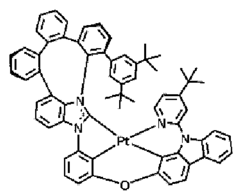
1

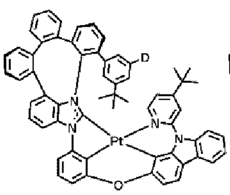
2

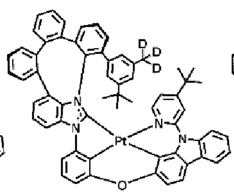
3

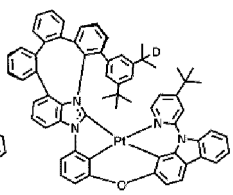
4

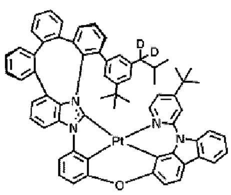
5

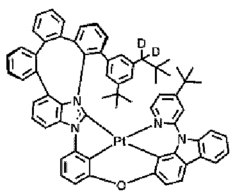
6

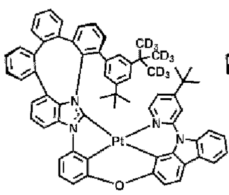
7

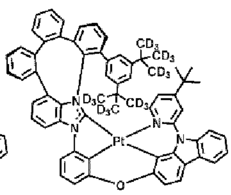
8

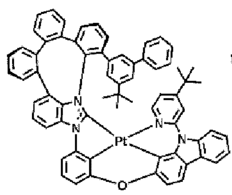
9

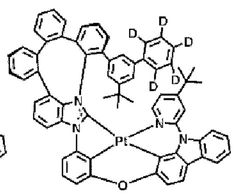
10

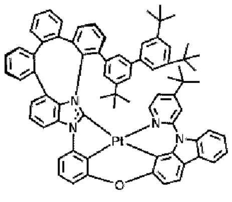
11

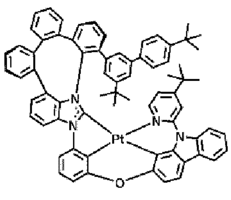
12

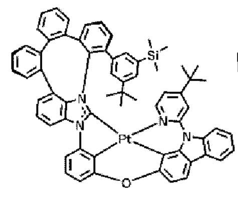
13

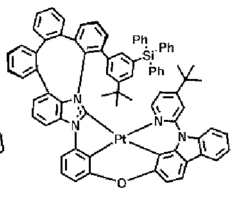
14

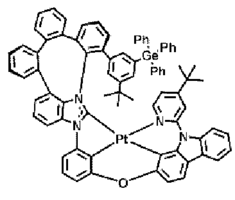
15

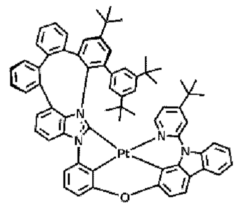
16

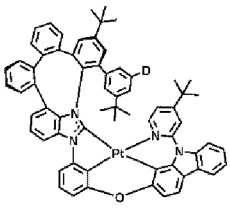
17

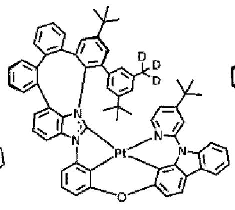
18

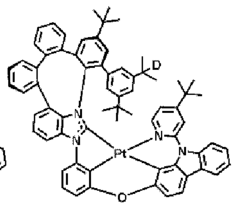
19

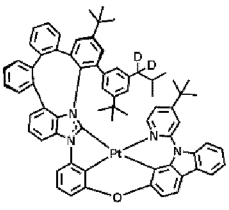
20

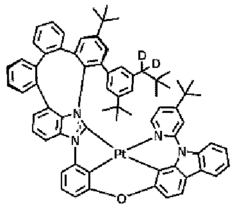
21

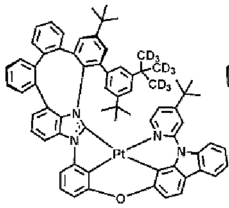
22

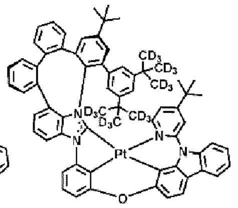
23

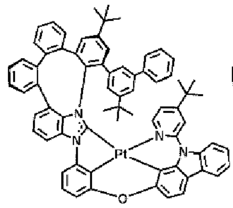
24

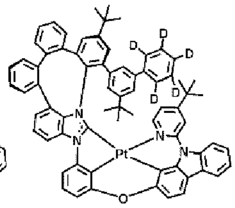
25

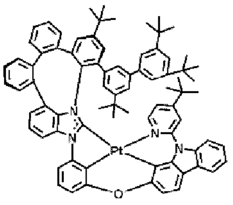
26

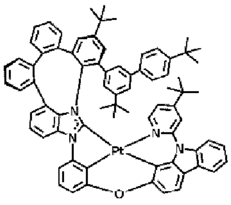
27

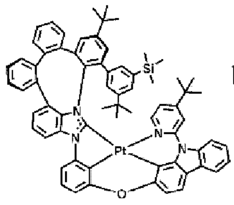
28

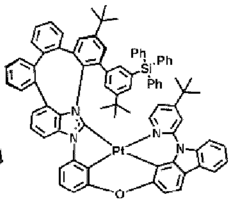
29

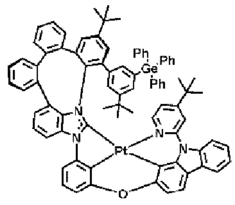
30

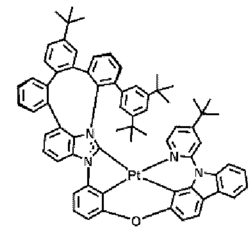
31

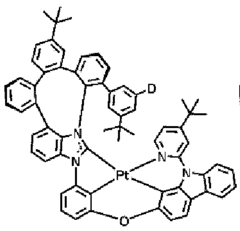
32

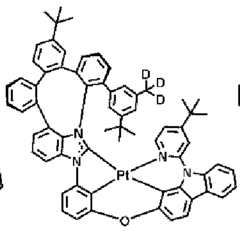
33

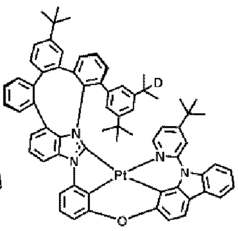
34

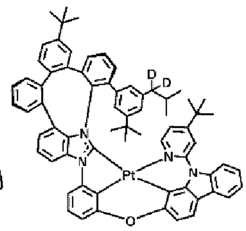
35

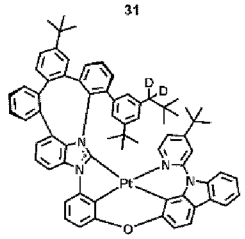
36

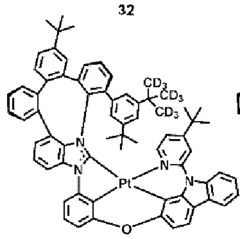
37

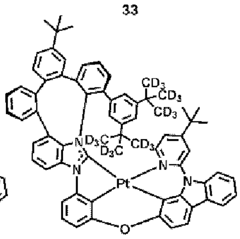
38

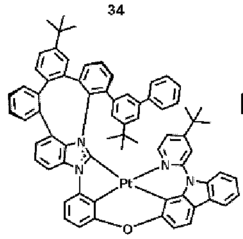
39

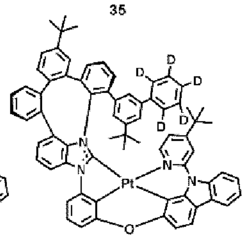
40

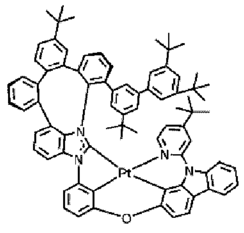
41
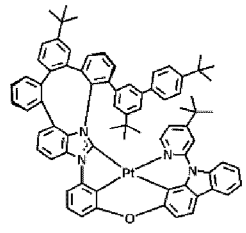
42
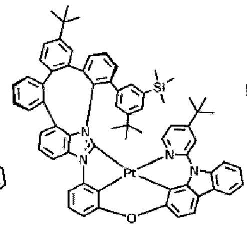
43
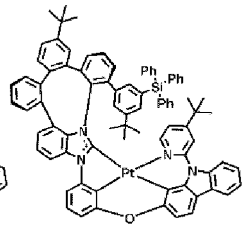
44
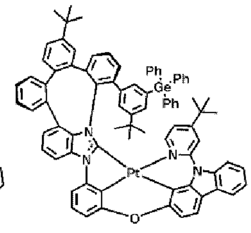
45

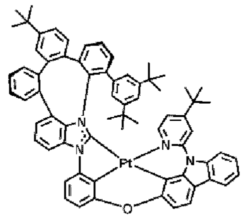
46
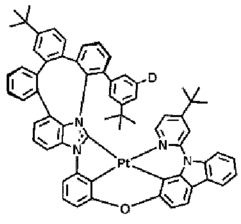
47
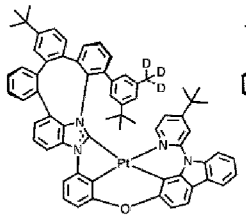
48
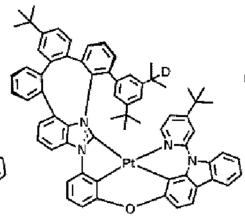
49
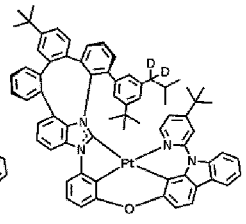
50

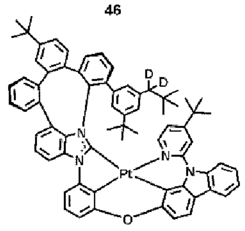
51
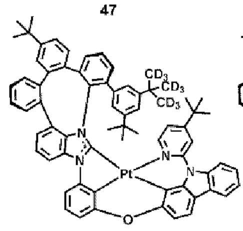
52
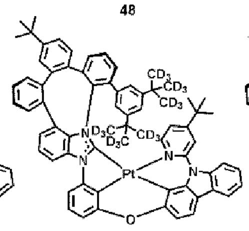
53
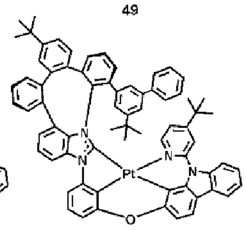
54
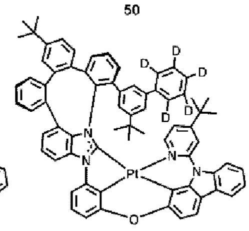
55

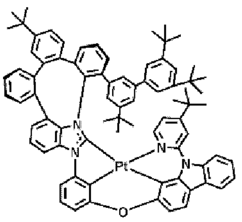
56
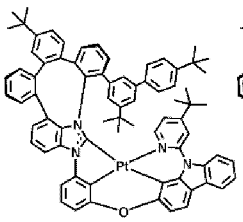
57
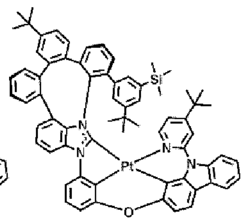
58
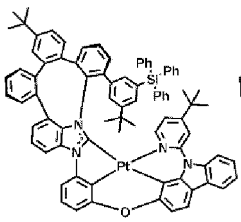
59
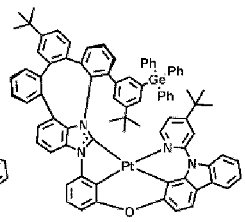
60

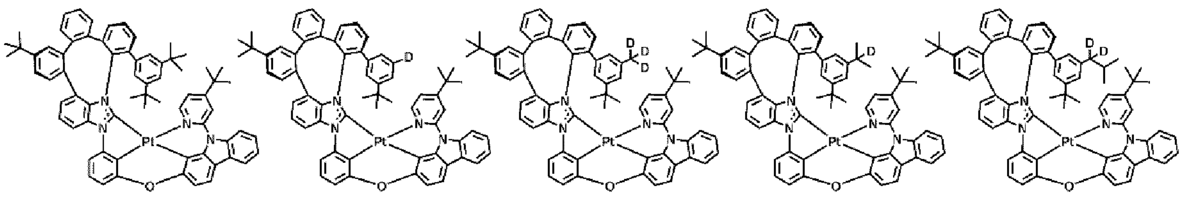
61 62 63 64 65

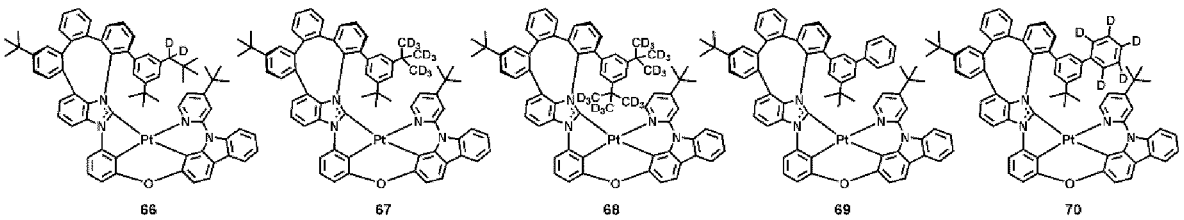
66 67 68 69 70

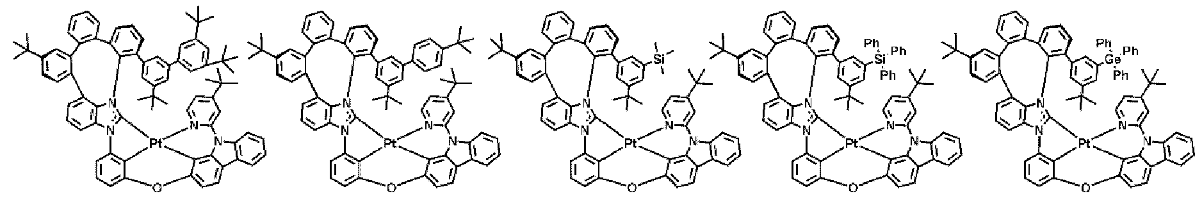

71 72 73 74 75

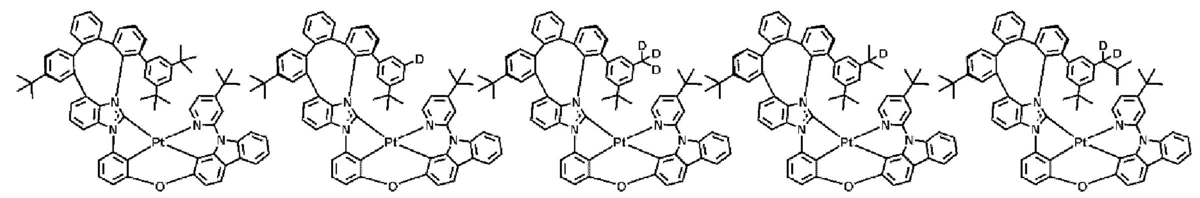

76 77 78 79 80

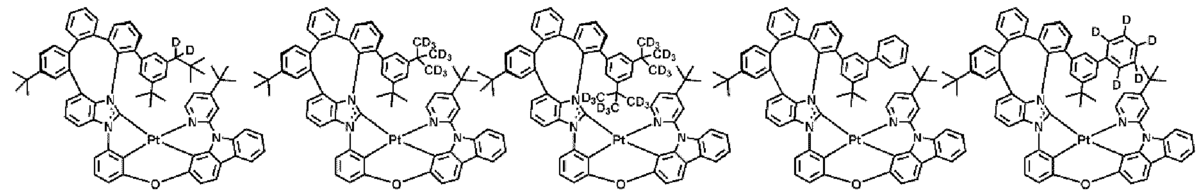

81 82 83 84 85

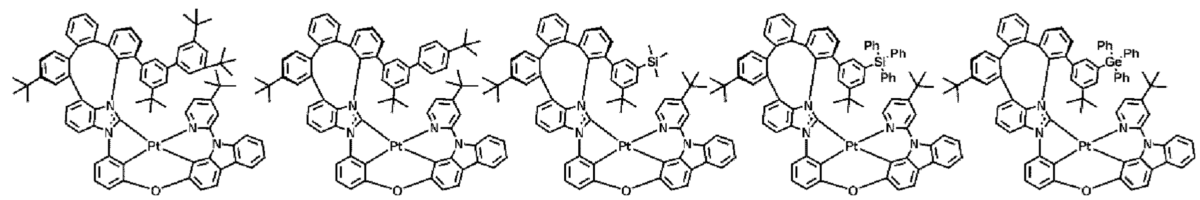

86 87 88 89 90

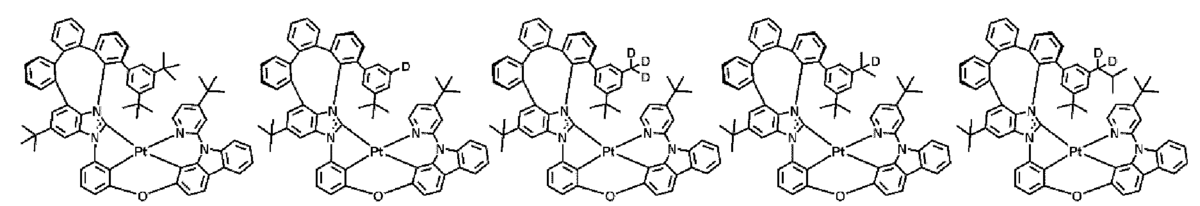

91 92 93 94 95

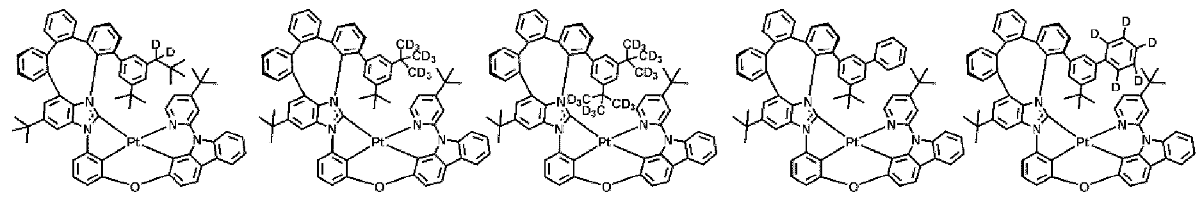

96 97 98 99 100

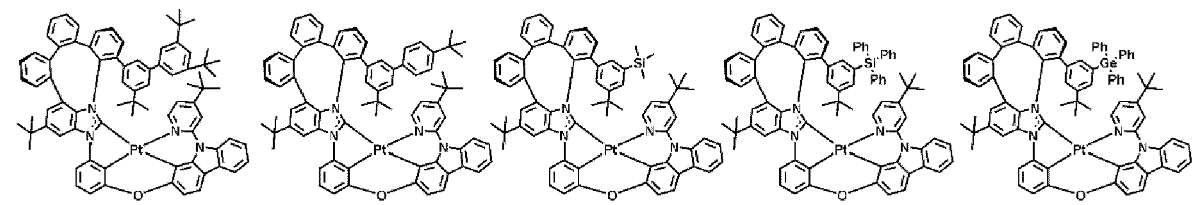

101 102 103 104 105

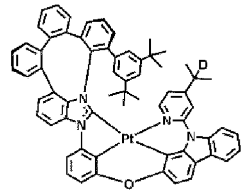
106
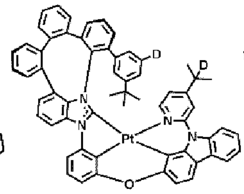
107
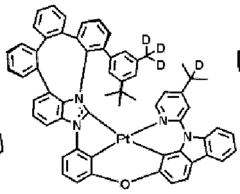
108
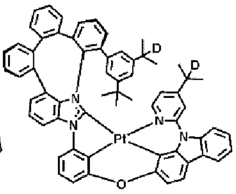
109
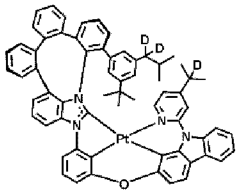
110

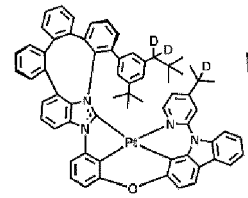
111
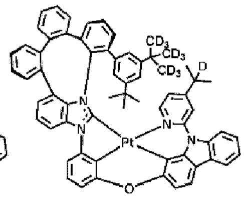
112
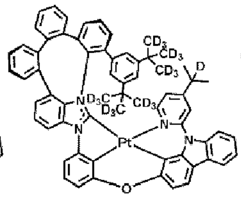
113
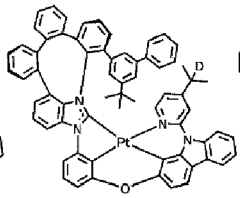
114
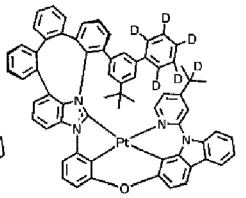
115

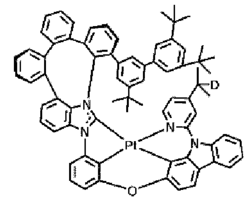
116
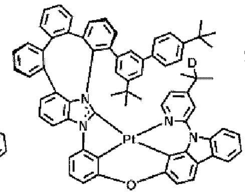
117
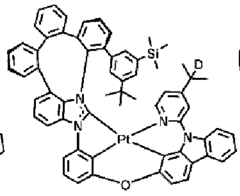
118
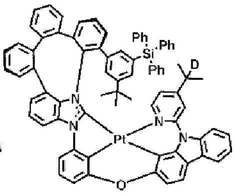
119
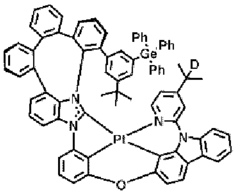
120

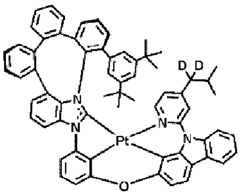
121
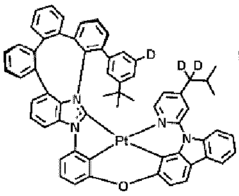
122
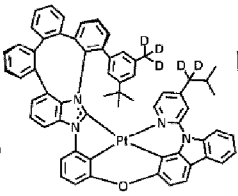
123
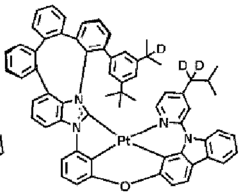
124
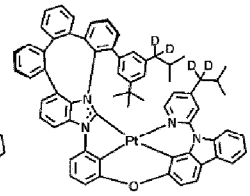
125

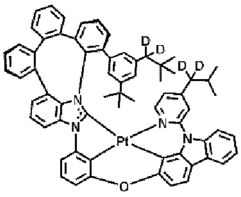
126
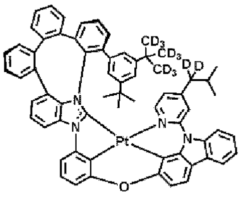
127
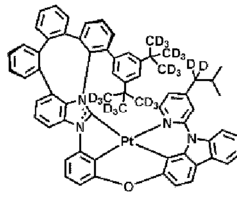
128
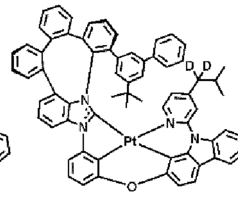
129
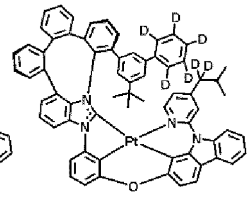
130

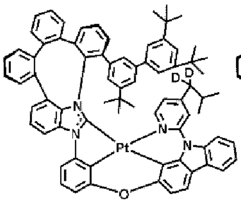
131
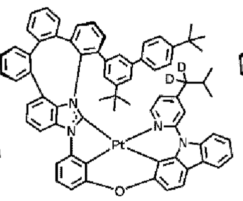
132
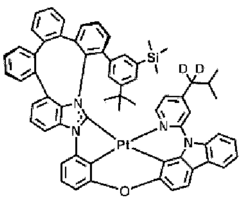
133
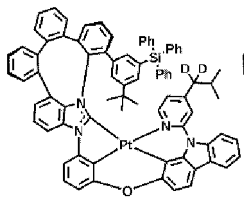
134
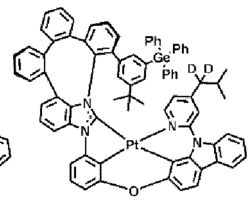
135

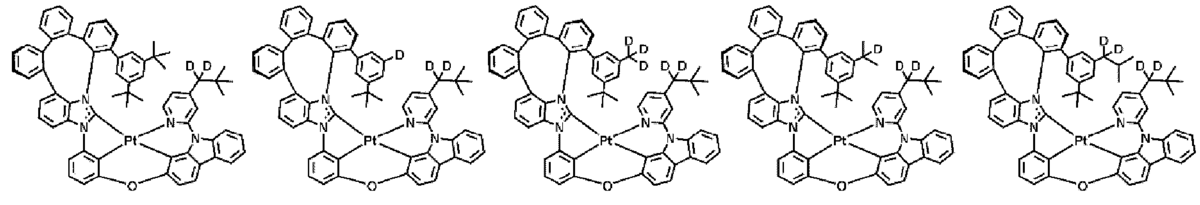

136 137 138 139 140

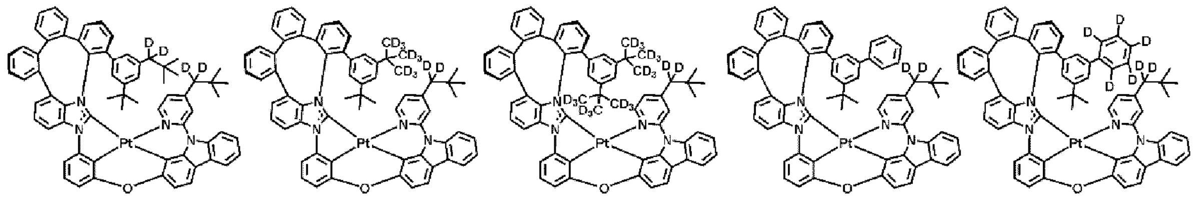

141 142 143 144 145

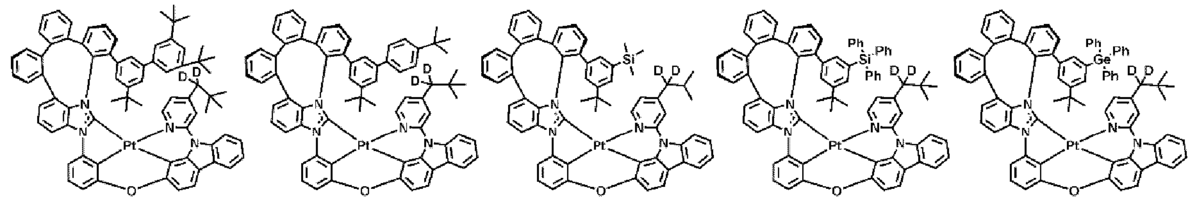

146 147 148 149 150

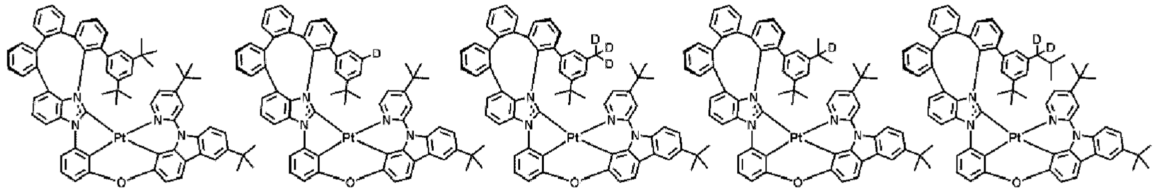

151 152 153 154 155

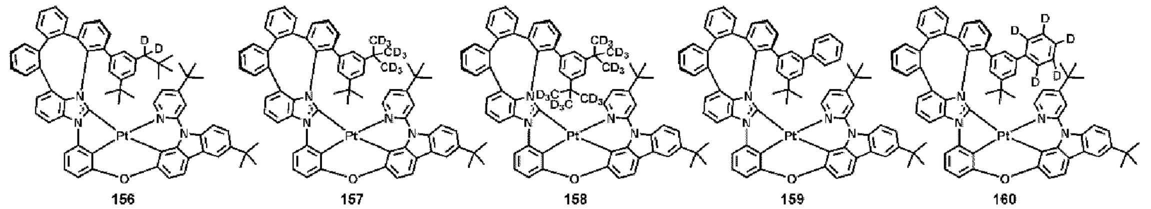

156 157 158 159 160

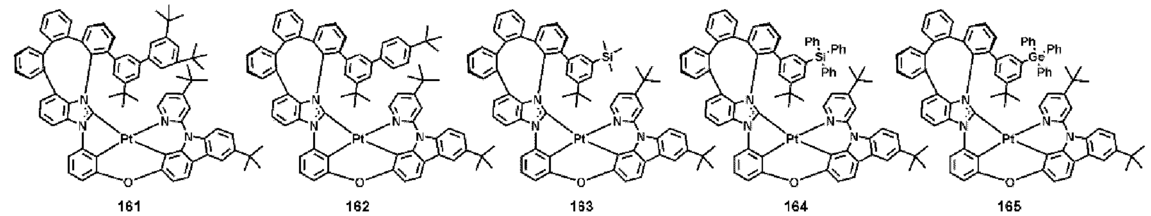

161 162 163 164 165

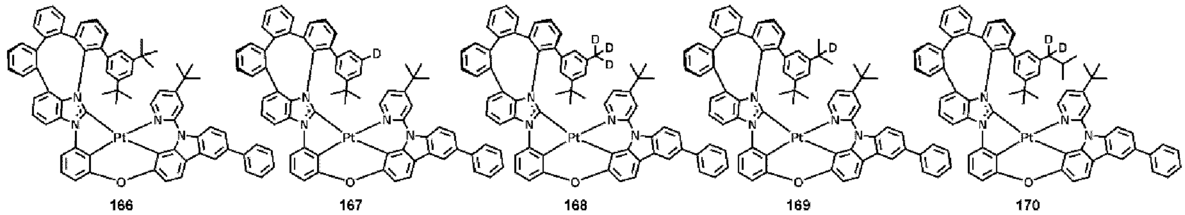

166 167 168 169 170

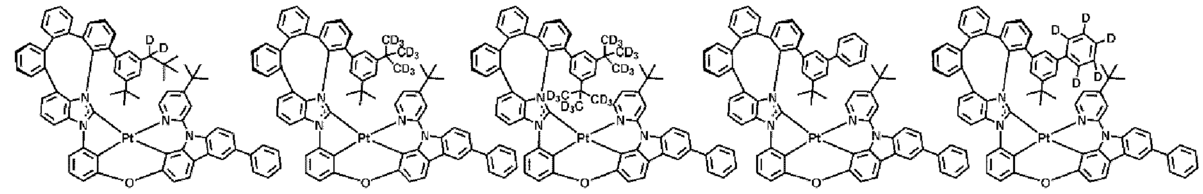

171 172 173 174 175

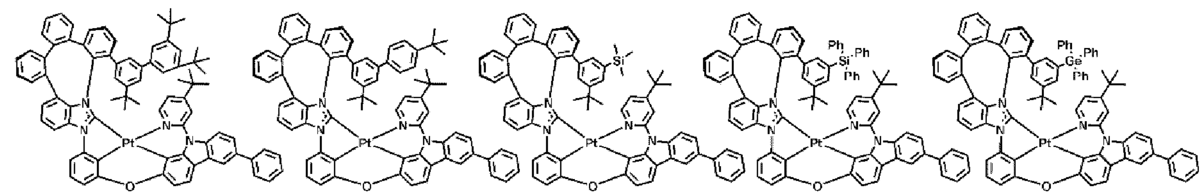

176 177 178 179 180

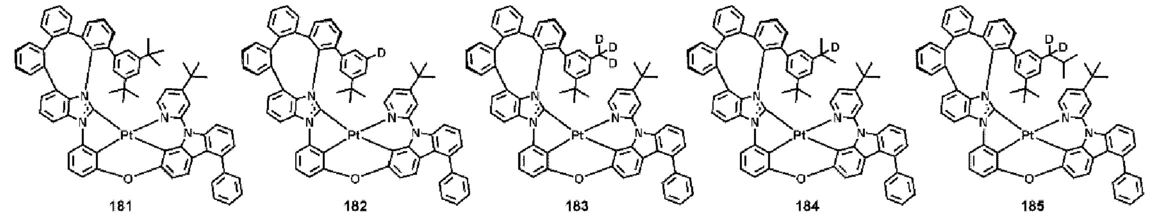

181 182 183 184 185

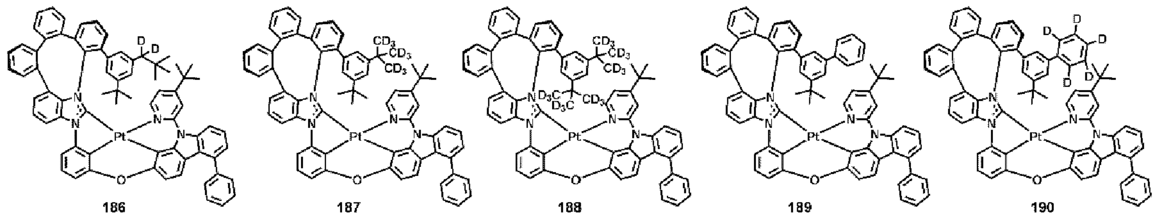

186 187 188 189 190

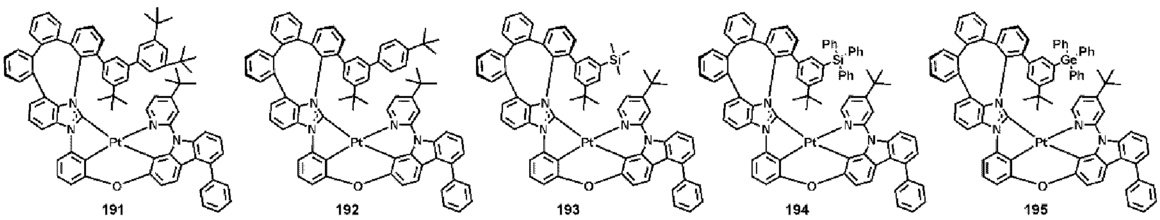

191 192 193 194 195

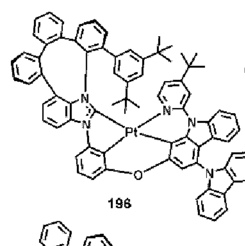
196
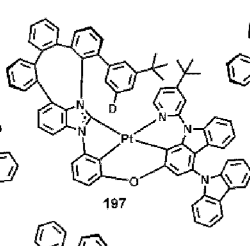
197
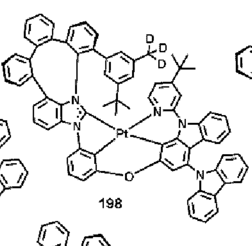
198
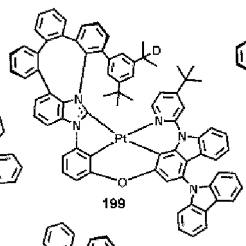
199
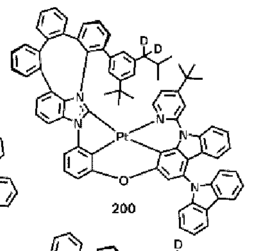
200

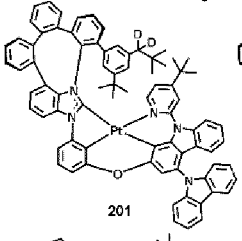
201
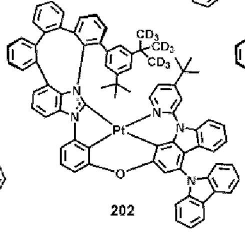
202
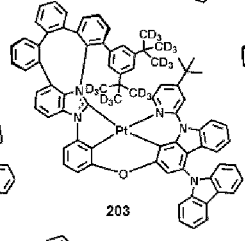
203
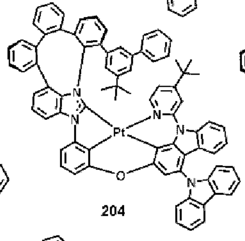
204
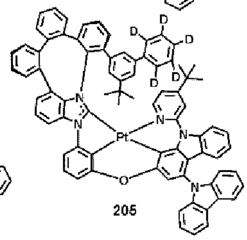
205

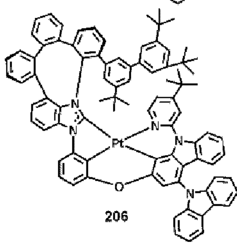
206
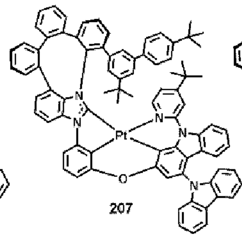
207
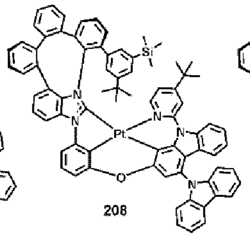
208
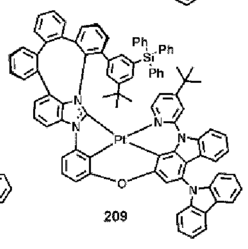
209
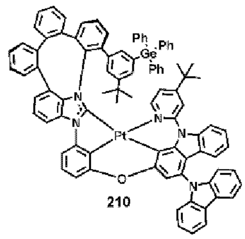
210

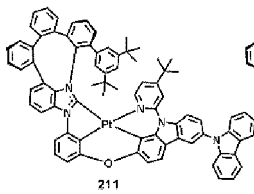
211
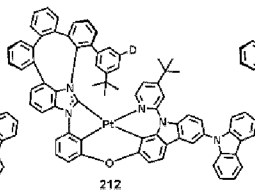
212
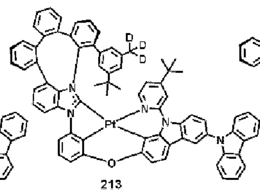
213
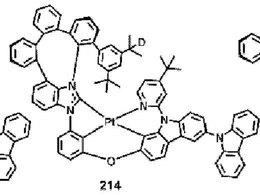
214
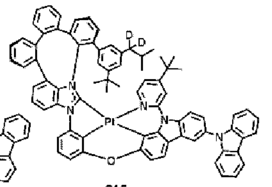
215

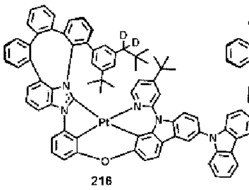
216
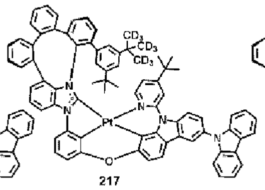
217
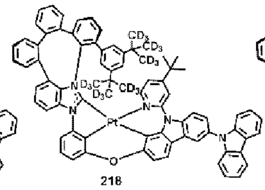
218
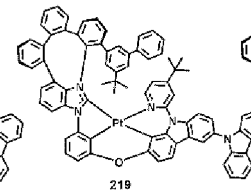
219
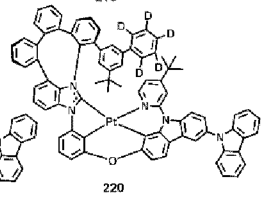
220

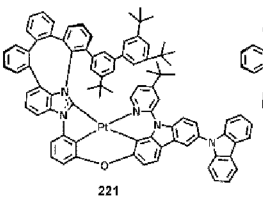
221
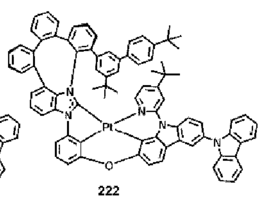
222
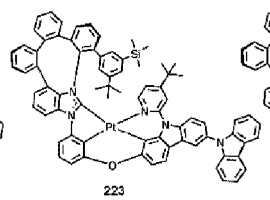
223
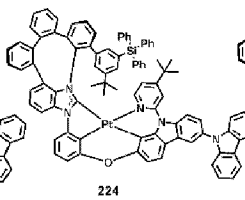
224
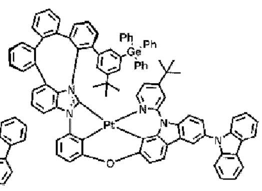
225

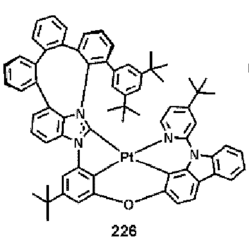
226
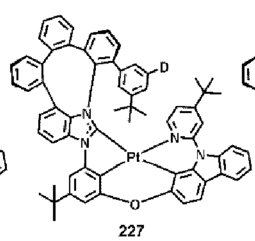
227
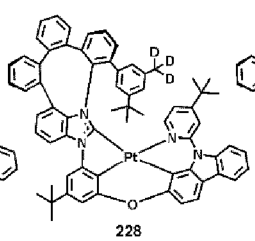
228
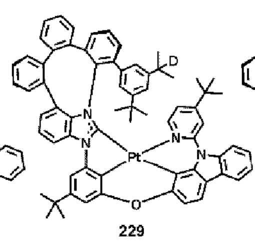
229
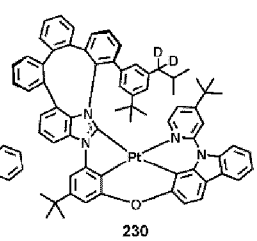
230

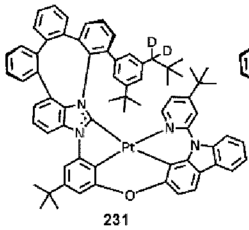
231
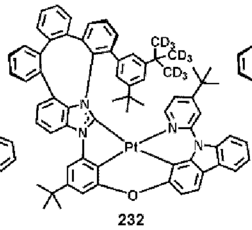
232
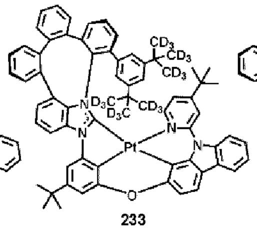
233
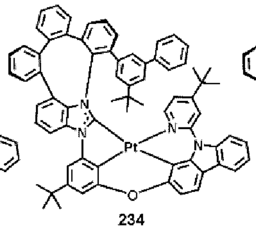
234
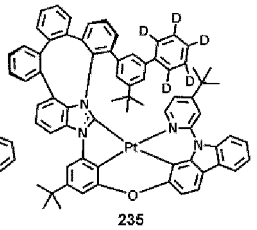
235
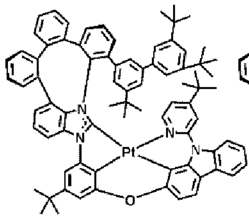
236
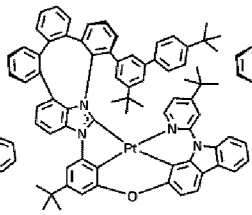
237
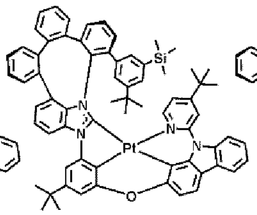
238
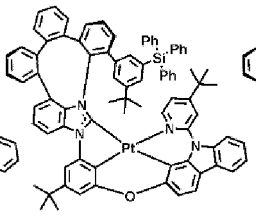
239
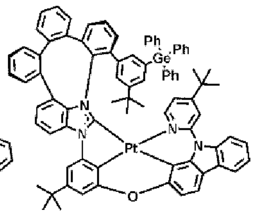
240
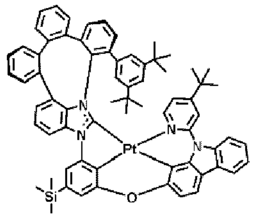
241
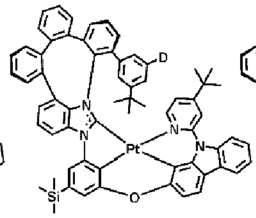
242
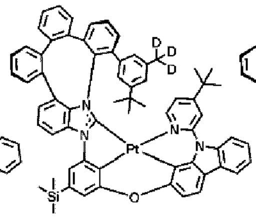
243
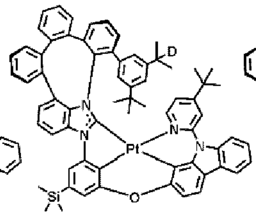
244
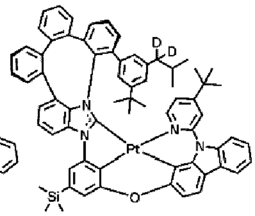
245
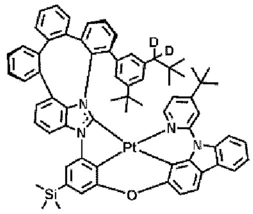
246
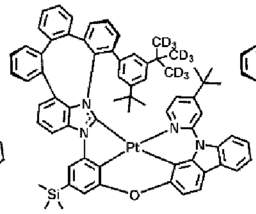
247
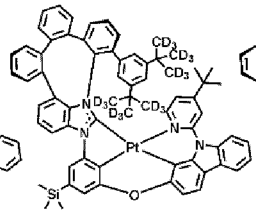
248
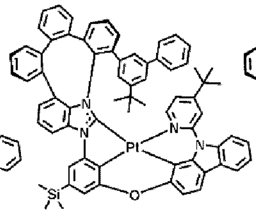
249
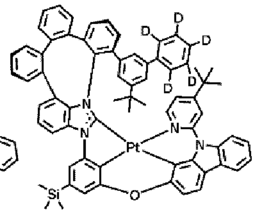
250
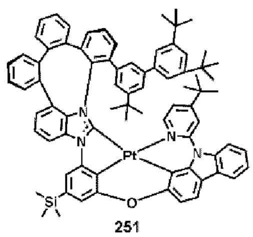
251
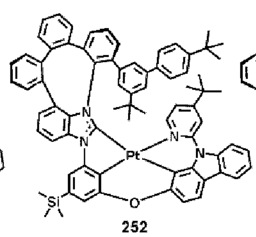
252
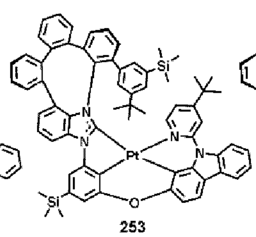
253
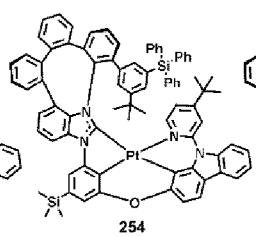
254
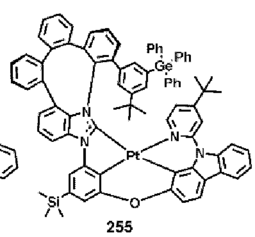
255
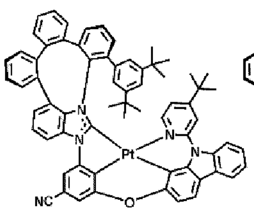
256
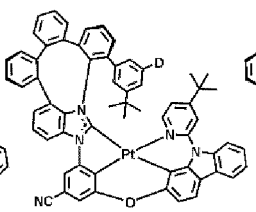
257
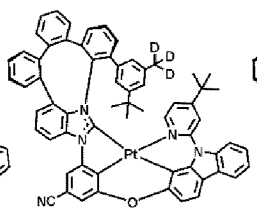
258
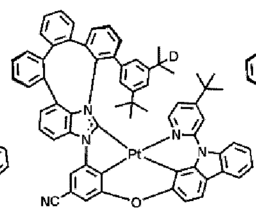
259
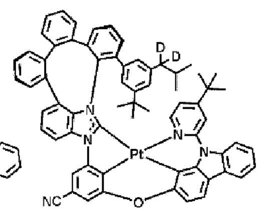
260

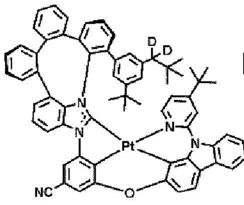
261
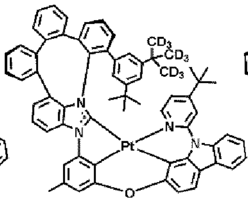
262
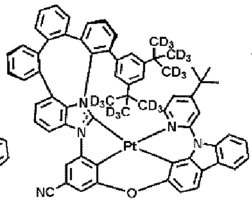
263
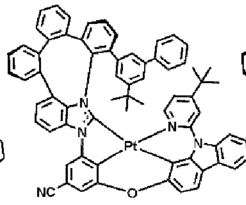
264
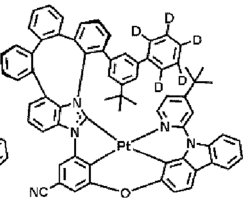
265

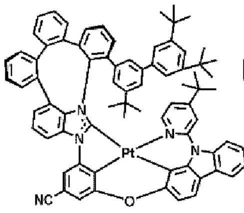
266
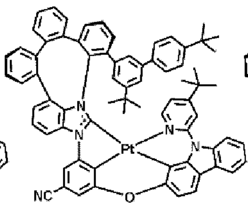
267
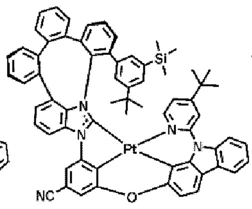
268
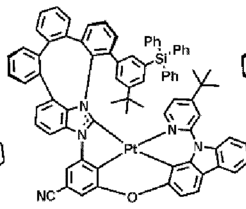
269
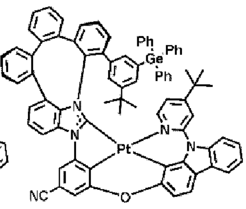
270

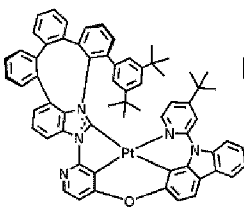
271
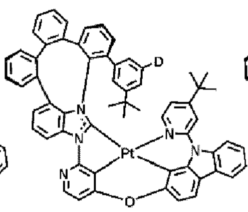
272
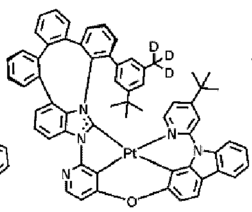
273
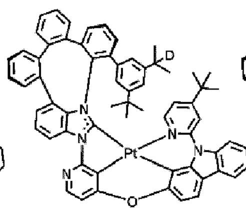
274
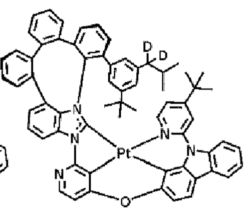
275

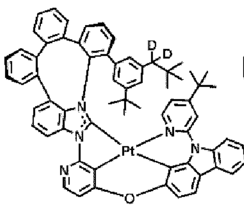
276
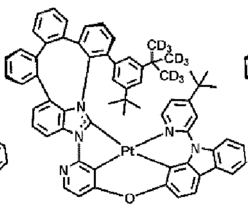
277
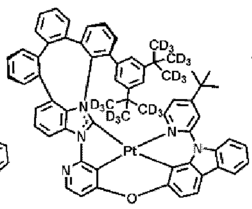
278
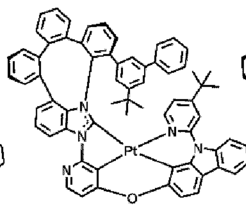
279
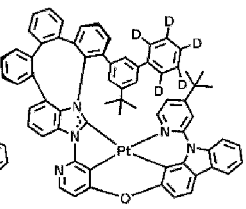
280

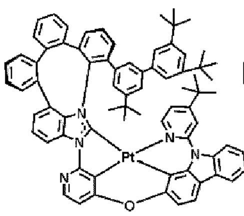
281
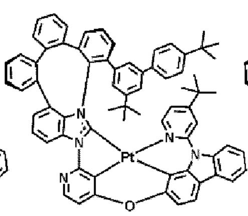
282
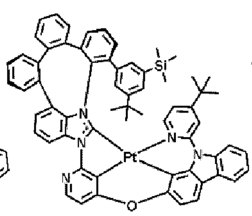
283
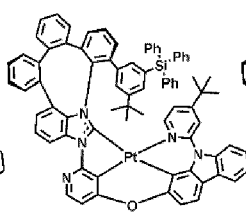
284
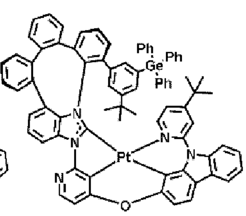
285

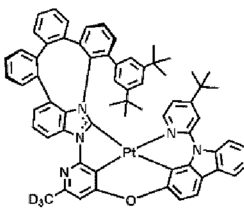
286
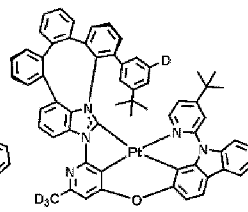
287
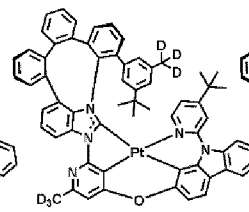
288
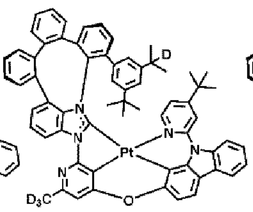
289
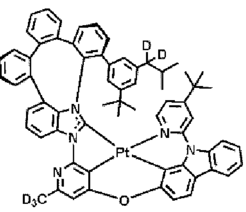
290

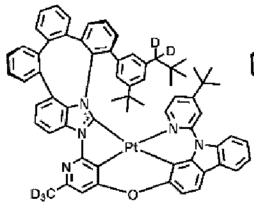
291
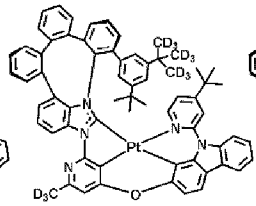
292
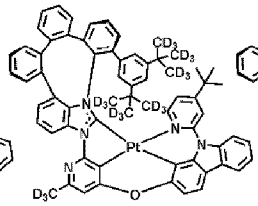
293
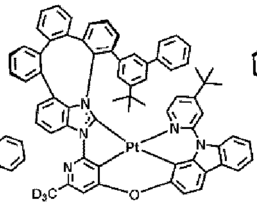
294
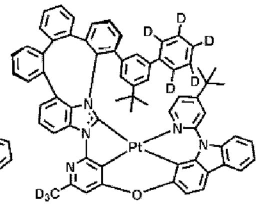
295

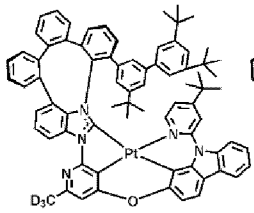
296
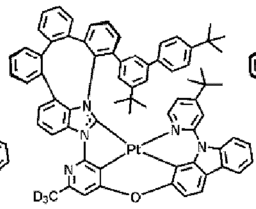
297
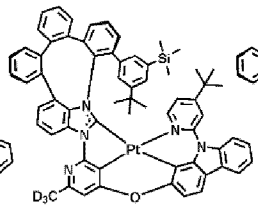
298
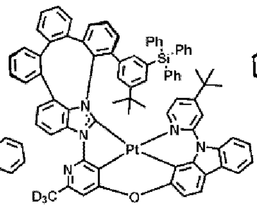
299
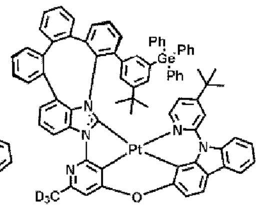
300

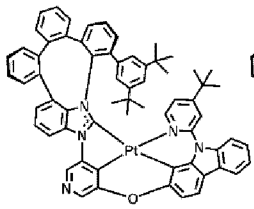
301
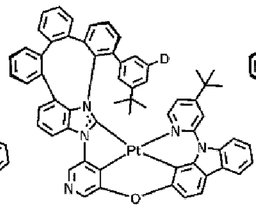
302
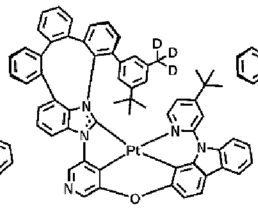
303
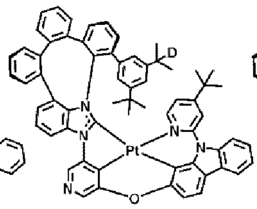
304
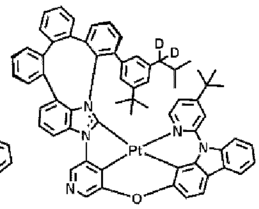
305

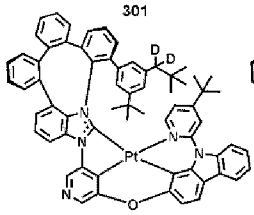
306
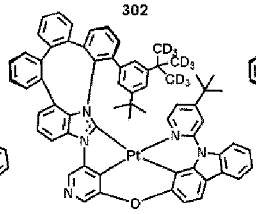
307
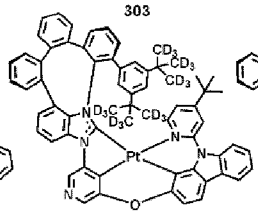
308
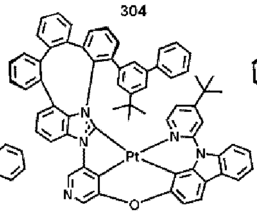
309
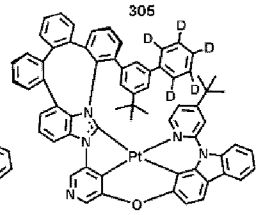
310

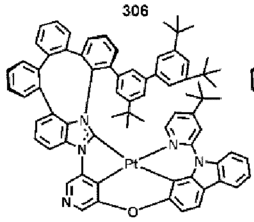
311
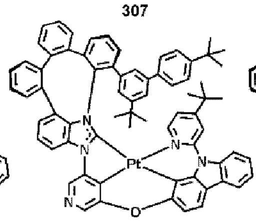
312
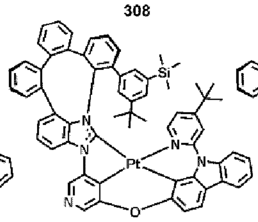
313
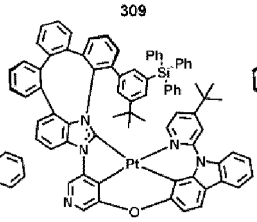
314
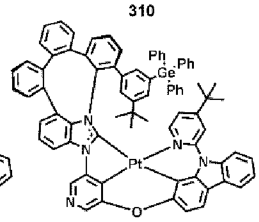
315

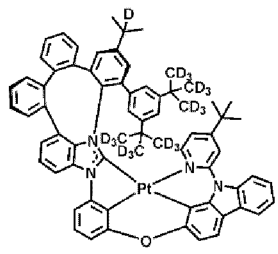
316
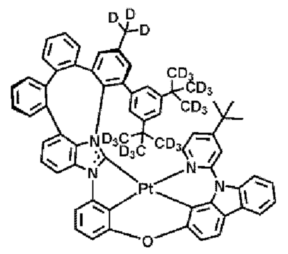
317
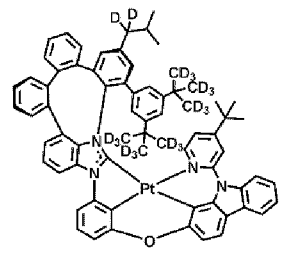
318
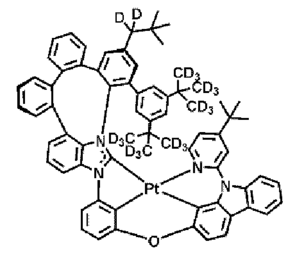
319

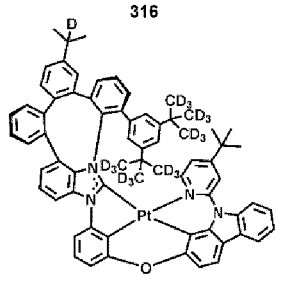
320
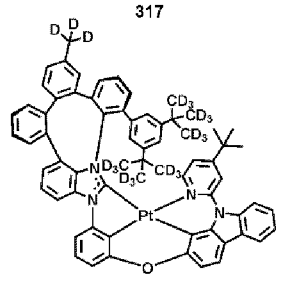
321
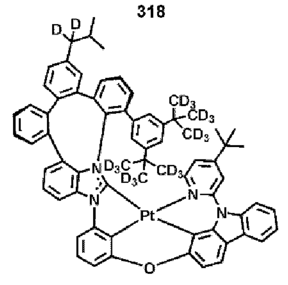
322
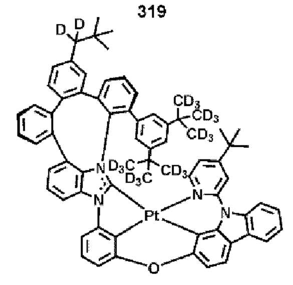
323

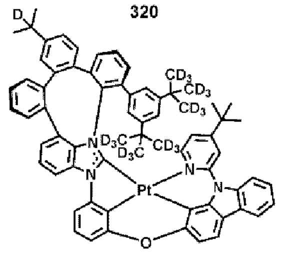
324
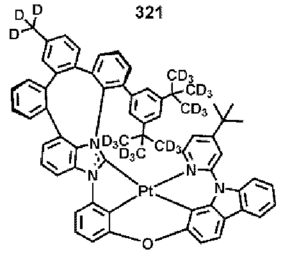
325
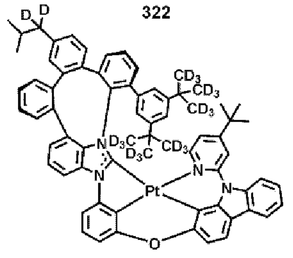
326
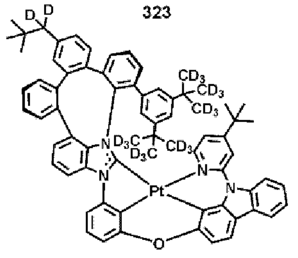
327

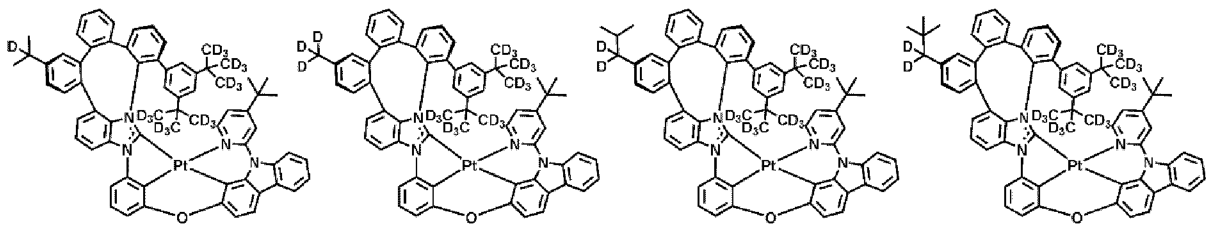
328
329
330
331

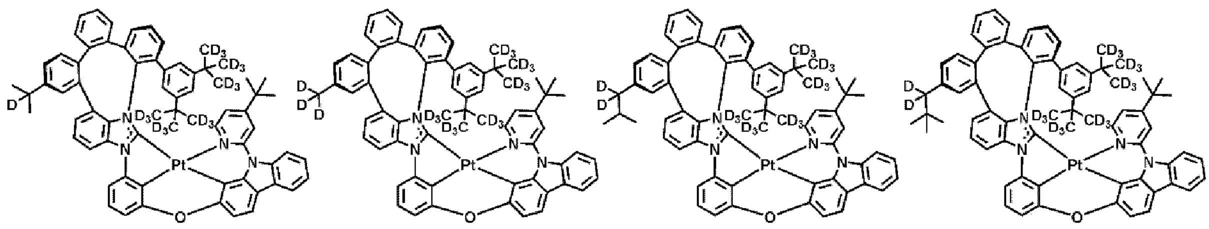
332
333
334
335

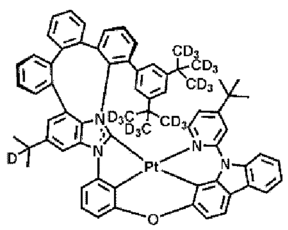
336
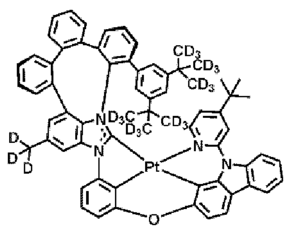
337
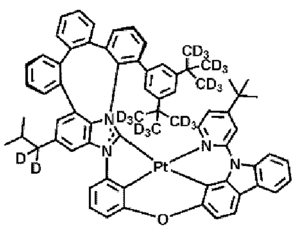
338
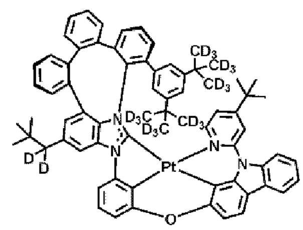
339

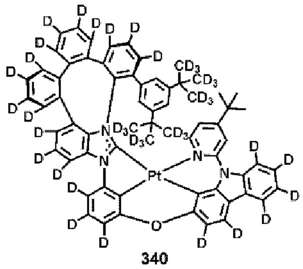
340

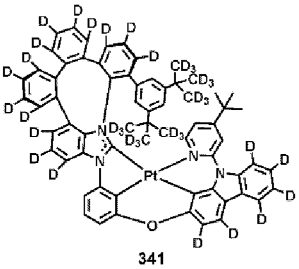
341

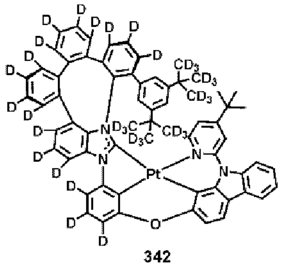
342

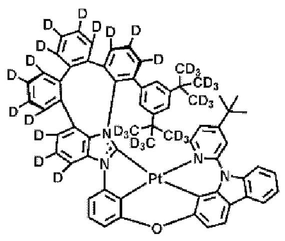
343

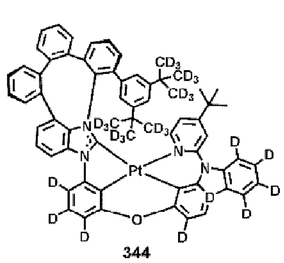
344

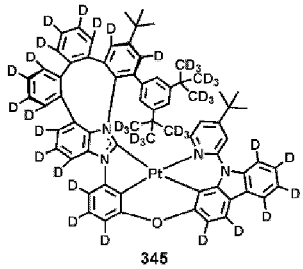
345

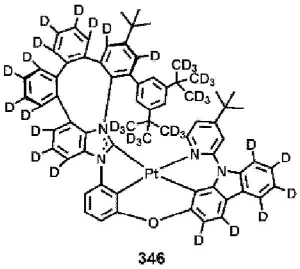
346

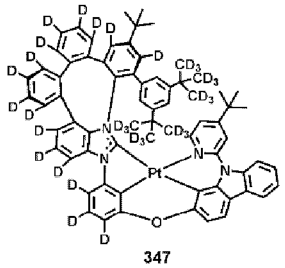
347

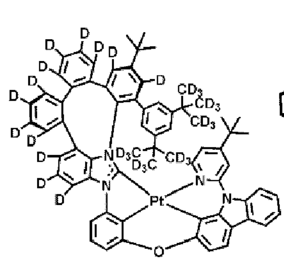
348

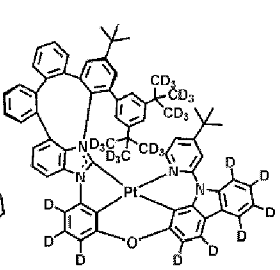
349

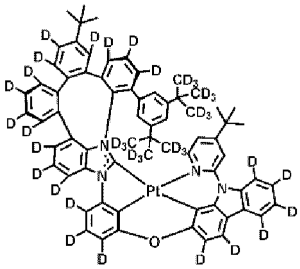
350

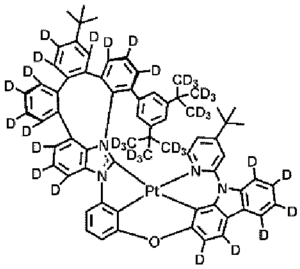
351

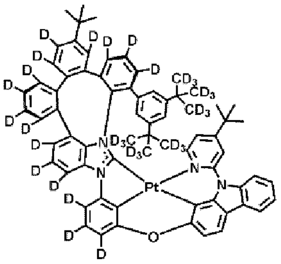
352

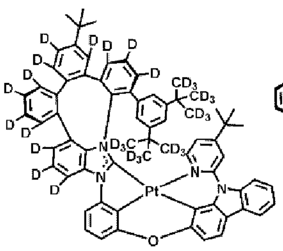
353

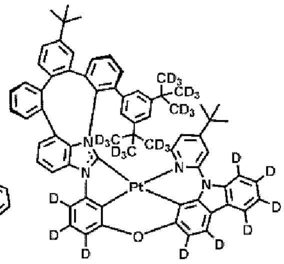
354

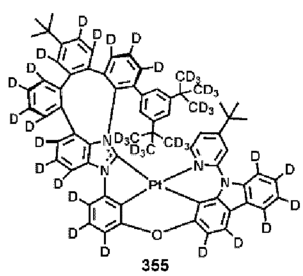
355

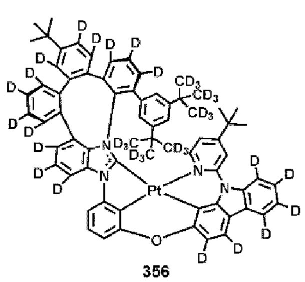
356

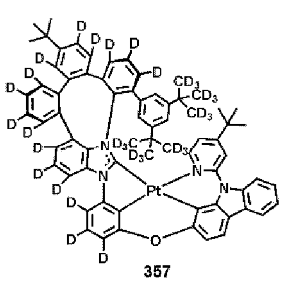
357

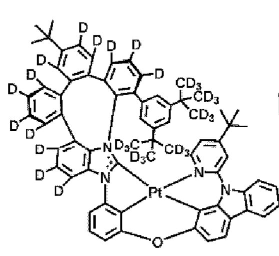
358

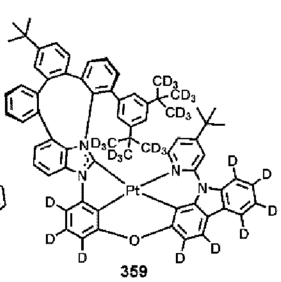
359

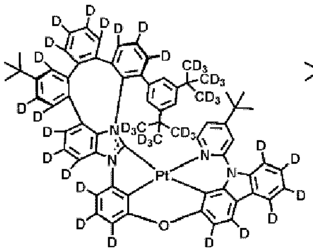

360

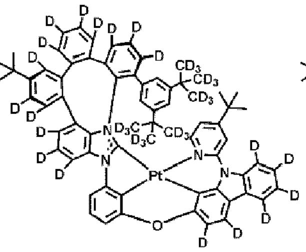

361

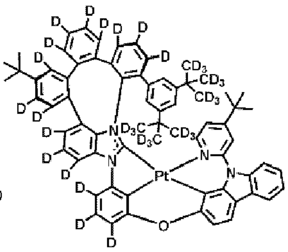

362

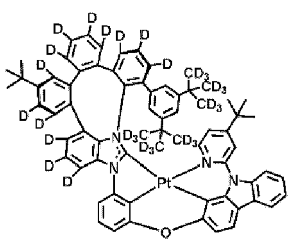

363

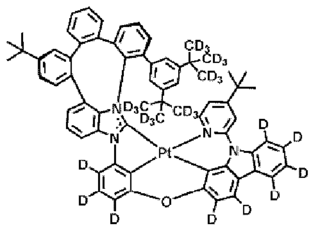

364

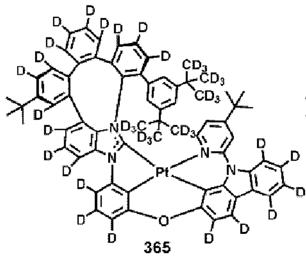

365

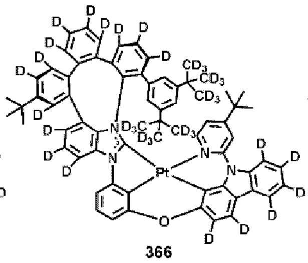

366

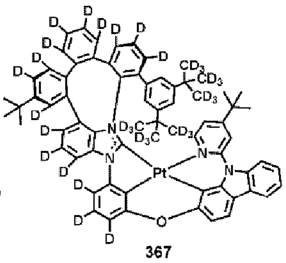

367

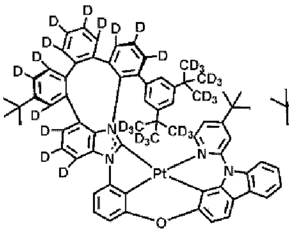

368

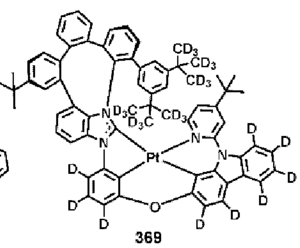

369

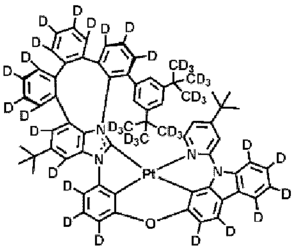

370

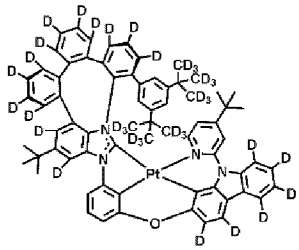

371

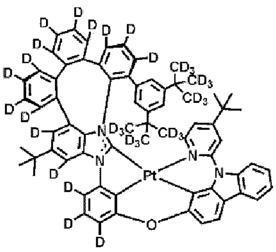

372

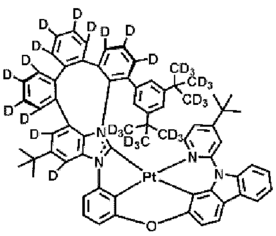

373

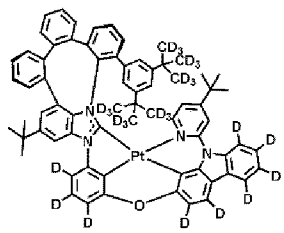

374

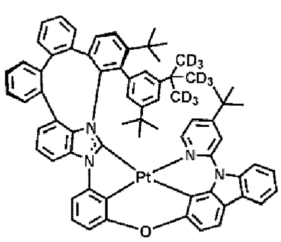

375

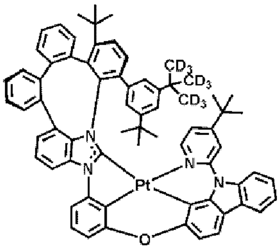

376

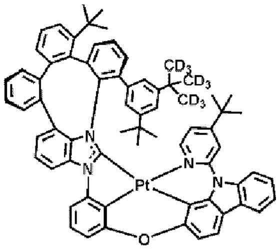

377

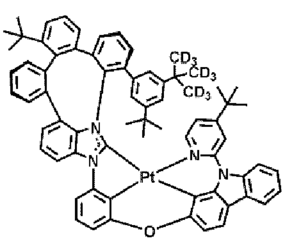

378

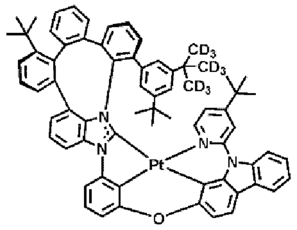
379

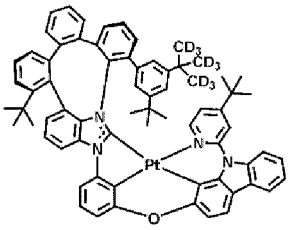
380

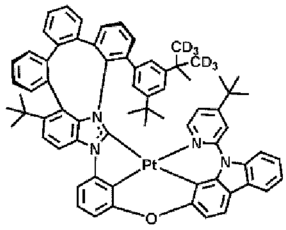
381

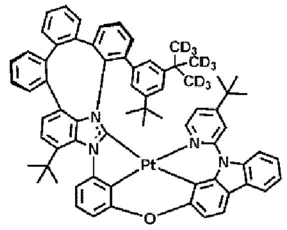
382

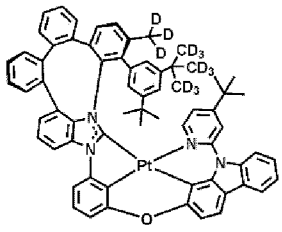
383

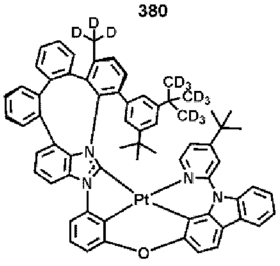
384

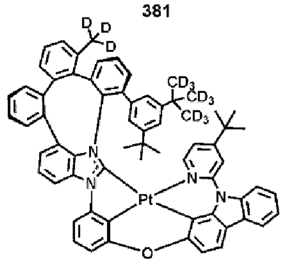
385

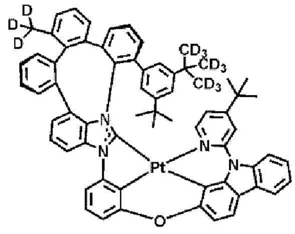
386

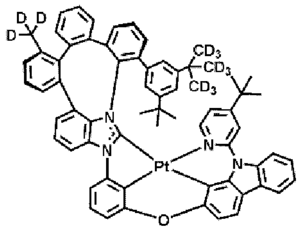
387

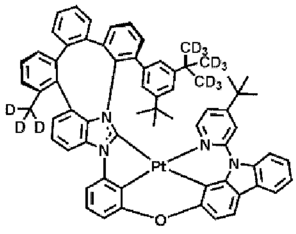
388

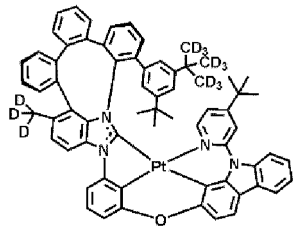
389

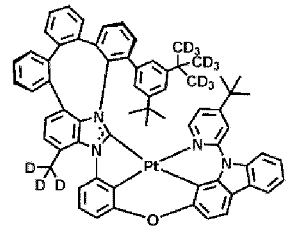
390

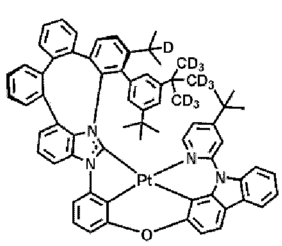
391

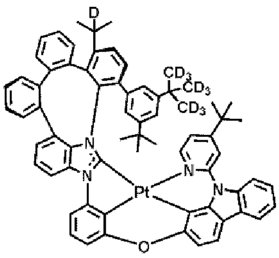
392

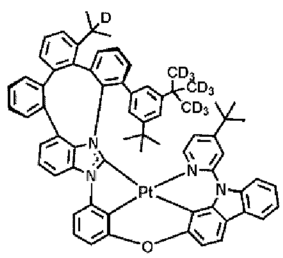
393

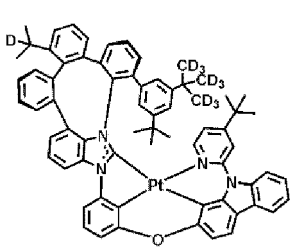
394

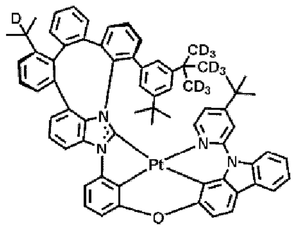
395

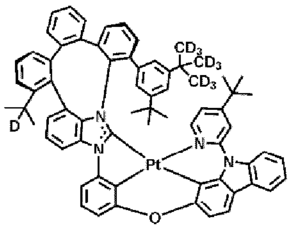
396

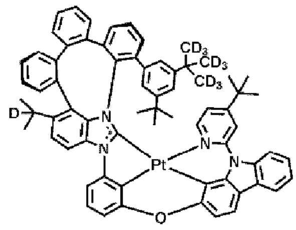
397

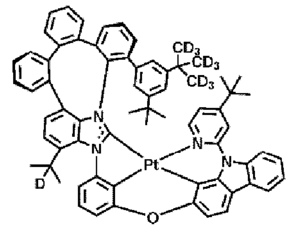
398

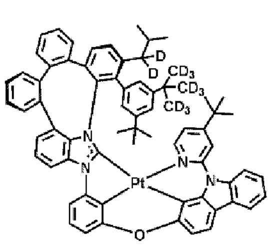
399

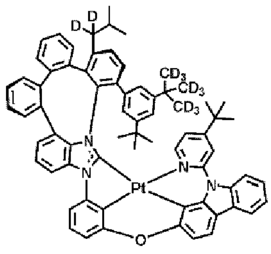
400

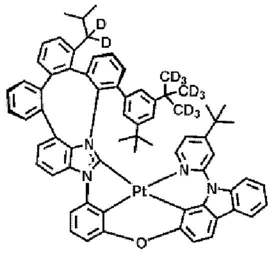
401

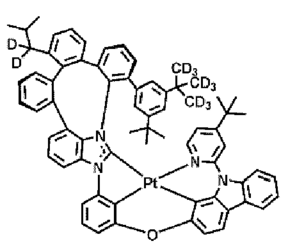
402

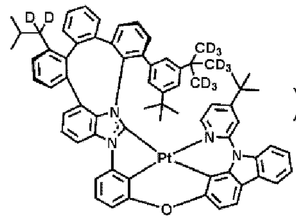

403

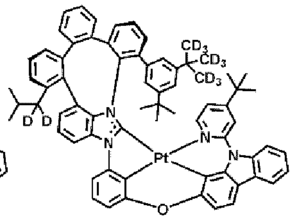

404

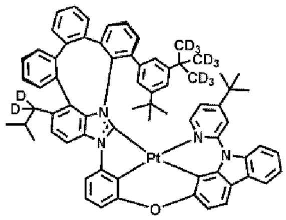

405

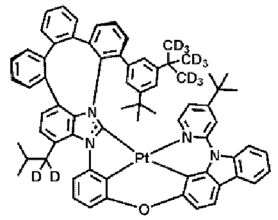

406

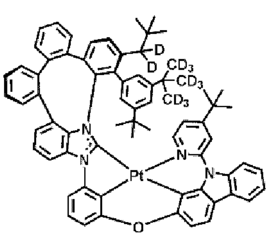

407

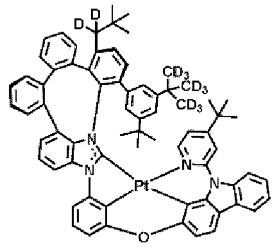

408

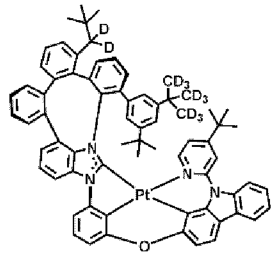

409

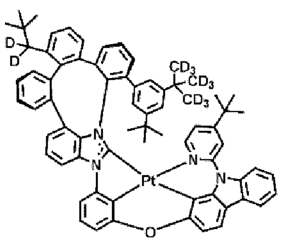

410

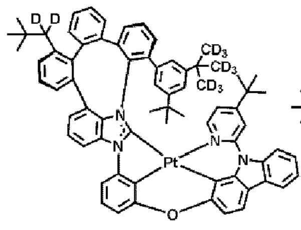

411

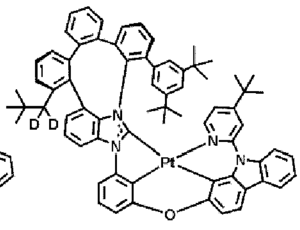

412

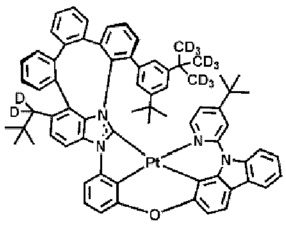

413

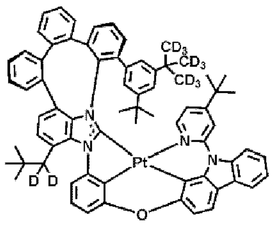

414

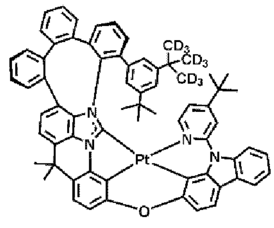

415

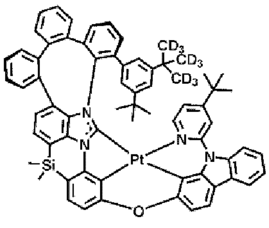

416

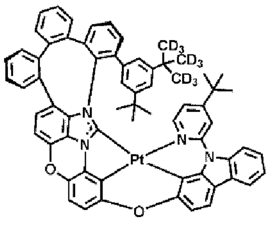

417

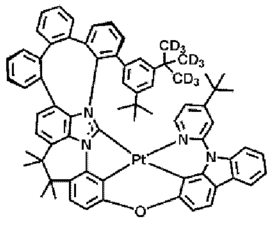

418

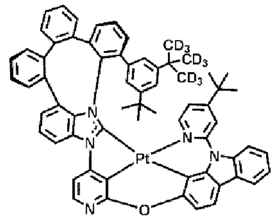

419

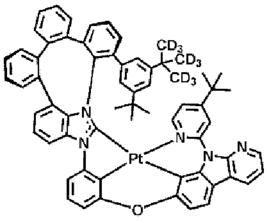

420

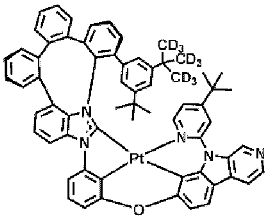

421

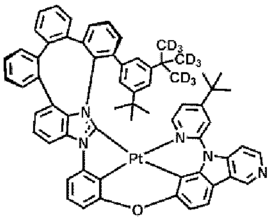

422

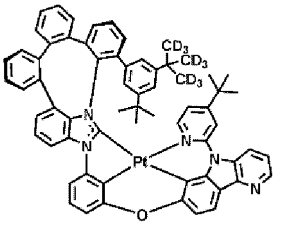

423

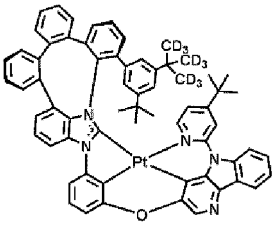

424

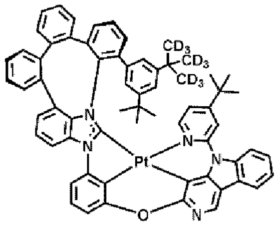

425

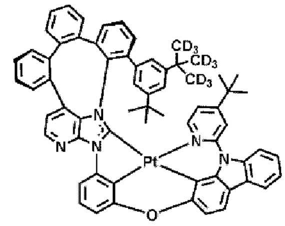

426

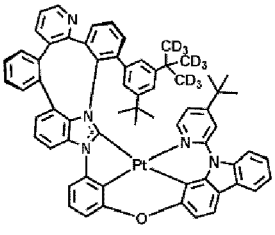
427

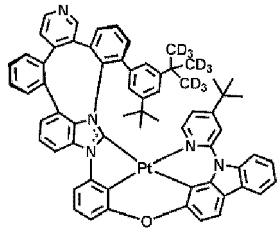
428

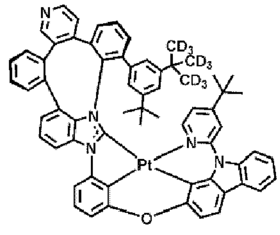
429

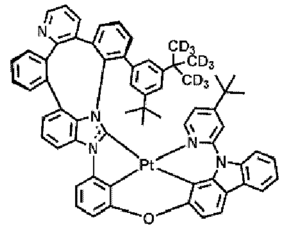
430

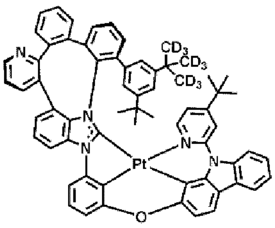
431

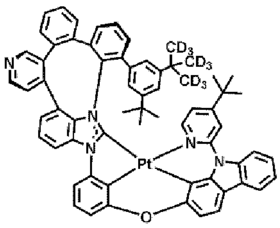
432

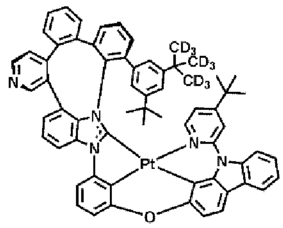
433

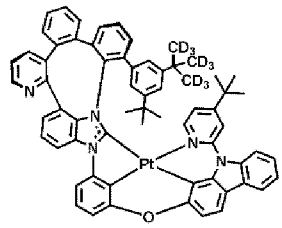
434

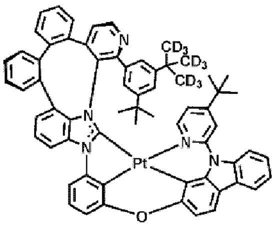
435

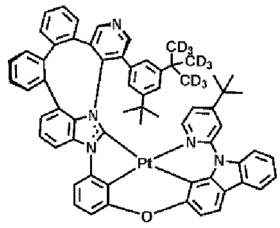
436

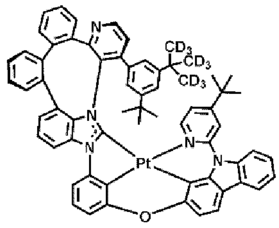
437

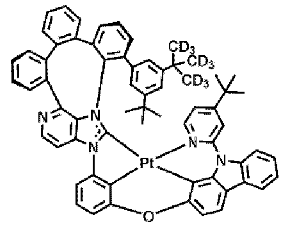
438

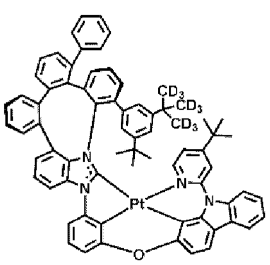
439

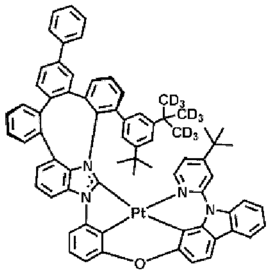
440

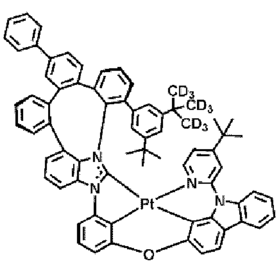
441

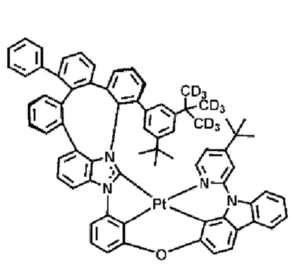
442

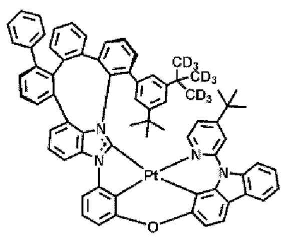
443

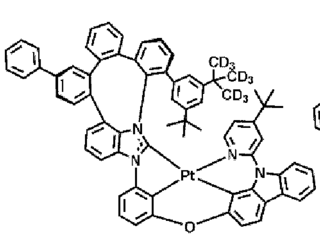
444

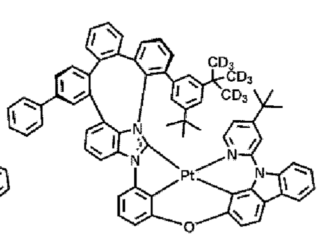
445

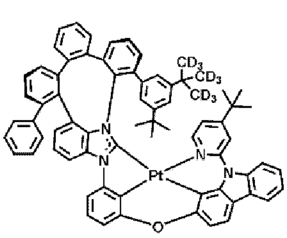
446

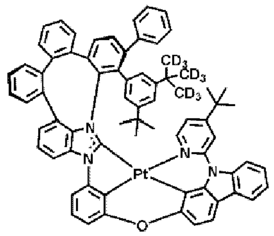
447

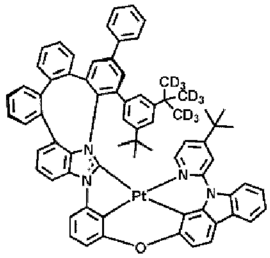
448

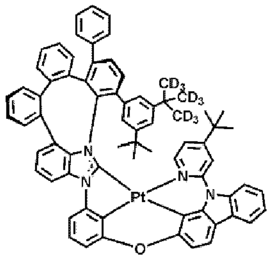
449

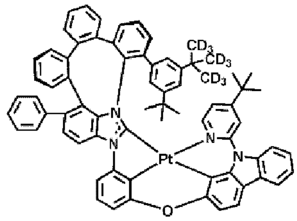
450

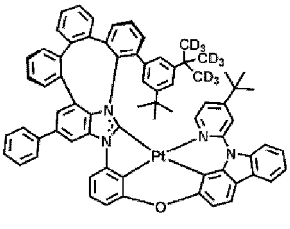
451

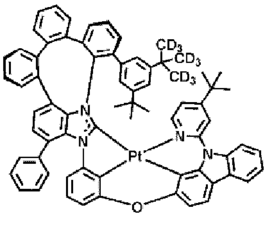
452

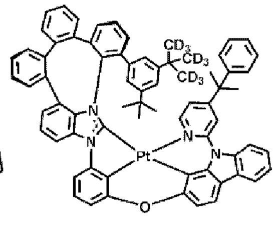
453

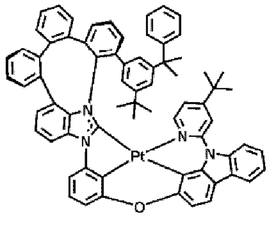
454

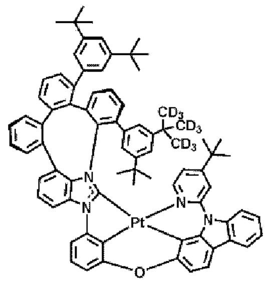
455

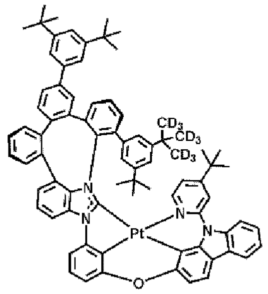
456

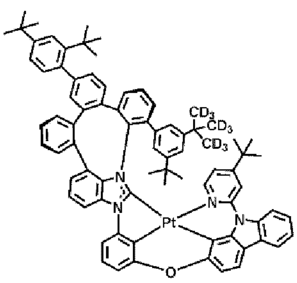
457

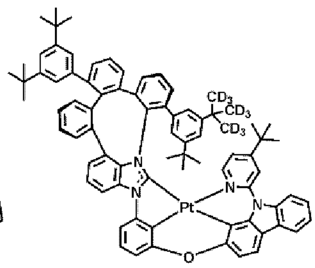
458

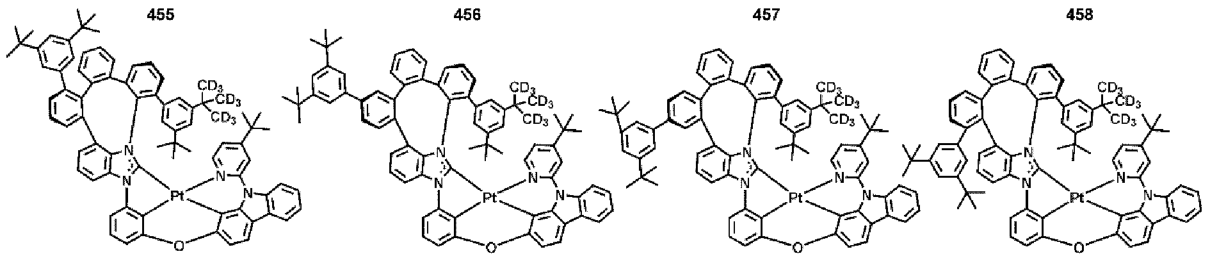
459

460

461

462

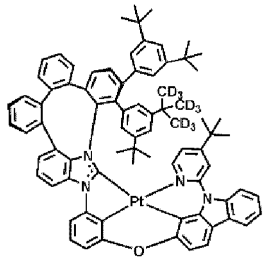
463

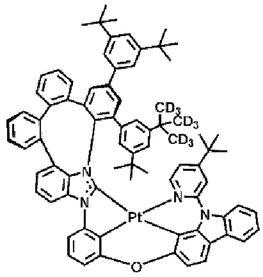
464

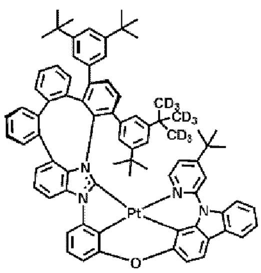
465

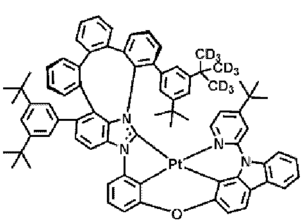
466

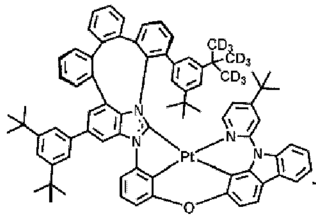

467

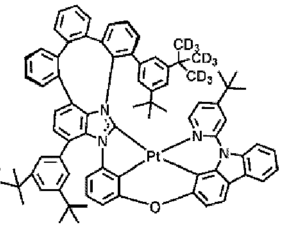

468

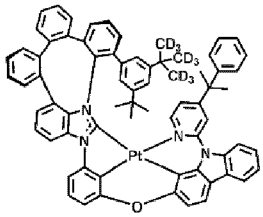

469

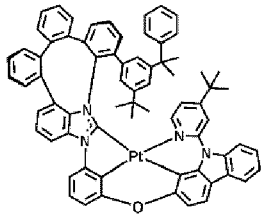

470

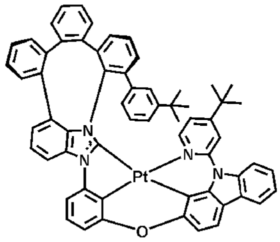

471

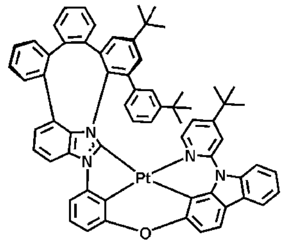

472

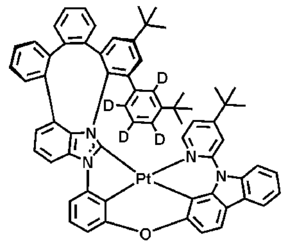

473

.

The organometallic compound represented by Formula 1 satisfies the structure of Formula 1 described above. Due to this structure, the organometallic compound represented by Formula 1 may have excellent luminescence characteristics and excellent charge transfer characteristics, and may be suitable for realizing a deep blue color.

Although not limited to a certain theory, since the organometallic compound represented by Formula 1 includes a rigid polycyclic carbene structure as shown in Formula 1, structural changes in an excited state may be reduced, and thus, non-luminescent transitions may be suppressed, and intermolecular interactions may be controlled due to the steric hindrance effect. In addition, since $R_4$ in Formula 1 is a substituted or unsubstituted $C_1$-$C_{60}$ alkyl group, due to the resulting inductive effect, the electron-donating effect may be increased. Accordingly, the organometallic compound represented by Formula 1 may have improved luminescence efficiency and color purity, may easily control an emission wavelength for deep blue emission, and may realize an organic light-emitting device having excellent characteristics including improved lifespan characteristics.

In one or more embodiments, the organometallic compound represented by Formula 1 may not be Compound A:

Compound A

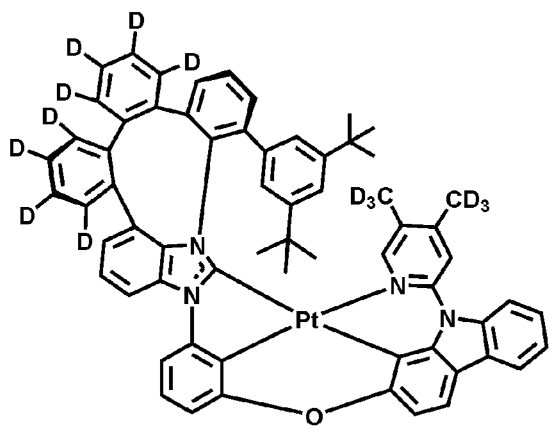

.

Although not limited to a certain theory, in Compound A, $CD_3$, which is a primary alkyl group with low electron-donating properties, is attached to pyridine in which the lowest unoccupied molecular orbital (LUMO) is present, and thus, the LUMO energy level may not be a sufficiently high enough energy level. As a result, the band gap energy may be lower than that of a secondary or tertiary alkyl group, resulting in a longer emission wavelength. In addition, the ligand-centered (LC) character may be weakened, and thus, the full width at half maximum (FWHM) of an emission waveform may be widened, thereby reducing color purity. Lastly, due to the large number of benzylic hydrogens with weak binding force, the compound may be vulnerable to deterioration, thereby having a shorter lifespan.

The highest occupied molecular orbital (HOMO) energy level, LUMO energy level, triplet ($T_1$) energy level, and

emission wavelength ($\lambda_{em}$, nm) of selected organometallic compounds represented by Formula 1 were calculated using a density functional theory (DFT) method of the Gaussian 09 program with the molecular structure optimized at the B3LYP level, and results thereof are shown in Table 1. The energy levels are expressed in electron volts (eV).

Table 1

| | HOMO (eV) | LUMO (eV) | $T_1$ (eV) | $\lambda_{em}$ (nm) |
|---|---|---|---|---|
| Compound 1 | -4.61 | -1.18 | 2.66 | 466 |
| Compound 2 | -4.60 | -1.16 | 2.66 | 466 |
| Compound 8 | -4.61 | -1.18 | 2.66 | 466 |
| Compound 10 | -4.63 | -1.20 | 2.65 | 467 |
| Compound 13 | -4.60 | -1.17 | 2.67 | 464 |
| Compound 14 | -4.60 | -1.17 | 2.67 | 464 |
| Compound 23 | -4.59 | -1.19 | 2.66 | 466 |
| Compound 31 | -4.60 | -1.16 | 2.66 | 466 |
| Compound 68 | -4.59 | -1.15 | 2.66 | 466 |
| Compound 98 | -4.58 | -1.13 | 2.68 | 462 |
| Compound 143 | -4.61 | -1.20 | 2.65 | 467 |
| Compound 158 | -4.57 | -1.16 | 2.65 | 467 |
| Compound 173 | -4.63 | -1.21 | 2.66 | 466 |
| Compound 203 | -4.83 | -1.33 | 2.71 | 457 |
| Compound 218 | -4.78 | -1.32 | 2.69 | 460 |
| Compound 248 | -4.62 | -1.19 | 2.65 | 467 |
| Compound 278 | -4.83 | -1.23 | 2.70 | 459 |
| Compound A | -4.62 | -1.22 | 2.63 | 471 |
| Compound B | -4.63 | -1.23 | 2.63 | 471 |
| Compound C | -4.64 | -1.22 | 2.66 | 466 |
| Compound D | -4.63 | -1.25 | 2.62 | 473 |

Compound A

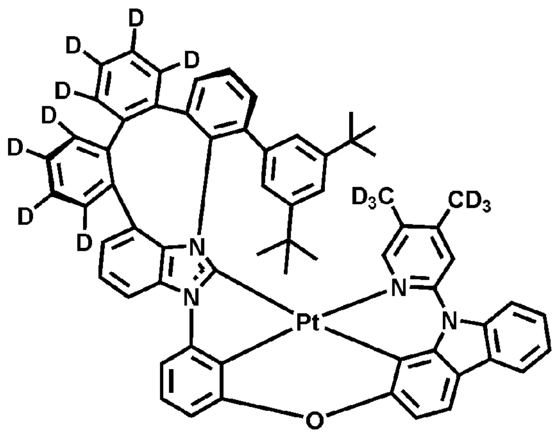

Compound B

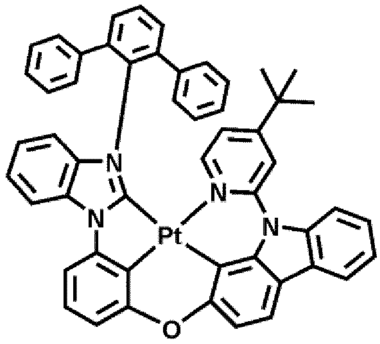

Compound C

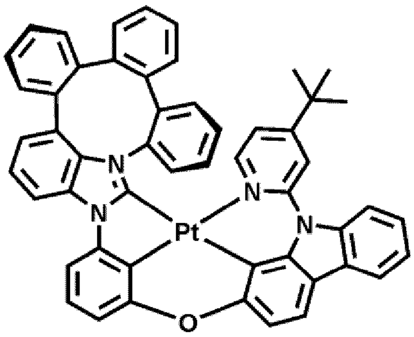

Compound D

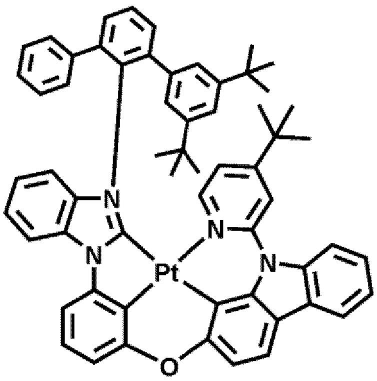

From Table 1, it was confirmed that the organometallic compound represented by Formula 1 has such electric characteristics that are suitable for use as a dopant (for example, an emitter or a sensitizer) for an electronic device, for example, an organic light-emitting device.

In one or more embodiments, the FWHM of the emission peak of the emission spectrum or the electroluminescence (EL) spectrum of the organometallic compound represented by Formula 1 may be about 60 nanometers (nm) or less. For example, the FWHM of the emission peak of the emission spectrum or the EL spectrum of the organometallic compound represented by Formula 1 may be about 5 nm to about 50 nm, about 7 nm to about 40 nm, or about 10 nm to about 30 nm.

Synthesis methods of the organometallic compound represented by Formula 1 may be recognizable by one of ordinary skill in the art and by referring to Synthesis Examples described below.

A method of conforming the structure of the organometallic compound represented by Formula 1 is not particularly limited. In one or more embodiments, the structure of the organometallic compound may be confirmed by a known method (for example, NMR, LC-MS, or the like).

## Electronic Device

Another aspect provides an electronic device including at least one of the organometallic compounds represented by Formula 1.

In one or more embodiments, the electronic device may be an organic light-emitting device, an organic photodiode (OPD), or an organic solar cell (OSC).

## Organic light-emitting device

Another aspect of the disclosure provides an organic light-emitting device including the organometallic compound.

In one or more embodiments, the organic light-emitting device may include a first electrode; a second electrode; and an organic layer arranged between the first electrode and the second electrode and including an emission layer,

Wherein the organic layer may include at least one of the organometallic compounds represented by Formula 1.

In one or more embodiments, the emission layer may include at least one of the organometallic compounds represented by Formula 1.

In one or more embodiments, the emission layer may include a host and an emitter, and the emitter may include at least one of the organometallic compounds represented by Formula 1.

In one or more embodiments, the amount of the host in the emission layer may be greater than an amount of the at least one of the organometallic compounds represented by Formula 1 in the emission layer, based on weight.

In one or more embodiments, the emission layer may further include a sensitizer.

In one or more embodiments, the sensitizer may include a phosphorescent compound, a delayed fluorescence compound, or a combination thereof.

Details on the host, the emitter, and the sensitizer may be the same as described herein.

Since the organic light-emitting device has an emission layer including at least one of the organometallic compounds represented by Formula 1 as described herein, the organic light-emitting device may have a relatively narrow EL spectrum emission peak FWHM, and may have excellent efficiency and lifespan characteristics.

In one or more embodiments, the organometallic compound represented by Formula 1 may act as a dopant (for example, an emitter or a sensitizer) in the emission layer, and the emission layer may further include a host (that is, the amount of the organometallic compound represented by Formula 1 in the emission layer may be less than an amount of the host in the emission layer, based on weight).

In one or more embodiments, the emission layer may emit a blue light. For example, the emission layer may emit a blue light having a maximum emission wavelength of about 400 nm to about 490 nm. For example, the emission layer may emit a blue light having a maximum emission wavelength of about 430 nm to about 480 nm.

The expression "(an emission layer) includes at least one organometallic compound represented by Formula 1" and "(an emission layer) includes at least one of the organometallic compounds represented by Formula 1" as used herein may include a case in which "(an emission layer) includes identical organometallic compounds represented by Formula 1" and a case in which "(an emission layer) includes two or more different organometallic compounds represented by Formula 1".

In one or more embodiments, the emission layer may include, as the at least one organometallic compound represented by Formula 1, only Compound 1. In this regard, Compound 1 may be present in the emission layer of the organic light-emitting device. In one or more embodiments, the emission layer may include, as the at least one organometallic compound represented by Formula 1, Compound 1 and Compound 2. In this regard, Compound 1 and Compound 2 may be different from each other.

## Description of FIG. 1

FIG. 1 is a schematic cross-sectional view of an organic light-emitting device 10 according to one or more embodiments. Hereinafter, the structure and manufacturing method of the organic light-emitting device 10 according to one or more embodiments will be described in further detail with reference to FIG. 1.

In FIG. 1, the organic light-emitting device 10 includes a first electrode 11, a second electrode 19 facing the first electrode 11, and an organic layer 15 arranged between the first electrode 11 and the second electrode 19.

The organic layer 15 may include an emission layer, a hole transport region (not shown) may be arranged between the first electrode 11 and the emission layer, and an electron transport region (not shown) may be arranged between the emission layer and the second electrode 19.

A substrate may be additionally arranged under the first electrode 11 or on the second electrode 19. For use as the substrate, any suitable substrate that is used in organic light-emitting devices available in the art may be used, and the substrate may be a glass substrate or a transparent plastic substrate, each having excellent mechanical strength, thermal

stability, transparency, surface smoothness, ease of handling, and/or water resistance.

First Electrode 11

The first electrode 11 may be formed by, for example, depositing or sputtering, onto the substrate, a material for forming the first electrode 11. The first electrode 11 may be an anode. The material for forming the first electrode 11 may be selected from materials with a high work function to facilitate hole injection.

The first electrode 11 may be a reflective electrode, a semi-transmissive electrode, or a transmissive electrode. In one or more embodiments, when the first electrode 11 is a transmissive electrode, the material for forming the first electrode 11 may be indium tin oxide (ITO), indium zinc oxide (IZO), tin oxide ($SnO_2$), zinc oxide (ZnO), or a combination thereof, but embodiments are not limited thereto. In one or more embodiments, when the first electrode 11 is a semi-transmissive electrode or a reflective electrode, the material for forming the first electrode 11 may be magnesium (Mg), silver (Ag), aluminum (Al), aluminum-lithium (Al-Li), calcium (Ca), magnesium-indium (Mg-In), magnesium-silver (Mg-Ag), or a combination thereof, but embodiments are not limited thereto.

The first electrode 11 may have a single-layer structure or a multi-layer structure including two or more layers.

Emission Layer

The emission layer may include at least one of the organometallic compounds represented by Formula 1.

Description of FIG. 2

In one or more embodiments, the organometallic compound represented by Formula 1 may be included as an emitter in the emission layer.

In one or more embodiments, the emission layer may further include a host (hereinafter, the host may be referred to as 'Host A', and Host A may not be the same as the organometallic compound represented by Formula 1). Host A may be as described herein in connection with a host material, but embodiments are not limited thereto.

Hereinafter, energy transfer according to one or more embodiments will be described with reference to FIG. 2.

Singlet excitons may be generated at a ratio of about 25% in Host A in the emission layer, and the singlet excitons generated in Host A may be transferred to the organometallic compound represented by Formula 1 through Forster energy transfer (or Forster resonance energy transfer (FRET)). In addition, triplet excitons generated at a ratio of about 75% in Host A in the emission layer may be transferred to the organometallic compound represented by Formula 1 through Dexter energy transfer. At least a portion of the energy of a singlet state of the organometallic compound represented by Formula 1 may be transferred to a triplet state thereof by intersystem crossing (ISC), and the organometallic compound represented by Formula 1 may emit phosphorescence. In addition, at least a portion of the energy of the triplet state of the organometallic compound represented by Formula 1 may be transferred to the singlet state thereof by reverse intersystem crossing (RISC), and the organometallic compound represented by Formula 1 may emit delayed fluorescence (or thermally activated delayed fluorescence (TADF)).

In one or more embodiments, the ratio of emission components emitted from the organometallic compound represented by Formula 1 to the total emission components emitted from the emission layer may be about 80% or more, for example, about 90% or more. For example, the ratio of the emission components emitted from the organometallic compound represented by Formula 1 to the total emission components emitted from the emission layer may be about 95% or more.

In this regard, the organometallic compound represented by Formula 1 may emit phosphorescence or delayed fluorescence, and the host may not emit a light.

In one or more embodiments, when the emission layer further includes Host A, in addition to the organometallic compound represented by Formula 1, the amount of the organometallic compound represented by Formula 1 may be about 50 parts by weight or less, for example, about 30 parts by weight or less, based on 100 parts by weight of the emission layer, and the amount of Host A in the emission layer may be about 50 parts by weight or more, for example, about 70 parts by weight or more, based on 100 parts by weight of the emission layer, but embodiments are not limited thereto.

Description of FIG. 3

In one or more embodiments, the organometallic compound represented by Formula 1 may be used as a sensitizer, and the emission layer may further include a fluorescence emitter.

In one or more embodiments, the emission layer may further include a host (hereinafter, the host may be referred to as 'Host B', and Host B may not be the same as the organometallic compound represented by Formula 1 or the fluorescence emitter) and a fluorescence emitter (hereinafter, the fluorescence emitter may be referred to as 'Fluorescence Emitter B', and Fluorescence Emitter B may not be the same as Host B or the organometallic compound represented by Formula 1). Host B and Fluorescence Emitter B may respectively be as described herein in connection with a host material and a fluorescence emitter material, but embodiments are not limited thereto.

In one or more embodiments, a ratio of emission components of Fluorescence Emitter B may be about 80% or more, for example, about 90% or more (or for example, about 95% or more) to the total emission components emitted from the emission layer. For example, Fluorescence Emitter B may emit fluorescence. In addition, the host and the sensitizer may not each emit a light.

Hereinafter, energy transfer according to one or more embodiments will be described with reference to FIG. 3.

Triplet excitons generated at a ratio of about 75% in Host B in the emission layer may be transferred to the organometallic compound represented by Formula 1 through Dexter energy transfer, the energy of singlet excitons generated at a ratio of about 25% in Host B may be transferred to singlet and triplet states of the organometallic compound represented by Formula 1, at least a portion of the energy transferred to the singlet state of the organometallic compound represented by Formula 1 may undergo ISC to the triplet state thereof, and then, the triplet energy of the organometallic compound may be transferred to the Fluorescence Emitter B through FRET. In addition, at least a portion of the triplet energy of the organometallic compound represented by Formula 1 may be transferred to the singlet state thereof through RISC and then transferred to Fluorescence Emitter B.

Accordingly, by transferring all the singlet excitons and triplet excitons generated in the emission layer to the emitter, an organic light-emitting device having improved efficiency may be obtained. In addition, since an organic light-emitting device may be obtained with significantly reduced energy loss, the lifespan characteristics of the organic light-emitting device may be improved.

In one or more embodiments, the amount of organometallic compound represented by Formula 1 in the emission layer may be about 5 wt% to about 50 wt%, for example, about 10 wt% to about 30 wt%, based on total weight of the emission layer. When the above ranges are satisfied, effective energy transfer may be achieved in the emission layer, and thus, an organic light-emitting device having high efficiency and long lifespan may be obtained.

In one or more embodiments, the amount of Fluorescence Emitter B in the emission layer may be about 0.01 wt% to about 15 wt%, for example, about 0.05 wt% to about 3 wt%, based on total weight of the emission layer, but embodiments are not limited thereto.

Description of FIG. 4

In one or more embodiments, the organometallic compound represented by Formula 1 may be used as a sensitizer, and the emission layer may further include a delayed fluorescence emitter.

In one or more embodiments, the emission layer may further include a host (hereinafter, the host may be referred to as 'Host C', and Host C may not be the same as the organometallic compound represented by Formula 1 or the delayed fluorescence emitter) and a delayed fluorescence emitter (hereinafter, the delayed fluorescence emitter may be referred to as 'Delayed Fluorescence Emitter C', and Delayed Fluorescence Emitter C may not be the same as Host C or the organometallic compound represented by Formula 1). Host C and Delayed Fluorescence Emitter C may respectively be as described herein in connection with a host material and a delayed fluorescence emitter material, but embodiments are not limited thereto.

In one or more embodiments, the ratio of emission components of the delayed fluorescence emitter may be about 80% or more, for example, about 90% or more (or for example, about 95% or more) to the total emission components emitted from the emission layer. For example, the delayed fluorescence emitter may emit delayed fluorescence. In addition, the host and the sensitizer may not each emit light.

Hereinafter, energy transfer according to one or more embodiments will be described with reference to FIG. 4.

Triplet excitons generated at a ratio of about 75% in Host C in the emission layer may be transferred to the organometallic compound represented by Formula 1 through Dexter energy transfer, the energy of singlet excitons generated at a ratio of about 25% in Host C may be transferred to singlet and triplet states of the organometallic compound represented by Formula 1, at least a portion of the energy transferred to the singlet state of the organometallic compound represented by Formula 1 may undergo ISC to the triplet state thereof, and then, the triplet energy of the organometallic compound represented by Formula 1 may be transferred to Delayed Fluorescence Emitter C through FRET. In addition, at least a portion of the triplet energy of the organometallic compound represented by Formula 1 may be transferred to the singlet state thereof through RISC and then transferred to Delayed Fluorescence Emitter C.

Accordingly, by transferring all the singlet excitons and triplet excitons generated in the emission layer to the emitter, an organic light-emitting device having improved efficiency may be obtained. In addition, since an organic light-emitting device may be obtained with significantly reduced energy loss, the lifespan characteristics of the organic light-emitting device may be improved.

In one or more embodiments, the amount of organometallic compound of Formula 1 in the emission layer may be about 5 wt% to about 50 wt%, for example, about 10 wt% to about 30 wt%, based on total weight of the emission layer.

When the above ranges are satisfied, effective energy transfer may be achieved in the emission layer, and thus, an organic light-emitting device having high efficiency and long lifespan may be obtained.

In one or more embodiments, the amount of Delayed Fluorescence Emitter C in the emission layer may be about 0.01 wt% to about 15 wt%, for example, about 0.05 wt% to about 3 wt%, based on total weight of the emission layer, but embodiments are not limited thereto.

Host in Emission Layer

In one or more embodiments, the host may not include a metal atom.

In one or more embodiments, the host may include at least one compound that is a fluorene-containing compound, a carbazole-containing compound, a dibenzofuran-containing compound, a dibenzothiophene-containing compound, an indenocarbazole-containing compound, an indolocarbazole-containing compound, a benzofurocarbazole-containing compound, a benzothienocarbazole-containing compound, an acridine-containing compound, a dihydroacridine-containing compound, a triindolobenzene-containing compound, a pyridine-containing compound, a pyrimidine-containing compound, a triazine-containing compound, a silicon-containing compound, a cyano group-containing compound, a phosphine oxide-containing compound, a sulfoxide-containing compound, or a sulfonyl-containing compound.

In one or more embodiments, the host may be a compound including at least one carbazole ring and at least one cyano group, or a phosphine oxide-containing compound.

In one or more embodiments, the host may consist of one host. When the host consists of one host, the one host may be a bipolar host, an electron-transporting host, or a hole-transporting host, which will be described below.

In one or more embodiments, the host may be a mixture of two or more different hosts. For example, the host may include a hole-transporting host, an electron-transporting host, a bipolar host, or a combination thereof.

In one or more embodiments, the host may be a combination of an electron-transporting host and a hole-transporting host, a combination of two different electron-transporting hosts, or a combination of two different hole-transporting hosts. Details on the electron-transporting host and the hole-transporting host may be as described herein.

In one or more embodiments, the host may include an electron-transporting host including at least one electron-transporting moiety and a hole-transporting host that is free of an electron-transporting moiety.

The electron-transporting moiety used herein may be a cyano group, a π electron-deficient nitrogen-containing cyclic group, or a group represented by one of the formulae below:

ET-moiety

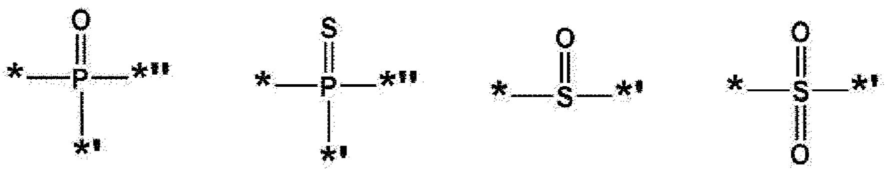

wherein, in the formulae above, *, *', and *" each indicate a binding site to a neighboring atom.

In one or more embodiments, the electron-transporting host in the emission layer may include at least one of a cyano group or a π electron-deficient nitrogen-containing cyclic group.

In one or more embodiments, the electron-transporting host in the emission layer may include at least one cyano group.

In one or more embodiments, the electron-transporting host in the emission layer may include at least one cyano group or at least one π electron-deficient nitrogen-containing cyclic group.

In one or more embodiments, the hole-transporting host in the emission layer may include a hole-transporting moiety and may not include an electron-transporting moiety.

The hole-transporting moiety used herein may be a π electron-rich $C_3$-$C_{60}$ cyclic group or a group represented by Formula HT-moiety:

HT-moiety

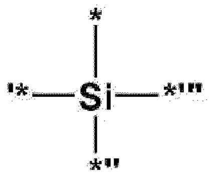

wherein, in the formula above, *, *’, *", and *‴ each indicate a binding site to a neighboring atom.

In one or more embodiments, the host may include an electron-transporting host and a hole-transporting host, the electron-transporting host may include at least one π electron-deficient nitrogen-free cyclic group or at least one electron-transporting moiety, and the hole-transporting host may include at least one π electron-deficient nitrogen-free cyclic group or may not include an electron-transporting moiety.

The term "π electron-deficient nitrogen-containing ring group" as used herein refers to a ring group having at least one *-N=*’ moiety, and for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, or an azacarbazole group; or a condensed ring group of two or more π electron-deficient nitrogen-containing ring groups.

The π electron-deficient nitrogen-free ring group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group; or a condensed ring group of two or more π electron-deficient nitrogen-free ring groups, but embodiments are not limited thereto.

In one or more embodiments, when the host is a combination of an electron-transporting host and a hole-transporting host, the weight ratio of the electron-transporting host to the hole-transporting host may be about 1:9 to about 9:1, for example, about 2:8 to about 8:2, for example, about 4:6 to about 6:4, or for example, 5:5. When the weight ratio of the electron-transporting host to the hole-transporting host is within the above ranges, hole-and-electron-transporting balance in the emission layer may be achieved.

In one or more embodiments, the bipolar host may include at least one electron-transporting moiety or at least one hole-transporting moiety.

In one or more embodiments, the host may include a first compound and a second compound, and

i) the first compound may be a hole-transporting host, and the second compound may be an electron-transporting host,
ii) the first compound may be an electron-transporting host, and the second compound may be a hole-transporting host,
iii) the first compound and the second compound may each be a bipolar host,
iv) the first compound may be a hole-transporting host, and the second compound may be a bipolar host,
v) the first compound may be an electron-transporting host, and the second compound may be a bipolar host,
vi) the first compound may be a bipolar host, and the second compound may be a hole-transporting host, or
vii) the first compound may be a bipolar host, and the second compound may be an electron-transporting host.

The host may include at least one of 1,3,5-tri(1-phenyl-1H-benzo[d]imidazol-2-yl)benzene (TPBi), 3-tert-butyl-9,10-di(naphth-2-yl)anthracene (TBADN), 9,10-di(naphthalene-2-yl)anthracene (ADN) (also referred to as "DNA"), 4,4’-bis(N-carbazolyl)-1,1’-biphenyl (CBP), 4,4’-bis(9-carbazolyl)-2,2’-dimethyl-biphenyl (CDBP), 1,3,5-tris(carbazole-9-yl)benzene (TCP), 1,3-bis(N-carbazolyl)benzene (mCP), Compound H50, or Compound H51, but embodiments are not limited thereto:

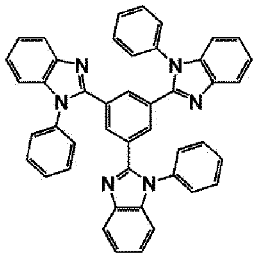

TPBi

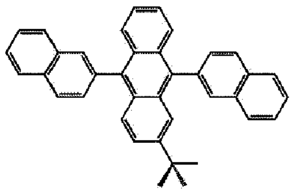

TBADN

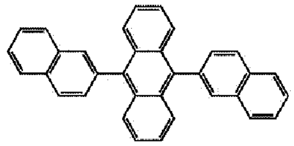

ADN

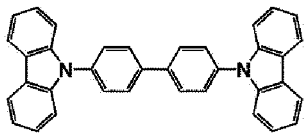

CBP

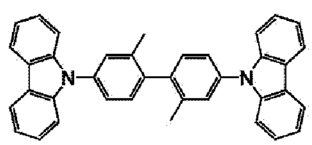

CDBP

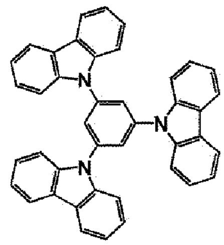

TCP

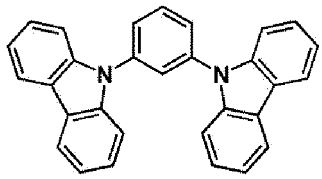

mCP

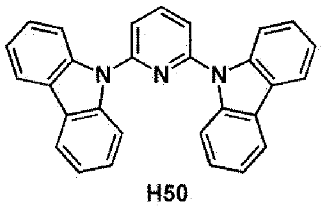

H50

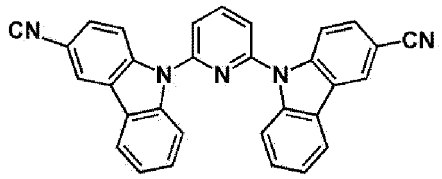

H51

.

In one or more embodiments, the host may include a compound represented by Formula 301, but embodiments are not limited thereto:

Formula 301

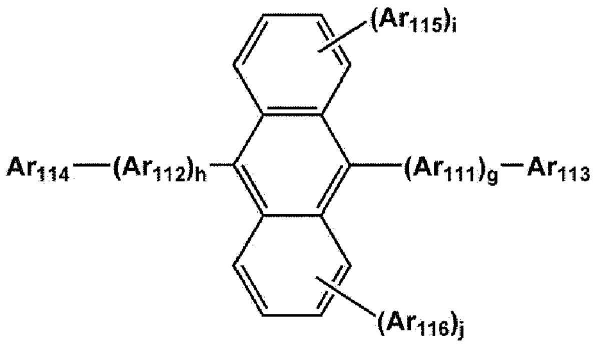

wherein, in Formula 301, $Ar_{111}$ and $Ar_{112}$ may each independently be:

a phenylene group, a naphthylene group, a phenanthrenylene group, or a pyrenylene group; or
a phenylene group, a naphthylene group, a phenanthrenylene group, or a pyrenylene group, each substituted with at least one of a phenyl group, a naphthyl group, an anthracenyl group, or a combination thereof.

In Formula 301, $Ar_{113}$ to $Ar_{116}$ may each independently be:

a $C_1$-$C_{10}$ alkyl group, a phenyl group, a naphthyl group, a phenanthrenyl group, or a pyrenyl group; or
a phenyl group, a naphthyl group, a phenanthrenyl group, or a pyrenyl group, each substituted with at least one of a

phenyl group, a naphthyl group, an anthracenyl group, or a combination thereof.

In Formula 301, g, h, i, and j may each independently be an integer from 0 to 4, and for example, may each independently be 0, 1, or 2.

In Formula 301, $Ar_{113}$ to $Ar_{116}$ may each independently be:

a $C_1$-$C_{10}$ alkyl group substituted with at least one of a phenyl group, a naphthyl group, an anthracenyl group, or a combination thereof;

a phenyl group, a naphthyl group, an anthracenyl group, a pyrenyl group, a phenanthrenyl group, or a fluorenyl group;

a phenyl group, a naphthyl group, an anthracenyl group, a pyrenyl group, a phenanthrenyl group, or a fluorenyl group, each substituted with at least one of deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a phenyl group, a naphthyl group, an anthracenyl group, a pyrenyl group, a phenanthrenyl group, a fluorenyl group, or a combination thereof; or

a group represented by the structure:

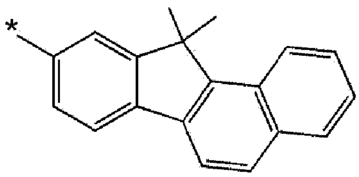

,

but embodiments are not limited thereto.

In one or more embodiments, the host may include a compound represented by Formula 302, but embodiments are not limited thereto:

Formula 302

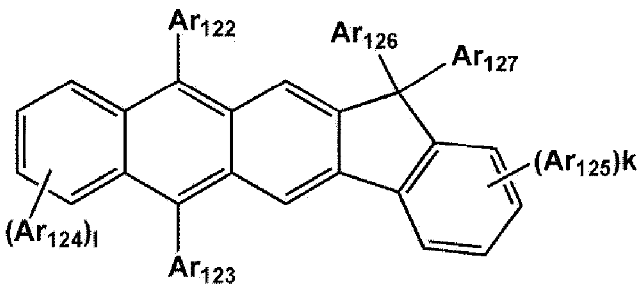

wherein, in Formula 302, $Ar_{122}$ to $Ar_{125}$ may each be as described in connection with $Ar_{113}$ in Formula 301.

In Formula 302, $Ar_{126}$ and $Ar_{127}$ may each independently be a $C_1$-$C_{10}$ alkyl group (for example, a methyl group, an ethyl group, a propyl group, or the like).

In Formula 302, k and l may each independently be an integer from 0 to 4. For example, k and l may each independently be 0, 1, or 2.

In one or more embodiments, the host may include at least one of Compounds H1 to H31:

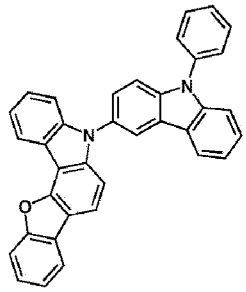

H1

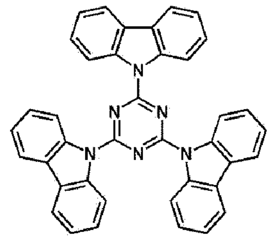

H2

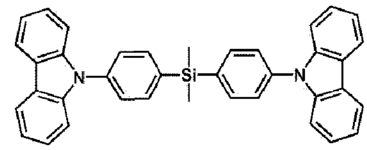

H3

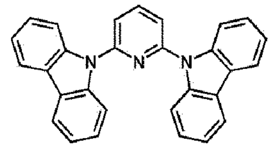

H4

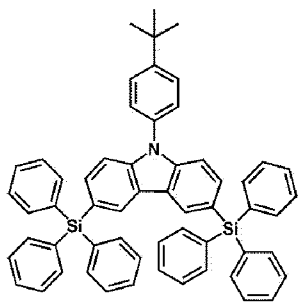

H5

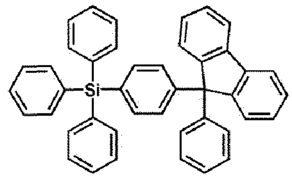

H6

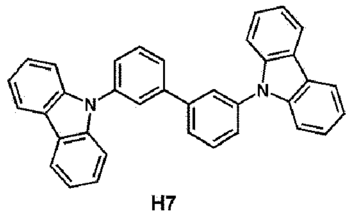

H7

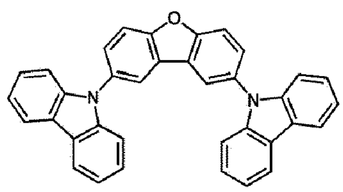

H8

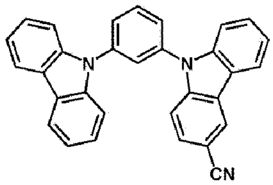

H9

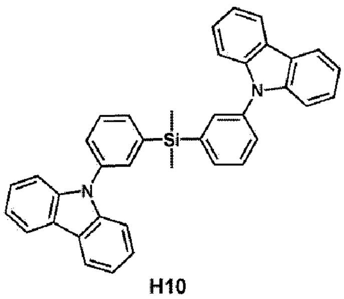

H10

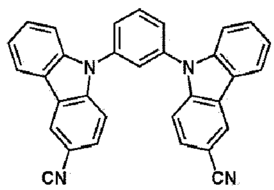

H11

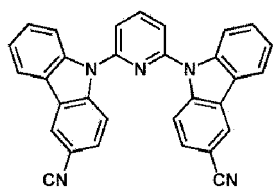

H12

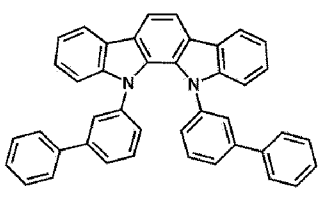

H13

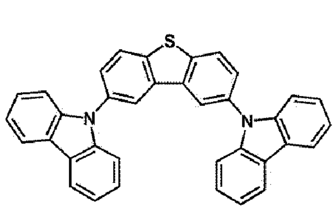

H14

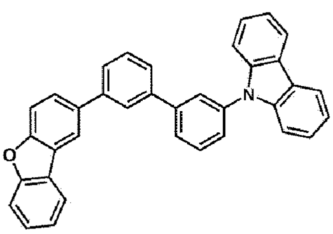

H15

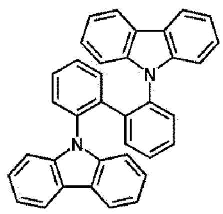
H16

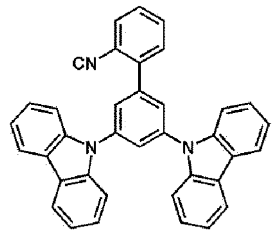
H17

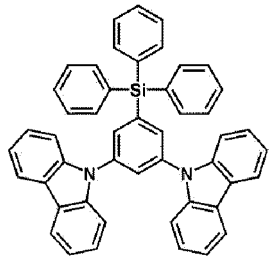
H18

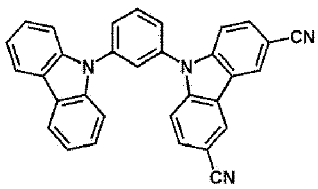
H19

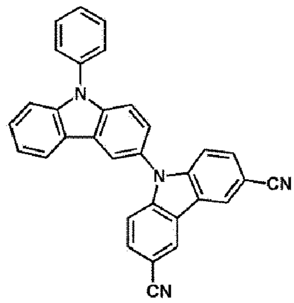
H20

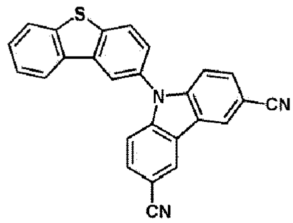
H21

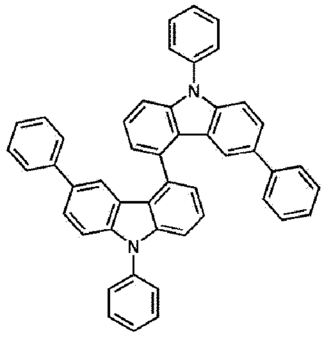
H22

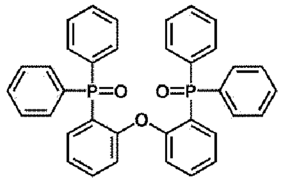
H23

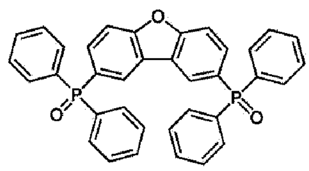
H24

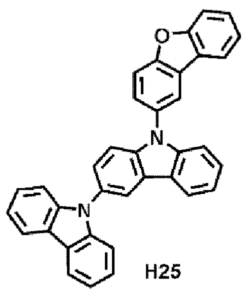
H25

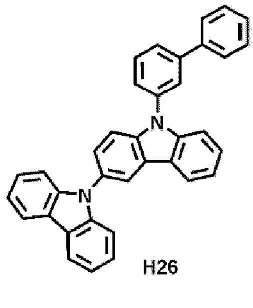
H26

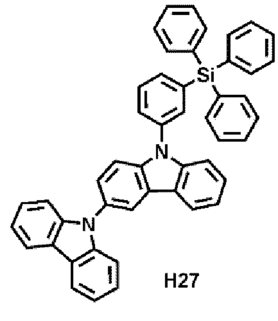
H27

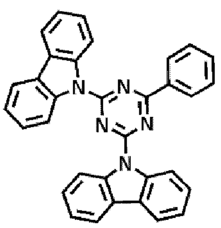
H28

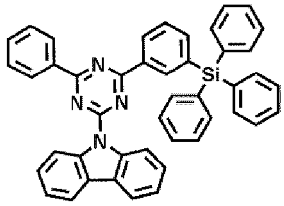
H29

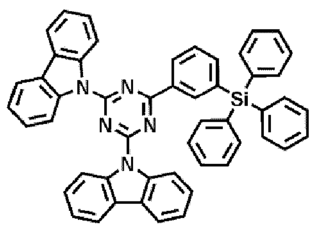
H30

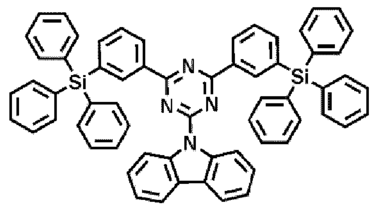

H31

In one or more embodiments, the host may consist of one compound. For example, the one compound may be selected from the first compound (a hole-transporting host) and the second compound (an electron-transporting host) as described above.

In one or more embodiments, the host may include two or more compounds. For example, the host may include two or more different hole-transporting hosts, two or more different electron-transporting hosts, or a combination of at least one hole-transporting host and at least one electron-transporting host.

Emitter in Emission Layer

The emitter may emit a light.

In one or more embodiments, the emitter may include at least one of the organometallic compounds represented by Formula 1.

In one or more embodiments, the emitter may be a fluorescence and/or delayed fluorescence emitter that emits fluorescence and/or delayed fluorescence. Accordinly, a decay time of the emitter ($T_{decay}$(E)) may be less than 100 microseconds (μs).

$T_{decay}$(E) may be measured from a time-resolved photoluminescence (TRPL) spectrum at room temperature of a film having a thickness of 40 nm formed by vacuum-co-depositing the host and the emitter included in the emission layer on a quartz substrate at a weight ratio of 90:10 at a vacuum degree of $10^{-7}$ torr.

In one or more embodiments, the emitter may include a tetracyclic or higher carbocyclic group or a tetracyclic or higher heterocyclic group.

In one or more embodiments, the emitter may be an organic compound that does not include a metal.

In one or more embodiments, the emitter may be a compound represented by one of Formulae 51 to 54, but embodiments are not limited thereto:

Formula 51

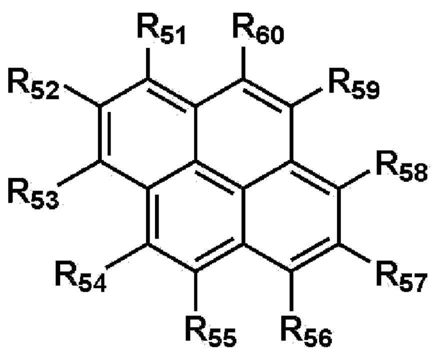

Formula 52

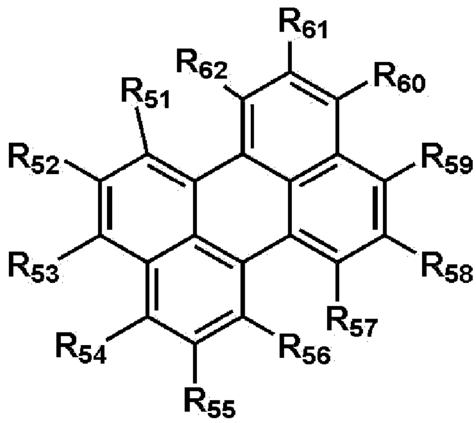

Formula 53

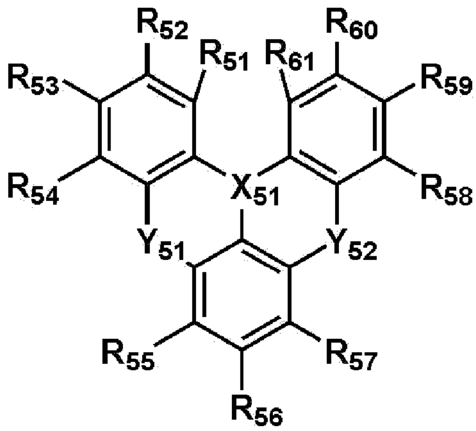

Formula 54

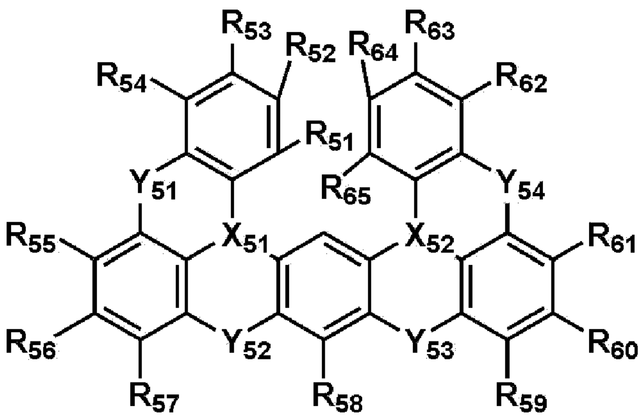

wherein, in Formulae 51 to 54,

$X_{51}$ and $X_{52}$ may each independently be N or B,
$Y_{51}$ may be a single bond, O, S, Se, $N(R_{501})$, $B(R_{501})$, $C(R_{501})(R_{502})$, or $Si(R_{501})(R_{502})$,
$Y_{52}$ may be a single bond, O, S, Se, $N(R_{503})$, $B(R_{503})$, $C(R_{503})(R_{504})$, or $Si(R_{503})(R_{504})$,
$Y_{53}$ may be a single bond, O, S, Se, $N(R_{505})$, $B(R_{505})$, $C(R_{505})(R_{506})$, or $Si(R_{505})(R_{506})$,
$Y_{54}$ may be a single bond, O, S, Se, $N(R_{507})$, $B(R_{507})$, $C(R_{507})(R_{508})$, or $Si(R_{507})(R_{508})$,
$R_{51}$ to $R_{65}$ and $R_{501}$ to $R_{508}$ may each independently be hydrogen, deuterium, -F, -Cl, -Br, -I, $-SF_5$, a hydroxyl group, a

cyano group, a nitro group, an amino group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-C(=O)(Q_1)$, $-S(=O)(Q_1)$, $-S(=O)_2(Q_1)$, $-N(Q_4)(Q_5)$, $-B(Q_6)(Q_7)$, $-P(Q_8)(Q_9)$, $-P(=O)(Q_8)(Q_9)$, or $-P(=S)(Q_8)(Q_9)$,

neighboring two or more of $R_{51}$ to $R_{65}$ and $R_{501}$ to $R_{508}$ may optionally be bonded to each other to form a $C_5$-$C_{30}$ carbocyclic group unsubstituted or substituted with at least one $R_5$ or a $C_1$-$C_{30}$ heterocyclic group unsubstituted or substituted with at least one $R_5$, $R_5$ may be the same as described in connection with $R_1$ in Formula 1,

at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group may be:

deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, $-C(Q_{11})(Q_{12})(Q_{13})$, $-C(=O)(Q_{11})$, $-S(=O)(Q_{11})_7$ $-S(=O)_2(Q_{11})$, $-N(Q_{14})(Q_{15})$, $-B(Q_{16})(Q_{17})$, $-P(Q_{18})(Q_{19})$, $-P(=O)(Q_{18})(Q_{19})$, $-P(=S)(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$

alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, -Si($Q_{21}$)($Q_{22}$)($Q_{23}$), -Ge($Q_{21}$)($Q_{22}$)($Q_{23}$), -C($Q_{21}$)($Q_{22}$)($Q_{23}$), -C(=O)($Q_{21}$), -S(=O)($Q_{21}$), -S(=O)$_2$($Q_{21}$), -N($Q_{24}$)($Q_{25}$), -B($Q_{26}$)($Q_{27}$), -P($Q_{28}$)($Q_{29}$), - P(=O)($Q_{28}$)($Q_{29}$), -P(=S)($Q_{28}$)($Q_{29}$), or a combination thereof; or

-Si($Q_{31}$)($Q_{32}$)($Q_{33}$), -Ge($Q_{31}$)($Q_{32}$)($Q_{33}$), -C($Q_{31}$)($Q_{32}$)($Q_{33}$), -C(=O)($Q_{31}$), - S(=O)($Q_{31}$), -S(=O)$_2$($Q_{31}$), -N($Q_{34}$)($Q_{35}$), -B($Q_{36}$)($Q_{37}$), -P($Q_{38}$)($Q_{39}$), - P(=O)($Q_{38}$)($Q_{39}$), or -P(=S)($Q_{38}$)($Q_{39}$), and

$Q_1$ to Q9, $Q_{11}$ to Q19, Q21 to Q29, and Q31 to Q39 may each independently be hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

In one or more embodiments, $R_{51}$ to $R_{65}$ and $R_{501}$ to $R_{508}$ may each be as described in connection with $R_1$.

In one or more embodiments, the emitter may be condensed polycyclic compound or a styryl-containing compound.

In one or more embodiments, the emitter may include one of a naphthalene-containing core, a fluorene-containing core, a spiro-bifluorene-containing core, a benzofluorene-containing core, a dibenzofluorene-containing core, a phenanthrene-containing core, an anthracene-containing core, a fluoranthene-containing core, a triphenylene-containing core, a pyrene-containing core, a chrysene-containing core, a picene-containing core, a perylene-containing core, a pentacene-containing core, an indenoanthracene-containing core, a tetracene-containing core, a bisanthracene-containing core, or a core represented by one of Formulae 501-1 to 501-21:

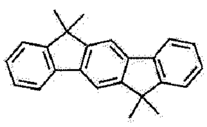
501-1

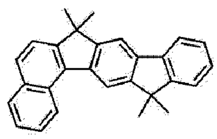
501-2

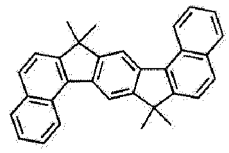
501-3

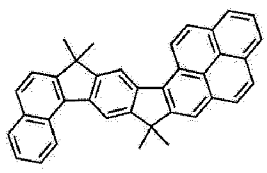
501-4

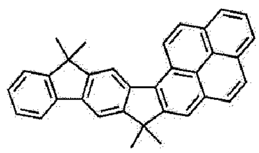
501-5

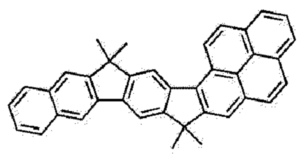
501-6

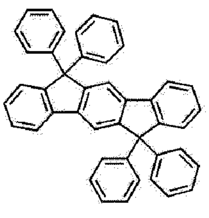
501-7

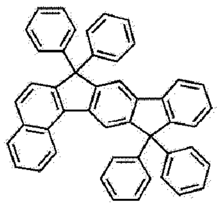
501-8

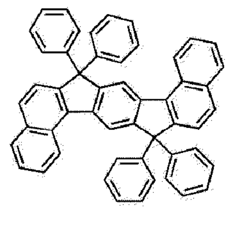
501-9

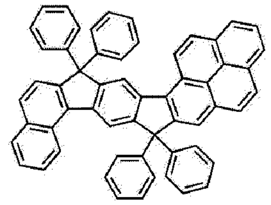

501-10

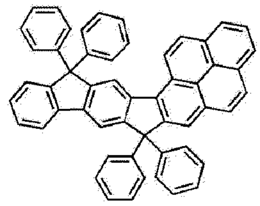

501-11

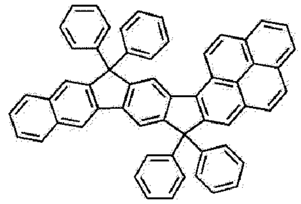

501-12

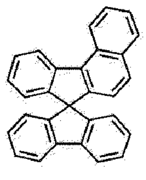

501-13

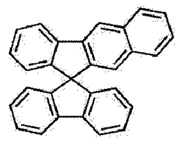

501-14

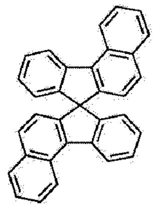

501-15

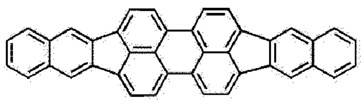

501-16

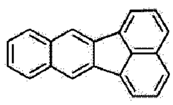

501-17

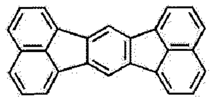

501-18

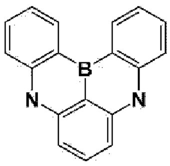

501-19

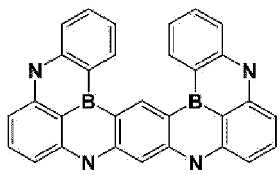

501-20

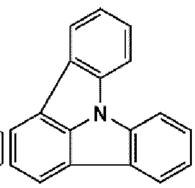

501-21

.

In one or more embodiments, the emitter may be represented by Formula 501, but embodiments are not limited thereto:

Formula 501

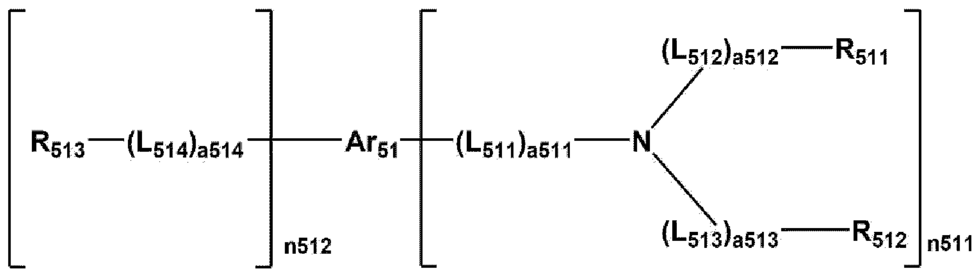

wherein, in Formula 501,

$Ar_{51}$ may be a naphthalene group, a fluorene group, a spiro-bifluorene group, a benzofluorene group, a dibenzofluorene group, a phenanthrene group, an anthracene group, a fluoranthene group, a triphenylene group, a pyrene group, a chrysene group, a picene group, a perylene group, a pentacene group, an indenoanthracene group, a tetracene group, a bisanthracene group, or a group represented by one of Formulae 501-1 to 501-21, each unsubstituted or substituted with at least one of deuterium, -F, -Cl, -Br, -I, $-SF_5$, a hydroxyl group, a cyano group, a nitro group, an amino group, an amidino group, a hydrazine group, a hydrazone group, a sulfonic acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy

group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{511})(Q_{512})(Q_{513})$, $-Ge(Q_{511})(Q_{512})(Q_{513})$, $-C(Q_{511})(Q_{512})(Q_{513})$, - $C(=O)(Q_{511})$, $-S(=O)(Q_{511})$, $-S(=O)_2(Q_{511})$, $-N(Q_{514})(Q_{515})$, $-B(Q_{516})(Q_{517})$, - $P(Q_{518})(Q_{519})$, $-P(=O)(Q_{518})(Q_{519})$, $-P(=S)(Q_{518})(Q_{519})$, or a combination thereof,

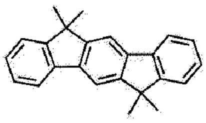

501-1

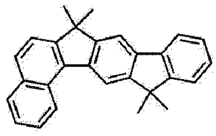

501-2

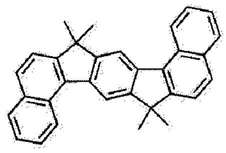

501-3

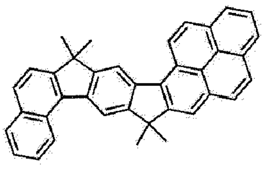

501-4

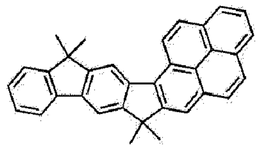

501-5

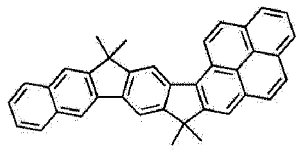

501-6

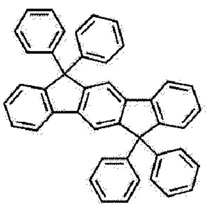

501-7

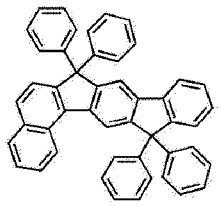

501-8

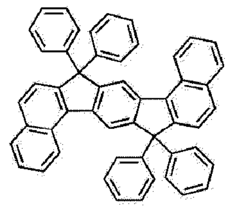

501-9

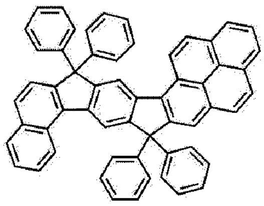

501-10

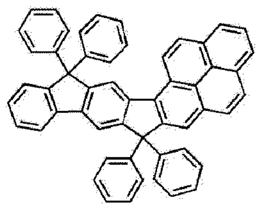

501-11

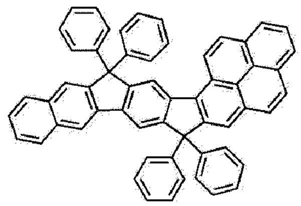

501-12

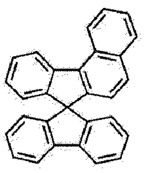

501-13

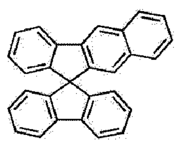

501-14

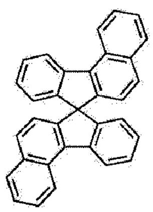

501-15

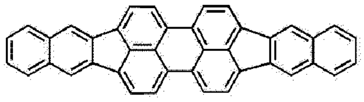

501-16

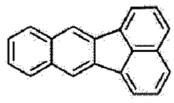

501-17

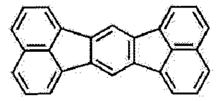

501-18

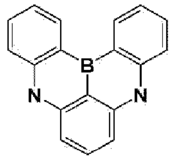
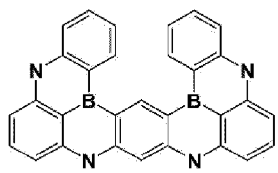
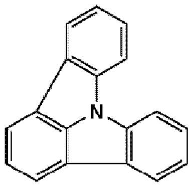

501-19 501-20 501-21

$L_{511}$ to $L_{514}$ may each independently be a substituted or unsubstituted $C_3$-$C_{10}$ cycloalkylene group, a substituted or unsubstituted $C_1$-$C_{10}$ heterocycloalkylene group, a substituted or unsubstituted $C_3$-$C_{10}$ cycloalkenylene group, a substituted or unsubstituted $C_1$-$C_{10}$ heterocycloalkenylene group, a substituted or unsubstituted $C_6$-$C_{60}$ arylene group, a substituted or unsubstituted $C_1$-$C_{60}$ heteroarylene group, a substituted or unsubstituted divalent non-aromatic condensed polycyclic group, or a substituted or unsubstituted divalent non-aromatic condensed heteropolycyclic group,

a511 to a514 may each independently be 0, 1, 2, or 3,

$R_{511}$ to $R_{513}$ may each independently be a substituted or unsubstituted $C_1$-$C_{60}$ alkyl group, a substituted or unsubstituted $C_3$-$C_{10}$ cycloalkyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group,

$Q_{511}$ to $Q_{519}$ may each independently be hydrogen, deuterium, -F, -Cl, -Br, -I, $-SF_5$, a hydroxyl group, a cyano group, a nitro group, an amino group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, a $C_1$-$C_{60}$ alkyl group substituted with at least one of deuterium, -F, a cyano group, a $C_1$-$C_{20}$ alkyl group, or a $C_6$-$C_{30}$ aryl group, or a $C_6$-$C_{60}$ aryl group substituted with at least one of deuterium, -F, a cyano group, a $C_1$-$C_{20}$ alkyl group, or a $C_6$-$C_{30}$ aryl group, and

n511 and n512 may each independently be 0, 1, 2, 3, 4, 5, or 6.

In one or more embodiments, in Formula 501, the sum of n511 and n512 may be 1 or more, but embodiments are not limited thereto.

In one or more embodiments, in Formula 501, $R_{511}$ and $R_{512}$ may each independently be:

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazole group, a triazinyl group, a dibenzofuranyl group, or a dibenzothiophenyl group; or

a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, or a dibenzothiophenyl group, each substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a biphenyl group, a terphenyl group, a naphthyl group, a fluorenyl group, a spiro-bifluorenyl group, a benzofluorenyl group, a dibenzofluorenyl group, a phenanthrenyl group, an anthracenyl group, a pyrenyl group, a chrysenyl group, a pyridinyl group, a pyrazinyl group, a pyrimidinyl group, a pyridazinyl group, a quinolinyl group, an isoquinolinyl group, a quinoxalinyl group, a quinazolinyl group, a carbazolyl group, a triazinyl group, a dibenzofuranyl group, a dibenzothiophenyl group, or a combination thereof.

In one or more embodiments, the emitter may be a compound from Group FD1:

Group FD1

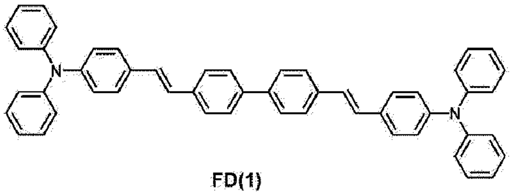

FD(1)

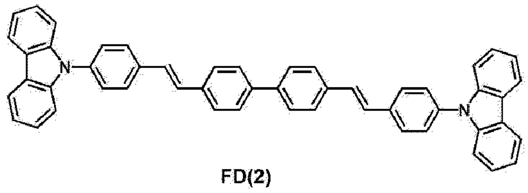

FD(2)

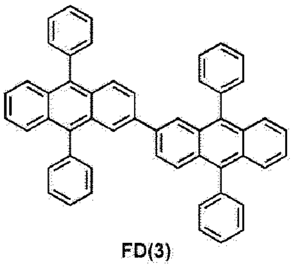

FD(3)

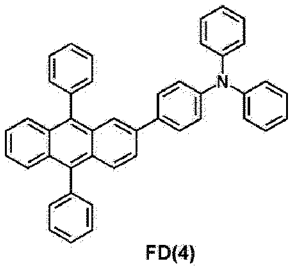

FD(4)

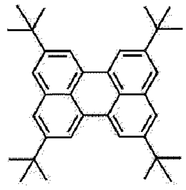

FD(5)

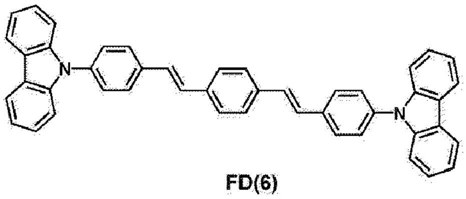

FD(6)

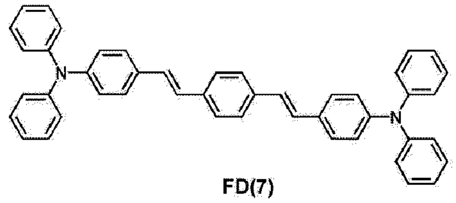

FD(7)

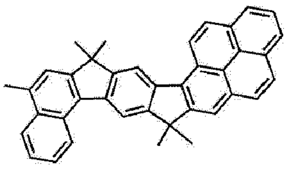

FD(8)

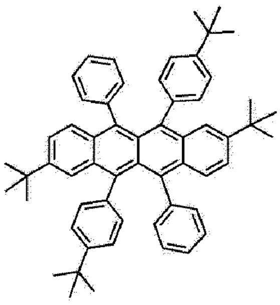

FD(9)

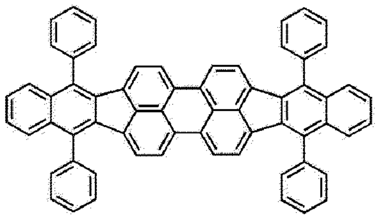

FD(10)

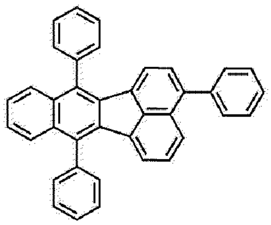
FD(11)

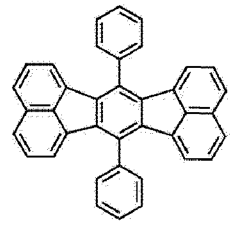
FD(12)

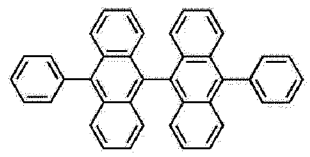
FD(13)

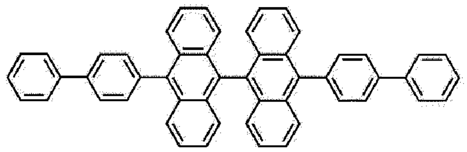
FD(14)

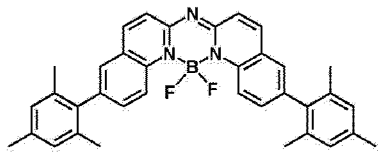
FD(15)

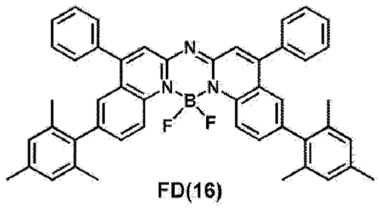
FD(16)

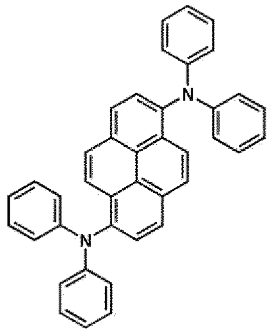
FD1

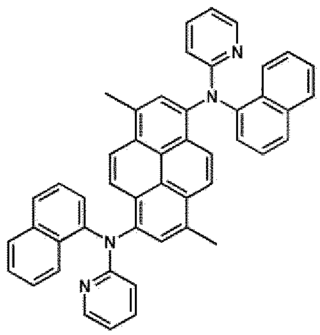
FD2

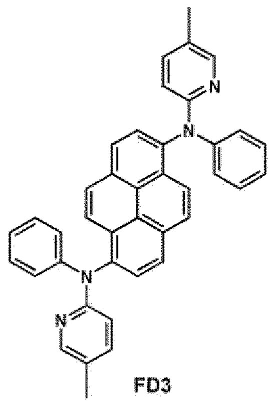
FD3

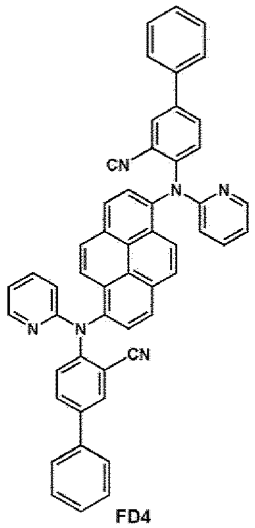
FD4

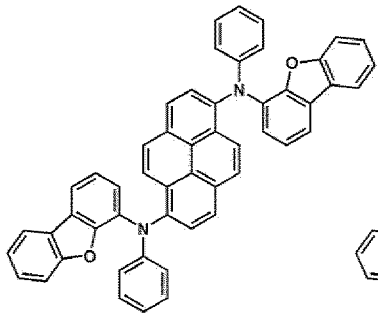
FD5

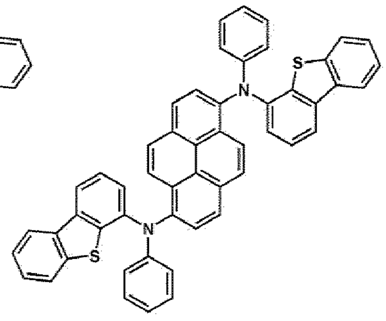
FD6

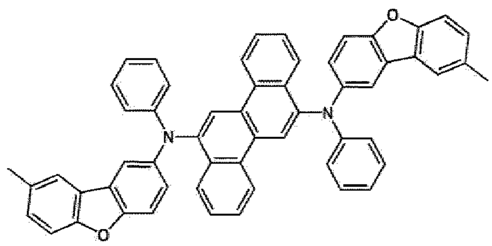

FD7

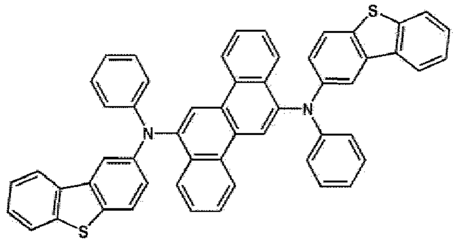

FD8

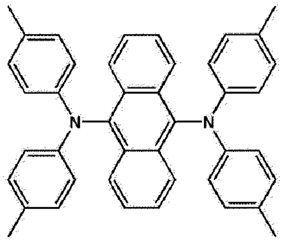

FD9

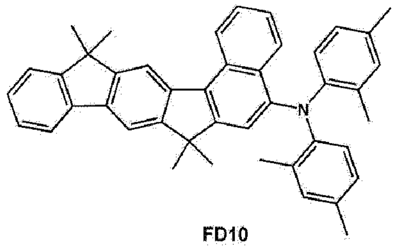

FD10

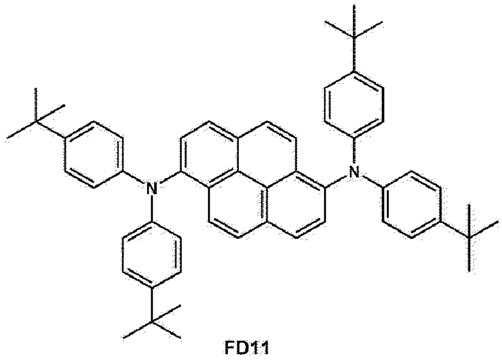

FD11

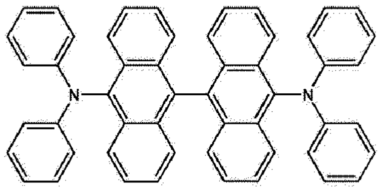

FD12

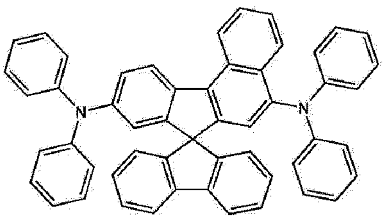

FD13

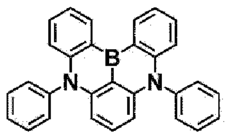

BD1-1

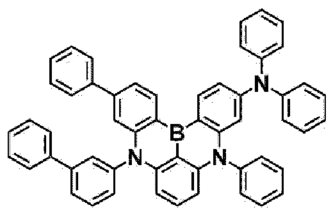

BD1-2

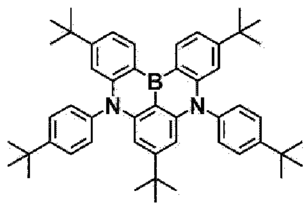

BD1-3

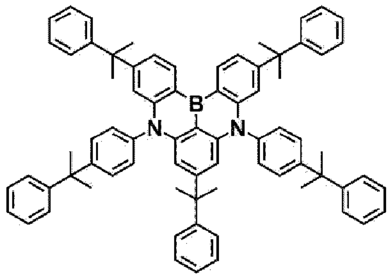

BD1-4

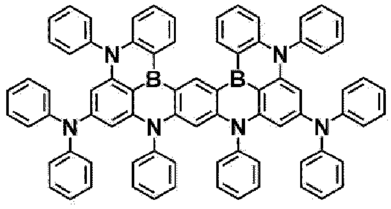

BD1-5

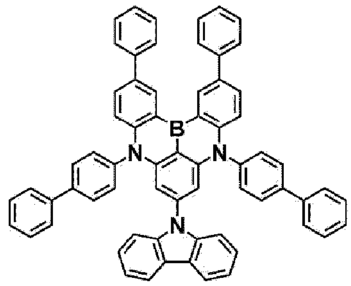

BD1-6

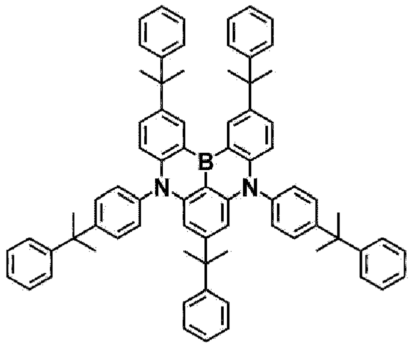

BD1-7

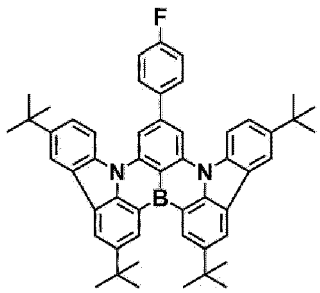

BD1-8

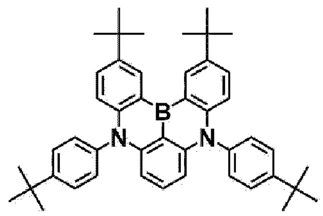

BD1-9

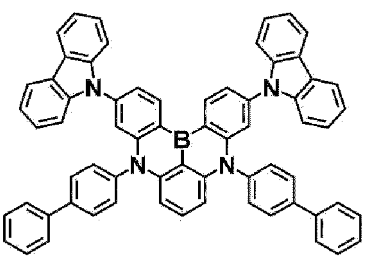

BD1-10

The maximum emission wavelength of the emission spectrum of the emitter may be at least about 400 nm but not more than about 650 nm. For example, the maximum emission wavelength of the emission spectrum of the emitter may be may be at least about 400 nm but not more than about 550 nm, at least about 410 nm but not more than about 495 nm, or at least about 450 nm but not more than about 495 nm, but embodiments are not limited thereto. The emitter may emit a blue light to a green light, for example, a blue light, but embodiments are not limited thereto. The term "maximum emission wavelength" as used herein refers to a wavelength of which the emission intensity is greatest, and may also be referred to as "peak emission wavelength."
The amount of the emitter in the emission layer may be about 0.01 wt% to about 15 wt%, based on total weight of the emission layer, but embodiments are not limited thereto.
In the emission layer, among the amounts of the host, the sensitizer, and the emitter, the amount of the host may be the greatest, and the amount of the emitter may be the smallest, but embodiments are not limited thereto.
The organic light-emitting device may satisfy Condition 1:

Condition 1

$$S_1(H) > S_1(S) \geq S_1(E)$$

wherein, in Condition 1,

$S_1(H)$ indicates a lowest excited singlet energy level of the host,
$S_1(S)$ indicates a lowest excited singlet energy level of the sensitizer, and
$S_1(E)$ indicates a lowest excited singlet energy level of the emitter.

$S_1(H)$, $S_1(S)$, and $S_1(E)$ may respectively be calculated from a photoluminescence (PL) spectrum obtained from a film having a thickness of 40 nm formed by vacuum-depositing the host, sensitizer, or emitter each on a quartz substrate at a vacuum degree of $10^{-7}$ torr.

When Condition 1 is satisfied, the emitter may emit a light, and the organic light-emitting device may have improved efficiency.

For example, when Condition 1 is satisfied, the emission ratio from the emitter in the organic light-emitting device may be about 85% or more. That is, when the above ratio is satisfied, in the organic light-emitting device, only the emitter may substantially emit light, and the host and the sensitizer may not substantially emit light.

Singlet and/or triplet excitons generated in the host may be transferred to the sensitizer, the triplet excitons in the sensitizer may be converted into singlet excitons through RISC, and then, the singlet excitons may be transferred to the emitter through FRET. Since all the singlet excitons and triplet excitons of the host may be transferred to the emitter, the organic light-emitting device may have significantly improved lifespan and efficiency.

The host and the sensitizer may satisfy Condition 2:

Condition 2

$$T_1(H) \geq T_1(S)$$

wherein, in Condition 2,

$T_1(H)$ indicates a lowest excited triplet energy level of the host, and
$T_1(S)$ indicates a lowest excited triplet energy level of the sensitizer.

Sensitizer in Emission Layer

The sensitizer may include at least one of the organometallic compounds represented by Formula 1.

In one or more embodiments, the sensitizer may further include a phosphorescent compound.

In one or more embodiments, the phosphorescent compound may include at least one metal.

In one or more embodiments, the phosphorescent compound may include at least one metal ($M_{11}$) that is a transition metal, and an organic ligand ($L_{11}$), and $L_{11}$ and $M_{11}$ may form 1, 2, 3, or 4 cyclometallated rings.

In one or more embodiments, the phosphorescent compound may be represented by Formula 101:

Formula 101 $$M_{11}(L_{11})_{n11}(L_{12})_{n12}$$

wherein, in Formula 101,

$M_{11}$ may be a transition metal,
$L_{11}$ may be a ligand represented by one of Formulae 1-1 to 1-4,
$L_{12}$ may be a monodentate ligand or a bidentate ligand,
n11 may be 1,
n12 may be 0, 1, or 2,

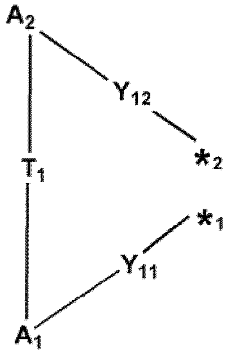

1-1

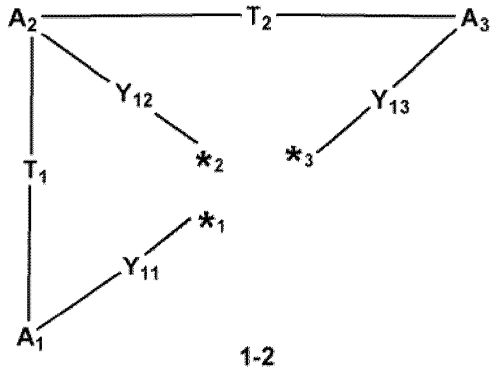

1-2

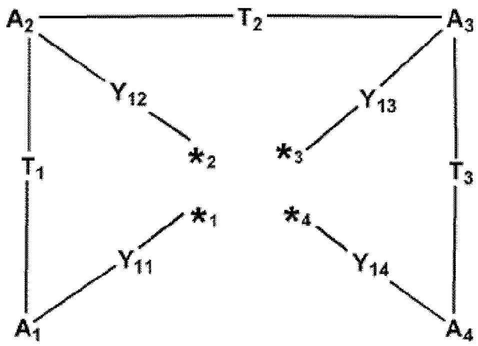

1-3

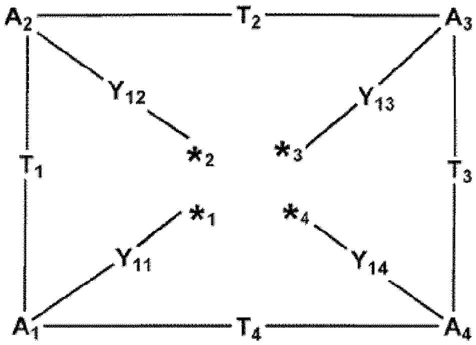

1-4

wherein, in Formulae 1-1 to 1-4,

$A_1$ to $A_4$ may each independently be a substituted or unsubstituted $C_5$-$C_{30}$ carbocyclic group, a substituted or unsubstituted $C_1$-$C_{30}$ heterocyclic group, or a non-cyclic group,

$Y_{11}$ to $Y_{14}$ may each independently be a chemical bond, O, S, $N(R_{91})$, $B(R_{91})$, $P(R_{91})$, or $C(R_{91})(R_{92})$,

$T_1$ to $T_4$ may each independently be a single bond, a double bond, *-N($R_{93}$)-*', *-B($R_{93}$)-*', *-P($R_{93}$)-*', *-C($R_{93}$)($R_{94}$)-*', *-Si($R_{93}$)($R_{94}$)-*', *-Ge($R_{93}$)($R_{94}$)-*', *-S-*', *-Se-*', *-O-*$^1$, *-C(=O)-*', *-S(=O)-*', *-S(=O)$_2$-*', *-C($R_{93}$)=*', *=C($R_{93}$)-*', *-C($R_{93}$)=C($R_{94}$)-*', *-C(=S)-*', or *-C≡C-*',

a substituent of the substituted $C_5$-$C_{30}$ carbocyclic group, a substituent of the substituted $C_1$-$C_{30}$ heterocyclic group, and $R_{91}$ to $R_{94}$ may each independently be hydrogen, deuterium, -F, -Cl, -Br, -I, -$SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent aromatic condensed polycyclic group, a substituted or unsubstituted monovalent aromatic condensed heteropolycyclic group, a substituted or unsubstituted monovalent non-aromatic condensed polycyclic group, a substituted or unsubstituted monovalent non-aromatic condensed heteropolycyclic group, -Si($Q_1$)($Q_2$)($Q_3$), -Ge($Q_1$)($Q_2$)($Q_3$), - C($Q_1$)($Q_2$)($Q_3$), -C(=O)($Q_1$), -S(=O)($Q_1$), -S(=O)$_2$($Q_1$), -N($Q_4$)($Q_5$), -B($Q_6$)($Q_7$), - P($Q_8$)($Q_9$), -P(=O)($Q_8$)($Q_9$), or -P(=S)($Q_8$)($Q_9$), wherein a substituent of the substituted $C_5$-$C_{30}$ carbocyclic group and a substituent of the substituted $C_1$-$C_{30}$ heterocyclic group may not each be hydrogen,

$*_1$, $*_2$, $*_3$, and $*_4$ each indicate a binding site to $M_{11}$, and

$Q_1$ to $Q_9$ may each independently be hydrogen, deuterium, -F, -Cl, -Br, -I, -SFs, a hydroxyl group, a cyano group, a

nitro group, an amino group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent aromatic condensed polycyclic group, a monovalent aromatic condensed heteropolycyclic group, a monovalent non-aromatic condensed polycyclic group, a monovalent non-aromatic condensed heteropolycyclic group, a $C_1$-$C_{60}$ alkyl group substituted with at least one of deuterium, -F, a cyano group, a $C_1$-$C_{60}$ alkyl group, or a $C_6$-$C_{60}$ aryl group, or a $C_6$-$C_{60}$ aryl group substituted with at least one of deuterium, -F, a cyano group, a $C_1$-$C_{60}$ alkyl group, or a $C_6$-$C_{60}$ aryl group.

In one or more embodiments, the transition metal may be platinum (Pt), palladium (Pd), gold (Au), iridium (Ir), osmium (Os), titanium (Ti), zirconium (Zr), hafnium (Hf), europium (Eu), terbium (Tb), thulium (Tm), or rhodium (Rh).

In one or more embodiments, the sensitizer may further include a delayed fluorescence compound.

In one or more embodiments, the delayed fluorescence compound may be represented by Formula 101 or 102, but embodiments are not limited thereto:

Formula 101

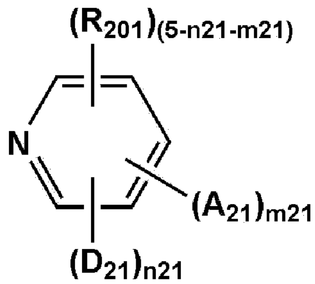

Formula 102

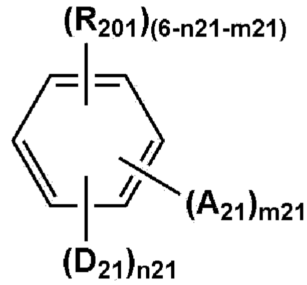

wherein, in Formulae 101 and 102,

$A_{21}$ may be an acceptor group,
$D_{21}$ may be a donor group,
m21 may be 1, 2, or 3, and n21 may be 1, 2, or 3,
the sum of n21 and m21 in Formula 101 may be 5 or less, and the sum of n21 and m21 in Formula 102 may be 6 or less,
$R_{201}$ may be hydrogen, deuterium, -F, -Cl, -Br, -I, -SFs, a hydroxyl group, a cyano group, a nitro group, an amino group, an amidino group, a hydrazino group, a hydrazono group, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-C(=O)(Q_1)$, $-S(=O)(Q_1)$, $-S(=O)_2(Q_1)$, $-N(Q_4)(Q_5)$, $-B(Q_6)(Q_7)$, $- P(Q_8)(Q_9)$, $-P(=O)(Q_8)(Q_9)$, or $-P(=S)(Q_8)(Q_9)$, wherein a plurality of $R_{201}$(s) may optionally be bonded to each other to form a substituted or unsubstituted Cs-$C_{30}$ carbocyclic group or a substituted or unsubstituted $C_1$-$C_{30}$ heterocyclic group,
$Q_1$ to $Q_9$ may each independently be hydrogen, deuterium, -F, -Cl, -Br, -I, $-SF_5$, a hydroxyl group, a cyano group, a nitro group, an amino group, an amidino group, a hydrazino group, a hydrazono group, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent aromatic condensed polycyclic group, a monovalent aromatic condensed

heteropolycyclic group, a monovalent non-aromatic condensed polycyclic group, a monovalent non-aromatic condensed heteropolycyclic group, a $C_1$-$C_{60}$ alkyl group substituted with at least one of deuterium, -F, a cyano group, a $C_1$-$C_{60}$ alkyl group, or a $C_6$-$C_{60}$ aryl group, or a $C_6$-$C_{60}$ aryl group substituted with at least one of deuterium, -F, a cyano group, a $C_1$-$C_{60}$ alkyl group, or a $C_6$-$C_{60}$ aryl group.

In one or more embodiments, in Formulae 101 and 102, $D_{21}$ may be a substituted or unsubstituted $\pi$ electron-deficient nitrogen-free ring group.

In one or more embodiments, the $\pi$ electron-deficient nitrogen-free ring group may be a benzene group, a heptalene group, an indene group, a naphthalene group, an azulene group, an indacene group, an acenaphthylene group, a fluorene group, a spiro-bifluorene group, a benzofluorene group, a dibenzofluorene group, a phenalene group, a phenanthrene group, an anthracene group, a fluoranthene group, a triphenylene group, a pyrene group, a chrysene group, a naphthacene group, a picene group, a perylene group, a pentaphene group, a hexacene group, a pentacene group, a rubicene group, a coronene group, an ovalene group, a pyrrole group, an isoindole group, an indole group, a furan group, a thiophene group, a benzofuran group, a benzothiophene group, a benzocarbazole group, a dibenzocarbazole group, a dibenzofuran group, a dibenzothiophene group, a dibenzothiophene sulfone group, a carbazole group, a dibenzosilole group, an indenocarbazole group, an indolocarbazole group, a benzofurocarbazole group, a benzothienocarbazole group, or a triindolobenzene group; or a condensed ring group of two or more $\pi$ electron-deficient nitrogen-free ring groups, but embodiments are not limited thereto.

In one or more embodiments, in Formulae 101 and 102, $A_{21}$ may be:

-F, a cyano group, or $\pi$ electron-deficient nitrogen-containing ring group;

a $C_1$-$C_{60}$ alkyl group, an $\pi$ electron-deficient nitrogen-containing ring group, or an $\pi$ electron-deficient nitrogen-free ring group, each substituted with at least one -F or a cyano group; or

an $\pi$ electron-deficient nitrogen-containing ring group substituted with at least one of deuterium, a $C_1$-$C_{60}$ alkyl group, an $\pi$ electron-deficient nitrogen-containing ring group, or an $\pi$ electron-deficient nitrogen-free ring group.

In one or more embodiments, the $\pi$ electron-deficient nitrogen-free ring group may be the same as described herein.

The term "$\pi$ electron-deficient nitrogen-containing ring group" as used herein refers to a ring group having at least one *-N=*' moiety, and, for example, may be an imidazole group, a pyrazole group, a thiazole group, an isothiazole group, an oxazole group, an isoxazole group, a pyridine group, a pyrazine group, a pyridazine group, a pyrimidine group, an indazole group, a purine group, a quinoline group, an isoquinoline group, a benzoquinoline group, a phthalazine group, a naphthyridine group, a quinoxaline group, a quinazoline group, a cinnoline group, a phenanthridine group, an acridine group, a phenanthroline group, a phenazine group, a benzimidazole group, an isobenzothiazole group, a benzoxazole group, an isobenzoxazole group, a triazole group, a tetrazole group, an oxadiazole group, a triazine group, a thiadiazole group, an imidazopyridine group, an imidazopyrimidine group, an azacarbazole group, or a benzimidazolobenzimidazole group; or a condensed ring group of two or more $\pi$ electron-deficient nitrogen-containing ring groups.

In one or more embodiments, the amount of the sensitizer in the organic layer may be greater than an amount of the emitter in the organic layer, based on volume. For example, the volume ratio of the sensitizer to the emitter may be about 30:0.1 to about 10:3, or about 10:0.1 to about 20:5. For example, the weight ratio of the sensitizer to the emitter may be in a range of about 10:0.1 to about 20:5. The volume ratio of the host to the sensitizer in the organic layer may be in a range of about 60:40 to about 95:5, or about 70:30 to about 90:10. In one or more embodiments, the weight ratio of the host to the sensitizer may be about 60:40 to about 95:5. When the above amount ranges are satisfied, the organic light-emitting device may have improved luminescence efficiency and/or lifespan characteristics.

FIG. 1 is a schematic cross-sectional view of an organic light-emitting device 10 according to one or more embodiments. Hereinafter, the structure and manufacturing method of the organic light-emitting device 10 according to one or more embodiments will be described with reference to the FIG. 1. The organic light-emitting device 10 has a structure in which a first electrode 11, an organic layer 15, and a second electrode 19 are sequentially stacked in the stated order.

A substrate may be additionally arranged under the first electrode 11 or on the second electrode 19. For use as the substrate, any suitable substrate that is used in organic light-emitting devices available in the art may be used, and the substrate may be a glass substrate or a transparent plastic substrate, each having excellent mechanical strength, thermal stability, transparency, surface smoothness, ease of handling, and/or water resistance.

The first electrode 11 may be formed by, for example, depositing or sputtering, onto the substrate, a material for forming the first electrode 11. The first electrode 11 may be an anode. The material for forming the first electrode 11 may be selected from materials with a high work function to facilitate hole injection. The first electrode 11 may be a reflective electrode, a semi-transmissive electrode, or a transmissive electrode. The material for forming the first electrode 11 may be indium tin oxide (ITO), indium zinc oxide (IZO), tin oxide ($SnO_2$), or zinc oxide (ZnO). In one or more embodiments, the

material for forming the first electrode 11 may be metal, such as magnesium (Mg), aluminum (Al), silver (Ag), aluminum-lithium (Al-Li), calcium (Ca), magnesium-indium (Mg-In), or magnesium-silver (Mg-Ag).

The first electrode 11 may have a single-layer structure or a multi-layer structure including two or more layers. For example, the first electrode 11 may have a three-layer structure of ITO/Ag/ITO, but embodiments are not limited thereto.

The organic layer 15 is arranged on the first electrode 11.

The organic layer 15 may include a hole transport region, an emission layer, an electron transport region, or a combination thereof.

The hole transport region may be arranged between the first electrode 11 and the emission layer.

The hole transport region may include a hole injection layer, a hole transport layer, an electron-blocking layer, a buffer layer, or a combination thereof.

The hole transport region may include a hole injection layer only or a hole transport layer only. In one or more embodiments, the hole transport region may have a hole injection layer/hole transport layer structure or a hole injection layer/hole transport layer/electron-blocking layer structure, wherein constituent layers of each structure are sequentially stacked in the stated order from the first electrode 11.

When the hole transport region includes a hole injection layer, the hole injection layer may be formed on the first electrode 11 by using one or more suitable methods, such as vacuum deposition, spin coating, casting, or Langmuir-Blodgett (LB) deposition, but embodiments are not limited thereto.

When the hole injection layer is formed by vacuum deposition, the deposition conditions may vary according to a material that is used to form the hole injection layer and the structure and thermal characteristics of the hole injection layer. For example, the deposition conditions may include a deposition temperature of about 100°C to about 500°C, a vacuum pressure in a range of about $10^{-8}$ torr to about $10^{-3}$ torr, and a deposition rate in a range of about 0.01 angstroms per second (Å/sec) to about 100 Å/sec, but embodiments are not limited thereto.

When the hole injection layer is formed by spin coating, the coating conditions may vary according to a material that is used to form the hole injection layer and the structure and thermal characteristics of the hole injection layer. For example, the coating conditions may include a coating speed in a range of about 2,000 revolutions per minute (rpm) to about 5,000 rpm and a heat treatment temperature for removing a solvent after coating of about 80°C to about 200°C, but embodiments are not limited thereto.

The conditions for forming the hole transport layer and the electron-blocking layer may be similar to or the same as the conditions for forming the hole injection layer.

The hole transport region may include, for example, at least one of 4,4',4"-tris(3-methylphenylphenylamino) triphenylamine (m-MTDATA), 4,4',4"-tris(N,N-diphenylamino)triphenylamine (TDATA), 4,4',4"-tris{N-(2-naphthyl)-N-phenylamino}-triphenylamine (2-TNATA), N,N'-di(1-naphthyl)-N,N'-diphenylbenzidine (NPB), β-NPB, N,N'-bis(3-methylphenyl)-N,N'-diphenyl-[1,1-biphenyl]-4,4'-diamine (TPD), Spiro-TPD, Spiro-NPB, methylated NPB, 4,4'-cyclohexylidene bis [N,N-bis(4-methylphenyl)benzenamine] (TAPC), 4,4'-bis[N,N'-(3-tolyl)amino]-3,3'-dimethylbiphenyl (HMTPD), 4,4',4"-tris(N-carbazolyl)triphenylamine (TCTA), polyaniline/dodecylbenzenesulfonic acid (PANI/DBSA), poly(3,4-ethylenedioxythiophene)/poly(4-styrenesulfonate) (PEDOT/PSS), polyaniline/camphor sulfonic acid (PANI/CSA), polyaniline/poly(4-styrenesulfonate) (PANI/PSS), a compound represented by Formula 201, or a compound represented by Formula 202, but embodiments are not limited thereto:

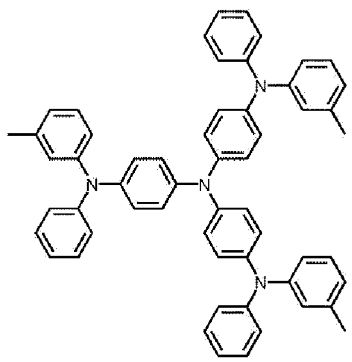

m-MTDATA

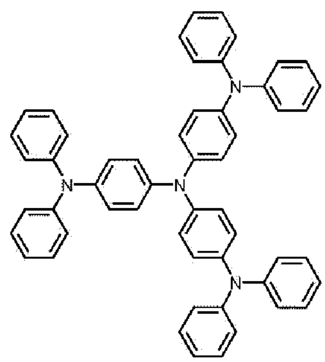

TDATA

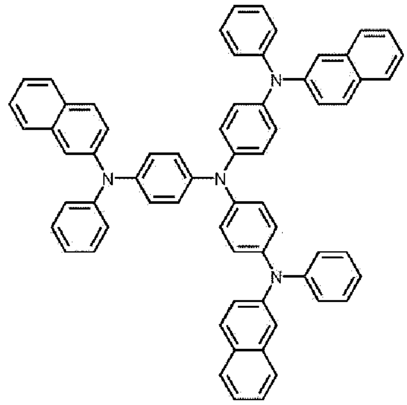

2-TNATA

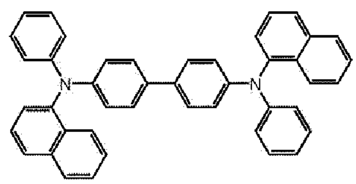

NPB

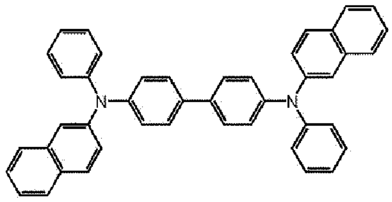

β-NPB

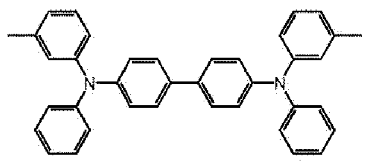

TPD

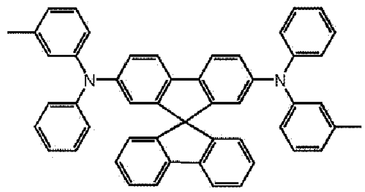

Spiro-TPD

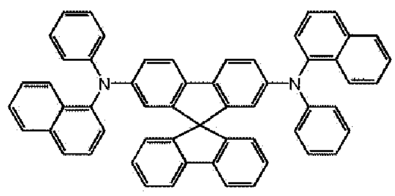

Spiro-NPB

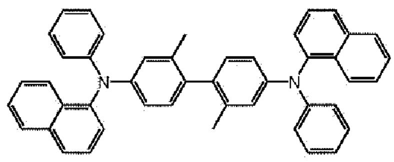

methylated NPB

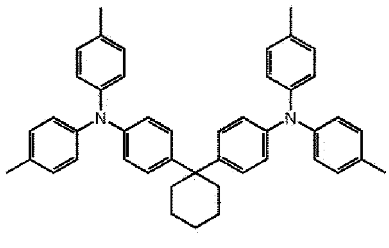

TAPC

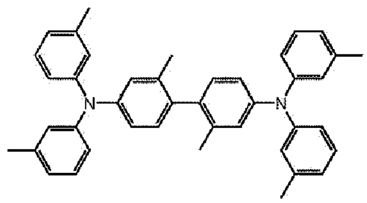

HMTPD

Formula 201

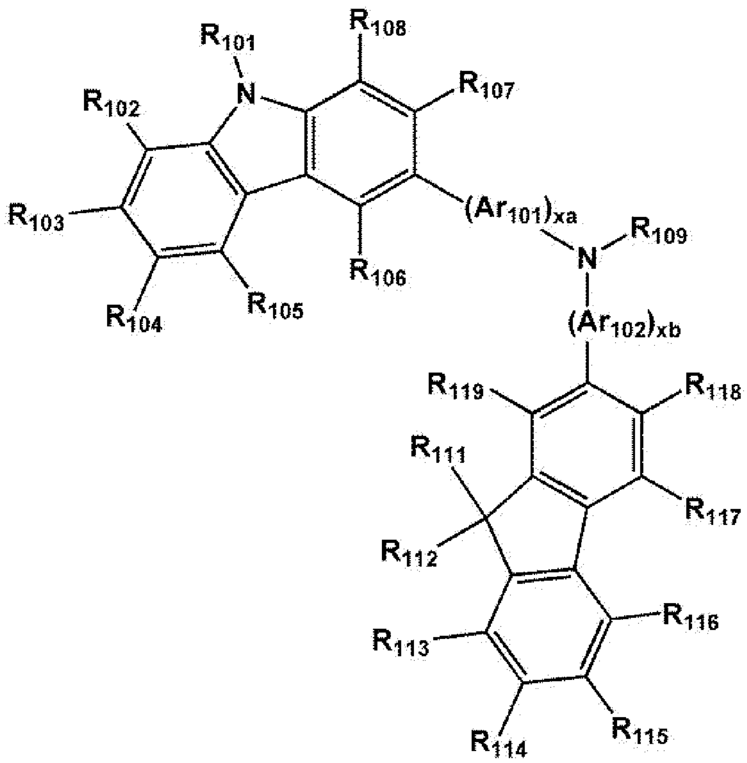

Formula 202

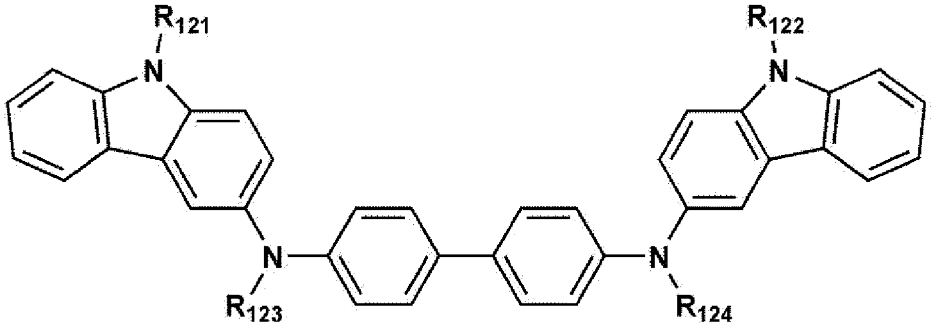

wherein, in Formula 201, $Ar_{101}$ and $Ar_{102}$ may each independently be:

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group; or

a phenylene group, a pentalenylene group, an indenylene group, a naphthylene group, an azulenylene group, a heptalenylene group, an acenaphthylene group, a fluorenylene group, a phenalenylene group, a phenanthrenylene group, an anthracenylene group, a fluoranthenylene group, a triphenylenylene group, a pyrenylene group, a chrysenylenylene group, a naphthacenylene group, a picenylene group, a perylenylene group, or a pentacenylene group, each substituted with at least one of deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_3$-$C_{10}$ cycloalkenyl group, a $C_1$-$C_{10}$ heterocycloalkyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, or a combination thereof.

In Formula 201, xa and xb may each independently be an integer from 0 to 5, or may each independently be 0, 1, or 2. For example, xa may be 1, and xb may be 0, but embodiments are not limited thereto.

In Formulae 201 and 202, $R_{101}$ to $R_{108}$, $R_{111}$ to $R_{119}$, and $R_{121}$ to $R_{124}$ may each independently be:

hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group (for example, a methyl group, an ethyl group, a propyl group, a butyl group, a pentyl group, a hexyl group, or the like), a $C_1$-$C_{10}$ alkoxy group (for example, a methoxy group, an ethoxy group, a propoxy group, a butoxy group, a pentoxy group, or the like), or a $C_1$-$C_{10}$ alkylthio group;

a $C_1$-$C_{10}$ alkyl group, a $C_1$-$C_{10}$ alkoxy group, or a $C_1$-$C_{10}$ alkylthio group, each substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, or a combination thereof;

a phenyl group, a naphthyl group, an anthracenyl group, a fluorenyl group, or a pyrenyl group; or

a phenyl group, a naphthyl group, an anthracenyl group, a fluorenyl group, or a pyrenyl group, each substituted with at least one of deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{10}$ alkyl group, a $C_1$-$C_{10}$ alkoxy group, a $C_1$-$C_{10}$ alkylthio group, or a combination thereof, but embodiments are not limited thereto.

In Formula 201, $R_{109}$ may be:

a phenyl group, a naphthyl group, an anthracenyl group, or a pyridinyl group; or

a phenyl group, a naphthyl group, an anthracenyl group, or a pyridinyl group, each substituted with at least one of

deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, a $C_1$-$C_{20}$ alkylthio group, a phenyl group, a naphthyl group, an anthracenyl group, a pyridinyl group, or a combination thereof.

In one or more embodiments, the compound represented by Formula 201 may be represented by Formula 201A, but embodiments are not limited thereto:

Formula 201A

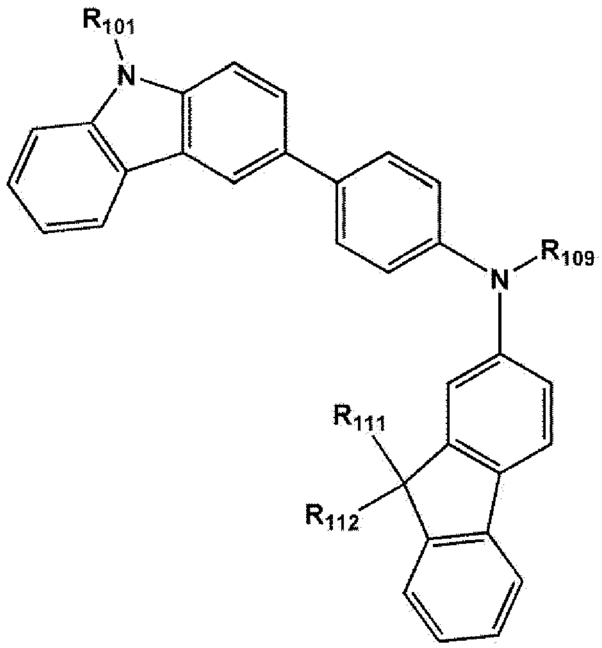

wherein, in Formula 201A, $R_{101}$, $R_{111}$, $R_{112}$, and $R_{109}$ may each be the same as described herein.

In one or more embodiments, the compounds represented by Formula 201 and 202 may include at least one of Compounds HT1 to HT20, but embodiments are not limited thereto:

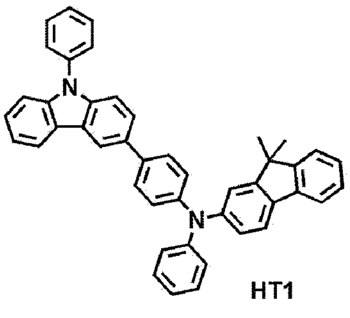

HT1

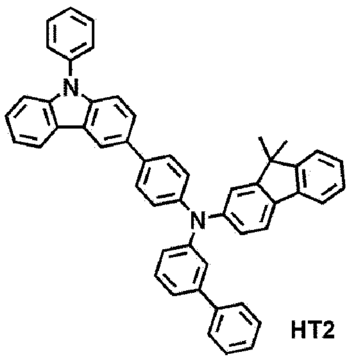

HT2

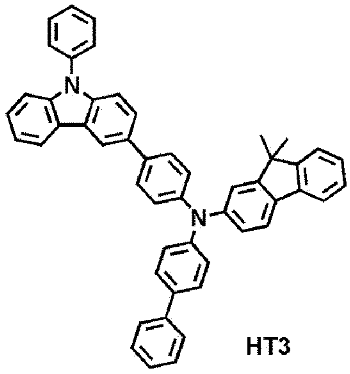

HT3

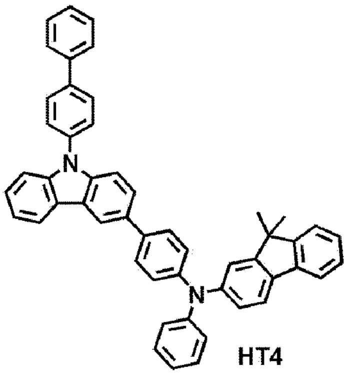
HT4

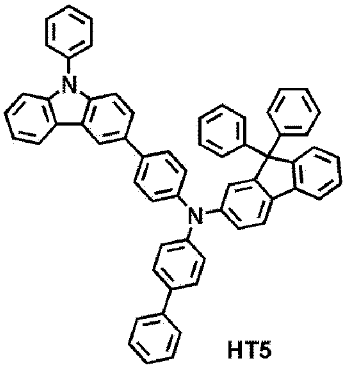
HT5

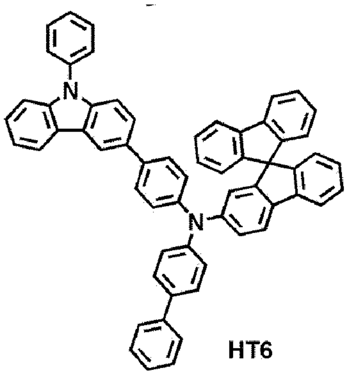
HT6

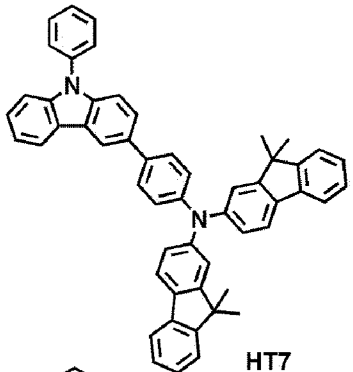
HT7

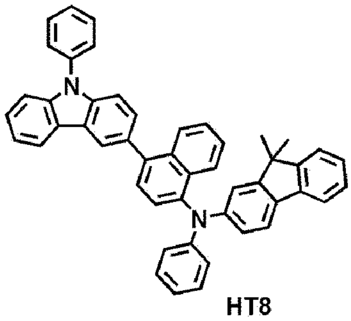
HT8

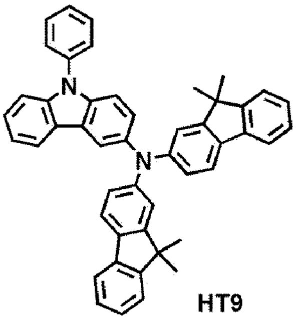
HT9

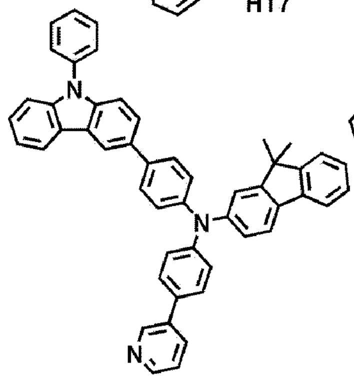
HT10

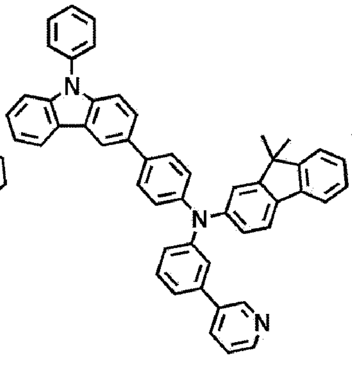
HT11

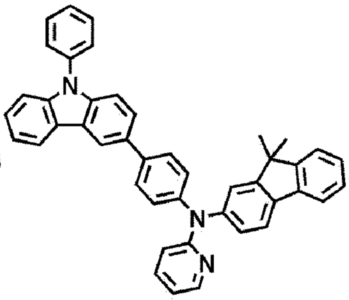
HT12

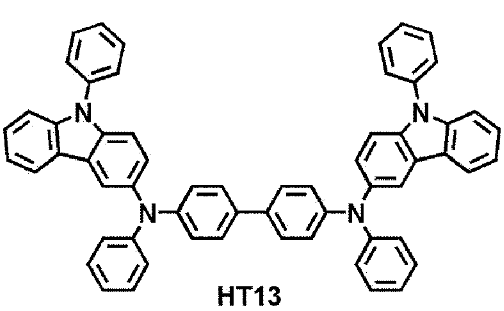
HT13

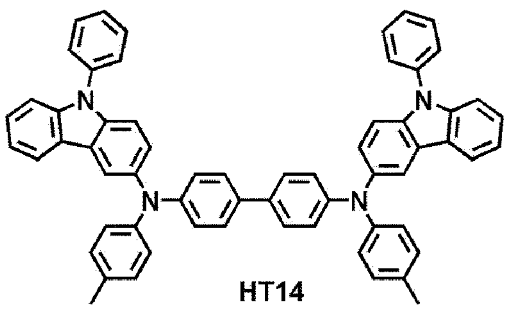
HT14

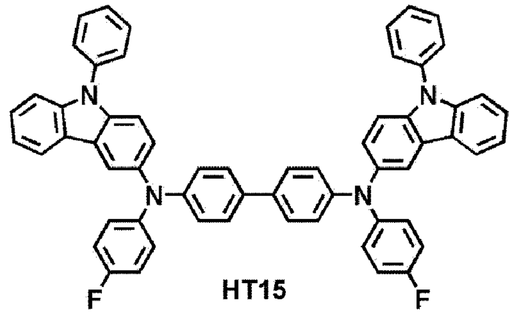

HT15

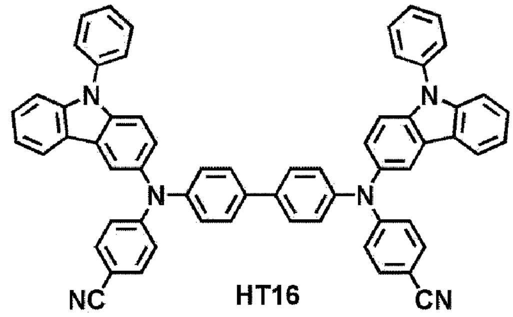

HT16

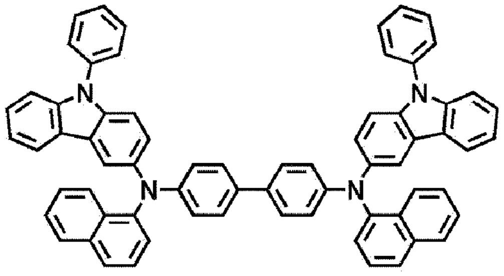

HT17

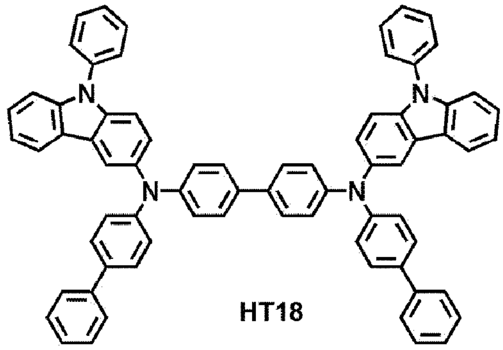

HT18

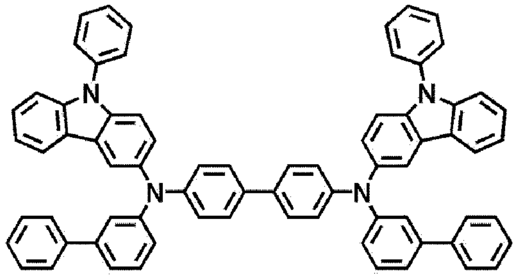

HT19

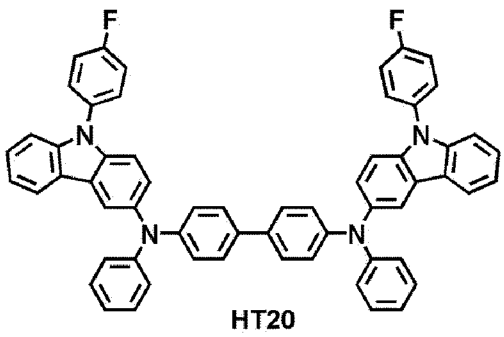

HT20

The thickness of the hole transport region may be about 100 Å to about 10,000 Å, for example, about 100 Å to about 1,000 Å. When the hole transport region includes at least one of a hole injection layer and a hole transport layer, the thickness of the hole injection layer may be about 100 Å to about 10,000 Å, for example, about 100 Å to about 1,000 Å, and the thickness of the hole transport layer may be about 50 Å to about 2,000 Å, for example, about 100 Å to about 1,500 Å. When the thicknesses of the hole transport region, the hole injection layer, and the hole transport layer are within the above ranges, satisfactory hole-transporting characteristics may be obtained without a substantial increase in driving voltage.

The hole transport region may further include, in addition to the materials described above, a charge-generation material for improving conductive properties. The charge-generation material may be homogeneously or non-homogeneously dispersed in the hole transport region.

The charge-generation material may be, for example, a p-dopant. The p-dopant may include one of a quinone derivative, a metal oxide, or a cyano group-containing compound, but embodiments are not limited thereto. Non-limiting examples of the p-dopant include a quinone derivative, such as tetracyanoquinodimethane (TCNQ), 2,3,5,6-tetrafluoro-tetracyano-1,4-benzoquinonedimethane (F4-TCNQ), 1,4,5,8,9,11-hexaazatriphenylene-hexacarbonitrile (HAT-CN), 1,3,4,5,7,8-hexafluorotetracyanonaphthoquinodimethane (F6-TCNNQ), or the like; a metal oxide, such as a tungsten oxide, a molybdenum oxide, or the like; or a cyano group-containing compound, such as Compound HT-D1 or F12, but embodiments are not limited thereto:

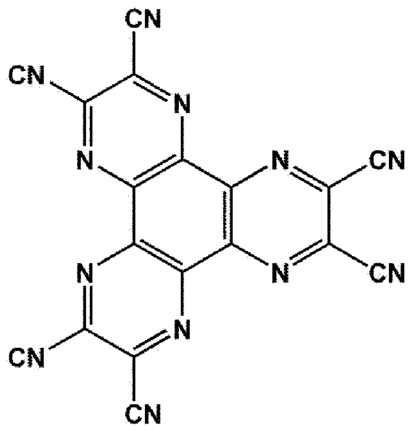

HT-D1

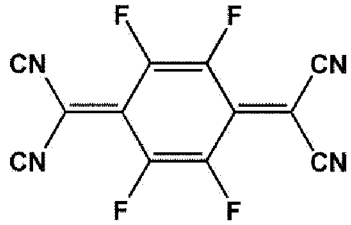

F4-TCNQ

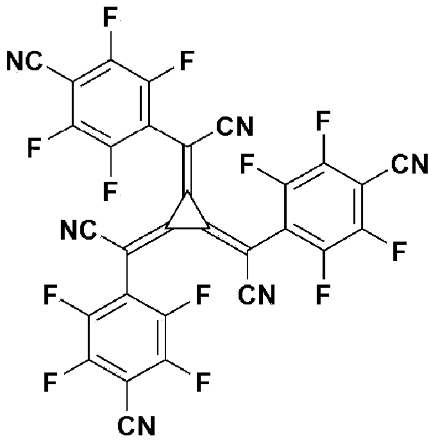

F12

The hole transport region may include a buffer layer.

The buffer layer may compensate for an optical resonance distance according to a wavelength of light emitted from the emission layer, and thus, the efficiency of a formed organic light-emitting device may be improved.

The emission layer may be formed on the hole transport region by using one or more suitable methods, such as vacuum deposition, spin coating, casting, or LB deposition, but embodiments are not limited thereto. When the emission layer is formed by vacuum deposition or spin coating, the deposition or coating conditions may be similar to those applied in forming the hole injection layer, though the deposition or coating conditions may vary according to a material that is used.

When the hole transport region includes an electron-blocking layer, a material for forming the electron-blocking layer may be selected from materials for forming the hole transport region described above and host materials described below, but embodiments are not limited thereto. For example, when the hole transport region includes an electron-blocking layer, a material for forming the electron-blocking layer may be mCP, which will be described below.

When the organic light-emitting device 10 is a full-color organic light-emitting device, the emission layer may be patterned into a red emission layer, a green emission layer, and/or a blue emission layer. In one or more embodiments, due to a stacked structure including a red emission layer, a green emission layer, and/or a blue emission layer, the emission layer may emit a white light, and various modifications are possible.

When the emission layer includes a host and a dopant, the amount of the dopant may be about 0.01 parts by weight to about 15 parts by weight, based on 100 parts by weight of the host, but embodiments are not limited thereto.

The thickness of the emission layer may be about 100 Å to about 1,000 Å, for example, about 200 Å to about 600 Å. When the thickness of the emission layer is within the above ranges, excellent luminescence characteristics may be obtained without a substantial increase in driving voltage.

Next, the electron transport region is arranged on the emission layer.

The electron transport region may include a hole-blocking layer, an electron transport layer, an electron injection layer, or a combination thereof.

In one or more embodiments, the electron transport region may have a hole-blocking layer/electron transport

layer/electron injection layer structure or an electron transport layer/electron injection layer structure, but embodiments are not limited thereto. The electron transport layer may have a single-layer structure or a multi-layer structure including two or more different materials.

The conditions for forming the hole-blocking layer, the electron transport layer, and the electron injection layer may be similar to or the same as the conditions for forming the hole injection layer.

When the electron transport region includes a hole-blocking layer, the hole-blocking layer may include, for example, at least one of 2,9-dimethyl-4,7-diphenyl-1,10-phenanthroline (BCP), 4,7-diphenyl-1,10-phenanthroline (Bphen), or bis(2-methyl-8-quinolinolato-N1,08)-(1,1'-biphenyl-4-olato)aluminum (BAlq), but embodiments are not limited thereto:

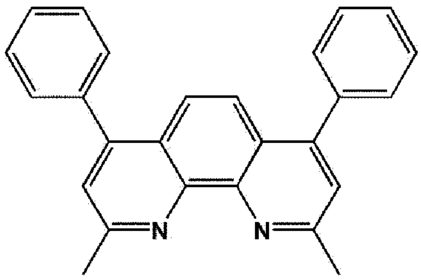

BCP

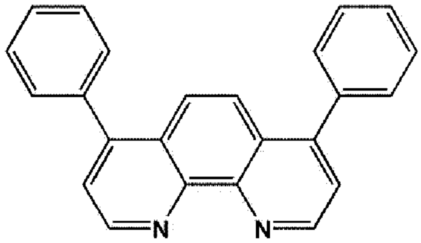

Bphen

.

The thickness of the hole-blocking layer may be about 20 Å to about 1,000 Å, for example, about 30 Å to about 300 Å. When the thickness of the hole-blocking layer is within the above ranges, excellent hole-blocking characteristics may be obtained without a substantial increase in driving voltage.

The electron transport layer may further include at least one of 2,9-dimethyl-4,7-diphenyl-1,10-phenanthroline (BCP), 4,7-diphenyl-1,10-phenanthroline (Bphen), tris(8-hydroxy-quinolinato)aluminum ($Alq_3$), bis(2-methyl-8-quinolinolato-N1,O8)-(1,1'-biphenyl-4-olato)aluminum (BAlq), 3-(4-biphenylyl)-4-phenyl-5-tert-butylphenyl-1,2,4-triazole (TAZ), or 4-(naphthalen-1-yl)-3,5-diphenyl-4H-1,2,4-triazole (NTAZ), but embodiments are not limited thereto:

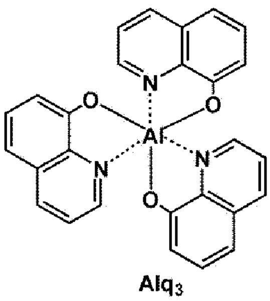

$Alq_3$

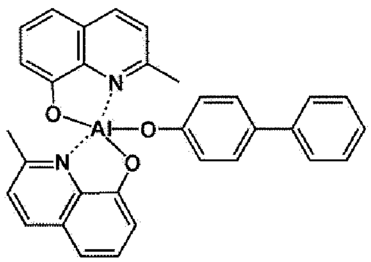

BAlq

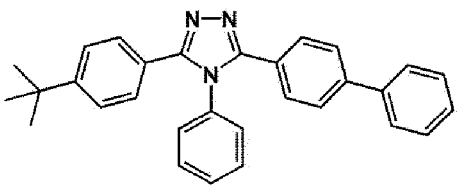

TAZ

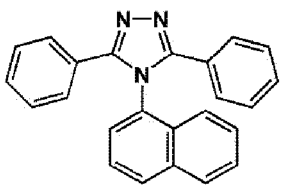

NTAZ

.

In one or more embodiments, the electron transport layer may include at least one of Compounds ET1 to ET25, but embodiments are not limited thereto:

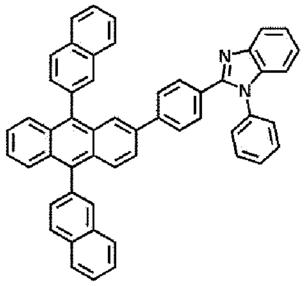

ET1

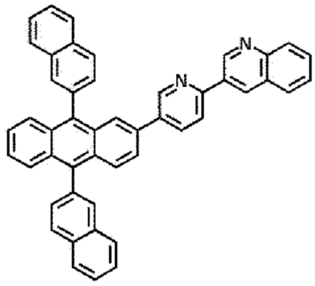

ET2

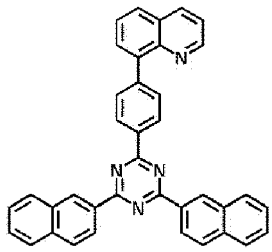

ET3

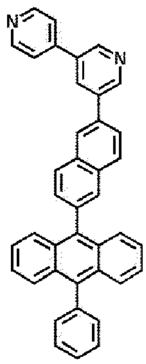

ET4

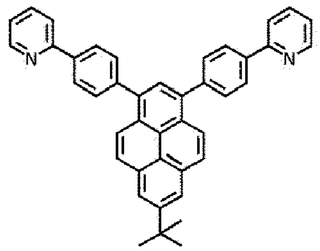

ET5

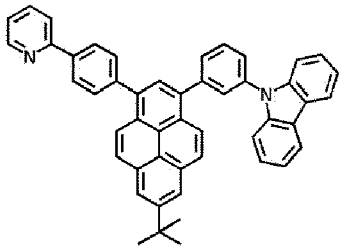

ET6

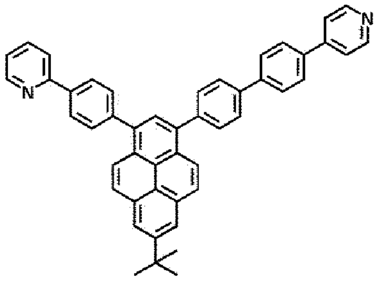

ET7

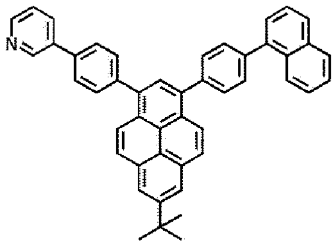

ET8

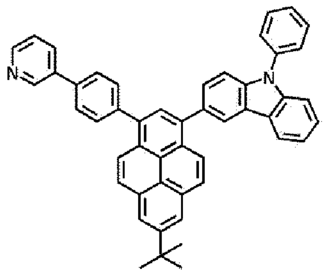

ET9

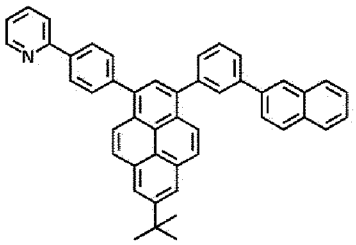

ET10

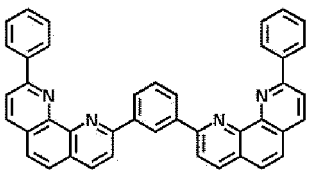

ET11

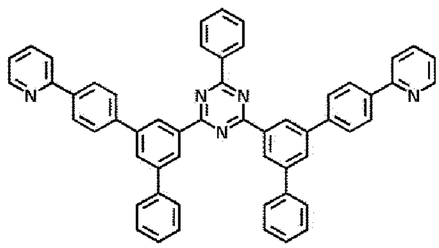

ET12

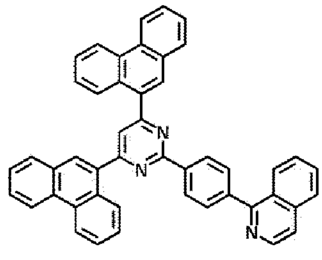

ET13

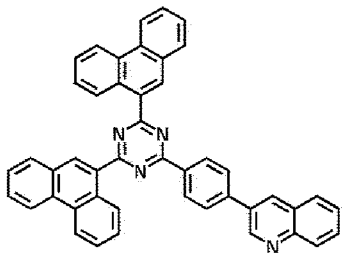

ET14

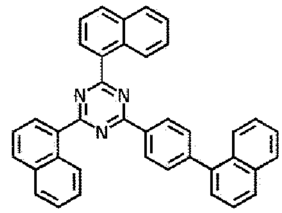

ET15

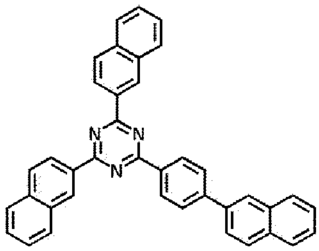

ET16

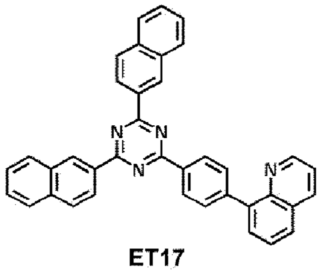

ET17

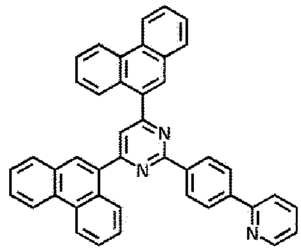

ET18

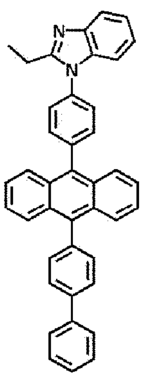

ET19

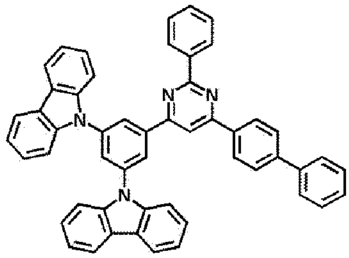

ET20

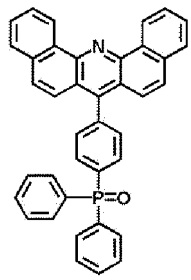

ET21

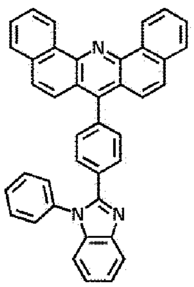

ET22

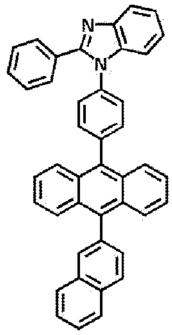

ET23

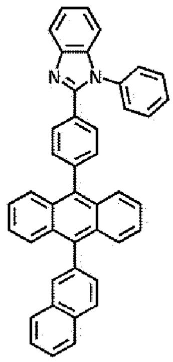

ET24

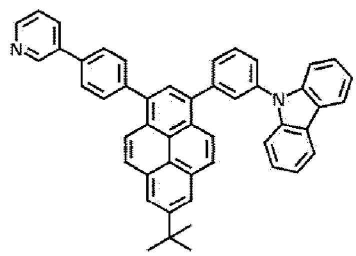

ET25

.

The thickness of the electron transport layer may be about 100 Å to about 1,000 Å, for example, about 150 Å to about 500 Å. When the thickness of the electron transport layer is within the above ranges, satisfactory electron-transporting characteristics may be obtained without a substantial increase in driving voltage.

The electron transport layer may further include, in addition to the materials described above, a metal-containing material.

The metal-containing material may include a Li complex. The Li complex may include, for example, Compound

ET-D1 ("lithium quinolate", LiQ) or ET-D2:

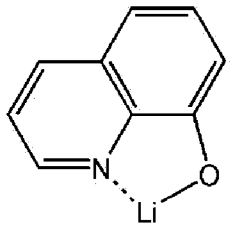

ET-D1

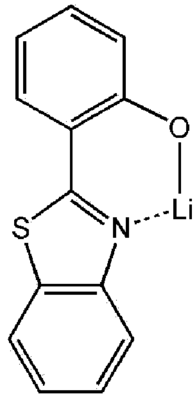

ET-D2

The electron transport region may include an electron injection layer that facilitates electron injection from the second electrode 19.

The electron injection layer may include LiF, NaCl, CsF, $Li_2O$, BaO, or a combination thereof.

The thickness of the electron injection layer may be about 1 Å to about 100 Å, for example, about 3 Å to about 90 Å. When the thickness of the electron injection layer is within the above ranges, satisfactory electron injection characteristics may be obtained without a substantial increase in driving voltage.

Second Electrode 19

The second electrode 19 is arranged on the organic layer 15. The second electrode 19 may be a cathode. A material for forming the second electrode 19 may be a metal, an alloy, an electrically conductive compound, or a combination thereof, which has a relatively low work function. For example, lithium (Li), magnesium (Mg), aluminum (Al), silver (Ag), aluminum-lithium (Al-Li), calcium (Ca), magnesium-indium (Mg-In), or magnesium-silver (Mg-Ag) may be used as the material for forming the second electrode 19. In one or more embodiments, to manufacture a top-emission type light-emitting device, a transmissive electrode formed using ITO or IZO may be used as the second electrode 19.

Hereinbefore, the organic light-emitting device 10 has been described with reference to FIG. 1, but embodiments are not limited thereto.

Another aspect provides an electronic apparatus including the organic light-emitting device.

The electronic apparatus may further include a thin-film transistor, in addition to the organic light-emitting device as described herein. The thin-film transistor may include a source electrode, a drain electrode, and an activation layer, wherein any one of the source electrode or the drain electrode may be electrically connected to any one of the first electrode or the second electrode of the organic light-emitting device.

Another aspect of the disclosure provides a diagnostic composition including at least one of the organometallic compounds represented by Formula 1.

The diagnostic composition may include at least one organometallic compound represented by Formula 1.

Since the organometallic compound represented by Formula 1 provides high luminescence efficiency, the diagnostic composition including at least one of the organometallic compounds represented by Formula 1 may have excellent diagnostic efficiency.

The diagnostic composition may be used in various applications, such as a diagnosis kit, a diagnosis reagent, a biosensor, a biomarker, or the like, but embodiments are not limited thereto.

The term "$C_1$-$C_{60}$ alkyl group" as used herein refers to a linear or branched saturated aliphatic hydrocarbon monovalent group having 1 to 60 carbon atoms. The term "$C_1$-$C_{60}$ alkylene group" as used herein refers to a divalent group having the same structure as the $C_1$-$C_{60}$ alkyl group.

Non-limiting examples of the $C_1$-$C_{60}$ alkyl group, the $C_1$-$C_{20}$ alkyl group, and/or the $C_1$-$C_{10}$ alkyl group include a methyl group, an ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, or a tert-decyl group, each unsubstituted or substituted with at least one of a methyl group, an

ethyl group, an n-propyl group, an isopropyl group, an n-butyl group, a sec-butyl group, an isobutyl group, a tert-butyl group, an n-pentyl group, a tert-pentyl group, a neopentyl group, an isopentyl group, a sec-pentyl group, a 3-pentyl group, a sec-isopentyl group, an n-hexyl group, an isohexyl group, a sec-hexyl group, a tert-hexyl group, an n-heptyl group, an isoheptyl group, a sec-heptyl group, a tert-heptyl group, an n-octyl group, an isooctyl group, a sec-octyl group, a tert-octyl group, an n-nonyl group, an isononyl group, a sec-nonyl group, a tert-nonyl group, an n-decyl group, an isodecyl group, a sec-decyl group, a tert-decyl group, or a combination thereof. For example, Formula 9-33 is a branched $C_6$ alkyl group, for example, a tert-butyl group substituted with two methyl groups.

The term "$C_1$-$C_{60}$ alkoxy group" as used herein refers to a monovalent group represented by -$OA_{101}$ (wherein $A_{101}$ is the $C_1$-$C_{60}$ alkyl group). Non-limiting examples of the $C_1$-$C_{60}$ alkoxy group, the $C_1$-$C_{20}$ alkoxy group, or the $C_1$-$C_{10}$ alkoxy group include a methoxy group, an ethoxy group, a propoxy group, a butoxy group, a pentoxy group, or the like. The term "$C_1$-$C_{60}$ alkylthio group" used herein refers to a monovalent group represented by -$SA_{101'}$ (wherein $A_{101'}$ is the $C_1$-$C_{60}$ alkyl group).

The term "$C_2$-$C_{60}$ alkenyl group" as used herein refers to a hydrocarbon group formed by substituting at least one carbon-carbon double bond in the middle or at the terminus of the $C_2$-$C_{60}$ alkyl group, and non-limiting examples thereof include an ethenyl group, a propenyl group, a butenyl group, or the like. The term "$C_2$-$C_{60}$ alkenylene group" as used herein refers to a divalent group having the same structure as the $C_2$-$C_{60}$ alkenyl group.

The term "$C_2$-$C_{60}$ alkynyl group" as used herein refers to a hydrocarbon group formed by substituting at least one carbon-carbon triple bond in the middle or at the terminus of the $C_2$-$C_{60}$ alkyl group, and non-limiting examples thereof include an ethynyl group, a propynyl group, or the like. The term "$C_2$-$C_{60}$ alkynylene group" as used herein refers to a divalent group having the same structure as the $C_2$-$C_{60}$ alkynyl group.

The term "$C_3$-$C_{10}$ cycloalkyl group" as used herein refers to a monovalent saturated hydrocarbon group having 3 to 10 carbon atoms. The term "$C_3$-$C_{10}$ cycloalkylene group" as used herein refers to a divalent group having the same structure as the $C_3$-$C_{10}$ cycloalkyl group.

Non-limiting examples of the $C_3$-$C_{10}$ cycloalkyl group include a cyclopropyl group, a cyclobutyl group, a cyclopentyl group, a cyclohexyl group, a cycloheptyl group, a cyclooctyl group, an adamantanyl group, a bicyclo [1.1.1]pentyl group, a bicyclo[2.1.1]hexyl group, a bicyclo[2.2.1]heptyl(norbornanyl) group, a bicyclo[2.2.2]octyl group, or the like.

The term "$C_1$-$C_{10}$ heterocycloalkyl group" as used herein refers to a monovalent group having at least one heteroatom selected from B, N, O, P, Si, S, Se, and Ge as a ring-forming atom and 1 to 10 carbon atoms as ring-forming atom(s). The term "$C_1$-$C_{10}$ heterocycloalkylene group" as used herein refers to a divalent group having the same structure as the $C_1$-$C_{10}$ heterocycloalkyl group.

Non-limiting examples of the $C_1$-$C_{10}$ heterocycloalkyl group include a silolanyl group, a silinanyl group, tetrahydrofuranyl group, a tetrahydro-2H-pyranyl group, a tetrahydrothiophenyl group, and the like.

The term "$C_3$-$C_{10}$ cycloalkenyl group" as used herein refers to a monovalent group that has 3 to 10 carbon atoms, at least one carbon-carbon double bond in its ring, and no aromaticity, and non-limiting examples thereof include a cyclopentenyl group, a cyclohexenyl group, a cycloheptenyl group, or the like. The term "$C_3$-$C_{10}$ cycloalkenylene group" as used herein refers to a divalent group having the same structure as the $C_3$-$C_{10}$ cycloalkenyl group.

The term "$C_1$-$C_{10}$ heterocycloalkenyl group" as used herein refers to a monovalent group that has at least one heteroatom selected from B, N, O, P, Si, S, Se, and Ge as a ring-forming atom, 1 to 10 carbon atoms as ring-forming atom(s), and at least one double bond in its ring. Non-limiting examples of the $C_1$-$C_{10}$ heterocycloalkenyl group include a 2,3-dihydrofuranyl group, a 2,3-dihydrothiophenyl group, or the like. The term "$C_1$-$C_{10}$ heterocycloalkenylene group" as used herein refers to a divalent group having the same structure as the $C_1$-$C_{10}$ heterocycloalkenyl group.

The term "$C_6$-$C_{60}$ aryl group" as used herein refers to a monovalent group having a carbocyclic aromatic ring system having 6 to 60 carbon atoms, and the term "$C_6$-$C_{60}$ arylene group" as used herein refers to a divalent group having a carbocyclic aromatic ring system having 6 to 60 carbon atoms. Non-limiting examples of the $C_6$-$C_{60}$ aryl group include a phenyl group, a naphthyl group, an anthracenyl group, a phenanthrenyl group, a pyrenyl group, a chrysenyl group, or the like. When the $C_6$-$C_{60}$ aryl group and the $C_6$-$C_{60}$ arylene group each include two or more rings, the rings may be fused to each other.

The term "$C_7$-$C_{60}$ alkyl aryl group" as used herein refers to a $C_6$-$C_{60}$ aryl group substituted with at least one $C_1$-$C_{60}$ alkyl group. The term "$C_7$-$C_{60}$ aryl alkyl group" as used herein refers to a $C_1$-$C_{60}$ alkyl group substituted with at least one $C_6$-$C_{60}$ aryl group.

The term "$C_1$-$C_{60}$ heteroaryl group" as used herein refers to a monovalent group having an aromatic ring system that has at least one heteroatom selected from B, N, O, P, Si, S, Se, and Ge as a ring-forming atom, and 1 to 60 carbon atoms as ring-forming atom(s). The term "$C_1$-$C_{60}$ heteroarylene group" as used herein refers to a divalent group having an aromatic ring system that has at least one heteroatom selected from B, N, O, P, Si, S, Se, and Ge as a ring-forming atom, and 1 to 60 carbon atoms as ring-forming atom(s). Non-limiting examples of the $C_1$-$C_{60}$ heteroaryl group include a pyridinyl group, a pyrimidinyl group, a pyrazinyl group, a pyridazinyl group, a triazinyl group, a quinolinyl group, an isoquinolinyl group, or the like. When the $C_1$-$C_{60}$ heteroaryl group and the $C_1$-$C_{60}$ heteroarylene group each include two or more rings,

the rings may be fused to each other.

The term "$C_2$-$C_{60}$ alkyl heteroaryl group" as used herein refers to a $C_1$-$C_{60}$ heteroaryl group substituted with at least one $C_1$-$C_{60}$ alkyl group. The term "$C_2$-$C_{60}$ heteroaryl alkyl group" as used herein refers to a $C_1$-$C_{60}$ alkyl group substituted with at least one $C_1$-$C_{60}$ heteroaryl group.

The term "$C_6$-$C_{60}$ aryloxy group" as used herein refers to -$OA_{102}$ (wherein $A_{102}$ is the $C_6$-$C_{60}$ aryl group), and the term "$C_6$-$C_{60}$ arylthio group" as used herein refers to -$SA_{103}$ (wherein $A_{103}$ is the $C_6$-$C_{60}$ aryl group).

The term "$C_1$-$C_{60}$ heteroaryloxy group" as used herein refers to -$OA_{104}$ (wherein $A_{104}$ is the $C_1$-$C_{60}$ heteroaryl group), and the term "$C_1$-$C_{60}$ heteroarylthio group" as used herein refers to -$SA_{105}$ (wherein $A_{105}$ is the $C_1$-$C_{60}$ heteroaryl group).

The term "monovalent non-aromatic condensed polycyclic group" as used herein refers to a monovalent group (for example, having 8 to 60 carbon atoms) having two or more rings condensed to each other, only carbon atoms as ring-forming atoms, and no aromaticity in its entire molecular structure. Non-limiting examples of the monovalent non-aromatic condensed polycyclic group include a fluorenyl group or the like. The term "divalent non-aromatic condensed polycyclic group" as used herein refers to a divalent group having the same structure as the monovalent non-aromatic condensed polycyclic group.

The term "monovalent non-aromatic condensed heteropolycyclic group" as used herein refers to a monovalent group (for example, having 1 to 60 carbon atoms) having two or more rings condensed with each other, a heteroatom selected from B, N, O, P, Si, S, Se, and Ge other than carbon atoms, as a ring-forming atom, and no aromaticity in its entire molecular structure. Non-limiting examples of the monovalent non-aromatic condensed heteropolycyclic group include a carbazolyl group or the like. The term "divalent non-aromatic condensed heteropolycyclic group" as used herein refers to a divalent group having the same structure as the monovalent non-aromatic condensed heteropolycyclic group.

The term "$C_5$-$C_{30}$ carbocyclic group" as used herein refers to a saturated or unsaturated cyclic group having, as a ring-forming atom, 5 to 30 carbon atoms only. The $C_5$-$C_{30}$ carbocyclic group may be a monocyclic group or a polycyclic group. Examples of the "$C_5$-$C_{30}$ carbocyclic group (unsubstituted or substituted with at least one $R_{1a}$)" as used herein may include an adamantane group, a norbornene group, a bicyclo[1.1.1]pentane group, a bicyclo[2.1.1]hexane group, a bicyclo[2.2.1]heptane(norbornane) group, a bicyclo[2.2.2]octane group, a cyclopentane group, a cyclohexane group, a cyclohexene group, a benzene group, a naphthalene group, an anthracene group, a phenanthrene group, a triphenylene group, a pyrene group, a chrysene group, a 1,2,3,4-tetrahydronaphthalene group, a cyclopentadiene group, an indene group, or a fluorene group (each unsubstituted or substituted with at least one $R_{1a}$).

The term "$C_1$-$C_{30}$ heterocyclic group" as used herein refers to a saturated or unsaturated cyclic group including 1 to 30 carbon atoms and at least one heteroatom selected from B, N, O, P, Si, S, Se, and Ge as ring-forming atoms. The $C_1$-$C_{30}$ heterocyclic group may be a monocyclic group or a polycyclic group. Non-limiting examples of the "$C_1$-$C_{30}$ heterocyclic group (unsubstituted or substituted with at least one $R_{1a}$)" as used herein include a thiophene group, a furan group, a pyrrole group, a silole group, borole group, a phosphole group, a selenophene group, a germole group, a benzothiophene group, a benzofuran group, an indole group, a silole group, a benzosilole group, a benzoborole group, a benzophosphole group, a benzoselenophene group, a benzogermole group, a dibenzothiophene group, a dibenzofuran group, a carbazole group, a dibenzosilole group, a dibenzoborole group, a dibenzophosphole group, a dibenzoselenophene group, a dibenzogermole group, a dibenzothiophene 5-oxide group, a 9H-fluoren-9-one group, a dibenzothiophene 5,5-dioxide group, an azabenzothiophene group, an azabenzofuran group, an azaindole group, an azaindene group, an azabenzosilole group, an azabenzoborole group, an azabenzophosphole group, an azabenzoselenophene group, an azabenzogermole group, an azadibenzothiophene group, an azadibenzofuran group, an azacarbazole group, an azafluorene group, an azadibenzosilole group, an azadibenzoborole group, an azadibenzophosphole group, an azadibenzoselenophene group, an azadibenzogermole group, an azadibenzothiophene 5-oxide group, an aza-9H-fluoren-9-one group, an azadibenzothiophene 5,5-dioxide group, a pyridine group, a pyrimidine group, a pyrazine group, a pyridazine group, a triazine group, a quinoline group, an isoquinoline group, a quinoxaline group, a quinazoline group, a phenanthroline group, a pyrazole group, an imidazole group, a triazole group, an oxazole group, an isoxazole group, a thiazole group, an isothiazole group, an oxadiazole group, a thiadiazole group, a benzopyrazole group, a benzimidazole group, a benzoxazole group, a benzothiazole group, a benzoxadiazole group, a benzothiadiazole group, a 5,6,7,8-tetrahydroisoquinoline group, or a 5,6,7,8-tetrahydroquinoline group (each unsubstituted or substituted with at least one $R_{1a}$).

The term "TMS" as used herein represents *-$Si(CH_3)_3$, and the term "TMG" as used herein represents *-$Ge(CH_3)_3$. As used herein, the term "($C_1$-$C_{20}$ alkyl) X group" means X group substituted with at least one $C_1$-$C_{20}$ alkyl group. For example, "($C_1$-$C_{20}$ alkyl)phenyl group" means a phenyl group substituted with at least one $C_1$-$C_{20}$ alkyl group.

Unless otherwise defined, at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the

substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, the substituted monovalent non-aromatic condensed heteropolycyclic group may be, the substituted monovalent non-aromatic condensed heteropolycyclic group, the substituted $C_3$-$C_{10}$ cycloalkylene group, the substituted $C_1$-$C_{10}$ heterocycloalkylene group, the substituted $C_3$-$C_{10}$ cycloalkenylene group, the substituted $C_1$-$C_{10}$ heterocycloalkenylene group, the substituted $C_6$-$C_{60}$ arylene group, the substituted $C_1$-$C_{60}$ heteroarylene group, the substituted divalent non-aromatic condensed polycyclic group, and the substituted divalent non-aromatic condensed heteropolycyclic group:

deuterium, -F, -Cl, -Br, -I, $-SF_5$, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;

a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, -SFs, $-CD_3$, $-CD_2H$, $-CDH_2$, $-CF_3$, $-CF_2H$, - $CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, - $C(Q_{11})(Q_{12})(Q_{13})$, $-C(=O)(Q_{11})$, $-S(=O)(Q_{11})$, $-S(=O)_2(Q_{11})$, $-N(Q_{14})(Q_{16})$, - $B(Q_{16})(Q_{17})$, $-P(Q_{18})(Q_{19})$, $-P(=O)(Q_{18})(Q_{19})$, $-P(=S)(Q_{18})(Q_{19})$, or a combination thereof;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;

a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with at least one of deuterium, -F, -Cl, -Br, -I, -SFs, - $CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, $-Ge(Q_{21})(Q_{22})(Q_{23})$, $-C(Q_{21})(Q_{22})(Q_{23})$, $-C(=O)(Q_{21})$, $-S(=O)(Q_{21})$, $-S(=O)_2(Q_{21})$, $-N(Q_{24})(Q_{25})$, $-B(Q_{26})(Q_{27})$, $-P(Q_{28})(Q_{29})$, - $P(=O)(Q_{28})(Q_{29})$, $-P(=S)(Q_{28})(Q_{29})$, or a combination thereof; or

$-Si(Q_{31})(Q_{32})(Q_{33})$, $-Ge(Q_{31})(Q_{32})(Q_{33})$, $-C(Q_{31})(Q_{32})(Q_{33})$, $-C(=O)(Q_{31})$, $-S(=O)(Q_{31})$, $-S(=O)_2(Q_{31})$, $-N(Q_{34})(Q_{35})$, $-B(Q_{36})(Q_{37})$, $-P(Q_{38})(Q_{39})$, - $P(=O)(Q_{38})(Q_{39})$, or $-P(=S)(Q_{38})(Q_{39})$, and

$Q_1$ to Q9, $Q_{11}$ to Q19, Q21 to Q29, and Q31 to Q39 may each independently be hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted

or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

Hereinafter, an organometallic compound represented by Formula 1 and an organic light-emitting device according to one or more embodiments will be described in further detail with reference to Synthesis Examples and Examples, but embodiments are not limited thereto. The wording "'B' was used instead of 'A'" used in describing Synthesis Examples means that an amount of 'A' used was identical to an amount of 'B' used, in terms of a molar equivalent.

EXAMPLES

Synthesis Example 1: Synthesis of Compound 8

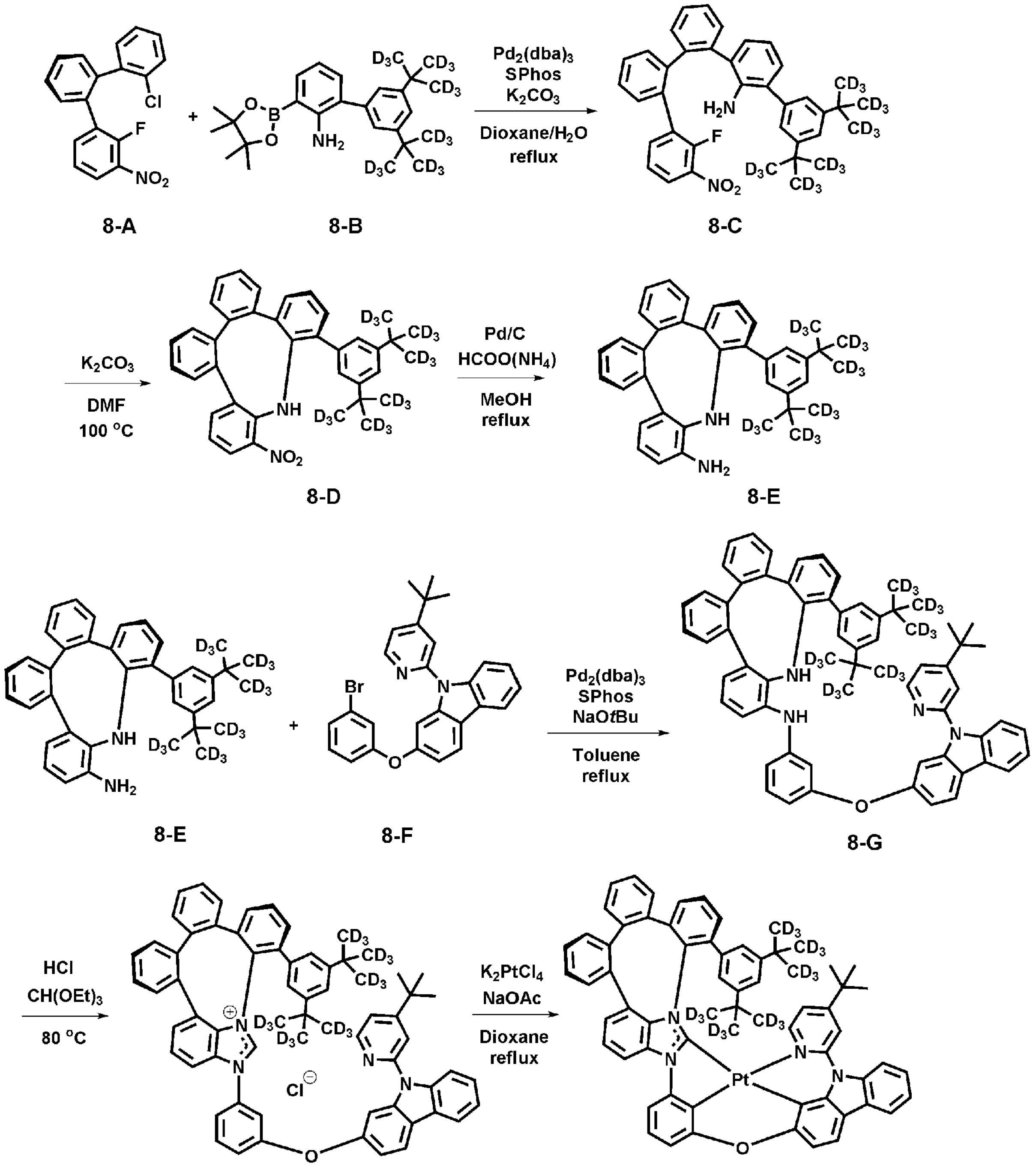


8-A 8-B 8-C

8-D 8-E

8-E 8-F 8-G

8-H 8

(1) Synthesis of Compound 8-C

Compound 8-A (15.0 grams (g), 45.8 millimoles (mmol)), Compound 8-B (17.3 g, 50.3 mmol), tris(dibenzylideneacetone)dipalladium(0) ($Pd_2(dba)_3$) (4.19 g, 4.58 mmol), 2-dicyclohexylphosphino-2',6'-dimethoxybiphenyl (SPhos) (3.76 g, 9.15 mmol), and $K_2CO_3$ (8.22 g, 59.5 mmol) were added to a round-bottom flask, and then mixed with 1,4-dioxane/$H_2O$ (200 mL/50 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 19.7 g (yield of 73%) of Compound 8-C.

high-performance liquid chromatography (HPLC)-mass spectrometry (MS): 594.36 $[M+H]^+$.

(2) Synthesis of Compound 8-D

Compound 8-C (19.5 g, 33.0 mmol) and $K_2CO_3$ (13.7 g, 99.0 mmol) were added to a round-bottom flask, and then mixed with DMF (400 mL). The resultant reaction solution was stirred at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 16.5 g (yield of 88%) of Compound 8-D.

HPLC-MS: 574.78 $[M+H]^+$.

(3) Synthesis of Compound 8-E

Compound 8-D (16.5 g, 28.9 mmol), palladium on carbon (Pd/C) (10 wt% on carbon, 3.08 g, 2.89 mmol), and ammonium formate (36.5 g, 578 mmol) were added to a round-bottom flask, and then mixed with methanol (300 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 13.1 g (yield of 84%) of Compound 8-E.

HPLC-MS: 544.37 $[M+H]^+$.

(4) Synthesis of Compound 8-G

Compound 8-E (13.0 g, 24.0 mmol), Compound 8-F (12.5 g, 26.4 mmol), $Pd_2(dba)_3$ (1.10 g, 1.20 mmol), SPhos (0.987 g, 2.40 mmol), and sodium tertiary-butoxide (NaOtBu) (3.00 g, 31.3 mmol) were added to a round-bottom flask, and then mixed with toluene (200 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 19.1 g (yield of 85%) of Compound 8-G.

HPLC-MS: 934.51 $[M+H]^+$.

(5) Synthesis of Compound 8-H

Compound 8-G (19.1 g, 20.5 mmol) and hydrochloric acid solution (35%, 2.00 mL, 22.6 mmol) were added to a round-bottom flask, and then mixed with triethylorthoformate (200 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 18.3 g (yield of 91%) of Compound 8-H.

(6) Synthesis of Compound 8

Compound 8-H (18.2 g, 18.6 mmol), $K_2PtCl_4$ (8.50 g, 20.5 mmol), and sodium acetate (NaOAc) (4.58 g, 55.8 mmol) were added to a round-bottom flask, and then mixed with dioxane (250 mL). The resultant reaction solution was stirred under reflux at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 5.8 g (yield of 27%) of Compound 8.

HPLC-MS: 1137.54 $[M+H]^+$.

Synthesis Example 2: Synthesis of Compound 10

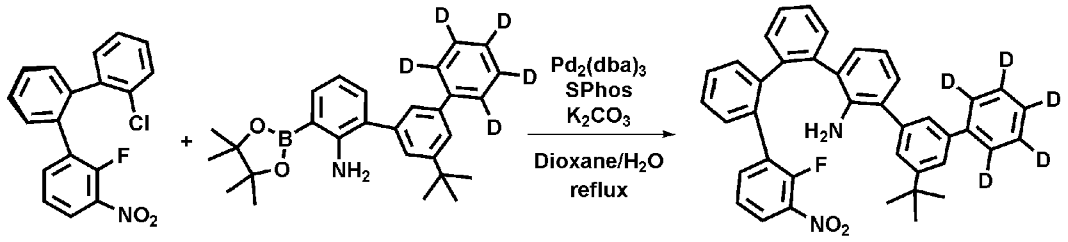


10-A 10-B 10-C

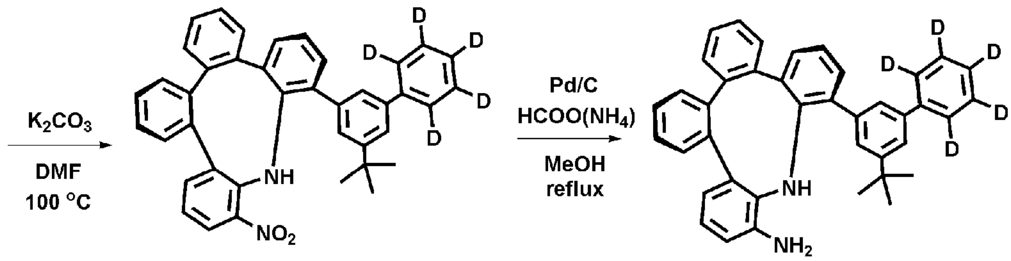


10-D 10-E

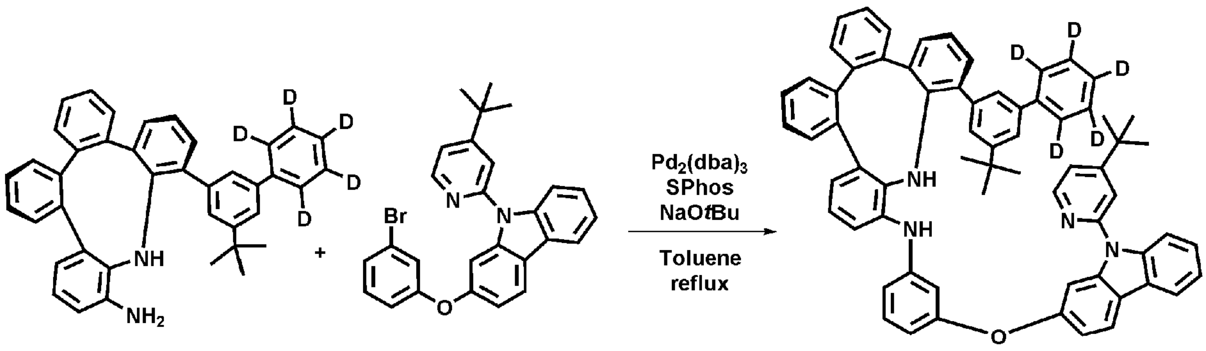


10-E 10-F 10-G

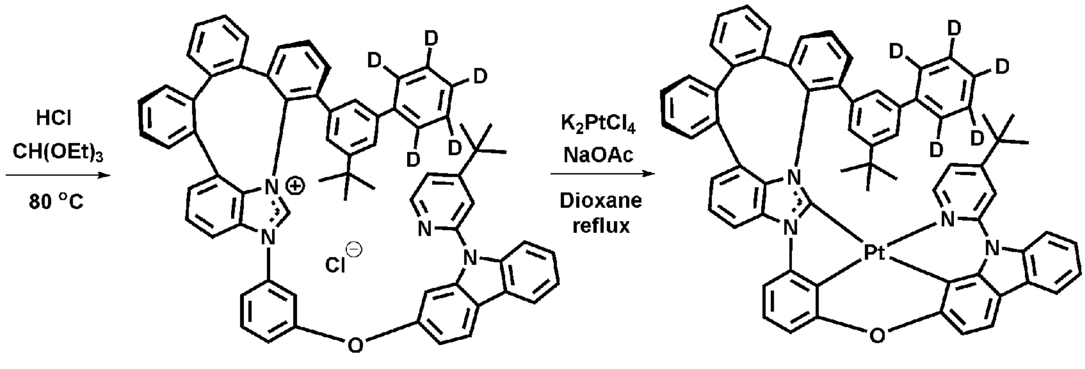


10-H 10

(1) Synthesis of [Compound 10-C]

Compound 10-A (10.0 g, 30.5 mmol), Compound 10-B (11.8 g, 33.6 mmol), $Pd_2(dba)_3$ (2.79 g, 3.05 mmol), SPhos (2.50 g, 6.10 mmol), and $K_2CO_3$ (5.48 g, 39.7 mmol) were added to a round-bottom flask, and then mixed with 1,4-dioxane/$H_2O$ (100 mL/25 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 12.1 g (yield of 66%) of Compound 10-C.

HPLC-MS: 598.27 $[M+H]^+$.

(2) Synthesis of Compound 10-D

Compound 10-C (12.0 g, 20.0 mmol) and $K_2CO_3$ (8.32 g, 60.2 mmol) were added to a round-bottom flask, and then mixed with dimethylformamide (DMF) (250 mL). The resultant reaction solution was stirred at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 9.7 g (yield of 84%) of Compound 10-D.
HPLC-MS: 578.28 $[M+H]^+$.

(3) Synthesis of Compound 10-E

Compound 10-D (9.50 g, 16.4 mmol), Pd/C (10 wt% on carbon, 1.75 g, 1.64 mmol), and ammonium formate (20.7 g, 328 mmol) were added to a round-bottom flask, and then mixed with methanol (100 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 7.2 g (yield of 76%) of Compound 10-E.
HPLC-MS: 548.29 $[M+H]^+$.

(4) Synthesis of Compound 10-G

Compound 10-E (7.10 g, 13.0 mmol), Compound 10-F (6.72 g, 14.3 mmol), $Pd_2(dba)_3$ (0.593 g, 0.650 mmol), SPhos (0.532 g, 1.30 mmol), and NaOtBu (1.62 g, 16.9 mmol) were added to a round-bottom flask, and then mixed with toluene (100 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 8.6 g (yield of 71%) of Compound 10-G.
HPLC-MS: 938.45 $[M+H]^+$.

(5) Synthesis of Compound 10-H

Compound 10-G (8.50 g, 9.06 mmol) and hydrochloric acid solution (35%, 0.88 mL, 9.97 mmol) were added to a round-bottom flask, and then mixed with triethylorthoformate (60 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 7.9 g (yield of 89%) of Compound 10-H.

(6) Synthesis of Compound 10

Compound 10-H (8.50 g, 8.63 mmol), $K_2PtCl_4$ (3.94 g, 9.50 mmol), and NaOAc (2.12 g, 25.9 mmol) were added to a round-bottom flask, and then mixed with dioxane (160 mL). The resultant reaction solution was stirred under reflux at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 2.1 g (yield of 21%) of Compound 10.
HPLC-MS: 1141.38 $[M+H]^+$.

Synthesis Example 3: Synthesis of Compound 471

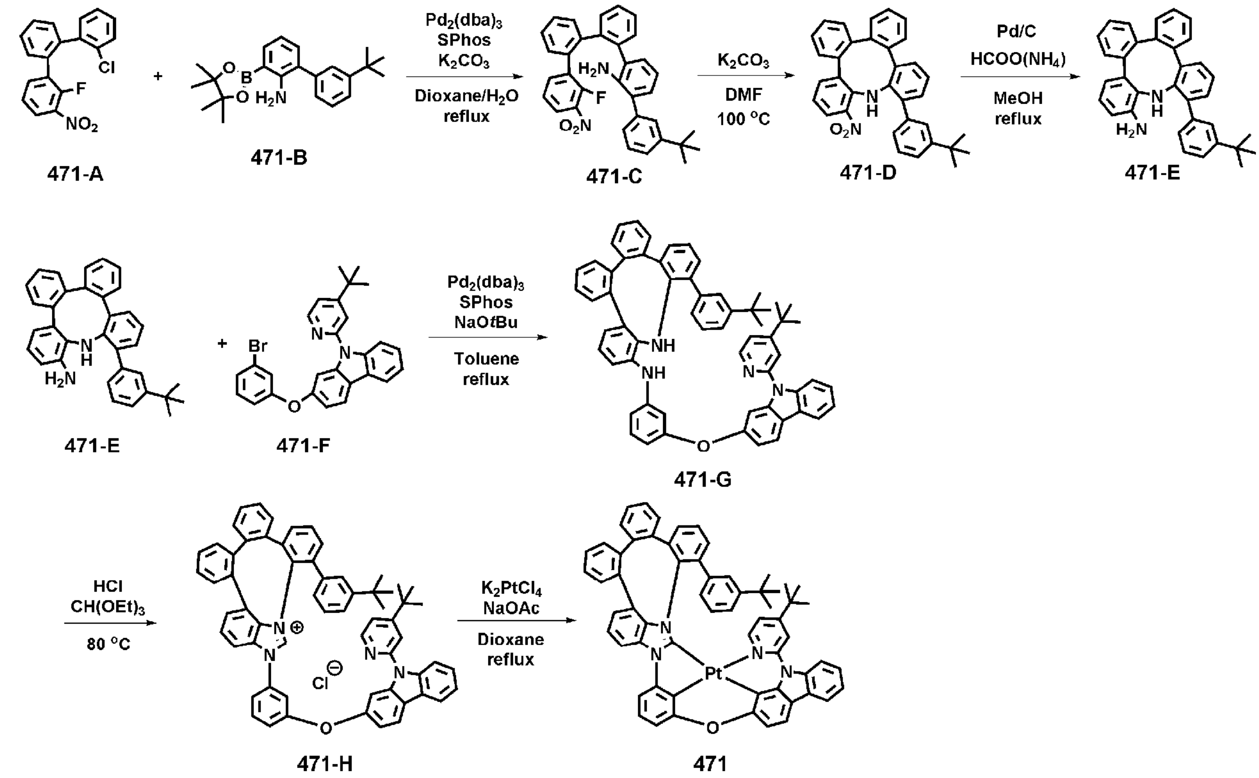


471-A 471-B 471-C 471-D 471-E

471-E 471-F 471-G

471-H 471

(1) Synthesis of Compound 471-C

Compound 471-A (5.86 g, 17.8 mmol), Compound 471-B (15.7 g, 44.6 mmol), $Pd_2(dba)_3$ (0.814 g, 0.89 mmol), SPhos (0.730 g, 1.78 mmol), and $K_2CO_3$ (3.20 g, 23.1 mmol) were added to a round-bottom flask, and then mixed with 1,4-dioxane/$H_2O$ (100 mL/25 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 7.1 g (yield of 77%) of Compound 471-C.
HPLC-MS: 517.20 $[M+H]^+$.

(2) Synthesis of Compound 471-D

Compound 471-C (7.1 g, 13.7 mmol) and $K_2CO_3$ (5.68 g, 41.1 mmol) were added to a round-bottom flask, and then mixed with dimethylformamide (DMF) (250 mL). The resultant reaction solution was stirred at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 5.2 g (yield of 76%) of Compound 471-D.
HPLC-MS: 497.20 $[M+H]^+$.

(3) Synthesis of Compound 471-E

Compound 471-D (5.2 g, 10.4 mmol), Pd/C (10 wt% on carbon, 1.10 g, 1.04 mmol), and ammonium formate (13.1 g, 208 mmol) were added to a round-bottom flask, and then mixed with methanol (100 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 4.8 g (yield of 98%) of Compound 471-E.
HPLC-MS: 467.22 $[M+H]^+$.

(4) Synthesis of Compound 471-G

Compound 471-E (4.80 g, 10.2 mmol), Compound 471-F (5.28 g, 11.2 mmol), $Pd_2(dba)_3$ (0.467 g, 0.510 mmol), SPhos (0.418 g, 1.02 mmol), and NaOtBu (1.26 g, 13.2 mmol) were added to a round-bottom flask, and then mixed with toluene (100 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 7.4 g (yield of 85%) of Compound 471-G.

HPLC-MS: 857.39 $[M+H]^+$.

(5) Synthesis of Compound 471-H

Compound 471-G (7.40 g, 8.63 mmol) and hydrochloric acid solution (35%, 0.83 mL, 9.49 mmol) were added to a round-bottom flask, and then mixed with triethylorthoformate (80 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 7.7 g (yield of 98%) of Compound 471-H.

(6) Synthesis of Compound 471

Compound 471-H (7.7 g, 8.52 mmol), $K_2PtCl_4$ (3.94 g, 9.50 mmol), and NaOAc (2.09 g, 25.5 mmol) were added to a round-bottom flask, and then mixed with dioxane (160 mL). The resultant reaction solution was stirred under reflux at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 4.6 g (yield of 50%) of Compound 471.

HPLC-MS: 1060.35 $[M+H]^+$.

Synthesis Example 2: Synthesis of Compound 472

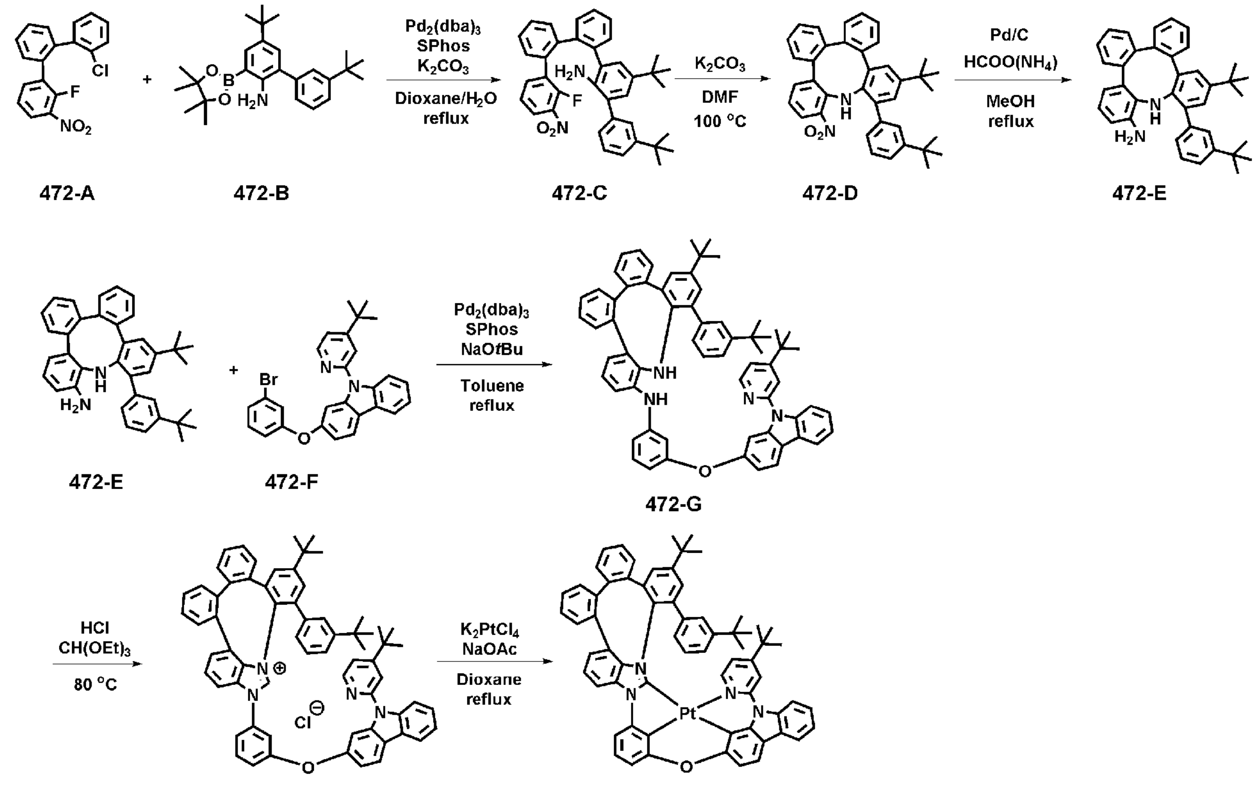


472-A 472-B 472-C 472-D 472-E

472-E 472-F 472-G

472-H 472

(1) Synthesis of Compound 472-C

Compound 472-A (10.7 g, 32.6 mmol), Compound 472-B (22.6 g, 55.4 mmol), $Pd_2(dba)_3$ (0.814 g, 1.49 mmol), SPhos (1.33 g, 3.26 mmol), and $K_2CO_3$ (5.86 g, 42.4 mmol) were added to a round-bottom flask, and then mixed with 1,4-dioxane/$H_2O$ (100 mL/25 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 16.1 g (yield of 86%) of Compound 472-C.
HPLC-MS: 573.29 $[M+H]^+$.

(2) Synthesis of Compound 472-D

Compound 472-C (16.1 g, 28.1 mmol) and $K_2CO_3$ (11.6 g, 84.3 mmol) were added to a round-bottom flask, and then mixed with dimethylformamide (DMF) (300 mL). The resultant reaction solution was stirred at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 4.0 g (yield of 26%) of Compound 472-D.
HPLC-MS: 553.28 $[M+H]^+$.

(3) Synthesis of Compound 472-E

Compound 472-D (4.0 g, 7.23 mmol), Pd/C (10 wt% on carbon, 0.769 g, 0.723 mmol), and ammonium formate (9.08 g, 144 mmol) were added to a round-bottom flask, and then mixed with methanol (50 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 3.39 g (yield of 89%) of Compound 472-E.
HPLC-MS: 523.30 $[M+H]^+$.

(4) Synthesis of Compound 472-G

Compound 472-E (3.39 g, 6.48 mmol), Compound 472-F (3.21 g, 6.80 mmol), $Pd_2(dba)_3$ (0.296 g, 0.324 mmol), SPhos (0.266 g, 0.648 mmol), and NaOtBu (0.810 g, 8.42 mmol) were added to a round-bottom flask, and then mixed with toluene (100 mL). The resultant reaction solution was stirred under reflux at 110°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 5.34 g (yield of 90%) of Compound 472-G.

HPLC-MS: 913.48 $[M+H]^+$.

(5) Synthesis of Compound 472-H

Compound 472-G (5.34 g, 5.85 mmol) and hydrochloric acid solution (35%, 0.57 mL, 6.43 mmol) were added to a round-bottom flask, and then mixed with triethylorthoformate (80 mL). The resultant reaction solution was stirred under reflux at 80°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 5.19 g (yield of 92%) of Compound 472-H.

(6) Synthesis of Compound 472

Compound 472-H (5.19 g, 5.40 mmol), $K_2PtCl_4$ (2.46 g, 5.94 mmol), and NaOAc (1.33 g, 16.2 mmol) were added to a round-bottom flask, and then mixed with dioxane (100 mL). The resultant reaction solution was stirred under reflux at 100°C for 12 hours. After completion of the reaction, the temperature was lowered to room temperature, and then, ethyl acetate and a saturated aqueous ammonium chloride solution were added to the reaction solution. An organic solution layer was extracted therefrom using ethyl acetate, dried using anhydrous $MgSO_4$, and then filtered. The filtrate was concentrated and purified through silica gel column chromatography to obtain 3.7 g (yield of 61%) of Compound 472.

HPLC-MS: 1116.48 $[M+H]^+$.

Evaluation Example 1: Evaluation of Emission Spectrum

For the compounds listed in Table 2, the compounds were diluted in toluene to a concentration of $1 \times 10^{-4}$ M, and the PL (photoluminescence) spectrum was measured at room temperature using an ISC PC1 spectrofluorometer equipped with a xenon lamp. The maximum emission wavelength ($\lambda_{max}$), the maximum emission wavelength of the second peak ($2^{nd}$ peak $\lambda_{max}$), and the intensity of the second peak ($2^{nd}$ peak intensity) were measured, and the results are shown in Table 2.

Table 2

| Compound No. | $\lambda_{max}$ (nm) | $2^{nd}$ peak $\lambda_{max}$ (nm) | $2^{nd}$ peak intensity |
|---|---|---|---|
| Compound 471 | 459 | 487 | 0.321 |
| Compound 472 | 458 | 486 | 0.312 |
| Compound 8 | 458 | 487 | 0.322 |
| Compound B | 461 | 490 | 0.367 |
| Compound C | 459 | 486 | 0.332 |
| Compound D | 461 | 489 | 0.387 |

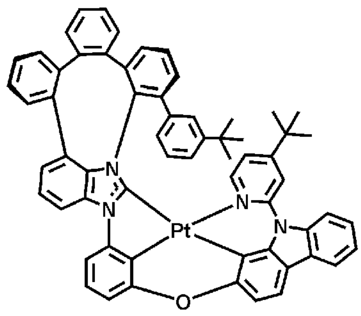

**471**

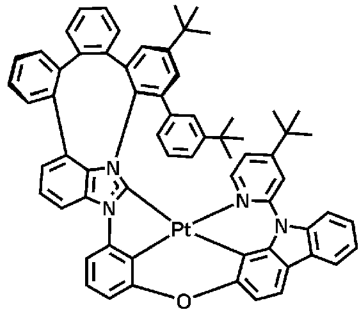

**472**

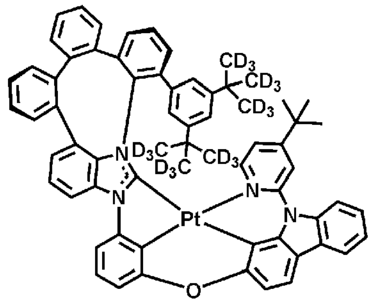

**8**

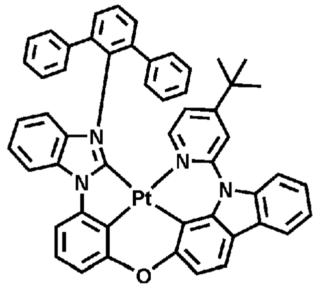

**B**

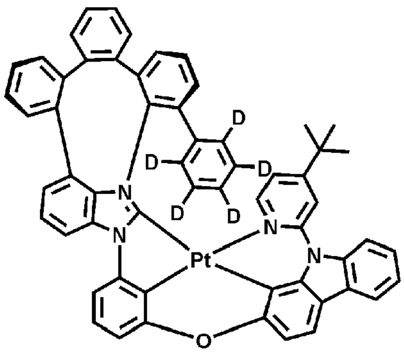

**C**

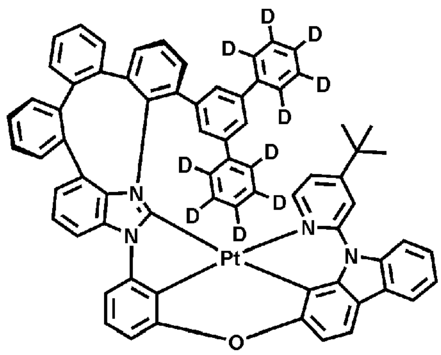

**D**

Referring to Table 2 above, it was found that the organometallic compound according to one embodiment exhibited high color purity with a reduced intensity of the second peak of the emission spectrum.

Example 1

A glass substrate with a 50 nm thick ITO electrode pattern was ultrasonically cleaned in acetone, isopropyl alcohol, and pure water for 15 minutes each, and then UV ozone cleaned for 30 minutes.

Subsequently, 2-(7-Dicyanomethylene-1,3,4,5,6,8,9,10-octafluoro-7H-pyren-2-ylidene)-malononitrile (NDP-9) was deposited on the ITO electrode (anode) on the glass substrate to a thickness of 10 nm, HT3 was deposited to a thickness of 40 nm, and 2,2'-Di(9H-carbazol-9-yl)biphenyl (o-CBP) was deposited to a thickness of 10 nm sequentially.

Then, the light-emitting layer was formed by mixing the first host (H1) and the second host (H2) in a 60:40 ratio, and co-depositing the compound 471 (emitter) to be 15 wt% based on the total weight of the first host, the second host, and the emitter, thereby forming a light-emitting layer with a thickness of 30 nm.

By depositing 9-(3-(9H-carbazol-9-yl)phenyl)-9H-carbazole-3,6-dicarbonitrile (mCP-2CN) on the light-emitting layer to a thickness of 10 nm, co-depositing DPEPO and LiQ at a weight ratio of 1:1 to a thickness of 30 nm, depositing LiQ to a thickness of 1 nm, and depositing Al to a thickness of 100 nm, an organic light-emitting device having the structure of ITO (50 nm)/NDP-9 (10 nm)/HT3 (40 nm)/o-CBP (10 nm)/light-emitting layer (30 nm)/mCP-2CN (10 nm)/DPEPO:LiQ (1:1) (30 nm)/LiQ (1 nm)/Al (100 nm) was fabricated.

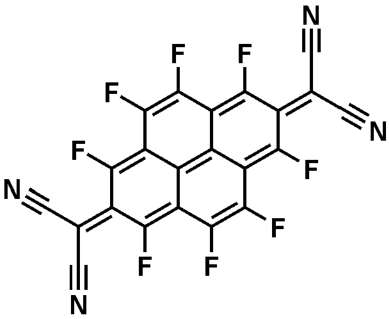

NDP-9

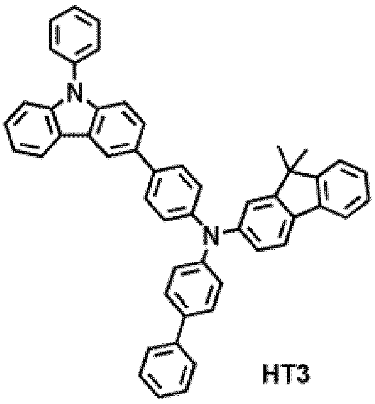

HT3

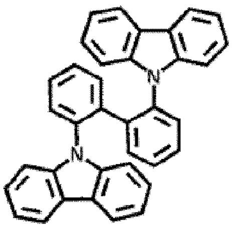

H1

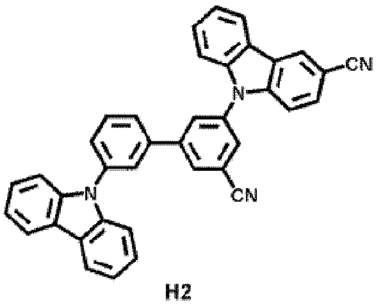

H2

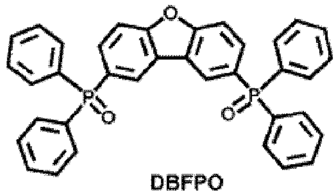

DBFPO

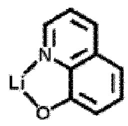

Liq

Examples 2 to 3 and Comparative Examples 1 to 3

Except that the compounds described in Table 3 were used as the light-emitting layer emitters, organic light-emitting devices were fabricated using the same method as in Example 1.

The conversion efficiency (cd/A/y), and $T_{95}$ lifetime characteristics (at 1200 cd/m$^2$, hr), which are the time required for the initial luminance to decrease by 95%, for the organic light-emitting devices fabricated in Examples 1 to 3 and Comparative Examples 1 to 3 were measured and evaluated using a current-voltage meter (Keithley 2400) and a luminance meter (Minolta Cs-1000A). The results are shown in Table 3 below, and the conversion efficiency and $T_{95}$ lifetime characteristics are each shown as relative values to Comparative Example 1.

Table 3

| Example No. | Emitter | Conversion Efficiency (Relative Value, %) | $T_{95}$ (Relative Value, %) |
|---|---|---|---|
| Example 1 | Compound 471 | 124 | 120 |
| Example 2 | Compound 472 | 131 | 107 |
| Example 3 | Compound 8 | 131 | 93 |
| Comparative Example 1 | Compound B | 100 | 100 |
| Comparative Example 2 | Compound C | 114 | 50 |
| Comparative Example 3 | Compound D | 116 | 57 |

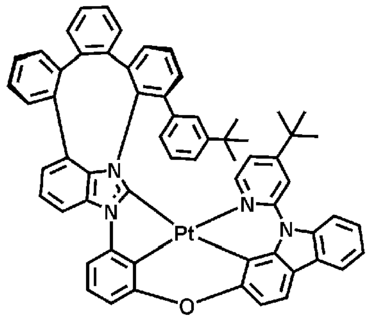

471

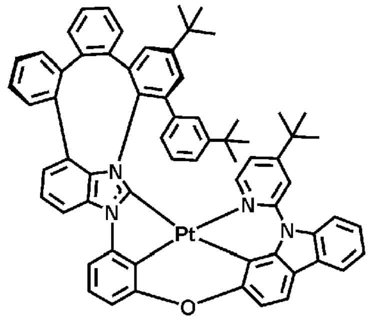

472

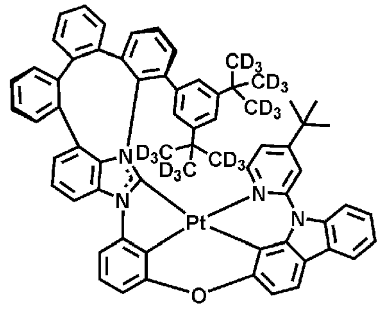

8

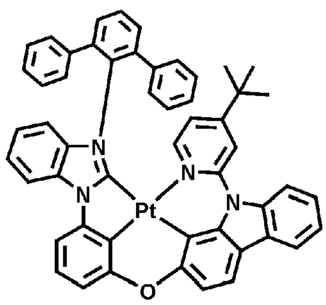

B

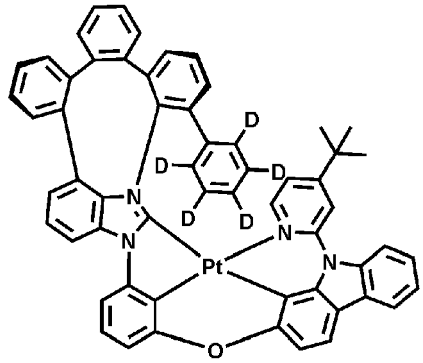

C

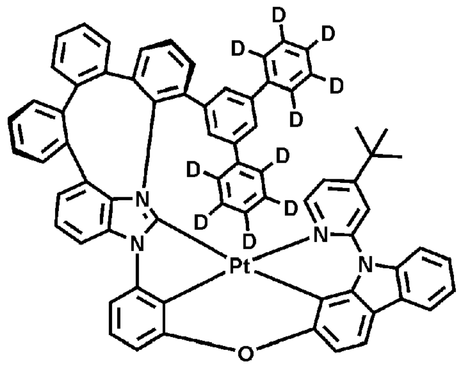

D

Referring to Table 3 above, it was found that the organic light-emitting device according to one embodiment has excellent luminous efficiency and lifespan characteristics. In addition, it was found that the organic light-emitting devices of Examples 1 to 3 have higher luminous efficiency and longer or equal lifespans compared to the organic light-emitting devices of Comparative Examples 1 to 3.

Example 4

A glass substrate having an ITO electrode was cut into a size of 50 mm x 50 mm x 0.5 mm, ultrasonically cleaned in acetone, isopropyl alcohol, and pure water for 15 minutes each, and then UV ozone cleaned for 30 minutes.

Subsequently, HAT-CN was deposited on the ITO electrode (anode) on the glass substrate to form a hole injection layer having a thickness of 100 Å, NPB was deposited on the hole injection layer to form a first hole transport layer having a thickness of 500 Å, TCTA was deposited on the first hole transport layer to form a second hole transport layer having a thickness of 50 Å, and mCP was deposited on the second hole transport layer to form an electron blocking layer having a thickness of 50 Å.

On the electron blocking layer, a first host (H1), a second host (H2), a sensitizer (Compound 471), and an emitter (Compound BD1-10) were co-deposited to form a 400 Å thick light-emitting layer. At this time, the first host and the second host were mixed at a ratio of 60:40, and the sensitizer and the emitter were adjusted to be 15 wt% and 1 wt%, respectively, based on the total weight of the first host, the second host, the sensitizer, and the emitter.

DBFPO was deposited on the above-mentioned light-emitting layer to form a hole-blocking layer having a thickness of 100 Å, DBFPO and Liq were co-deposited at a weight ratio of 5:5 to form an electron-transport layer having a thickness of 300 Å, Liq was deposited on the electron-transport layer to form an electron-injection layer having a thickness of 10 Å, and Al was deposited on the electron-injection layer to form a cathode having a thickness of 1,000 Å, thereby fabricating an organic light-emitting device.

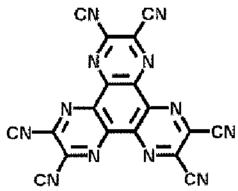

HT-D1(HAT-CN)

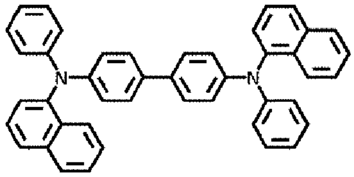

NPB

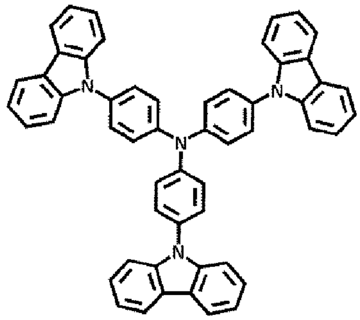

TCTA

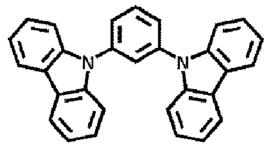

mCP

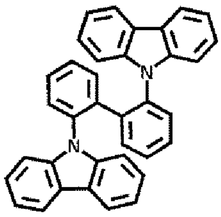

H1

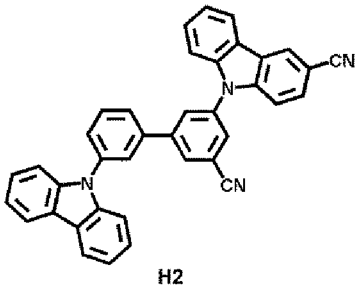

H2

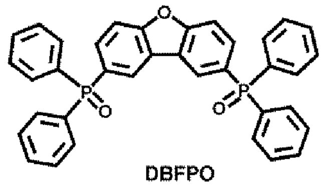

DBFPO

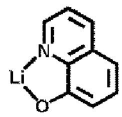

Liq

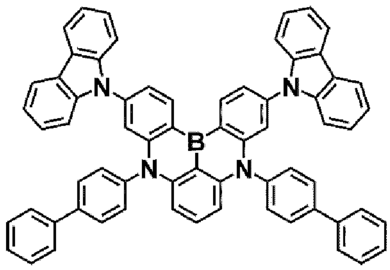

BD1-10

Examples 5 to 6 and Comparative Examples 4 to 7

Except that the compounds described in Table 4 were used as the light-emitting layer sensitizers, organic light-emitting devices were fabricated using the same method as in Example 4.

The conversion efficiency (cd/A/y) and $T_{95}$ lifetime characteristics (at 1200 cd/$m^2$, hr), which are the time required for the initial luminance to decrease by 95%, for the organic light-emitting devices fabricated in Examples 4 to 6 and Comparative Examples 4 to 7 were measured and evaluated using a current-voltage meter (Keithley 2400) and a luminance meter (Minolta Cs-1000A). The results are shown in Table 4 below, and the conversion efficiency and T95 lifetime characteristics are each shown as relative values to Comparative Example 5.

Table 4

| Example No. | Sensitizer | Conversion Efficiency (Relative Value, %) | $T_{95}$ (Relative Value, %) |
|---|---|---|---|
| Example 4 | Compound 471 | 112 | 216 |
| Example 5 | Compound 472 | 115 | 255 |
| Example 6 | Compound 8 | 115 | 247 |
| Comparative Example 4 | Compound A | 106 | 192 |
| Comparative Example 5 | Compound B | 100 | 100 |
| Comparative Example 6 | Compound C | 105 | 53 |

(continued)

| Example No. | Sensitizer | Conversion Efficiency (Relative Value, %) | $T_{95}$ (Relative Value, %) |
|---|---|---|---|
| Comparative Example 7 | Compound D | 107 | 66 |

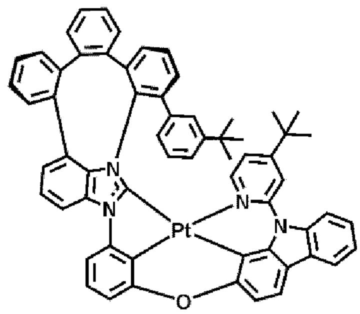

471

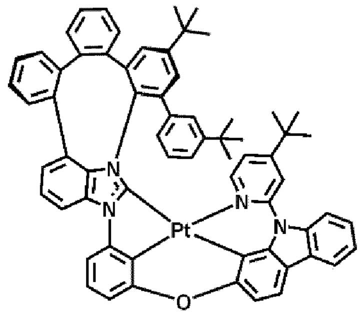

472

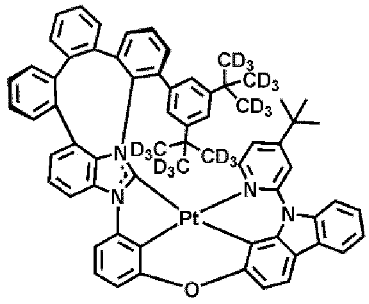

8

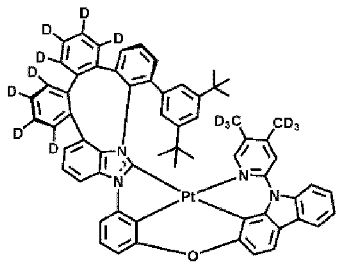

A

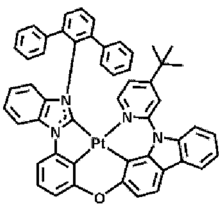

B

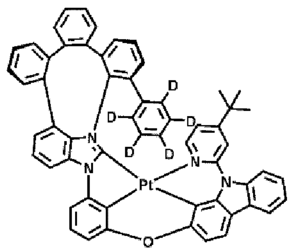

C

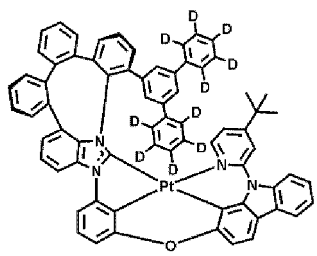

D

Referring to Table 4 above, it was found that the organic light-emitting device according to one embodiment has excellent luminous efficiency and lifespan characteristics. In addition, it was found that the organic light-emitting devices of Examples 4 to 6 have higher luminous efficiency and significantly excellent lifespan characteristics compared to the organic light-emitting devices of Comparative Examples 4 to 7.

As described above, according to the one or more embodiments, an organometallic compound represented by Formula 1 may have excellent luminescence characteristics and charge transfer characteristics, and thus, an electronic device, for example, an organic light-emitting device, including at least one of the organometallic compounds represented by Formula 1 may have characteristics of a low driving voltage, a high efficiency, and/or a long lifespan. Accordingly, by using at least one of the organometallic compounds represented by Formula 1, a high-quality organic light-emitting device may be realized.

In addition, a high-quality electronic apparatus including the organic light-emitting device may be provided.

It should be understood that exemplary embodiments described herein should be considered in a descriptive sense only and not for purposes of limitation. Descriptions of features or aspects within each exemplary embodiment should typically be considered as available for other similar features or aspects in other embodiments. While one or more exemplary embodiments have been described with reference to the figures, it will be understood by those of ordinary skill in the art that various changes in form and details may be made therein without departing from the scope as defined by the following claims.

## Claims

**1.** An organometallic compound, represented by Formula 1:

Formula 1

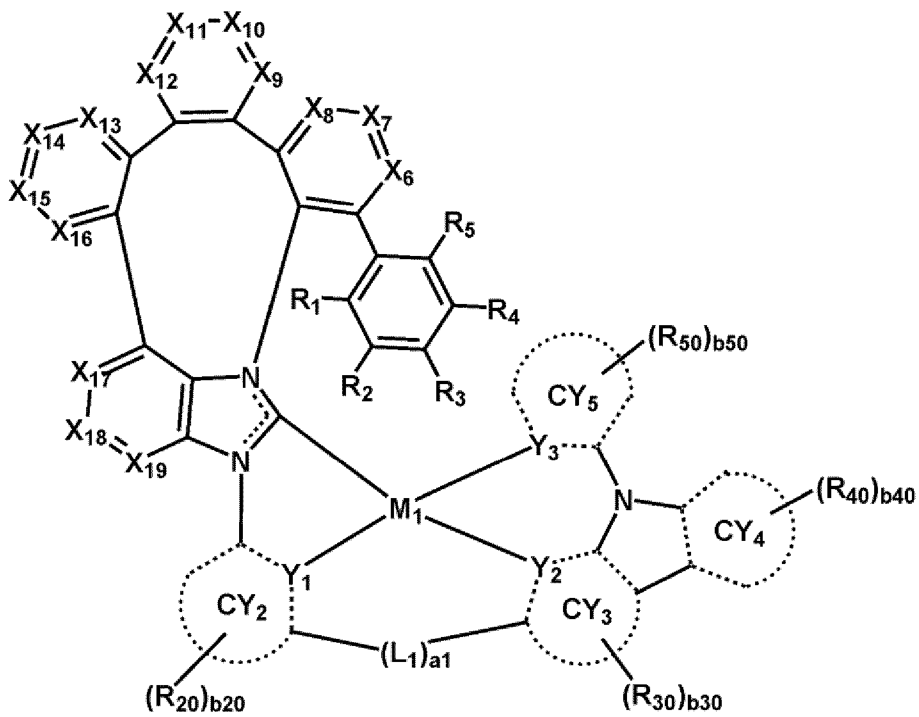

wherein, in Formula 1,

$M_1$ is a transition metal,
$Y_1$ to $Y_3$ are each independently C or N,
ring $CY_2$ to ring $CY_5$ are each independently a $C_5$-$C_{60}$ carbocyclic group or a $C_1$-$C_{60}$ heterocyclic group,
$X_6$ is $C(R_6)$ or N, $X_7$ is $C(R_7)$ or N, and $X_8$ is $C(R_8)$ or N,
$X_9$ is $C(R_9)$ or N, $X_{10}$ is $C(R_{10})$ or N, $X_{11}$ is $C(R_{11})$ or N, and $X_{12}$ is $C(R_{12})$ or N,
$X_{13}$ is $C(R_{13})$ or N, $X_{14}$ is $C(R_{14})$ or N, $X_{15}$ is $C(R_{16})$ or N, and $X_{16}$ is $C(R_{16})$ or N,
$X_{17}$ is $C(R_{17})$ or N, $X_{18}$ is $C(R_{18})$ or N, and $X_{19}$ is $C(R_{19})$ or N,
$L_1$ is a single bond, O, S, Se, $N(R_{61})$, $B(R_{61})$, $C(R_{61})(R_{62})$, or $Si(R_{61})(R_{62})$,
a1 is 1, 2, 3, 4, or 5,
$R_4$ is a substituted or unsubstituted $C_1$-$C_{60}$ alkyl group,
$R_1$ to $R_3$, $R_5$ to $R_{20}$, $R_{30}$, $R_{40}$, $R_{50}$, $R_{61}$, and $R_{62}$ are each independently hydrogen, deuterium, -F, -Cl, -Br, -I, -SFs, a hydroxyl group, a cyano group, a nitro group, an amino group, an amidino group, a hydrazino group, a hydrazono group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, a substituted or unsubstituted monovalent non-aromatic condensed heteropolycyclic group, $-Si(Q_1)(Q_2)(Q_3)$, $-Ge(Q_1)(Q_2)(Q_3)$, $-C(Q_1)(Q_2)(Q_3)$, $-C(=O)(Q_1)$, $-S(=O)(Q_1)$, $-S(=O)_2(Q_1)$, $-N(Q_4)(Q_5)$, $-B(Q_6)(Q_7)$, $-P(Q_8)(Q_9)$, $-P(=O)(Q_8)(Q_9)$, or $-P(=S)(Q_8)(Q_9)$,
neighboring two or more of $R_1$ to $R_{20}$, $R_{30}$, $R_{40}$, $R_{50}$, $R_{61}$, and $R_{62}$ are optionally bonded to each other to form a substituted or unsubstituted $C_5$-$C_{30}$ carbocyclic group or a substituted or unsubstituted $C_1$-$C_{30}$ heterocyclic group,

b20, b30, b40, and b50 are each independently 1, 2, 3, 4, 5, 6, 7, 8, 9, or 10,
at least one substituent of the substituted $C_5$-$C_{30}$ carbocyclic group, the substituted $C_1$-$C_{30}$ heterocyclic group, the substituted $C_1$-$C_{60}$ alkyl group, the substituted $C_2$-$C_{60}$ alkenyl group, the substituted $C_2$-$C_{60}$ alkynyl group, the substituted $C_1$-$C_{60}$ alkoxy group, the substituted $C_1$-$C_{60}$ alkylthio group, the substituted $C_3$-$C_{10}$ cycloalkyl group, the substituted $C_1$-$C_{10}$ heterocycloalkyl group, the substituted $C_3$-$C_{10}$ cycloalkenyl group, the substituted $C_1$-$C_{10}$ heterocycloalkenyl group, the substituted $C_6$-$C_{60}$ aryl group, the substituted $C_7$-$C_{60}$ alkyl aryl group, the substituted $C_7$-$C_{60}$ aryl alkyl group, the substituted $C_6$-$C_{60}$ aryloxy group, the substituted $C_6$-$C_{60}$ arylthio group, the substituted $C_1$-$C_{60}$ heteroaryl group, the substituted $C_2$-$C_{60}$ alkyl heteroaryl group, the substituted $C_2$-$C_{60}$ heteroaryl alkyl group, the substituted $C_1$-$C_{60}$ heteroaryloxy group, the substituted $C_1$-$C_{60}$ heteroarylthio group, the substituted monovalent non-aromatic condensed polycyclic group, and the substituted monovalent non-aromatic condensed heteropolycyclic group is:

deuterium, -F, -Cl, -Br, -I, -SFs, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group;
a $C_1$-$C_{60}$ alkyl group, a $C_2$-$C_{60}$ alkenyl group, a $C_2$-$C_{60}$ alkynyl group, a $C_1$-$C_{60}$ alkoxy group, or a $C_1$-$C_{60}$ alkylthio group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{11})(Q_{12})(Q_{13})$, $-Ge(Q_{11})(Q_{12})(Q_{13})$, - $C(Q_{11})(Q_{12})(Q_{13})$, $-C(=O)(Q_{11})$, $-S(=O)(Q_{11})$, $-S(=O)_2(Q_{11})$, $-N(Q_{14})(Q_{15})$, $-B(Q_{16})(Q_{17})$, - $P(Q_{18})(Q_{19})$, $-P(=O)(Q_{18})(Q_{19})$, $-P(=S)(Q_{18})(Q_{19})$, or a combination thereof;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group;
a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_1$-$C_{60}$ heteroaryloxy group, a $C_1$-$C_{60}$ heteroarylthio group, a monovalent non-aromatic condensed polycyclic group, or a monovalent non-aromatic condensed heteropolycyclic group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{60}$ alkyl group, a $C_2$-$C_{60}$ alkenyl group, a $C_2$-$C_{60}$ alkynyl group, a $C_1$-$C_{60}$ alkoxy group, a $C_1$-$C_{60}$ alkylthio group, a $C_3$-$C_{10}$ cycloalkyl group, a $C_1$-$C_{10}$ heterocycloalkyl group, a $C_3$-$C_{10}$ cycloalkenyl group, a $C_1$-$C_{10}$ heterocycloalkenyl group, a $C_6$-$C_{60}$ aryl group, a $C_7$-$C_{60}$ alkyl aryl group, a $C_7$-$C_{60}$ aryl alkyl group, a $C_6$-$C_{60}$ aryloxy group, a $C_6$-$C_{60}$ arylthio group, a $C_1$-$C_{60}$ heteroaryl group, a $C_2$-$C_{60}$ alkyl heteroaryl group, a $C_2$-$C_{60}$ heteroaryl alkyl group, a $C_1$-$C_{60}$ heteroaryloxy group, a $C_1$-$C_{60}$ heteroarylthio group, a monovalent non-aromatic condensed polycyclic group, a monovalent non-aromatic condensed heteropolycyclic group, $-Si(Q_{21})(Q_{22})(Q_{23})$, $-Ge(Q_{21})(Q_{22})(Q_{23})$, - $C(Q_{21})(Q_{22})(Q_{23})$, $-C(=O)(Q_{21})$, $-S(=O)(Q_{21})$, $-S(=O)_2(Q_{21})$, $-N(Q_{24})(Q_{25})$, $-B(Q_{26})(Q_{27})$, - $P(Q_{28})(Q_{29})$, $-P(=O)(Q_{28})(Q_{29})$, $-P(=S)(Q_{28})(Q_{29})$, or a combination thereof; or
$-Si(Q_{31})(Q_{32})(Q_{33})$, $-Ge(Q_{31})(Q_{32})(Q_{33})$, $-C(Q_{31})(Q_{32})(Q_{33})$, $-C(=O)(Q_{31})_7$ - $S(=O)(Q_{31})$, $-S(=O)_2(Q_{31})$, $-N(Q_{34})(Q_{35})$, $-B(Q_{36})(Q_{37})$, $-P(Q_{38})(Q_{39})$, $-P(=O)(Q_{38})(Q_{39})$, or $-P(=S)(Q_{38})(Q_{39})$, and
$Q_1$ to Q9, $Q_{11}$ to Q19, Q21 to Q29, and Q31 to Q39 are each independently hydrogen, deuterium, -F, -Cl, -Br, -I, $-SF_5$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a substituted or unsubstituted $C_1$-$C_{60}$ alkyl group, a substituted or unsubstituted $C_2$-$C_{60}$ alkenyl group, a substituted or unsubstituted $C_2$-$C_{60}$ alkynyl group, a substituted or unsubstituted $C_1$-$C_{60}$ alkoxy group, a substituted or unsubstituted $C_1$-$C_{60}$ alkylthio group, a substituted or

unsubstituted $C_3$-$C_{10}$ cycloalkyl group, a substituted or unsubstituted $C_1$-$C_{10}$ heterocycloalkyl group, a substituted or unsubstituted $C_3$-$C_{10}$ cycloalkenyl group, a substituted or unsubstituted $C_1$-$C_{10}$ heterocycloalkenyl group, a substituted or unsubstituted $C_6$-$C_{60}$ aryl group, a substituted or unsubstituted $C_7$-$C_{60}$ alkyl aryl group, a substituted or unsubstituted $C_7$-$C_{60}$ aryl alkyl group, a substituted or unsubstituted $C_6$-$C_{60}$ aryloxy group, a substituted or unsubstituted $C_6$-$C_{60}$ arylthio group, a substituted or unsubstituted $C_1$-$C_{60}$ heteroaryl group, a substituted or unsubstituted $C_2$-$C_{60}$ alkyl heteroaryl group, a substituted or unsubstituted $C_2$-$C_{60}$ heteroaryl alkyl group, a substituted or unsubstituted $C_1$-$C_{60}$ heteroaryloxy group, a substituted or unsubstituted $C_1$-$C_{60}$ heteroarylthio group, a substituted or unsubstituted monovalent non-aromatic condensed polycyclic group, or a substituted or unsubstituted monovalent non-aromatic condensed heteropolycyclic group.

2. The organometallic compound of claim 1, wherein $R_2$ and $R_4$ are different from each other, and $R_2$ is not hydrogen;

preferably $R_1$ to $R_3$ and $R_5$ are each independently hydrogen and deuterium; and/or
wherein the organometallic compound is represented by Formula 11:

Formula 11

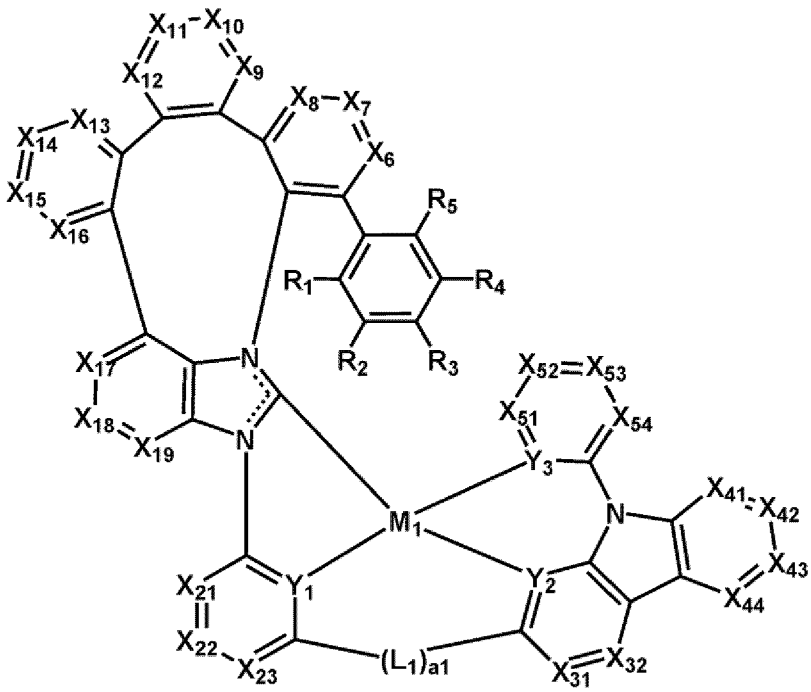

wherein, in Formula 11,

$M_1$, $Y_1$ to $Y_3$, $X_6$ to $X_{19}$, $L_1$, a1, and $R_1$ to $R_5$ are each as defined in claim 1,
$X_{21}$ is $C(R_{21})$ or N, $X_{22}$ is $C(R_{22})$ or N, and $X_{23}$ is $C(R_{23})$ or N,
$X_{31}$ is $C(R_{31})$ or N, and $X_{32}$ is $C(R_{32})$ or N,
$X_{41}$ is $C(R_{41})$ or N, $X_{42}$ is $C(R_{42})$ or N, $X_{43}$ is $C(R_{43})$ or N, and $X_{44}$ is $C(R_{44})$ or N,
$X_{51}$ may be $C(R_{51})$ or N, $X_{52}$ may be $C(R_{52})$ or N, $X_{53}$ may be $C(R_{53})$ or N, and $X_{54}$ may be $C(R_{54})$ or N,
$R_{21}$ to $R_{23}$ are each defined as in connection with $R_{20}$ in claim 1,
$R_{31}$ and $R_{32}$ are each defined as in connection with $R_{30}$ in claim 1,
$R_{41}$ to $R_{44}$ are each defined as in connection with $R_{40}$ in claim 1, and
$R_{51}$ to $R_{54}$ are each the same as described in connection with $R_{50}$ in claim 1.

3. The organometallic compound of claims 1 or 2, wherein $M_1$ is beryllium, magnesium, aluminum, calcium, titanium, manganese, cobalt, copper, zinc, gallium, germanium, zirconium, ruthenium, rhodium, palladium, silver, rhenium, platinum, or gold; and/or
wherein ring $CY_2$ to ring $CY_5$ are each independently a benzene group, a naphthalene group, a phenanthrene group, a furan group, a thiophene group, a pyrrole group, a cyclopentene group, a silole group, a germole group, a benzofuran

group, a benzothiophene group, an indole group, an indene group, a benzosilole group, a benzogermole group, a dibenzofuran group, a dibenzothiophene group, a carbazole group, a fluorene group, a dibenzosilole group, a dibenzogermole group, a pyridine group, a pyrimidine group, a pyridazine group, or a pyrazine group.

**4.** The organometallic compound of any of claims 1-3, wherein $R_4$ is a methyl group, $-CD_3$, $-CD_2H$, $-CDH_2$, or a group represented by one of Formulae 9-1 to 9-39 or 9-44 to 9-62:

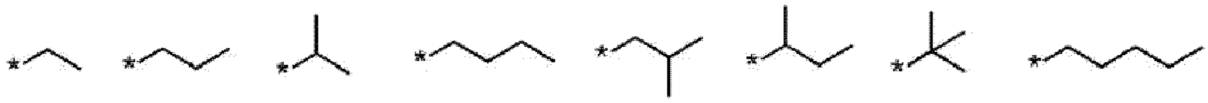

9-1 9-2 9-3 9-4 9-5 9-6 9-7 9-8

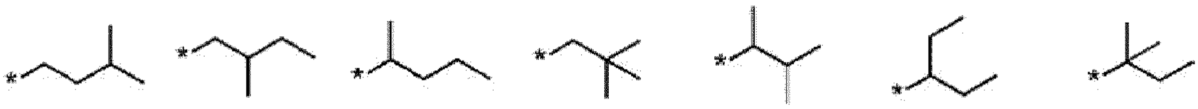

9-9 9-10 9-11 9-12 9-13 9-14 9-15

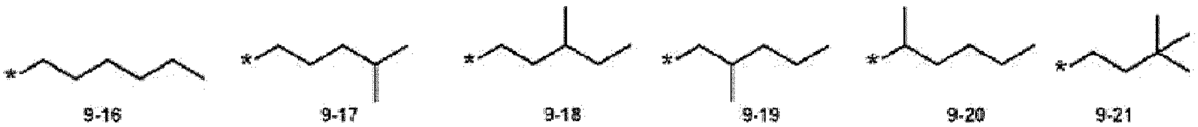

9-16 9-17 9-18 9-19 9-20 9-21

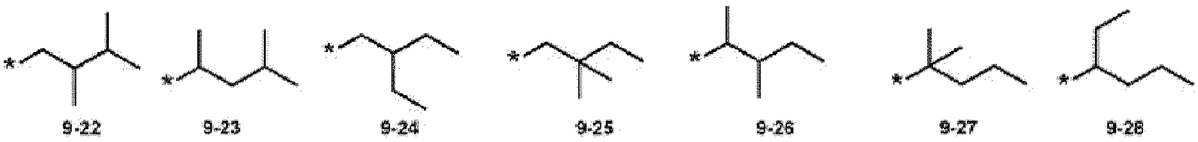

9-22 9-23 9-24 9-25 9-26 9-27 9-28

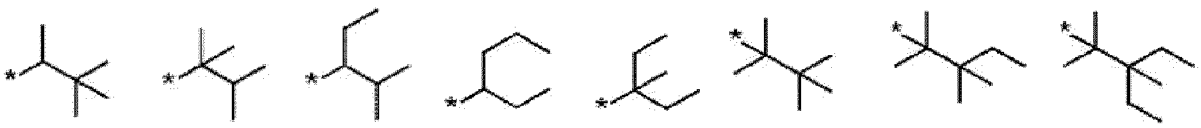

9-29 9-30 9-31 9-32 9-33 9-34 9-35 9-36

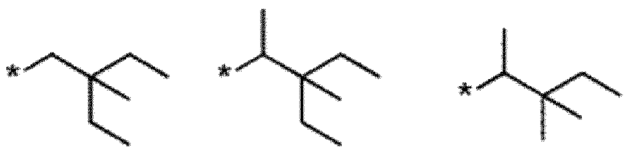

9-37 9-38 9-39

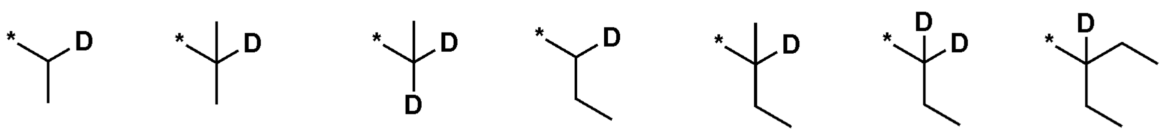

9-44 9-45 9-46 9-47 9-48 9-49 9-50

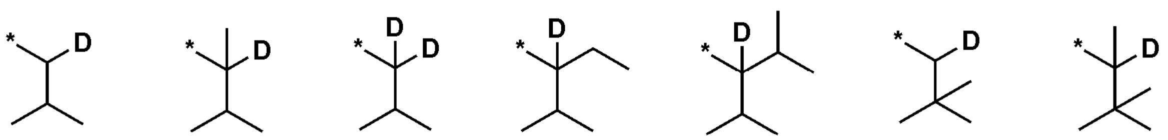

9-51 9-52 9-53 9-54 9-55 9-56 9-57

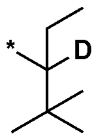 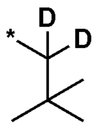 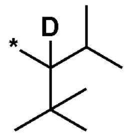 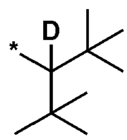 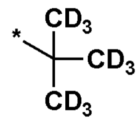

9-58 9-59 9-60 9-61 9-62

wherein, in Formulae 9-1 to 9-39 and 9-44 to 9-62,

* indicates a binding site to a neighboring atom.

**5.** The organometallic compound of any of claims 1-4, wherein $R_1$ to $R_3$, $R_5$ to $R_{20}$, $R_{30}$, $R_{40}$, $R_{50}$, $R_{61}$, and $R_{62}$ are each independently:

hydrogen, deuterium, -F, -Cl, -Br, -I, -SFs, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a $C_1$-$C_{20}$ alkoxy group, or a $C_1$-$C_{20}$ alkylthio group;

a $C_1$-$C_{20}$ alkyl group, a $C_1$-$C_{20}$ alkoxy group, or a $C_1$-$C_{20}$ alkylthio group, each substituted with at least one of deuterium, -F, -Cl, -Br, -I, $-SF_5$, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group (norbornanyl group), a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a pyridinyl group, a pyrimidinyl group, or a combination thereof;

a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, or an azadibenzothiophenyl group, each unsubstituted or substituted with at least one of deuterium, -F, -Cl, -Br, -I, -SFs, $-CD_3$, $-CD_2H$, $-CDH_2$, $-CF_3$, $-CF_2H$, $-CFH_2$, a hydroxyl group, a cyano group, a nitro group, an amino group, an amidino group, a hydrazine group, a hydrazone group, a carboxylic acid group or a salt thereof, a sulfonic acid group or a salt thereof, a phosphoric acid group or a salt thereof, a $C_1$-$C_{20}$ alkyl group, a deuterium-containing $C_1$-$C_{20}$ alkyl group, a fluorinated $C_1$-$C_{20}$ alkyl group, a $C_1$-$C_{20}$ alkoxy group, a $C_1$-$C_{20}$ alkylthio group, a cyclopentyl group, a cyclohexyl group, a cycloheptyl group, a cyclooctyl group, an adamantanyl group, a norbornenyl group, a cyclopentenyl group, a cyclohexenyl group, a cycloheptenyl group, a bicyclo[1.1.1]pentyl group, a bicyclo[2.1.1]hexyl group, a bicyclo[2.2.1]heptyl group, a bicyclo[2.2.2]octyl group, a ($C_1$-$C_{20}$ alkyl)cyclopentyl group, a ($C_1$-$C_{20}$ alkyl)cyclohexyl group, a ($C_1$-$C_{20}$ alkyl)cycloheptyl group, a ($C_1$-$C_{20}$ alkyl)cyclooctyl group, a ($C_1$-$C_{20}$ alkyl)adamantanyl group, a ($C_1$-$C_{20}$ alkyl)norbornenyl group, a ($C_1$-$C_{20}$ alkyl)cyclopentenyl

group, a ($C_1$-$C_{20}$ alkyl)cyclohexenyl group, a ($C_1$-$C_{20}$ alkyl)cycloheptenyl group, a ($C_1$-$C_{20}$ alkyl)bicyclo[1.1.1]pentyl group, a ($C_1$-$C_{20}$ alkyl)bicyclo[2.1.1]hexyl group, a ($C_1$-$C_{20}$ alkyl)bicyclo[2.2.1]heptyl group, a ($C_1$-$C_{20}$ alkyl)bicyclo[2.2.2]octyl group, a silolanyl group, a phenyl group, a ($C_1$-$C_{20}$ alkyl)phenyl group, a biphenyl group, a terphenyl group, a naphthyl group, a 1,2,3,4-tetrahydronaphthyl group, a fluorenyl group, a phenanthrenyl group, an anthracenyl group, a fluoranthenyl group, a triphenylenyl group, a pyrenyl group, a chrysenyl group, a pyrrolyl group, a thiophenyl group, a furanyl group, an imidazolyl group, a pyrazolyl group, a thiazolyl group, an isothiazolyl group, an oxazolyl group, an isoxazolyl group, a pyridinyl group, a pyrazinyl group, a pyrimidinyl group, a pyridazinyl group, an isoindolyl group, an indolyl group, an indazolyl group, a purinyl group, a quinolinyl group, an isoquinolinyl group, a benzoquinolinyl group, a quinoxalinyl group, a quinazolinyl group, a cinnolinyl group, a carbazolyl group, a phenanthrolinyl group, a benzimidazolyl group, a benzofuranyl group, a benzothiophenyl group, a isobenzothiazolyl group, a benzoxazolyl group, an isobenzoxazolyl group, a triazolyl group, a tetrazolyl group, an oxadiazolyl group, a triazinyl group, a dibenzofuranyl group, a dibenzothiophenyl group, a benzocarbazolyl group, a dibenzocarbazolyl group, an imidazopyridinyl group, an imidazopyrimidinyl group, an azacarbazolyl group, an azadibenzofuranyl group, an azadibenzothiophenyl group, or a combination thereof; or $-Si(Q_1)(Q_2)(Q_3)$, $-Ge(Q_1)(Q_2)(Q_3)$, $-C(Q_1)(Q_2)(Q_3)$, $-C(=O)(Q_1)$, $-S(=O)(Q_1)$, - $S(=O)_2(Q_1)$, $-N(Q_4)(Q_5)$, $-B(Q_6)(Q_7)$, $-P(Q_8)(Q_9)$, $-P(=O)(Q_8)(Q_9)$, or $-P(=S)(Q_8)(Q_9)$.

**6.** The organometallic compound of any of claims 1-5, wherein the organometallic compound is represented by Formula 11A:

Formula 11A

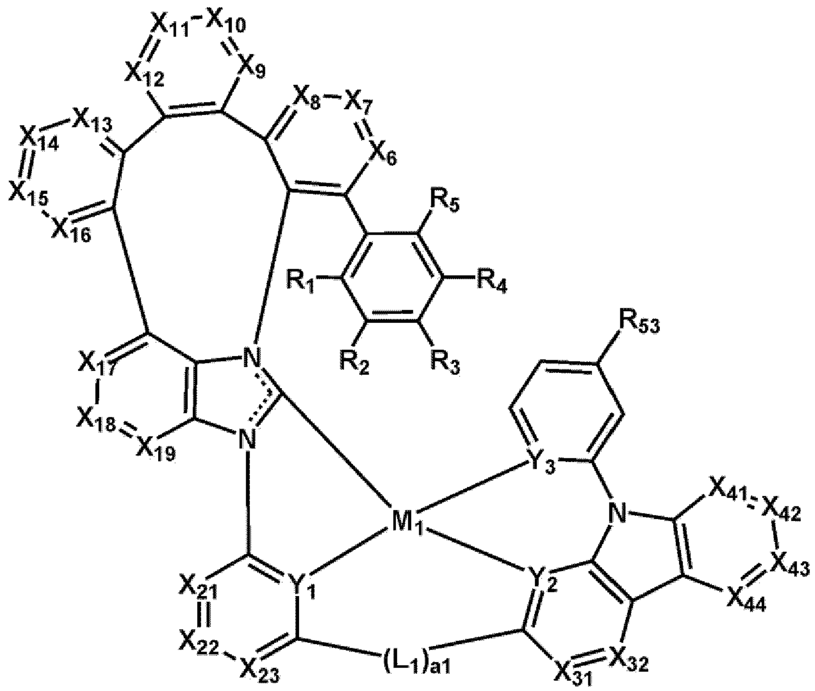

wherein, in Formula 11A,

$M_1$, $Y_1$ to $Y_3$, $X_6$ to $X_{19}$, $L_1$, a1, $R_1$ to $R_3$, and $R_5$ are each as defined in claim 1,
$R_4$ is a $C_1$-$C_{60}$ alkyl group substituted with deuterium,
$R_9$ to $R_{12}$ and $R_{53}$ are each independently hydrogen, deuterium, -F, -Cl, -Br, -I, -SFs, a cyano group, or a substituted or unsubstituted $C_1$-$C_{60}$ alkyl group,
$X_{21}$ is $C(R_{21})$ or N, $X_{22}$ is $C(R_{22})$ or N, and $X_{23}$ is $C(R_{23})$ or N,
$X_{31}$ is $C(R_{31})$ or N, and $X_{32}$ is $C(R_{32})$ or N,
$X_{41}$ is $C(R_{41})$ or N, $X_{42}$ is $C(R_{42})$ or N, $X_{43}$ is $C(R_{43})$ or N, and $X_{44}$ is $C(R_{44})$ or N,
$R_{21}$ to $R_{23}$ are each defined as in connection with $R_{20}$ in claim 1,
$R_{31}$ and $R_{32}$ are each defined as in connection with $R_{30}$ in claim 1, and
$R_{41}$ to $R_{44}$ are each defined as in connection with $R_{40}$ in claim 1.

7. The organometallic compound of any of claims 1-6, wherein the organometallic compound is represented by Formula 21:

Formula 21

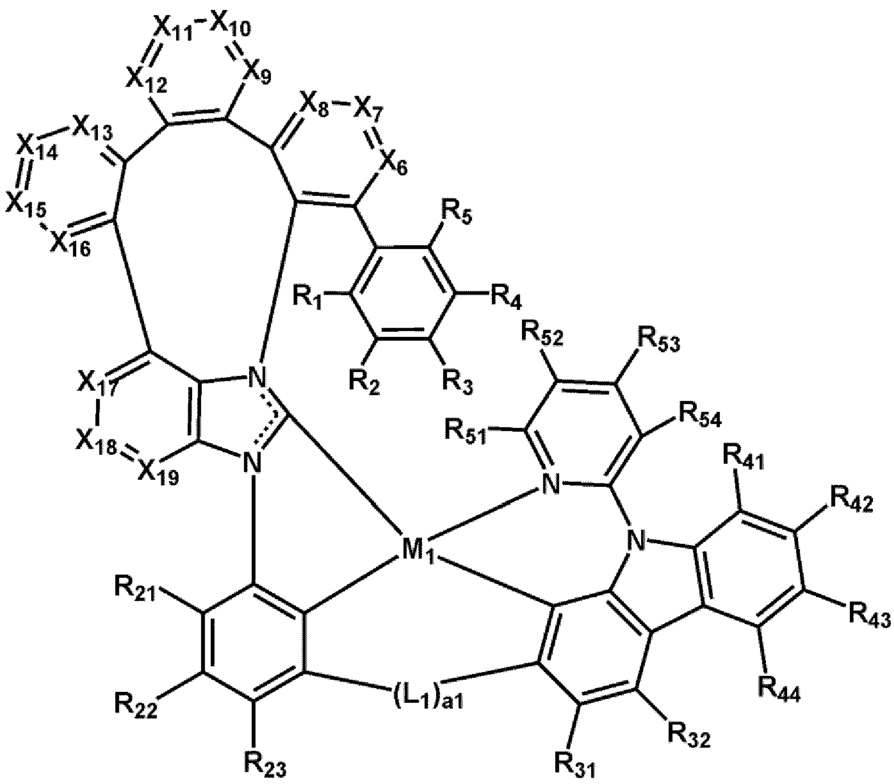

wherein, in Formula 21,

$M_1$, $X_6$ to $X_{19}$, $L_1$, a1, and $R_1$ to $R_5$ are each as defined in claim 1,
$R_{21}$ to $R_{23}$ are each defined as in connection with $R_{20}$ in claim 1,
$R_{31}$ and $R_{32}$ are each defined as in connection with $R_{30}$ in claim 1,
$R_{41}$ to $R_{44}$ are each defined as in connection with $R_{40}$ in claim 1, and
$R_{51}$ to $R_{54}$ are each defined as in connection with $R_{50}$ in claim 1.

8. The organometallic compound of claim 1, wherein the organometallic compound is represented by one of Compounds 1 to 473:

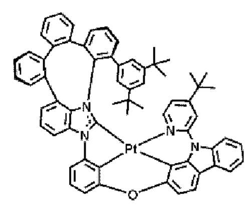

1

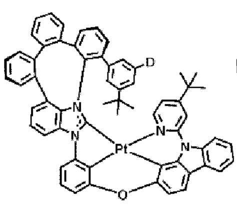

2

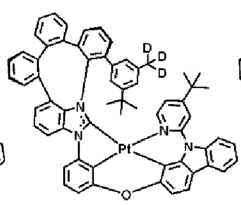

3

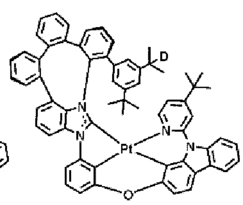

4

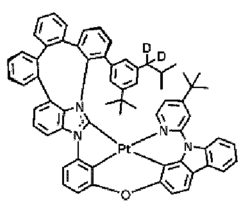

5

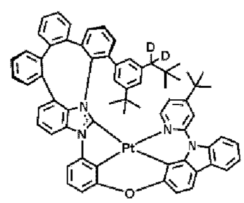

6

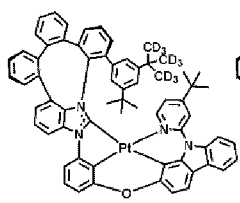

7

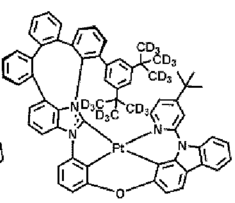

8

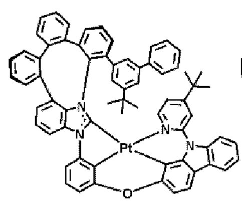

9

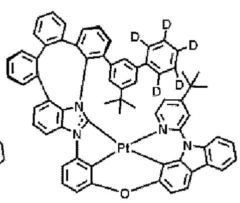

10

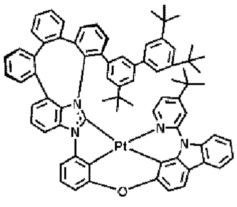
11

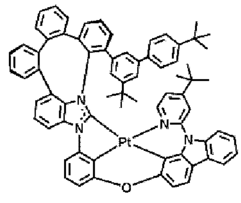
12

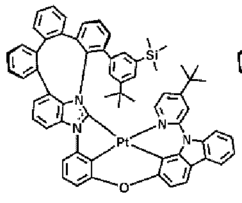
13

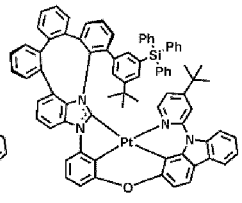
14

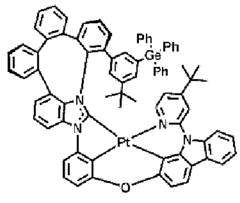
15

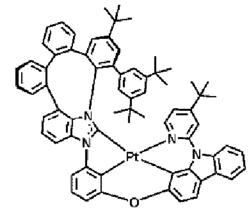
16

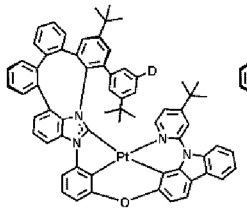
17

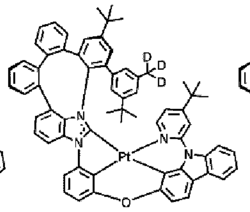
18

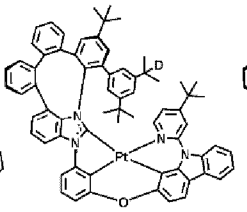
19

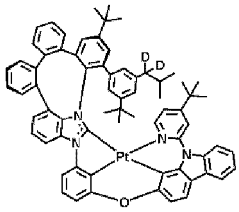
20

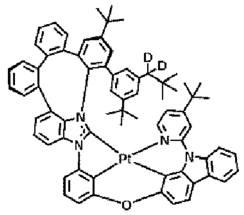
21

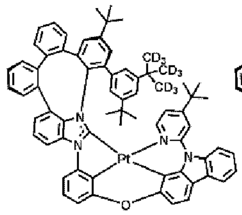
22

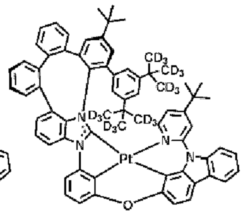
23

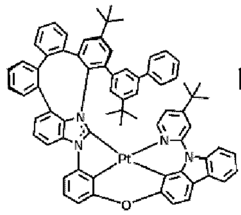
24

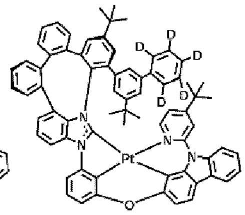
25

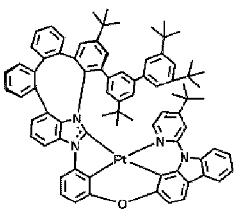
26

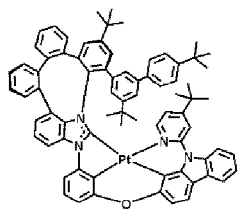
27

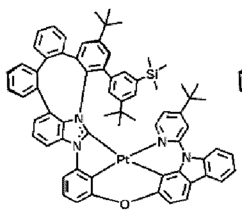
28

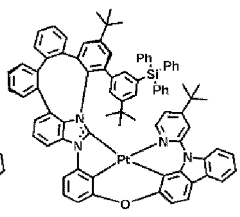
29

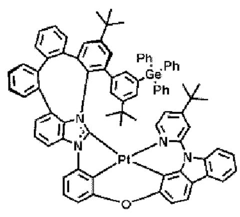
30

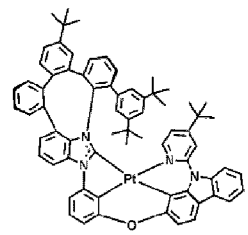
31

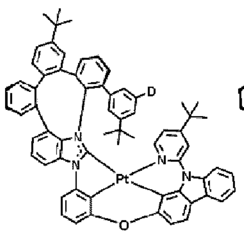
32

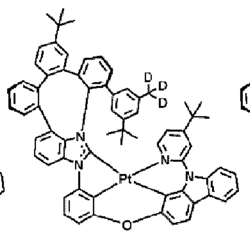
33

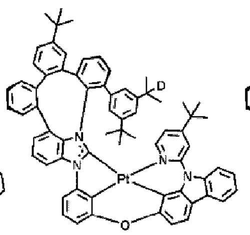
34

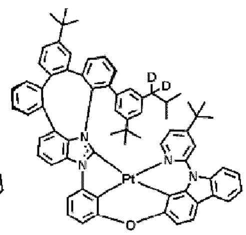
35

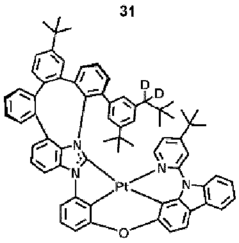
36

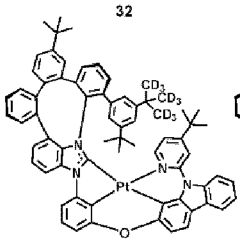
37

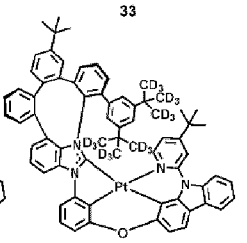
38

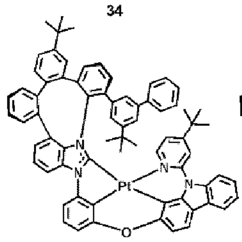
39

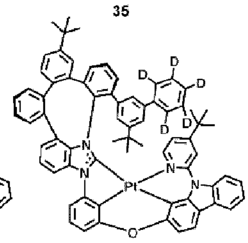
40

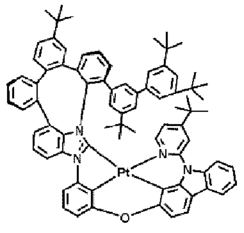
41

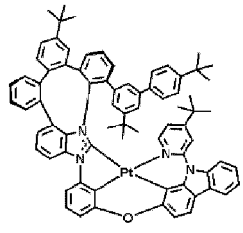
42

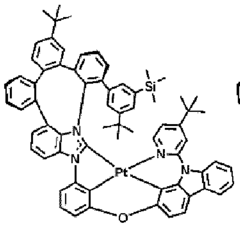
43

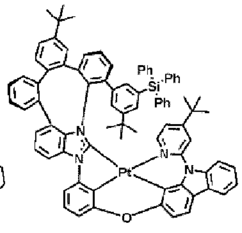
44

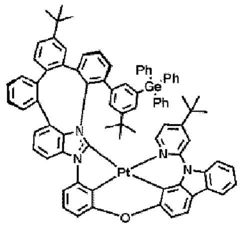
45

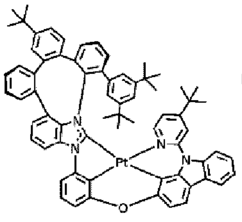
46

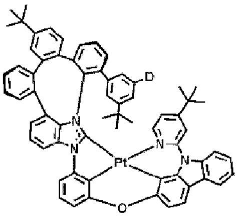
47

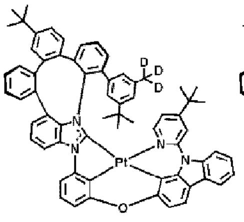
48

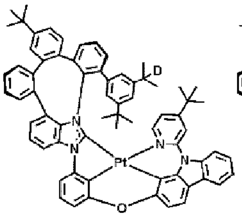
49

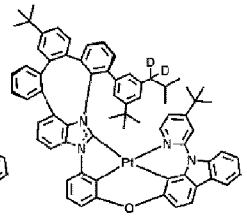
50

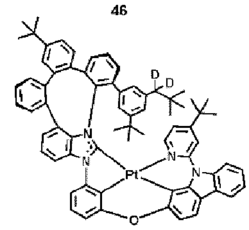
51

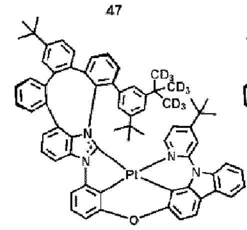
52

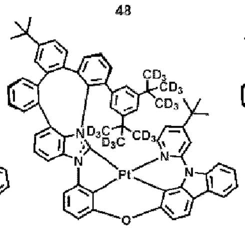
53

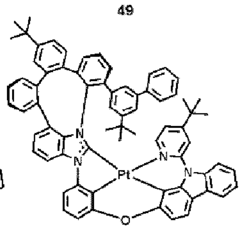
54

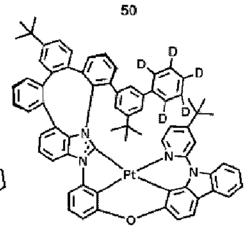
55

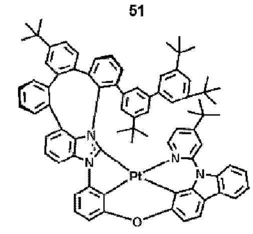
56

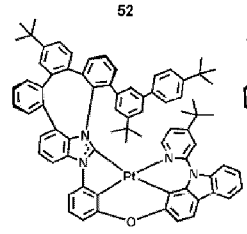
57

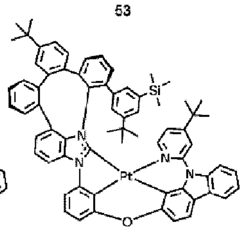
58

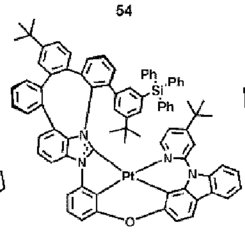
59

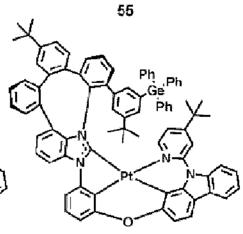
60

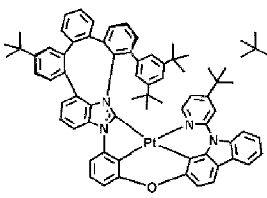
61

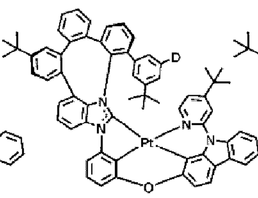
62

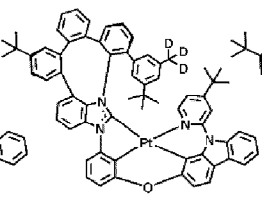
63

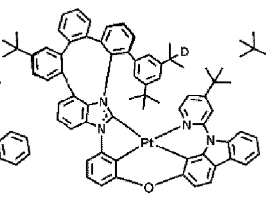
64

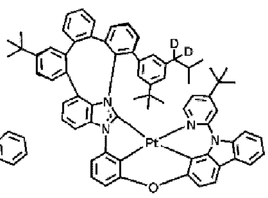
65

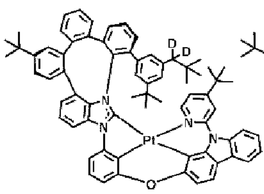
66

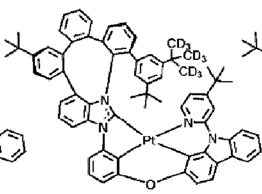
67

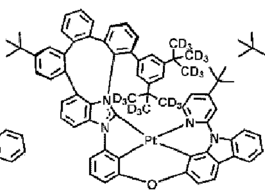
68

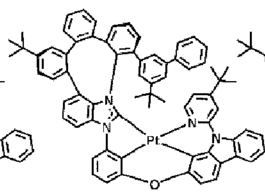
69

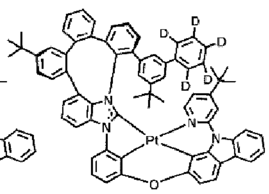
70

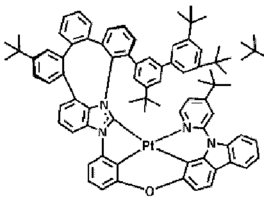
71

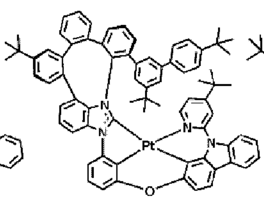
72

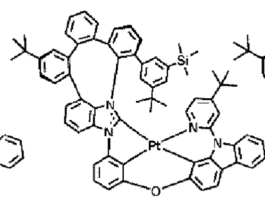
73

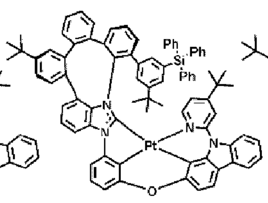
74

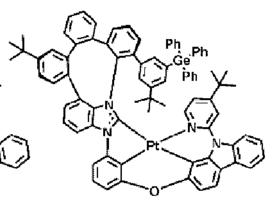
75

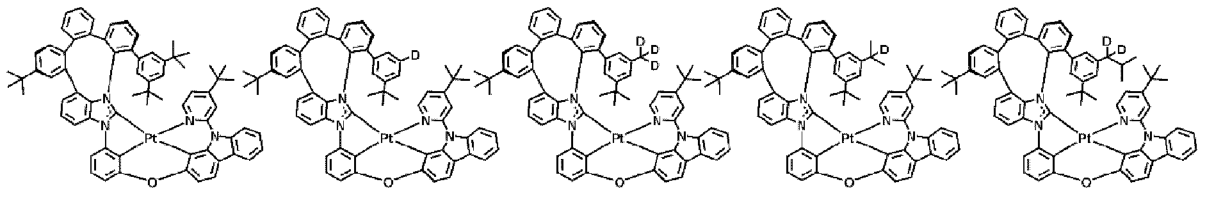

76 77 78 79 80

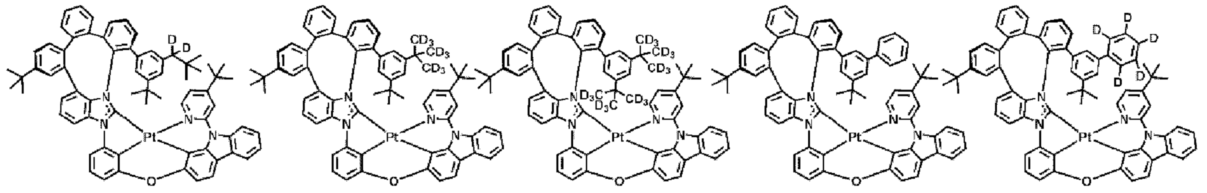

81 82 83 84 85

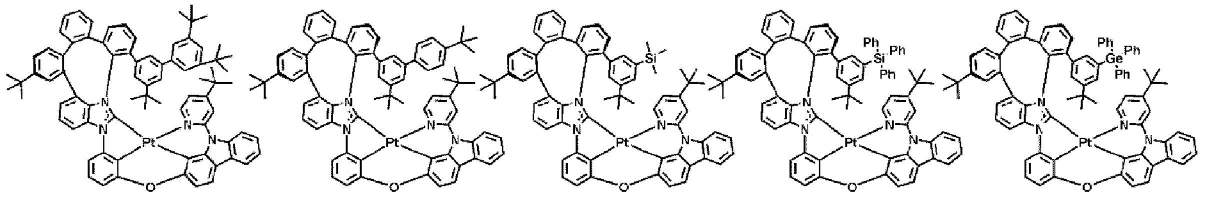

86 87 88 89 90

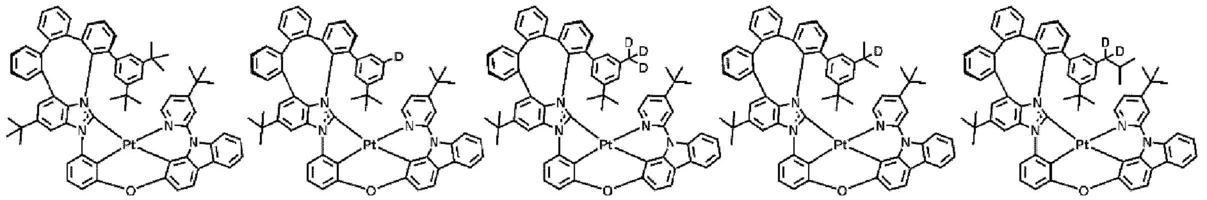

91 92 93 94 95

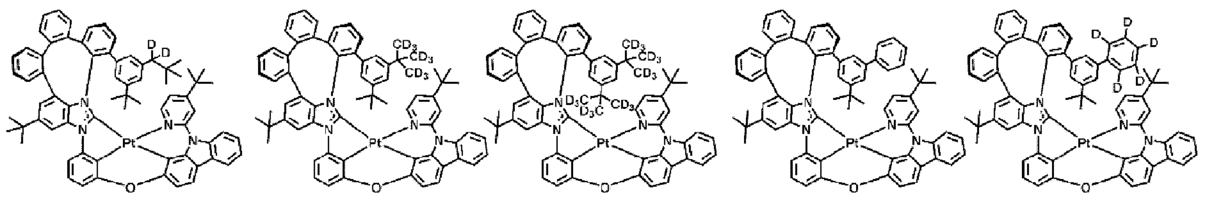

96 97 98 99 100

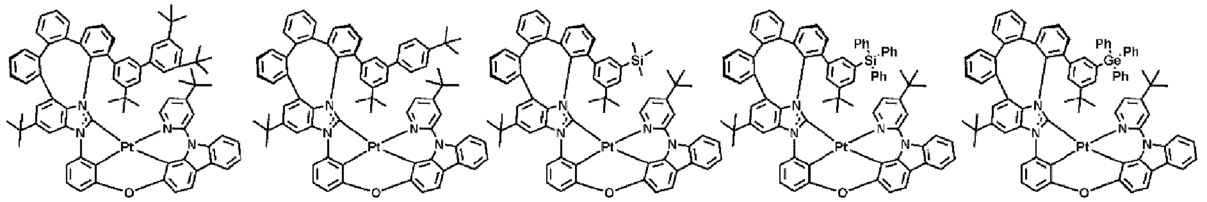

101 102 103 104 105

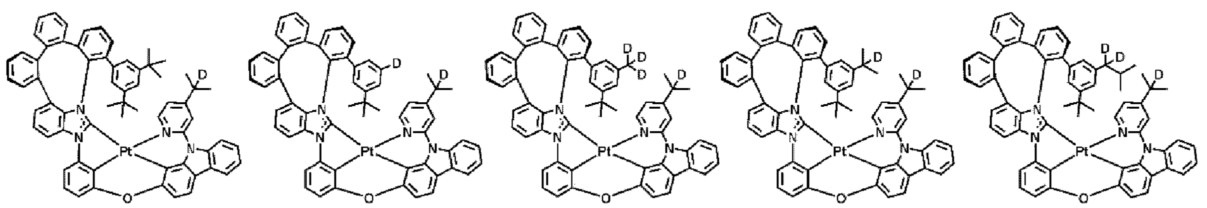

106 107 108 109 110

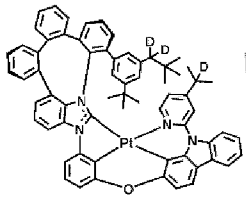
111
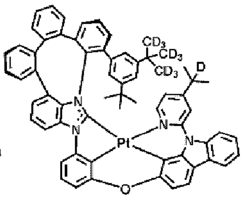
112
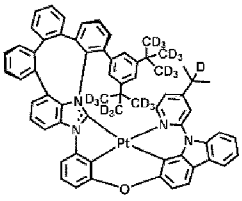
113
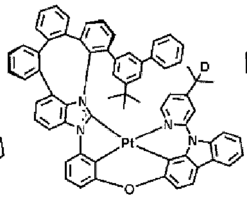
114
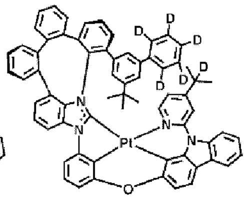
115

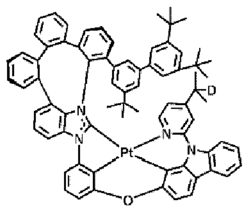
116
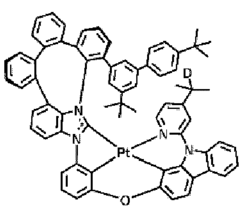
117
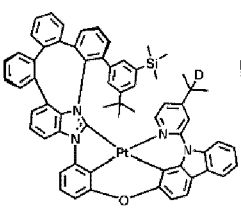
118
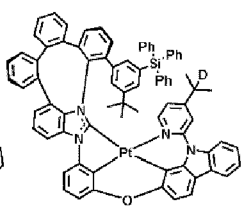
119
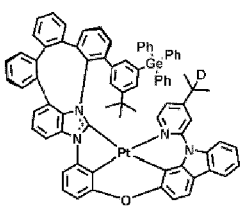
120

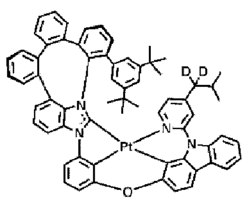
121
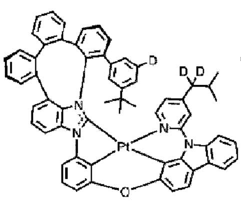
122
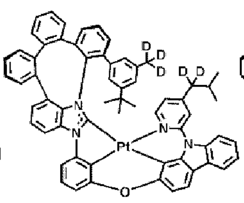
123
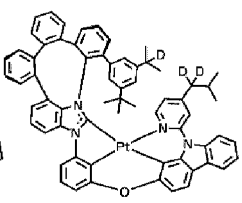
124
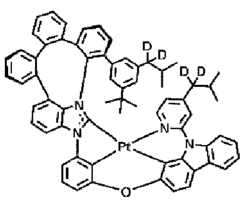
125

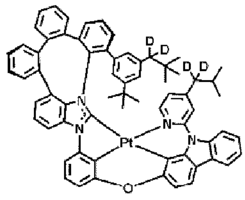
126
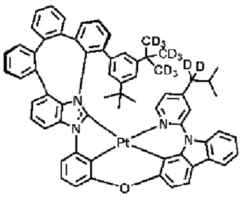
127
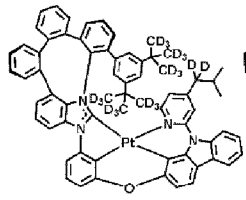
128
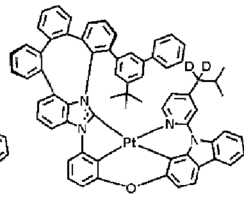
129
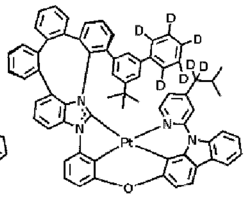
130

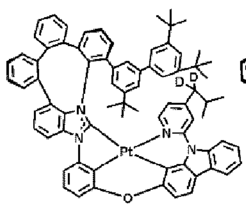
131
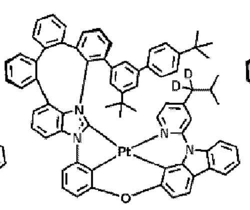
132
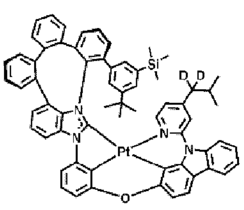
133
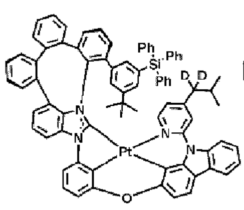
134
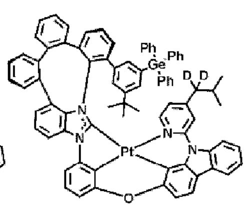
135

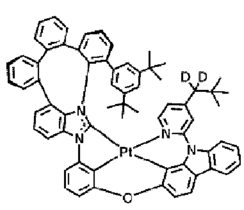
136
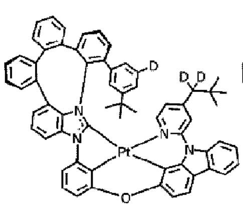
137
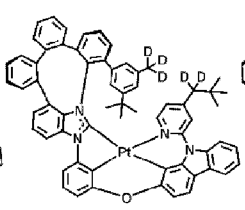
138
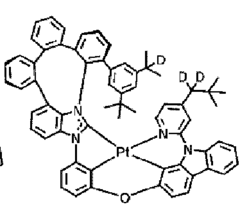
139
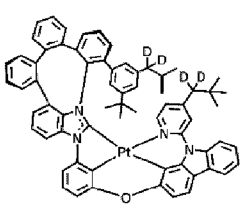
140

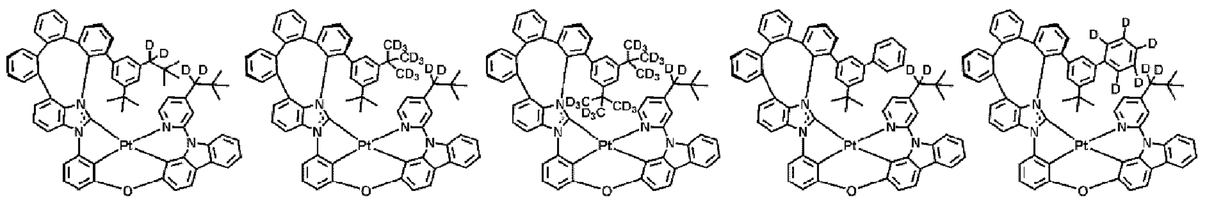

141 142 143 144 145

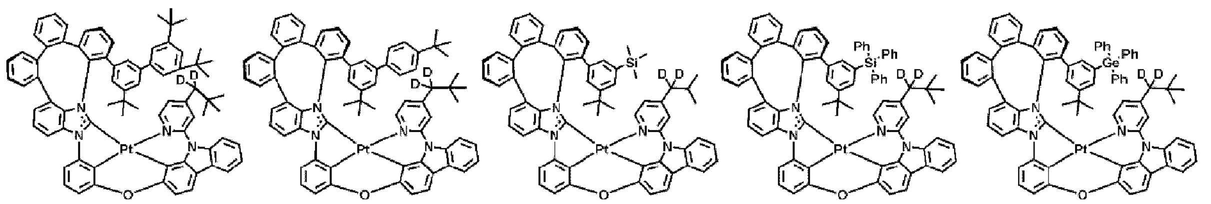

146 147 148 149 150

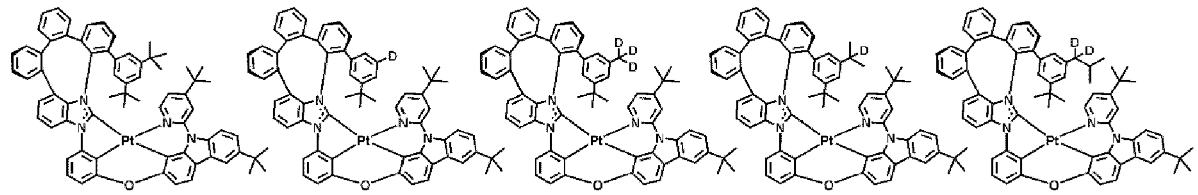

151 152 153 154 155

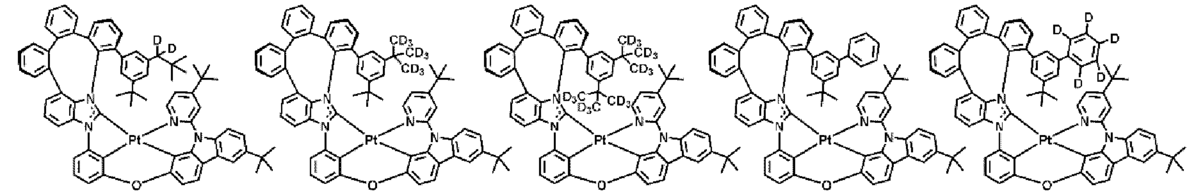

156 157 158 159 160

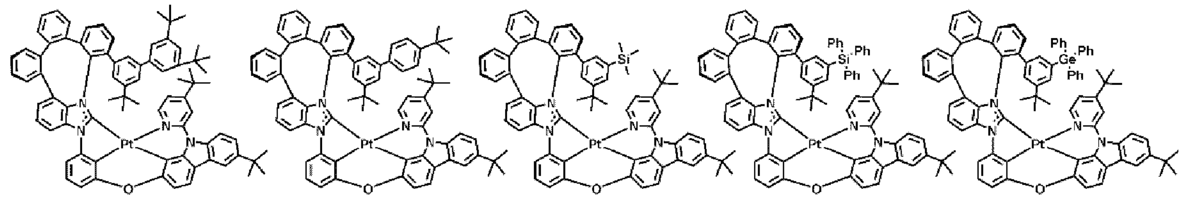

161 162 163 164 165

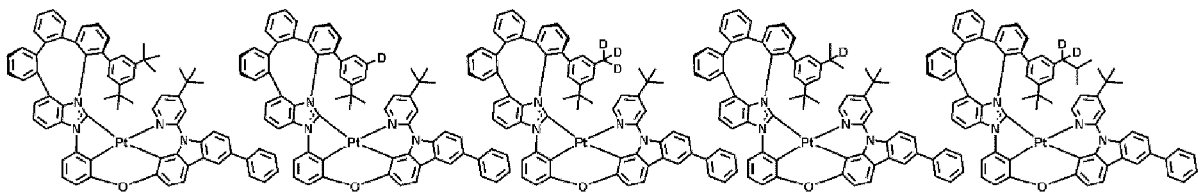

166 167 168 169 170

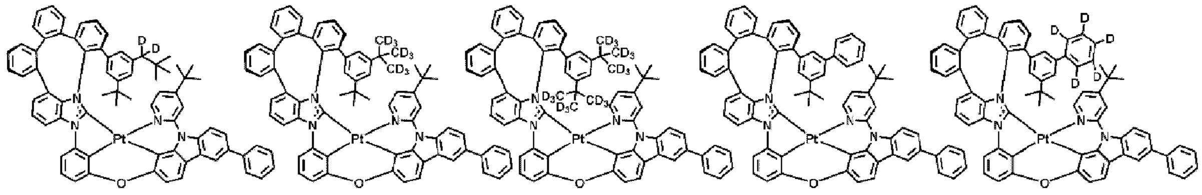

171 172 173 174 175

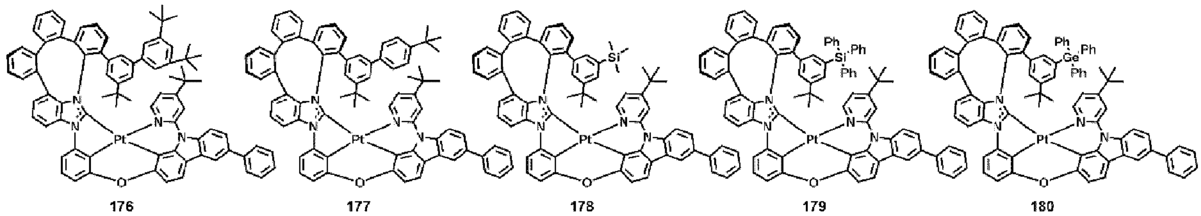

176 177 178 179 180

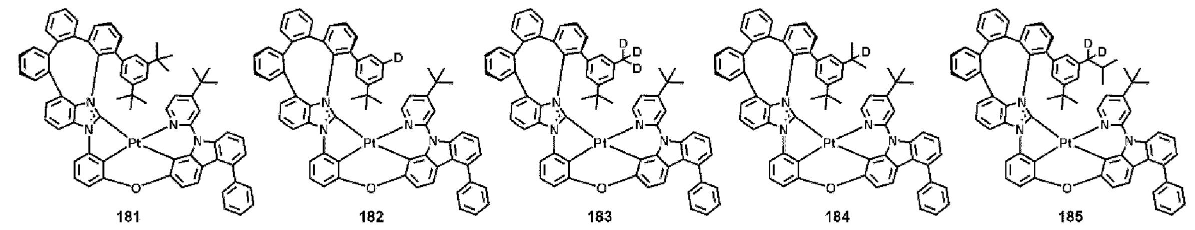

181 182 183 184 185

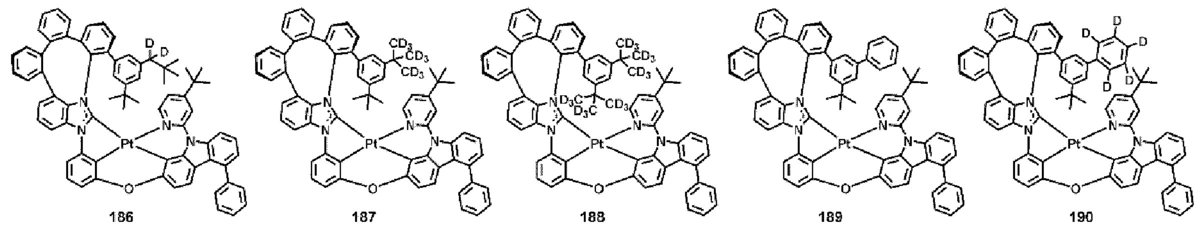

186 187 188 189 190

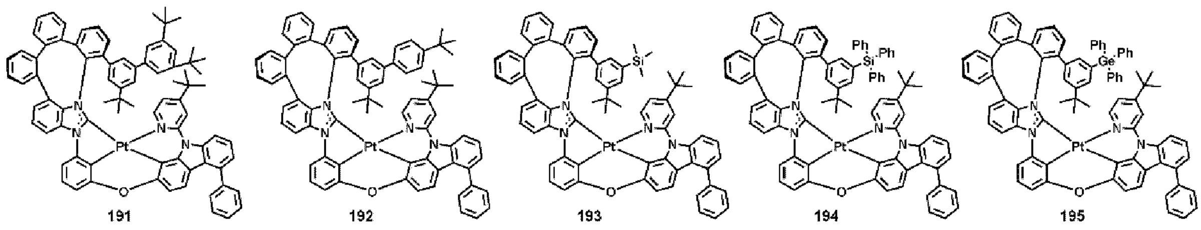

191 192 193 194 195

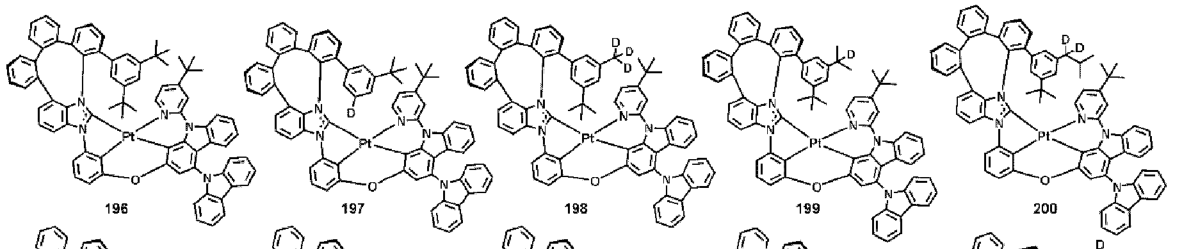

196 197 198 199 200

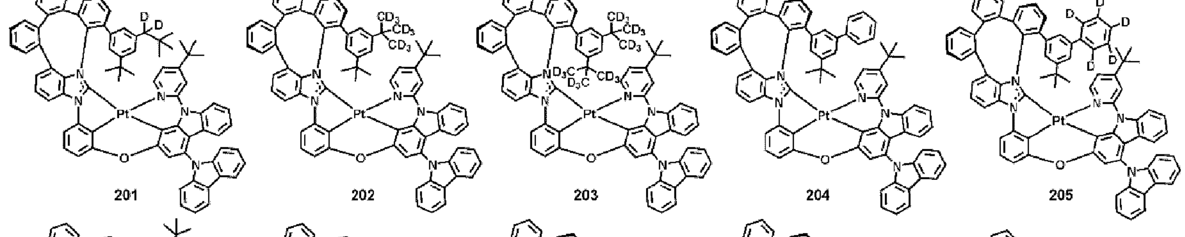

201 202 203 204 205

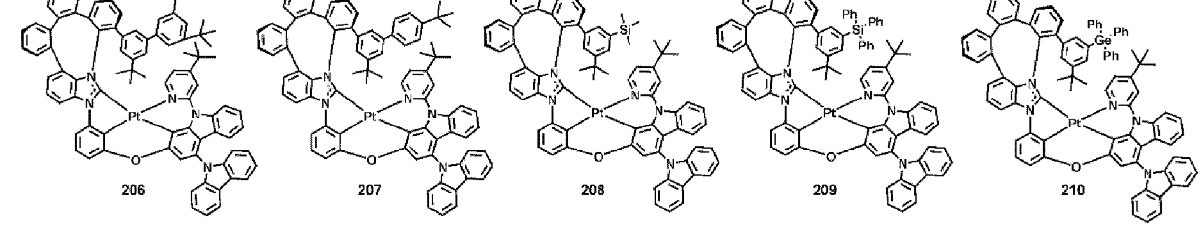

206 207 208 209 210

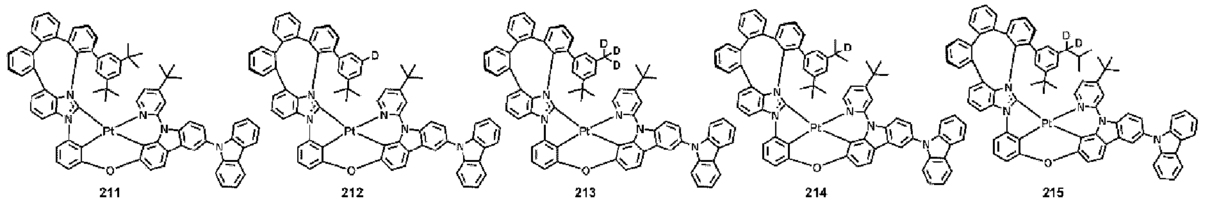

211 212 213 214 215

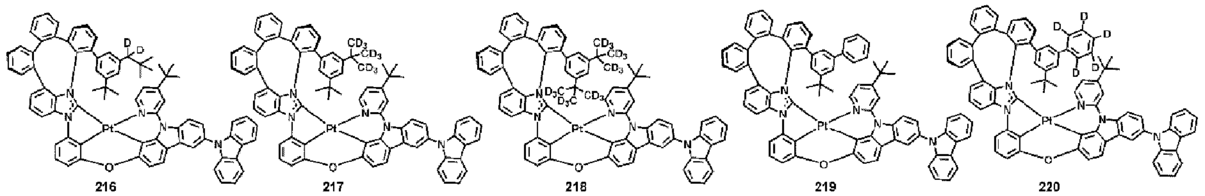

216 217 218 219 220

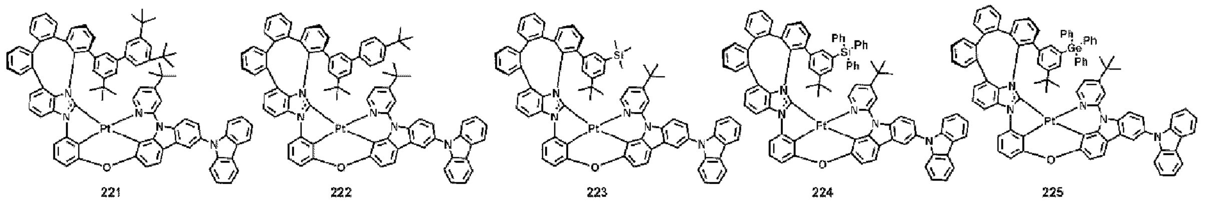

221 222 223 224 225

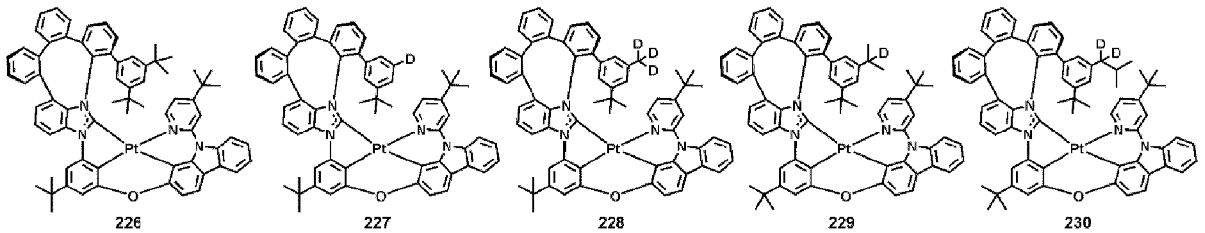

226 227 228 229 230

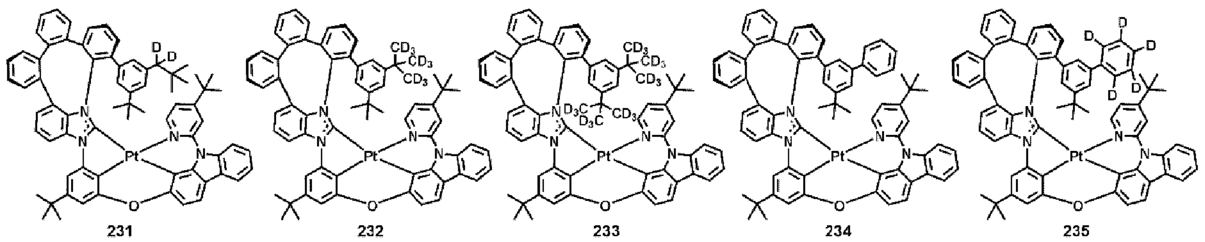

231 232 233 234 235

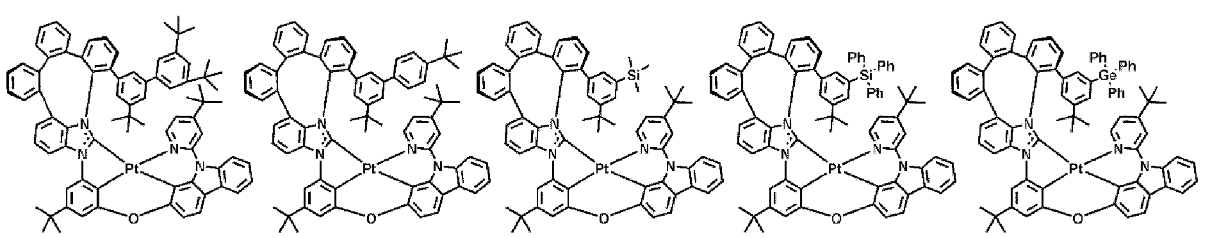

236 237 238 239 240

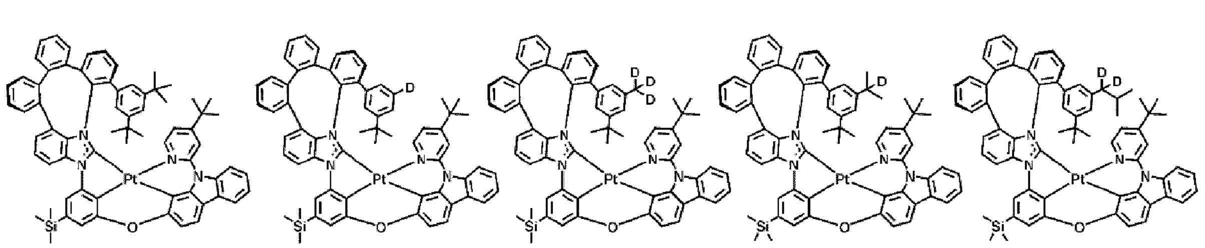

241 242 243 244 245

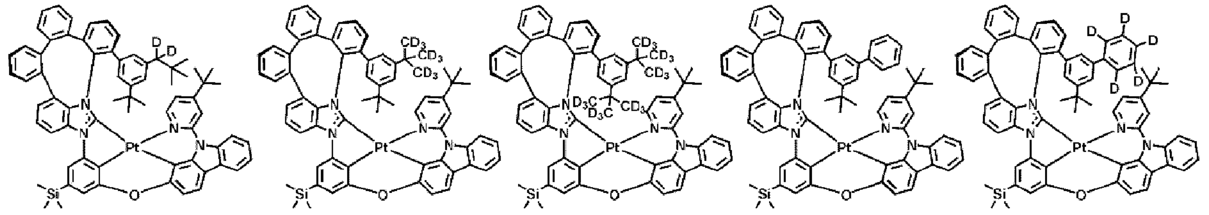

246 247 248 249 250

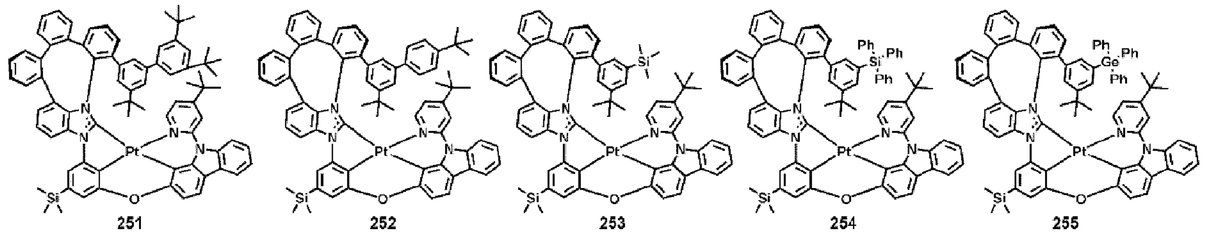

251 252 253 254 255

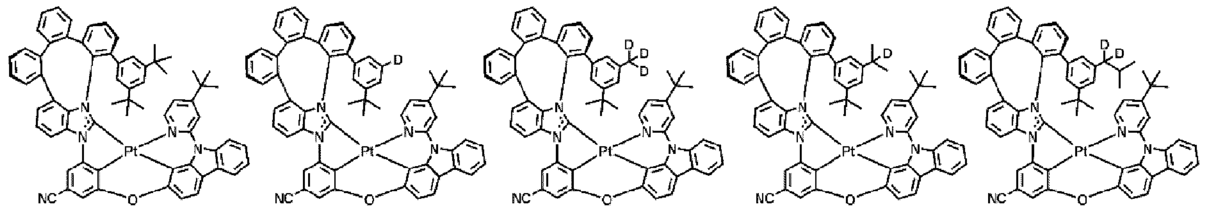

256 257 258 259 260

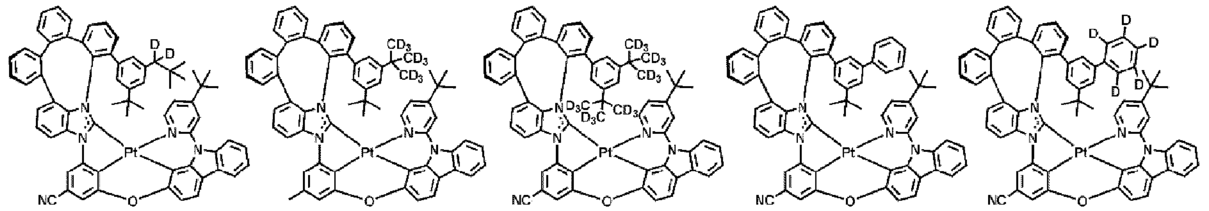

261 262 263 264 265

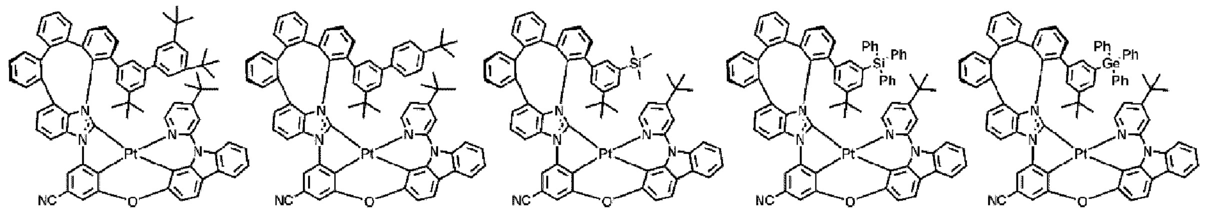

266 267 268 269 270

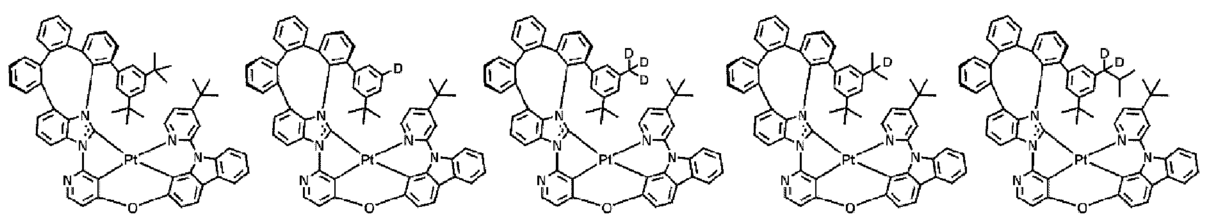

271 272 273 274 275

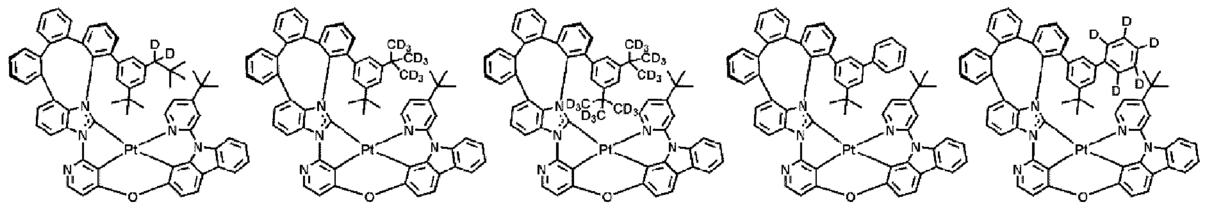

276 277 278 279 280

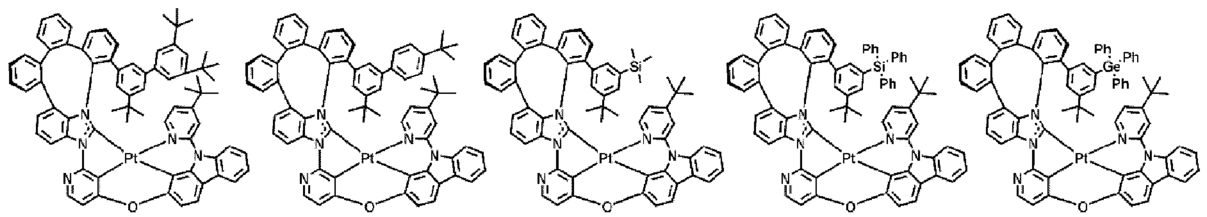

281 282 283 284 285

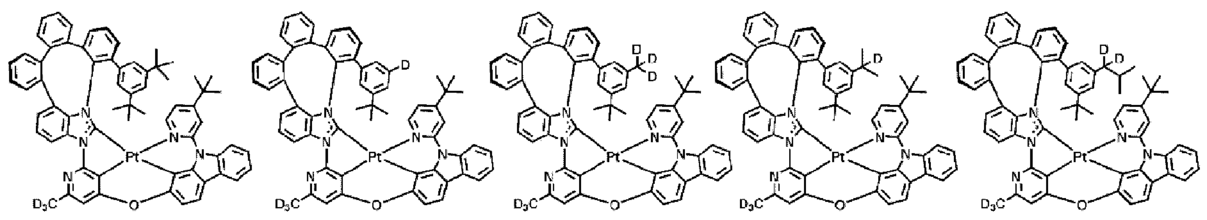

286 287 288 289 290

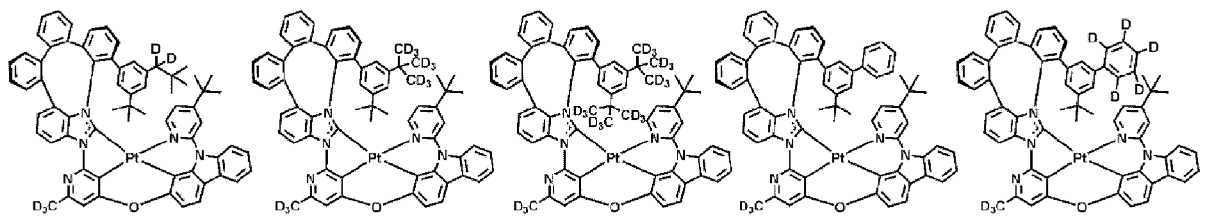

291 292 293 294 295

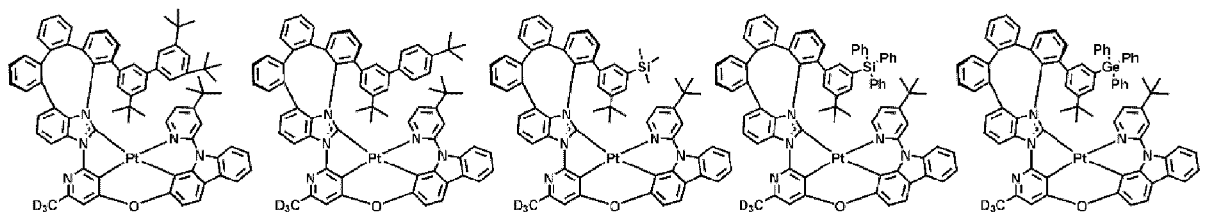

296 297 298 299 300

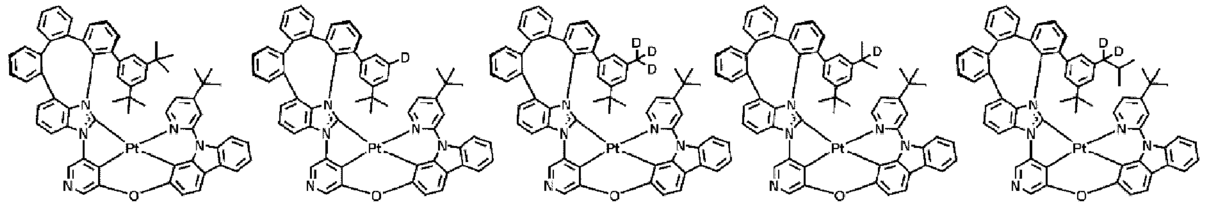

301 302 303 304 305

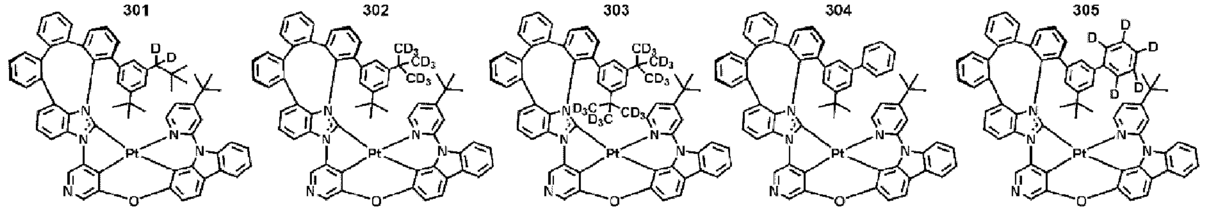

306 307 308 309 310

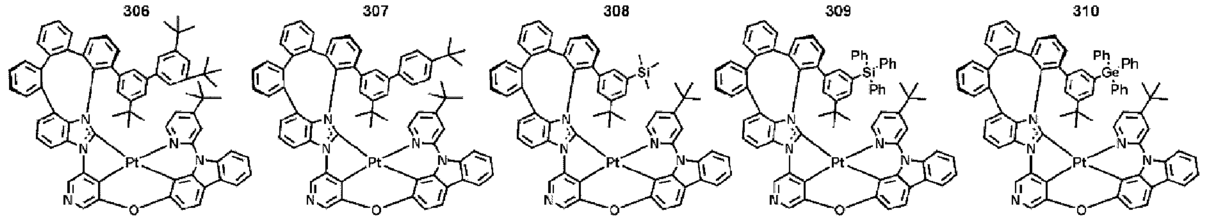

311 312 313 314 315

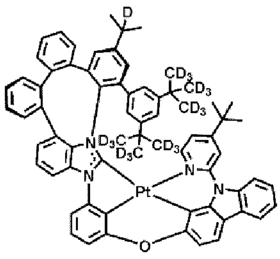

316

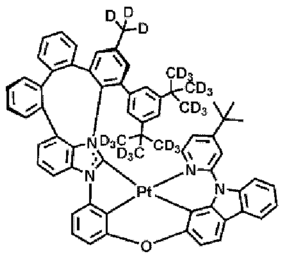

317

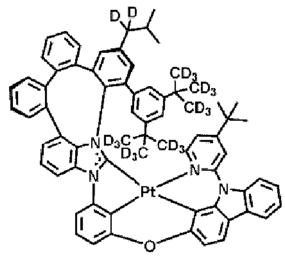

318

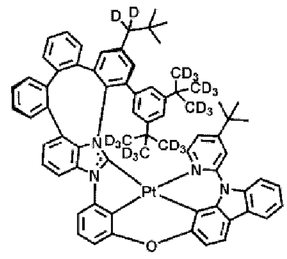

319

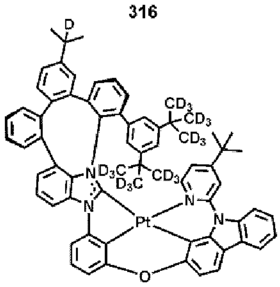

320

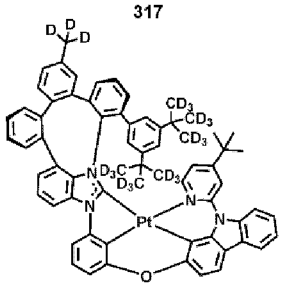

321

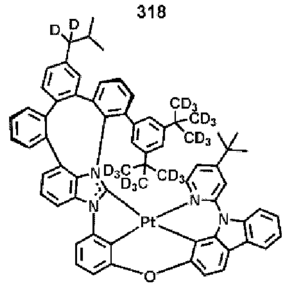

322

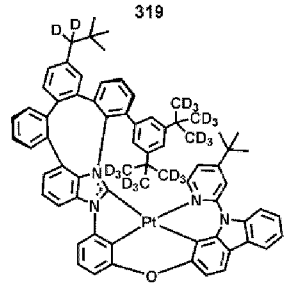

323

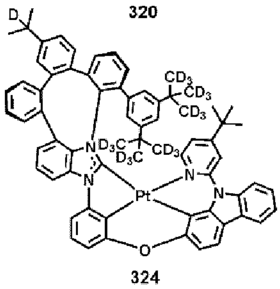

324

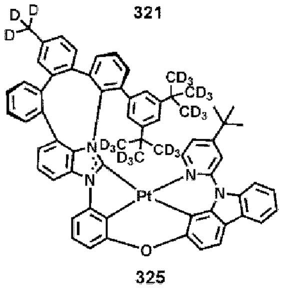

325

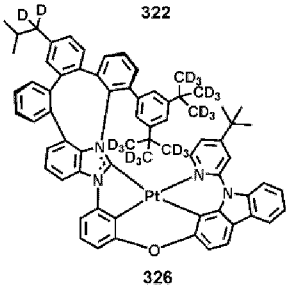

326

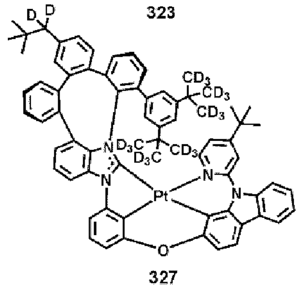

327

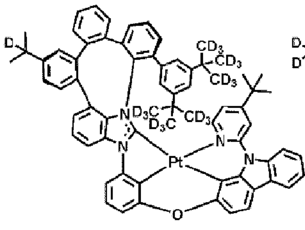
328
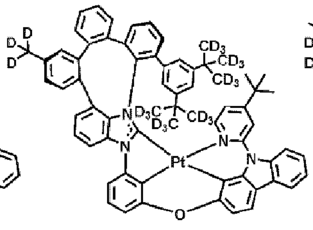
329
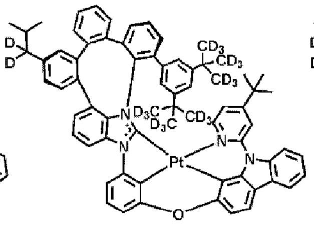
330
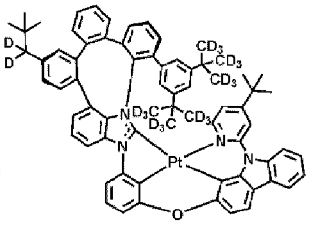
331

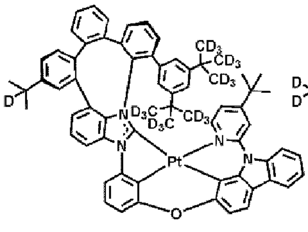
332
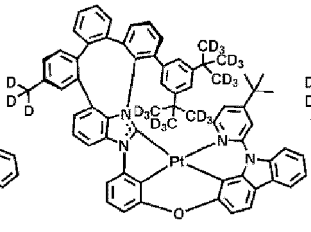
333
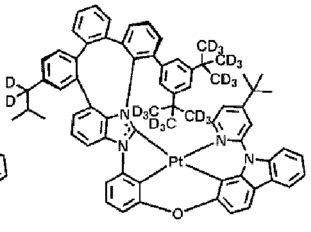
334
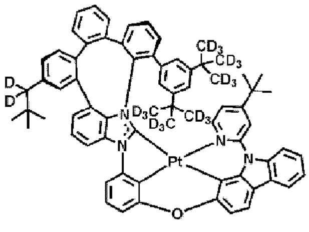
335

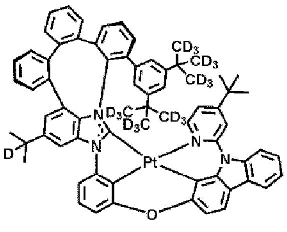
336
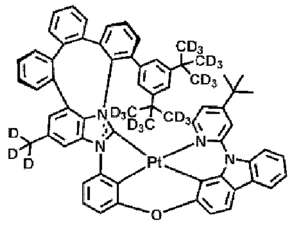
337
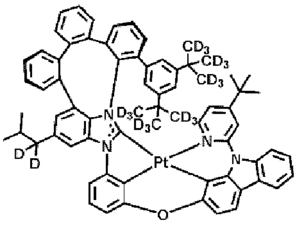
338
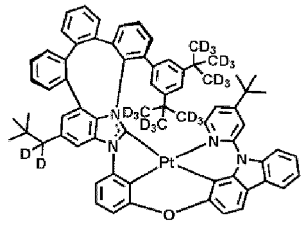
339

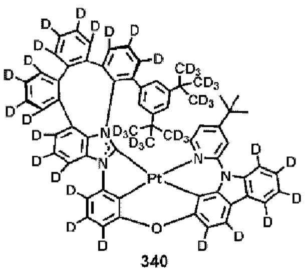
340
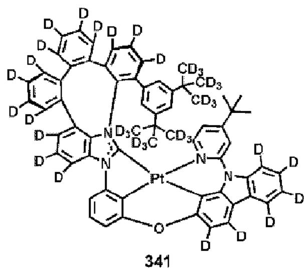
341
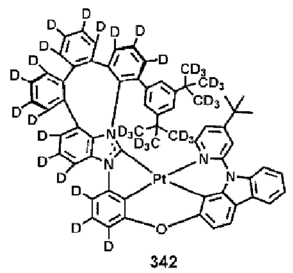
342
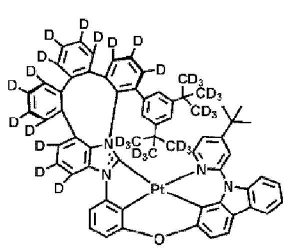
343

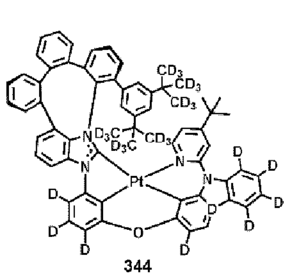
344
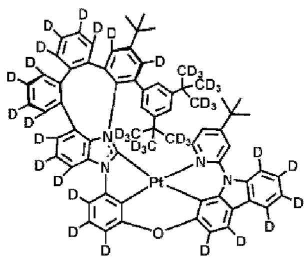
345
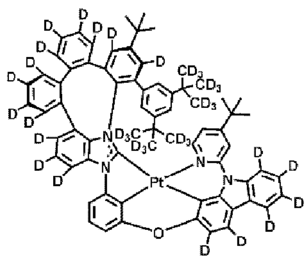
346
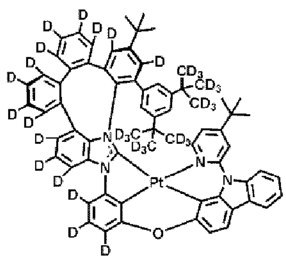
347

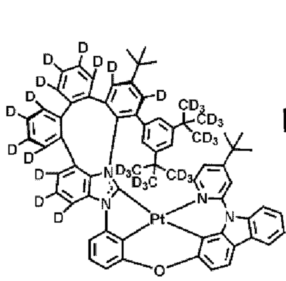
348
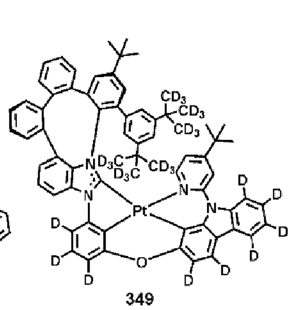
349
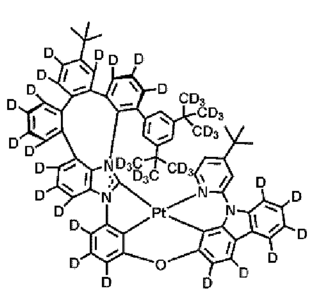
350
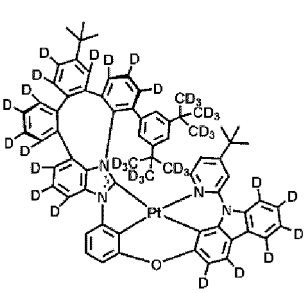
351

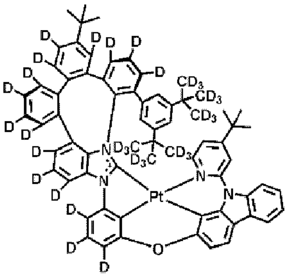
352

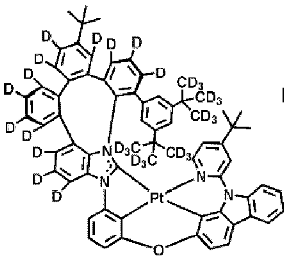
353

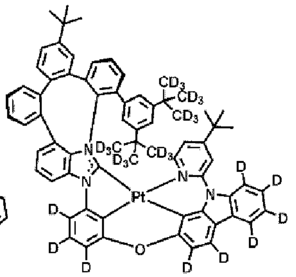
354

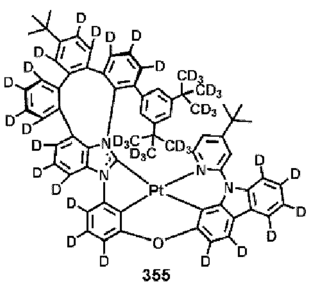
355

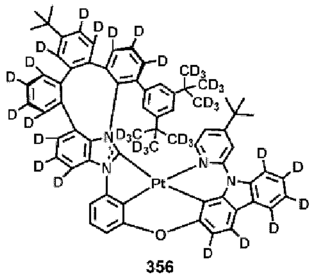
356

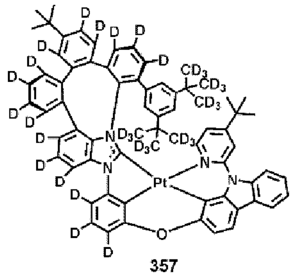
357

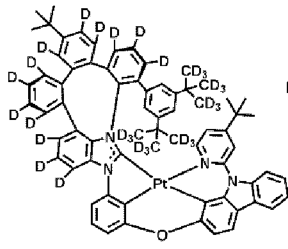
358

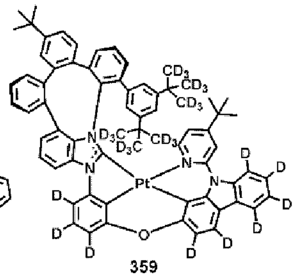
359

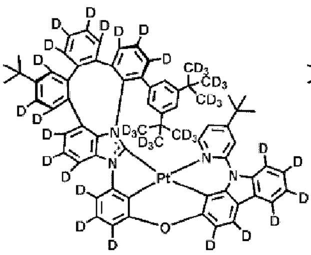
360

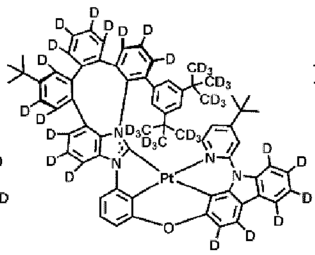
361

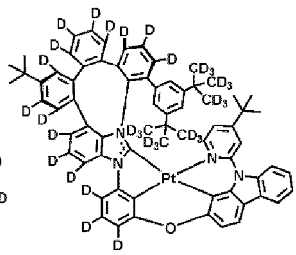
362

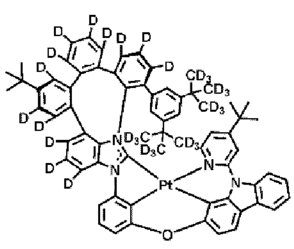
363

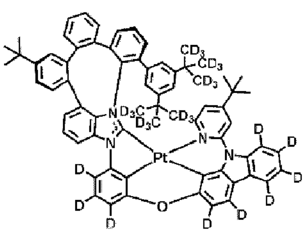
364

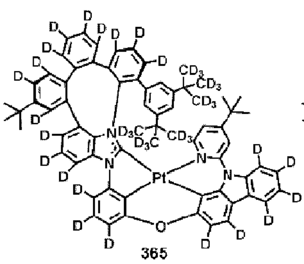
365

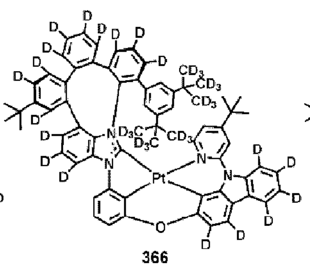
366

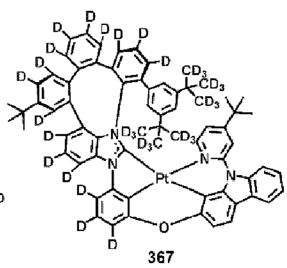
367

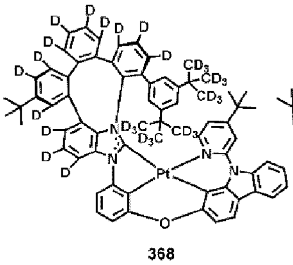
368

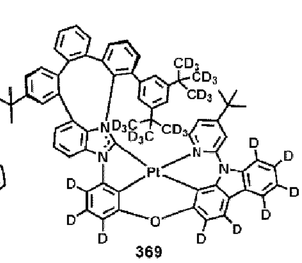
369

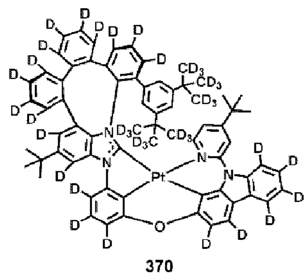
370

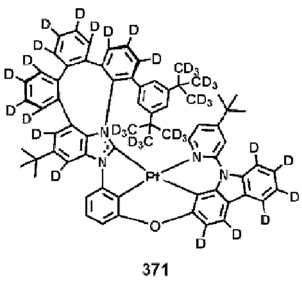
371

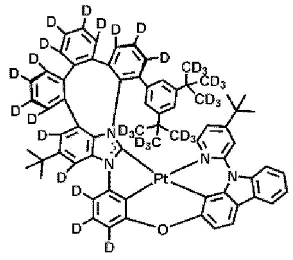
372
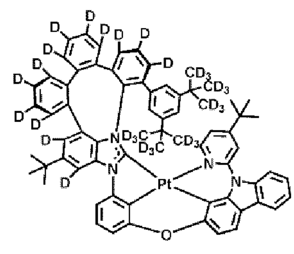
373
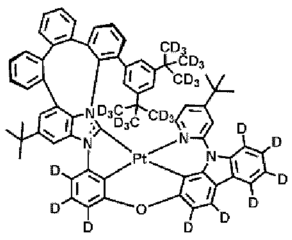
374

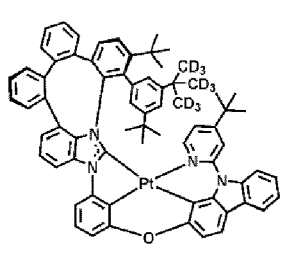
375
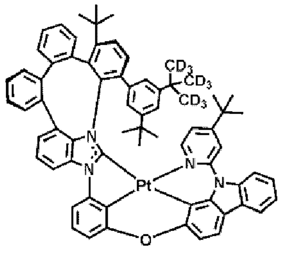
376
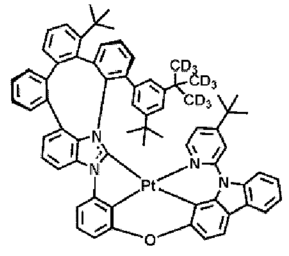
377
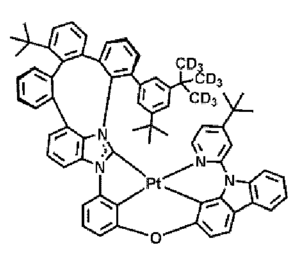
378

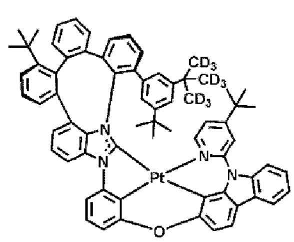
379
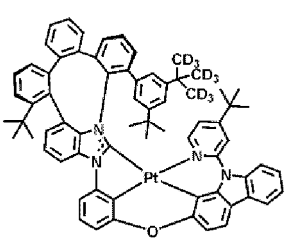
380
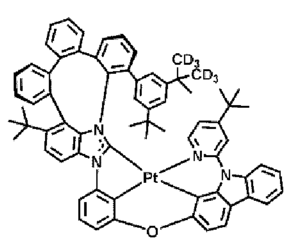
381
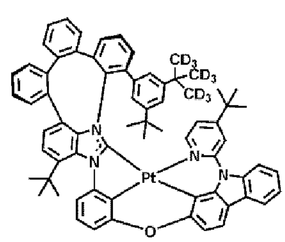
382

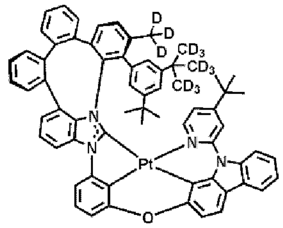
383
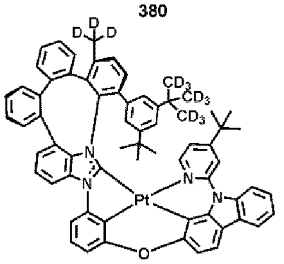
384
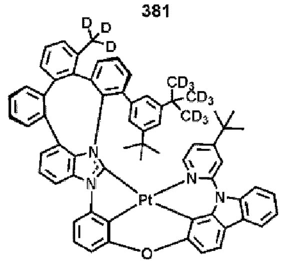
385
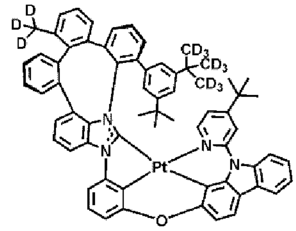
386

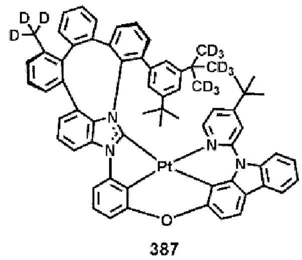
387
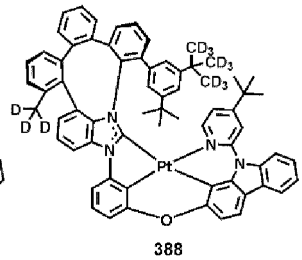
388
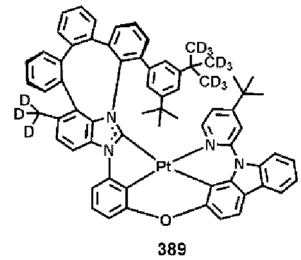
389
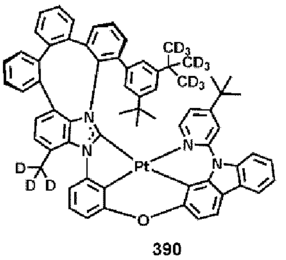
390

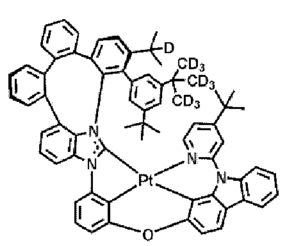
391
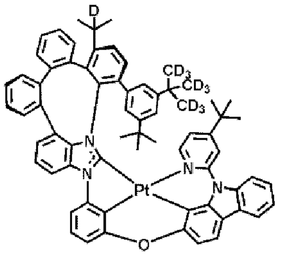
392
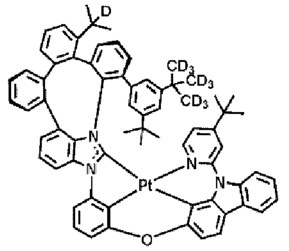
393
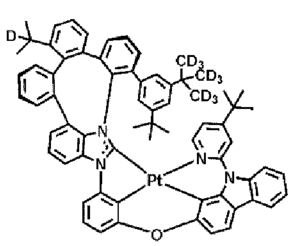
394

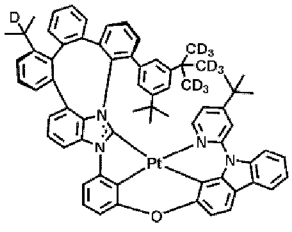
395

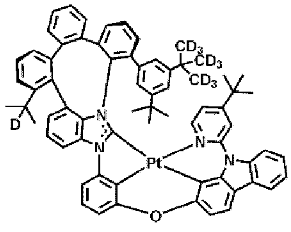
396

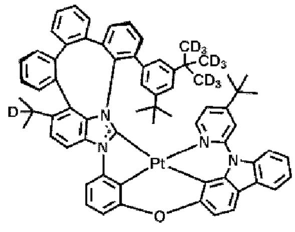
397

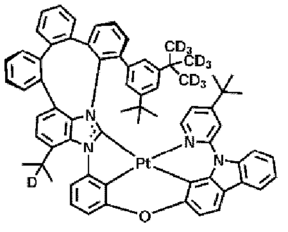
398

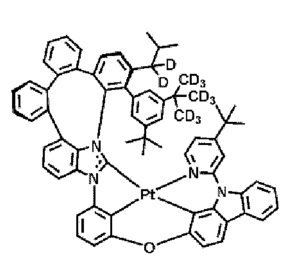
399

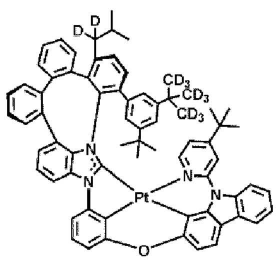
400

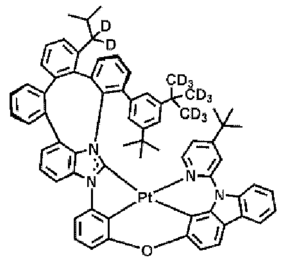
401

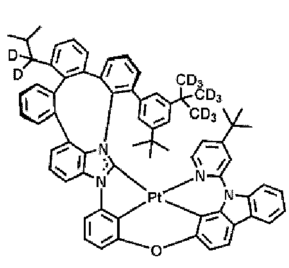
402

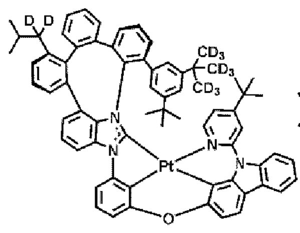
403

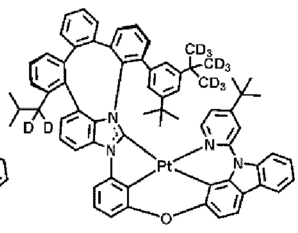
404

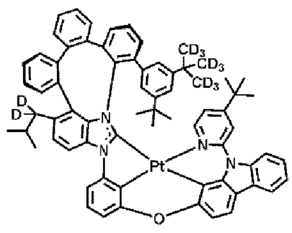
405

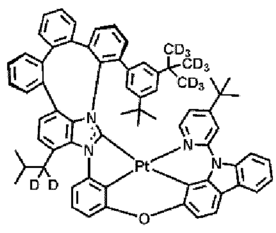
406

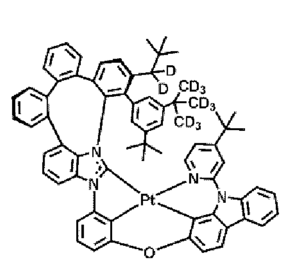
407

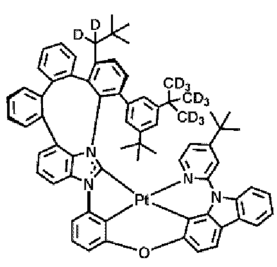
408

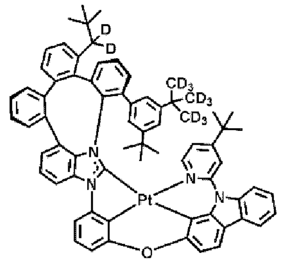
409

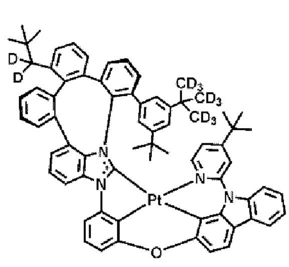
410

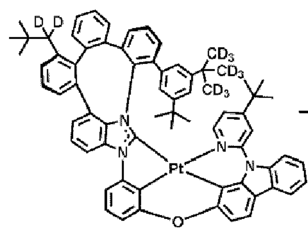
411

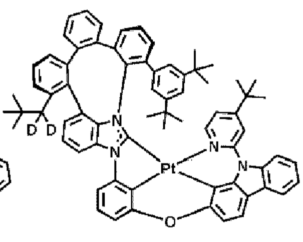
412

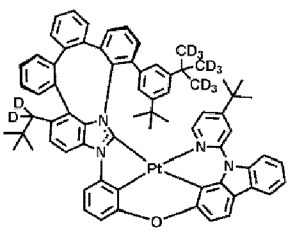
413

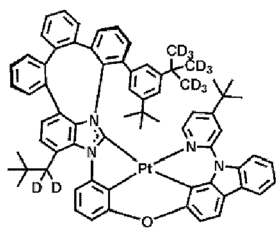
414

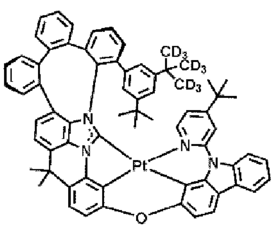
415

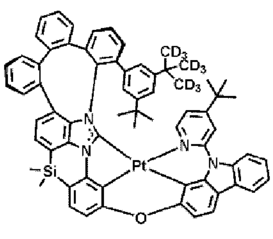
416

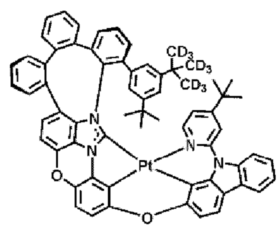
417

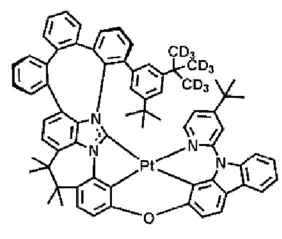
418

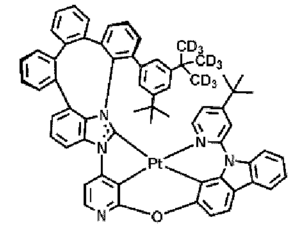

419

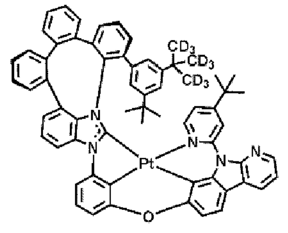

420

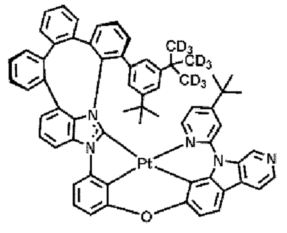

421

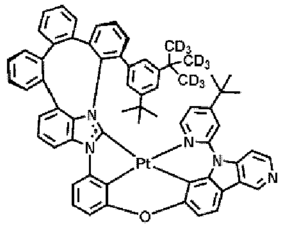

422

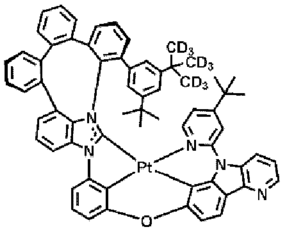

423

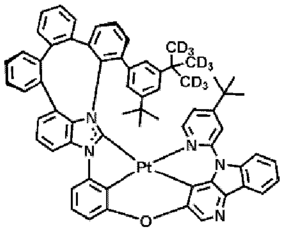

424

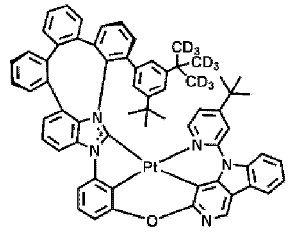

425

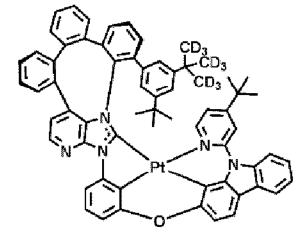

426

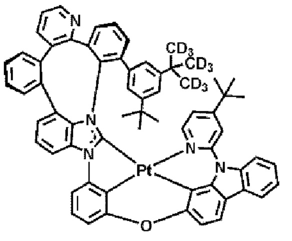

427

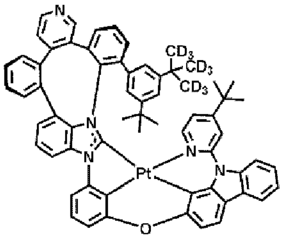

428

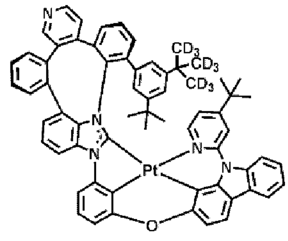

429

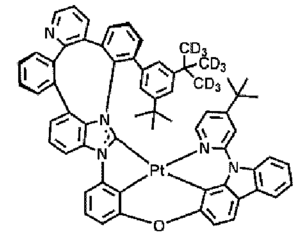

430

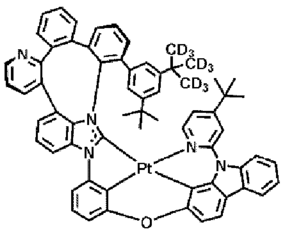

431

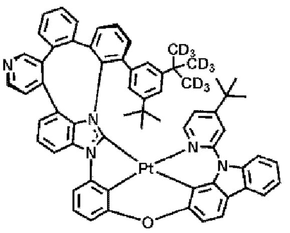

432

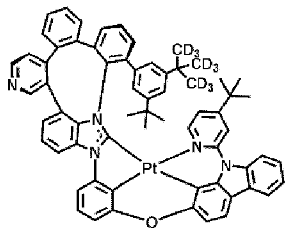

433

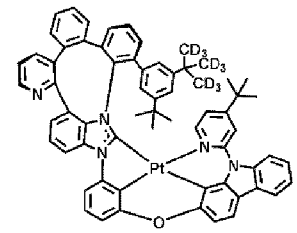

434

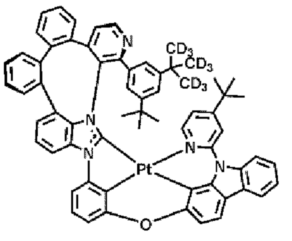

435

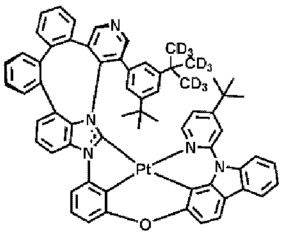

436

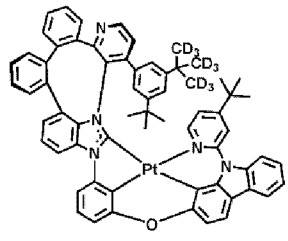

437

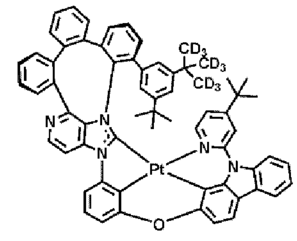

438

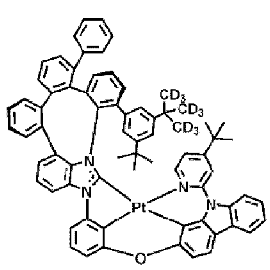
439

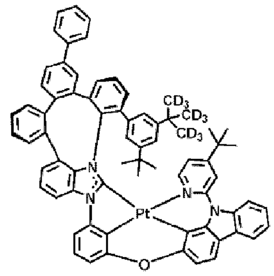
440

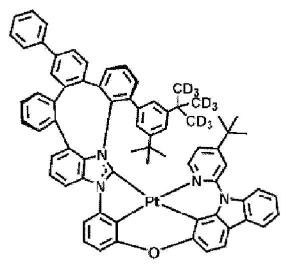
441

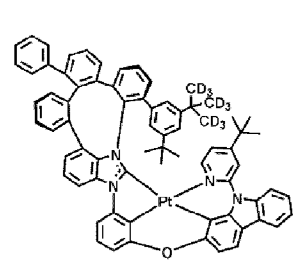
442

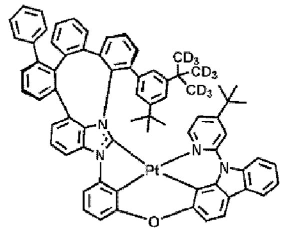
443

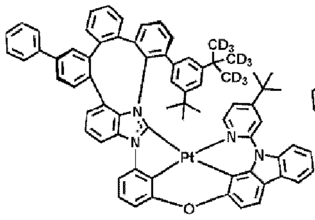
444

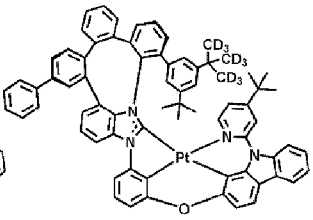
445

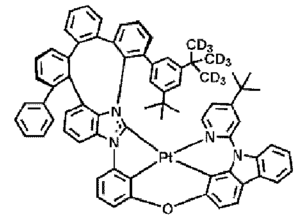
446

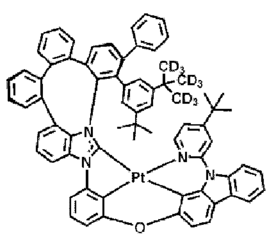
447

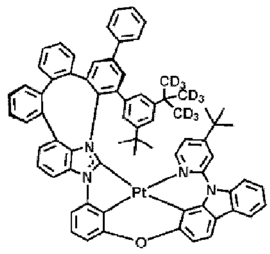
448

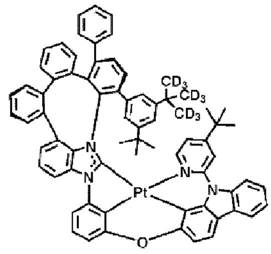
449

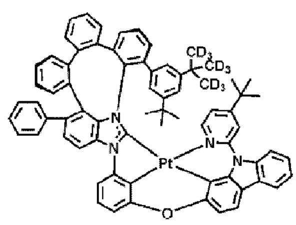
450

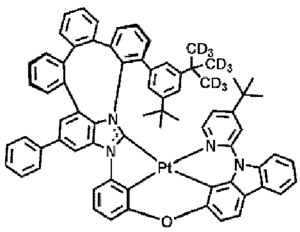
451

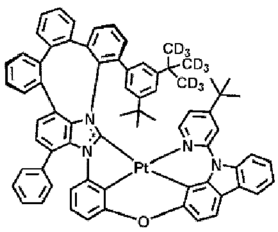
452

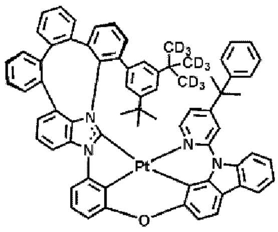
453

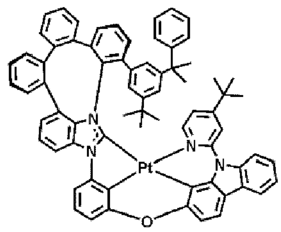
454

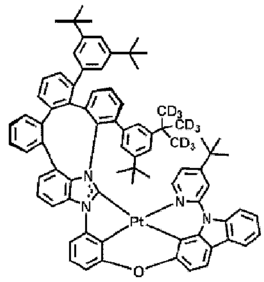

455

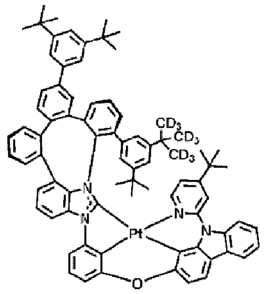

456

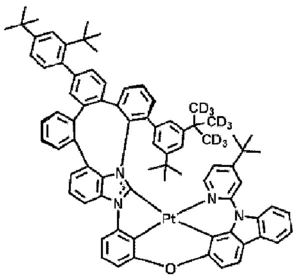

457

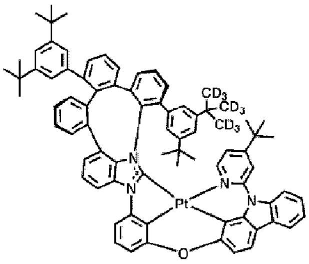

458

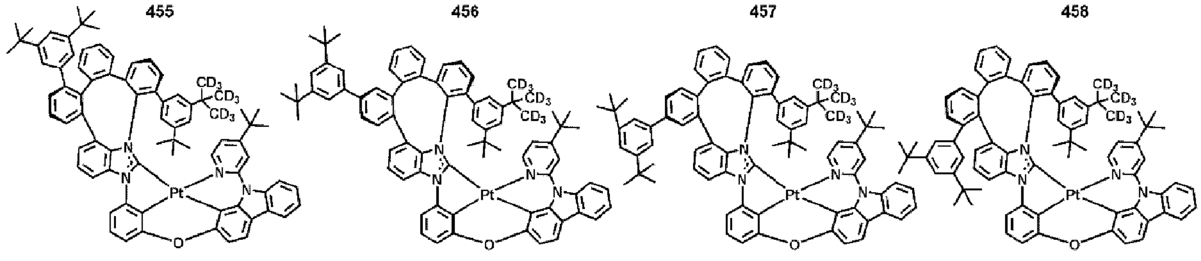

459

460

461

462

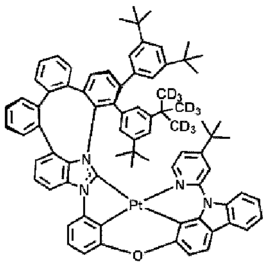

463

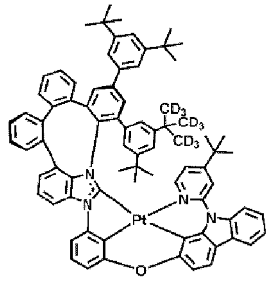

464

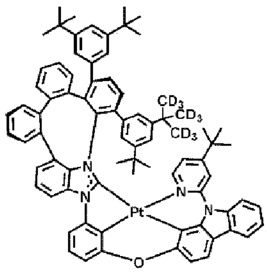

465

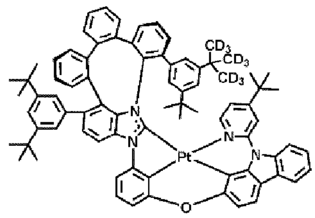

466

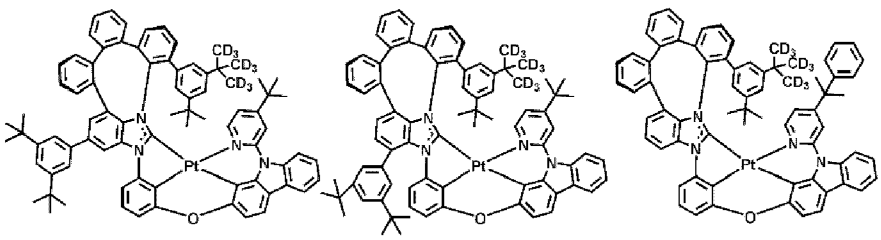

467

468

469

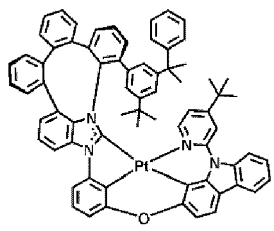

470

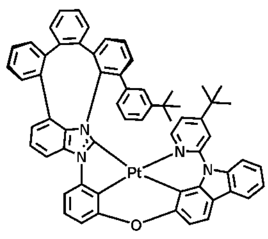

471

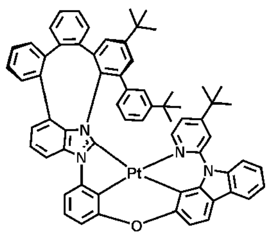

472

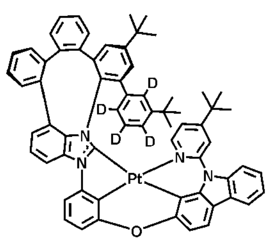

473

.

**9.** An organic light-emitting device, comprising:

a first electrode;
a second electrode; and
an organic layer arranged between the first electrode and the second electrode,
wherein the organic layer comprises at least one of the organometallic compounds of any of claims 1-8.

**10.** The organic light-emitting device of claim 9, wherein the organic layer comprises an emission layer, and the emission layer comprises the at least one of the organometallic compound;
preferably wherein the emission layer emits a blue light having a maximum emission wavelength of 400 nanometers to 490 nanometers.

**11.** The organic light-emitting device of claim 10, wherein

the emission layer comprises a host and an emitter, and
the emitter comprises the at least one of the organometallic compound.

**12.** The organic light-emitting device of claim 10, wherein

the emission layer comprises a host, a sensitizer, and an emitter, and
the sensitizer comprises the at least one of the organometallic compound.

**13.** The organic light-emitting device of claim 12, wherein the host comprises a hole-transporting host, an electron-transporting host, a bipolar host, or a combination thereof; and/or

wherein the emitter is an organic compound that does not comprise a metal; and/or
wherein the host and the sensitizer substantially do not emit a light, and the emitter emits a light.

**14.** The organic light-emitting device of any of claims 9-13, wherein the organic layer comprises

a hole transport region arranged between the first electrode and the emission layer; and
an electron transport region arranged between the emission layer and the second electrode,
wherein the hole transport region comprises at least one of a hole injection layer, a hole transport layer, or an electron-blocking layer,
the electron transport region comprises at least one of a hole-blocking layer, an electron transport layer, or an electron injection layer, and
at least one of the hole transport region and the electron transport region comprises the at least one of the organometallic compound.

**15.** An electronic apparatus, comprising the organic light-emitting device of any of claims 9-14.

FIG. 1

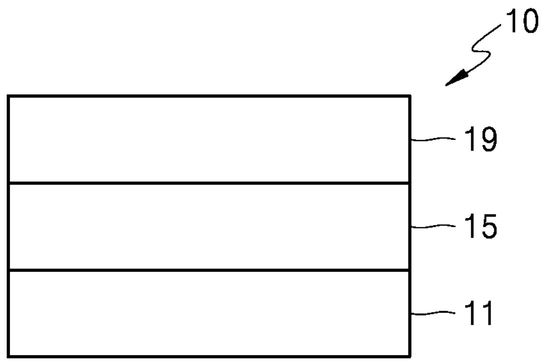
10
19
15
11

FIG. 2

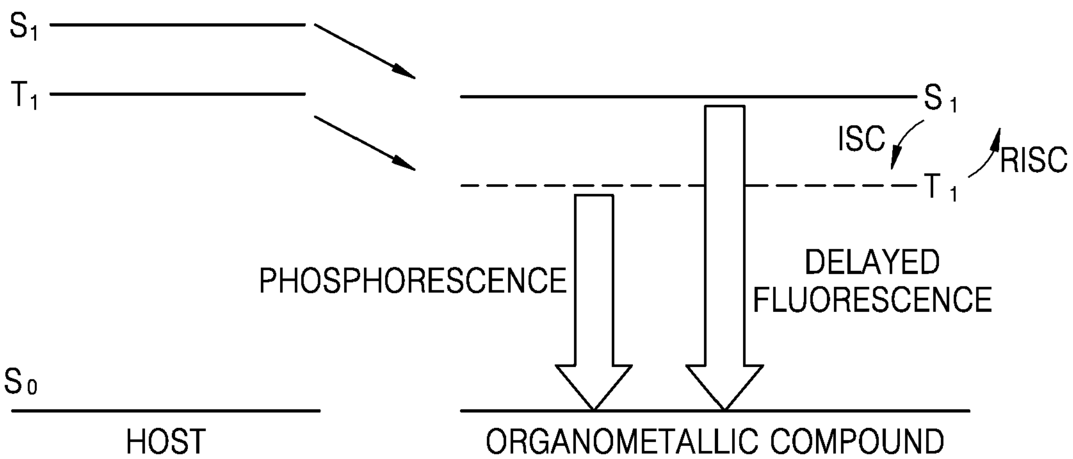
S1
T1
S1
ISC
T1
RISC
PHOSPHORESCENCE
DELAYED
FLUORESCENCE
S0
HOST
ORGANOMETALLIC COMPOUND

FIG. 3

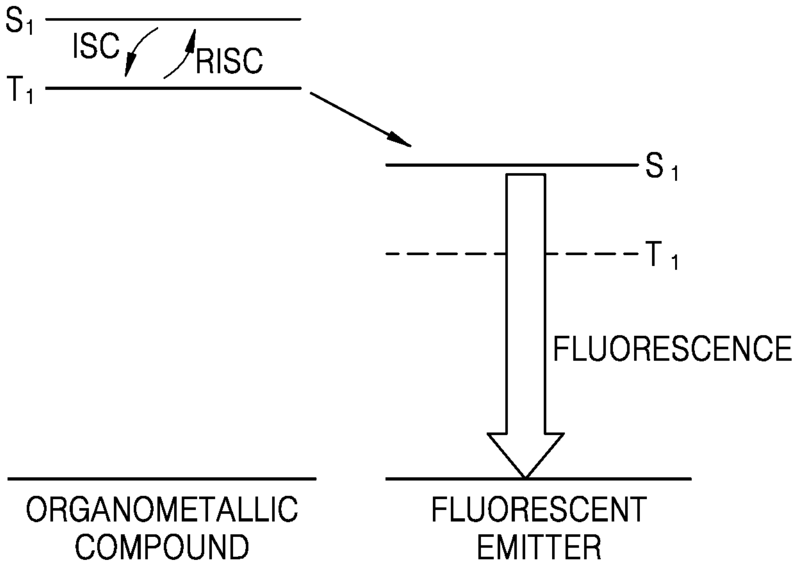
S1
ISC
RISC
T1
S1
T1
FLUORESCENCE
ORGANOMETALLIC COMPOUND
FLUORESCENT EMITTER

FIG. 4

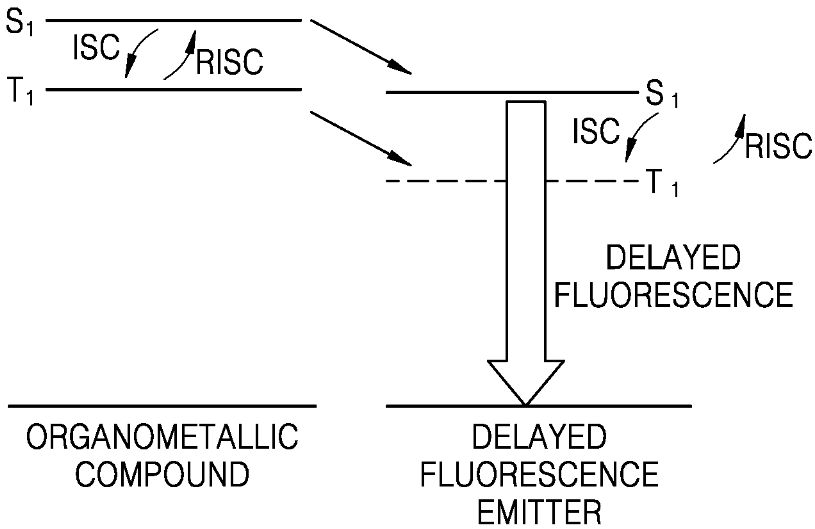
S1
ISC
RISC
T1
S1
ISC
RISC
T1
DELAYED FLUORESCENCE
ORGANOMETALLIC COMPOUND
DELAYED FLUORESCENCE EMITTER

Europäisches Patentamt
European Patent Office
Office européen des brevets

# EUROPEAN SEARCH REPORT

Application Number
EP 24 19 7919

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE REAXYS [Online]<br><br>1 January 2022 (2022-01-01),<br>Universal Display: "ORGANIC ELECTROLUMINESCENT MATERIALS AND DEVICES - US2022/112232 A1",<br>XP093239430,<br>Database accession no. XRN = 42008935, 42008972<br>* abstract * | 1-15 | INV.<br>C07F15/00<br>C09K11/06<br>H10K85/00 |
| X | -& DATABASE CAPLUS [Online]<br><br>1 January 2022 (2022-01-01),<br>Universal Display Corp: "Organic electroluminescent materials and devices Accession Number US 20220112232 A1",<br>XP093239446,<br>Database accession no. 2024:1612880<br>* abstract *<br>& US 2022/112232 A1 (MACINNIS MORGAN C [US] ET AL) 14 April 2022 (2022-04-14)<br>----- | 1-15 | |
| | | | TECHNICAL FIELDS SEARCHED (IPC) |
| X | DATABASE CAPLUS [Online]<br><br>1 January 2022 (2022-01-01),<br>Universal Display Corp: "Organic electroluminescent materials and devices - US 20230167145 A1",<br>XP093239451,<br>Database accession no. 2024:1612880<br>* abstract *<br>-/-- | 1-15 | C07F<br>H05B<br>C07B<br>C09K<br>H10K |

The present search report has been drawn up for all claims

3

| Place of search | Date of completion of the search | Examiner |
|---|---|---|
| The Hague | 29 January 2025 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 24 19 7919

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | -& DATABASE CAPLUS [Online]<br><br>1 June 2023 (2023-06-01),<br>Universal Display Corp J: "Organic electroluminescent materials and devices - US 20230167145 A1",<br>XP093239449,<br>Database accession no. 2023:1114479<br>* abstract *<br>-& US 2023/167145 A1 (THOMPSON NICHOLAS J [US] ET AL) 1 June 2023 (2023-06-01)<br>* claims 14-16 *<br>----- | 1-15 | |
| X | DATABASE CAPLUS [Online]<br><br>2 March 2023 (2023-03-02),<br>Universal Display Corp: "Organic electroluminescent materials and devices - US 20230065887 A1",<br>XP093239457,<br>Database accession no. 2023:400874<br>* abstract *<br>& US 2023/065887 A1 (CHEN HSIAO-FAN [US] ET AL) 2 March 2023 (2023-03-02)<br>----- | 1-15 | TECHNICAL FIELDS SEARCHED (IPC) |
| X | DATABASE CAPLUS [Online]<br><br>25 May 2023 (2023-05-25),<br>Universal Display Corp: "Organic electroluminescent materials and devices - US 20230159578 A1",<br>XP093239463,<br>Database accession no. 2023:1068005<br>* abstract *<br>& US 2023/159578 A1 (CHEN HSIAO-FAN [US] ET AL) 25 May 2023 (2023-05-25)<br>-----<br>-/-- | 1-15 | |

The present search report has been drawn up for all claims

3

| Place of search | Date of completion of the search | Examiner |
|---|---|---|
| The Hague | 29 January 2025 | Eberhard, Michael |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches Patentamt
European Patent Office
Office européen des brevets

# EUROPEAN SEARCH REPORT

Application Number
EP 24 19 7919

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE CAPLUS [Online]<br><br>13 April 2023 (2023-04-13), Universal Display Corp J: "Organic electroluminescent materials and devices - US 20230115552 A1", XP093239461, Database accession no. 2023:750401<br>* abstract *<br>& US 2023/115552 A1 (THOMPSON NICHOLAS J [US] ET AL) 13 April 2023 (2023-04-13)<br>----- | 1-15 | |
| | | | TECHNICAL FIELDS SEARCHED (IPC) |

The present search report has been drawn up for all claims

| Place of search | Date of completion of the search | Examiner |
|---|---|---|
| The Hague | 29 January 2025 | Eberhard, Michael |

3

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 24 19 7919

This annex lists the patent family members relating to the patent documents cited in the above-mentioned European search report. The members are as contained in the European Patent Office EDP file on
The European Patent Office is in no way liable for these particulars which are merely given for the purpose of information.

29-01-2025

| Patent document cited in search report | Publication date | Patent family member(s) | Publication date |
|---|---|---|---|
| US 2023167145 A1 | 01-06-2023 | NONE | |

EPO FORM P0459

For more details about this annex : see Official Journal of the European Patent Office, No. 12/82